(19) Europäisches Patentamt
European Patent Office
Office européen des brevets

(11) EP 4 306 612 B1

# (12) EUROPEAN PATENT SPECIFICATION

(45) Date of publication and mention of the grant of the patent:
**18.12.2024 Bulletin 2024/51**

(21) Application number: **23155290.2**

(22) Date of filing: **07.02.2023**

(51) International Patent Classification (IPC):
***C09K 11/06*** $^{(2006.01)}$ ***C07F 5/02*** $^{(2006.01)}$
***H10K 85/60*** $^{(2023.01)}$ *H10K 50/11* $^{(2023.01)}$

(52) Cooperative Patent Classification (CPC):
**C07F 5/027; C09K 11/06; H10K 85/6572; H10K 85/658;** C09K 2211/1029; C09K 2211/1096; H10K 50/11

## (54) HETEROCYCLIC COMPOUND, ORGANIC LIGHT-EMITTING DEVICE INCLUDING THE SAME, AND ELECTRONIC APPARATUS INCLUDING THE ORGANIC LIGHT-EMITTING DEVICE

HETEROCYCLISCHE VERBINDUNG, ORGANISCHE LICHTEMITTIERENDE VORRICHTUNG DAMIT UND ELEKTRONISCHE VORRICHTUNG MIT DER ORGANISCHEN LICHTEMITTIERENDEN VORRICHTUNG

COMPOSÉ HÉTÉROCYCLIQUE, DISPOSITIF ÉLECTROLUMINESCENT ORGANIQUE LE COMPRENANT ET APPAREIL ÉLECTRONIQUE COMPRENANT LE DISPOSITIF ÉLECTROLUMINESCENT ORGANIQUE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **14.07.2022 KR 20220087079**

(43) Date of publication of application:
**17.01.2024 Bulletin 2024/03**

(73) Proprietor: **Samsung Electronics Co., Ltd.**
**Suwon-si, Gyeonggi-do 16677 (KR)**

(72) Inventors:
- **KIM, Sangmo**
  **16678 Suwon-si (KR)**
- **CHOI, Hyeonho**
  **16678 Suwon-si (KR)**
- **MARUYAMA, Yusuke**
  **16678 Suwon-si (KR)**
- **WON, Joonghee**
  **16678 Suwon-si (KR)**
- **LEE, Eunkyung**
  **16678 Suwon-si (KR)**
- **JUNG, Yongsik**
  **16678 Suwon-si (KR)**
- **KIM, Jiwhan**
  **16678 Suwon-si (KR)**
- **NAM, Sungho**
  **16678 Suwon-si (KR)**
- **IHN, Sooghang**
  **16678 Suwon-si (KR)**

(74) Representative: **Elkington and Fife LLP**
**Prospect House**
**8 Pembroke Road**
**Sevenoaks, Kent TN13 1XR (GB)**

(56) References cited:
**US-A1- 2020 328 351**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 4 306 612 B1

## Description

### FIELD OF THE INVENTION

The disclosure relates to a heterocyclic compound, an organic light-emitting device including the same, and an electronic apparatus including the organic light-emitting device.

### BACKGROUND OF THE INVENTION

Organic light-emitting devices (OLEDs) are self-emissive devices that, as compared with conventional devices, have wide viewing angles, high contrast ratios, short response times, and excellent brightness, driving voltage, and response speed characteristics, and produce full-color images.

OLEDs include an anode, a cathode, and an organic layer between the anode and the cathode and including an emission layer. A hole transport region may be between the anode and the emission layer, and an electron transport region may be between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. The excitons may transition from an excited state to a ground state, thus generating light.

US 2020/328351 discloses a condensed cyclic compound and an organic light-emitting device including the same.

### SUMMARY OF THE INVENTION

Provided are a heterocyclic compound, an organic light-emitting device including the same, and an electronic apparatus including the organic light-emitting device.

Additional aspects will be set forth in part in the description which follows and, in part, will be apparent from the description, or may be learned by practice of the presented embodiments of the disclosure.

According to the invention, provided is a heterocyclic compound represented by Formula 1:

Formula 1

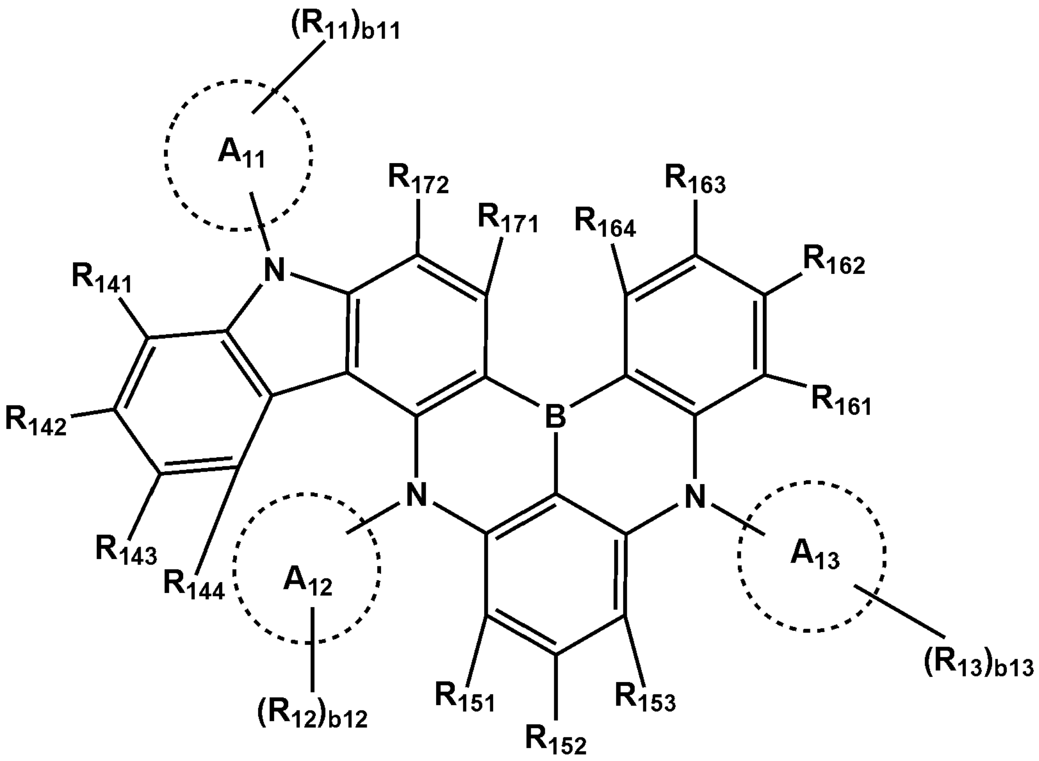

wherein, in Formula 1,

$A_{11}$ to $A_{13}$ are each independently a substituted or unsubstituted $C_5$-$C_{30}$ carbocyclic group or a substituted or unsubstituted $C_1$-$C_{30}$ heterocyclic group,

wherein $R_{11}$ to $R_{13}$, $R_{141}$ to $R_{144}$, $R_{151}$ to $R_{153}$, $R_{161}$ to $R_{164}$, $R_{171}$, and $R_{172}$ are each independently hydrogen, deuterium, -F, -Cl, -Br, -I, a hydroxyl group, a cyano group, a nitro group, an amidino group, a hydrazino group, a hydrazono group, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkylaryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, a substituted or unsubstituted monovalent non-aromatic condensed heteropolycyclic group, $-Si(Q_1)(Q_2)(Q_3)$, $-C(Q_1)(Q_2)(Q_3)$, $-B(Q_1)(Q_2)$, $-N(Q_1)(Q_2)$, $-P(Q_1)(Q_2)$, $-C(=O)(Q_1)$, $-S(=O)(Q_1)$, - $S(=O)_2(Q_1)$, $-P(=O)(Q_1)(Q_2)$, or $-P(=S)(Q_1)(Q_2)$,

b11 to b13 are each independently 0, 1, 2, 3, 4, 5, or 6,

$Q_1$ to $Q_3$ are each independently hydrogen, deuterium, -F, -Cl, -Br, -I, a hydroxyl group, a cyano group, a nitro group, an amidino group, a hydrazino group, a hydrazono group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, a $C_1$-$C_{60}$ alkyl group that is substituted with at least one deuterium, -F, cyano group, $C_1$-$C_{60}$ alkyl group, $C_6$-$C_{60}$ aryl group, or any combination thereof, or a $C_6$-$C_{60}$ aryl group substituted with at least one deuterium, -F, cyano group, $C_1$-$C_{60}$ alkyl group, $C_6$-$C_{60}$ aryl group, or any combination thereof, and

* indicates a binding site to an adjacent atom.

According to an embodiment, provided is an organic light-emitting device including a first electrode, a second electrode, and an organic layer arranged between the first electrode and the second electrode and including an emission layer, wherein the organic layer comprises the heterocyclic compound.

According to another embodiment, an electronic apparatus includes the organic light-emitting device.

BRIEF DESCRIPTION OF THE DRAWINGS

The above and other aspects, features, and advantages of certain embodiments of the disclosure will be more apparent from the following description taken in conjunction with the accompanying drawings, in which:

FIG. 1 shows a schematic cross-sectional view of an organic light-emitting device according to an exemplary embodiment;

FIG. 2 illustrates a schematic view of an organic light-emitting device according to an exemplary embodiment;

FIG. 3 illustrates a schematic view of an organic light-emitting device according to an exemplary embodiment;

FIGS. 4A to 4E each illustrate a schematic energy diagram of an emission layer of an organic light-emitting device according to an exemplary embodiment; and

FIG. 5 is a diagram showing the room-temperature photoluminescence (PL) spectrum of Compound 5.

DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

It will be understood that when an element is referred to as being "on" another element, it can be directly on the other element or intervening elements may be present therebetween. In contrast, when an element is referred to as being "directly on" another element, there are no intervening elements present

It will be understood that, although the terms "first," "second," "third" etc. may be used herein to describe various elements, components, regions, layers and/or sections, these elements, components, regions, layers and/or sections

should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

The terminology used herein is for the purpose of describing particular embodiments only and is not intended to be limiting. As used herein, "a," "an," "the," and "at least one" do not denote a limitation of quantity, and are intended to cover both the singular and plural, unless the context clearly indicates otherwise. For example, "an element" has the same meaning as "at least one element," unless the context clearly indicates otherwise.

"Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The exemplary term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The exemplary terms "below" or "beneath" can, therefore, encompass both an orientation of above and below.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within $\pm$ 30%, 20%, 10% or 5% of the stated value.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded Thus, the regions illustrated in the figures are schematic in nature and their shapes are not intended to illustrate the precise shape of a region and are not intended to limit the scope of the present claims.

A heterocyclic compound according to an embodiment may be represented by Formula 1:

Formula 1

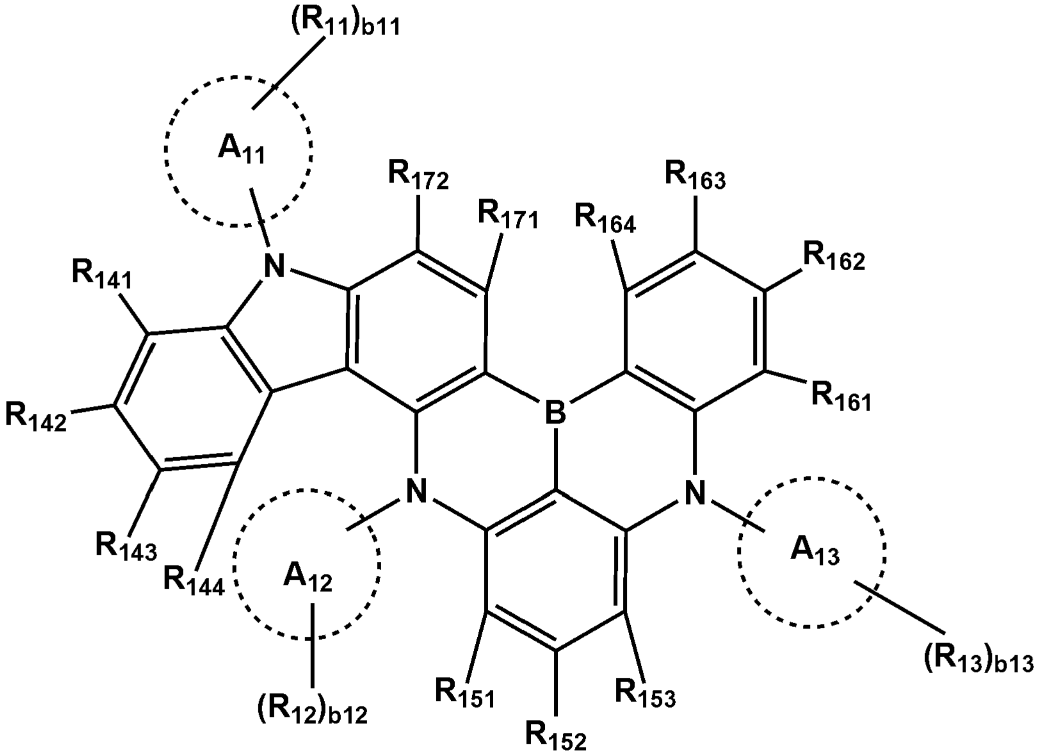

wherein $A_{11}$ to $A_{13}$ in Formula 1 are each independently a substituted or unsubstituted $C_5$-$C_{30}$ carbocyclic group or a substituted or unsubstituted $C_1$-$C_{30}$ heterocyclic group.

In an embodiment, in Formula 1, $A_{11}$ to $A_{13}$ may each independently be a benzene group, a naphthalene group, a phenanthrene group, a furan group, a thiophene group, a pyrrole group, a cyclopentene group, a silole group, a germole group, a benzofuran group, a benzothiophene group, an indole group, an indene group, a benzosilole group, a benzogermole group, a dibenzofuran group, a dibenzothiophene group, a carbazole group, a fluorene group, a dibenzosilole group, or a dibenzogermole group.

In some embodiments, in Formula 1, $A_{11}$ to $A_{13}$ may each independently be a benzene group, a naphthalene group, a benzofuran group, a benzothiophene group, an indole group, an indene group, a benzosilole group, or a benzogermole group.

In some embodiments, $A_{11}$ to $A_{15}$ in Formula 1 may each independently be a benzene group or a naphthalene group.

In detail, $A_{11}$ to $A_{13}$ in Formula 1 may each independently be a benzene group.

In Formula 1, $R_{11}$ to $R_{13}$, $R_{141}$ to $R_{144}$, $R_{151}$ to $R_{153}$, $R_{161}$ to $R_{164}$, $R_{171}$, and $R_{172}$ are each independently hydrogen, deuterium, -F, -Cl, -Br, -I, a hydroxyl group, a cyano group, a nitro group, an amidino group, a hydrazino group, a hydrazono group, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkylaryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, a substituted or unsubstituted monovalent non-aromatic condensed heteropolycyclic group, $-Si(Q_1)(Q_2)(Q_3)$, $-C(Q_1)(Q_2)(Q_3)$, $-B(Q_1)(Q_2)$, $-N(Q_1)(Q_2)$, $-P(Q_1)(Q_2)$, $-C(=O)(Q_1)$, $-S(=O)(Q_1)$, $-S(=O)_2(Q_1)$, $-P(=O)(Q_1)(Q_2)$, or $-P(=S)(Q_1)(Q_2)$, and

$Q_1$ to $Q_3$ are each independently hydrogen, deuterium, -F, -Cl, -Br, -I, a hydroxyl group, a cyano group, a nitro group, an amidino group, a hydrazine group, a hydrazone group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkylaryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$

heteroarylthio group, a monovalent non-aromatic condensed polycyclic group, a monovalent non-aromatic condensed heteropolycyclic group, a $C_1$-$C_{60}$ alkyl group that is substituted with at least one deuterium, -F, cyano group, $C_1$-$C_{60}$ alkyl group, $C_6$-$C_{60}$ aryl group, or any combination thereof, or a $C_6$-$C_{60}$ aryl group that is substituted with deuterium, -F, cyano group, $C_1$-$C_{60}$ alkyl group, $C_6$-$C_{60}$ aryl group, or any combination thereof.

In an embodiment, in Formula 1, $R_{11}$ to $R_{13}$, $R_{141}$ to $R_{144}$, $R_{151}$ to $R_{153}$, $R_{161}$ to $R_{164}$, $R_{171}$, and $R_{172}$ may each independently be hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkenyl group, a $C_1$-$C_{20}$ alkoxy group, or a $C_1$-$C_{20}$ alkylthio group;

a $C_1$-$C_{20}$ alkyl group, a $C_1$-$C_{20}$ alkenyl group, a $C_1$-$C_{20}$ alkoxy group, or a $C_1$-$C_{20}$ alkylthio group, each substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, a naphthyl group, a pyridinyl group, a pyrimidinyl group, or any combination thereof;

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a phenyl group, a ($C_1$-$C_{20}$ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a deuterated $C_2$-$C_{20}$ alkyl group, a $C_1$-$C_{20}$ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group,

an azadibenzothiophenyl group, or any combination thereof; or
$-Si(Q_1)(Q_2)(Q_3)$, $-C(Q_1)(Q_2)(Q_3)$, $-B(Q_1)(Q_2)$, or $-N(Q_1)(Q_2)$,
wherein $Q_1$ to $Q_3$ may be each independently:

deuterium, -F, $-CH_3$, $-CD_3$, $-CD_2H$, $-CDH_2$, $-CH_2CH_3$, $-CH_2CD_3$, - $CH_2CD_2H$, $-CH_2CDH_2$, $-CHDCH_3$, $-CHDCD_2H$, $-CHDCDH_2$, $-CHDCD_3$, - $CD_2CD_3$, $-CD_2CD_2H$, $-CD_2CDH_2$, $-CF_3$, $-CF_2H$, $-CFH_2$, $-CH_2CF_3$, $-CH_2CF_2H$, - $CH_2CFH_2$, $-CHFCH_3$, $-CHFCF_2H$, $-CHFCFH_2$, $-CHFCF_3$, $-CF_2CF_3$, $-CF_2CF_2H$, or $-CF_2CFH_2$; or
an n-propyl group, an iso-propyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with deuterium, -F, a $C_1$-$C_{10}$ alkyl group, a phenyl group, or any combination thereof.

In some embodiments, in Formula 1, $R_{11}$ to $R_{13}$, $R_{141}$ to $R_{144}$, $R_{151}$ to $R_{153}$, $R_{161}$ to $R_{164}$, $R_{171}$, and $R_{172}$ may each independently hydrogen, deuterium, -F, $-CH_3$, $-CD_3$, $-CD_2H$, $-CDH_2$, $-CF_3$, $-CF_2H$, $-CFH_2$, a $C_2$-$C_{10}$ alkenyl group, a $C_1$-$C_{10}$ alkoxy group, a $C_1$-$C_{10}$ alkylthio group, a group represented by one of Formulae 2-1 to 2-6, a group represented by one of Formulae 2-1 to 2-6 in which at least one hydrogen is substituted with deuterium, a group represented by one of Formulae 2-1 to 2-6 in which at least one hydrogen is substituted with -F, a group represented by one of Formulae 9-1 to 9-39, a group represented by one of Formulae 9-1 to 9-39 in which at least one hydrogen is substituted with deuterium, a group represented by one of Formulae 9-1 to 9-39 in which at least one hydrogen is substituted with -F, a group represented by one of Formulae 9-201 to 9-236, a group represented by one of Formulae 9-201 to 9-236 in which at least one hydrogen is substituted with deuterium, a group represented by one of Formulae 9-201 to 9-236 in which at least one hydrogen is substituted with -F, a group represented by one of Formulae 10-1 to 10-130, a group represented by one of Formulae 10-1 to 10-130 in which at least one hydrogen is substituted with deuterium, a group represented by one of Formulae 10-1 to 10-130 in which at least one hydrogen is substituted with -F, a group represented by one of Formulae 10-201 to 10-358, a group represented by one of Formulae 10-201 to 10-358 in which at least one hydrogen is substituted with deuterium, a group represented by one of Formulae 10-201 to 10-358 in which at least one hydrogen is substituted with -F, $-N(Q_1)(Q_2)$, - $Si(Q_1)(Q_2)(Q_3)$, or $-C(Q_1)(Q_2)(Q_3)$,
wherein $Q_1$ to $Q_3$ may each independently be:

deuterium, -F, $-CH_3$, $-CD_3$, $-CD_2H$, $-CDH_2$, $-CH_2CH_3$, $-CH_2CD_3$, - $CH_2CD_2H$, $-CH_2CDH_2$, $-CHDCH_3$, $-CHDCD_2H$, $-CHDCDH_2$, $-CHDCD_3$, - $CD_2CD_3$, $-CD_2CD_2H$, $-CD_2CDH_2$, $-CF_3$, $-CF_2H$, $-CFH_2$, $-CH_2CF_3$, $-CH_2CF_2H$, - $CH_2CFH_2$, $-CHFCH_3$, $-CHFCF_2H$, $-CHFCFH_2$, $-CHFCF_3$, $-CF_2CF_3$, $-CF_2CF_2H$, or $-CF_2CFH_2$; or
an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with deuterium, -F, a $C_1$-$C_{10}$ alkyl group, a phenyl group, or any combination thereof.

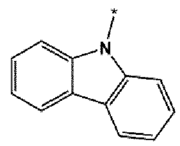
2-1

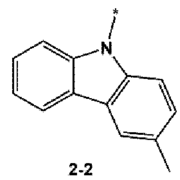
2-2

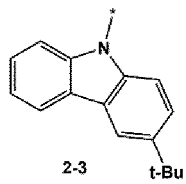
2-3

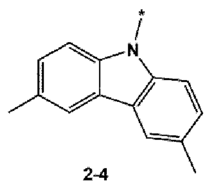
2-4

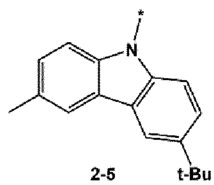
2-5

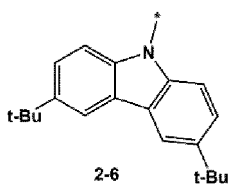
2-6

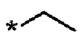
9-1

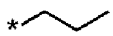
9-2

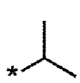
9-3

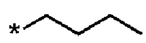
9-4

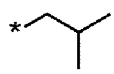
9-5

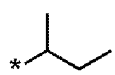
9-6

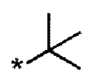
9-7

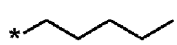
9-8

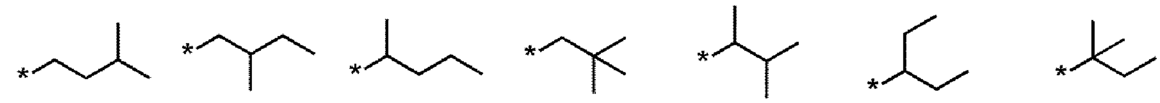

9-9 9-10 9-11 9-12 9-13 9-14 9-15

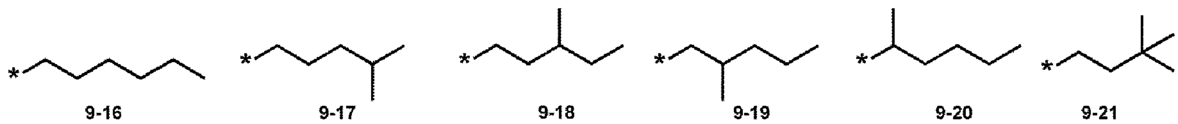

9-16 9-17 9-18 9-19 9-20 9-21

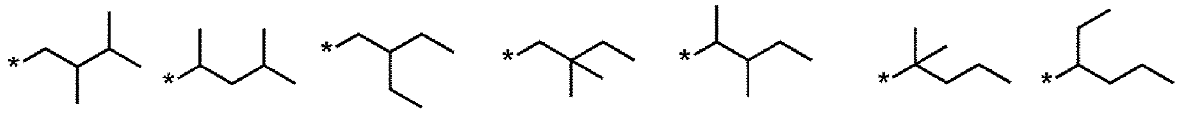

9-22 9-23 9-24 9-25 9-26 9-27 9-28

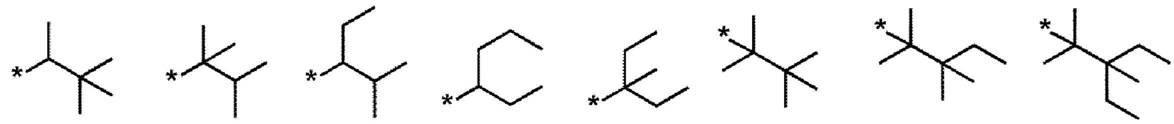

9-29 9-30 9-31 9-32 9-33 9-34 9-35 9-36

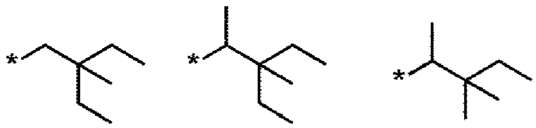

9-37 9-38 9-39

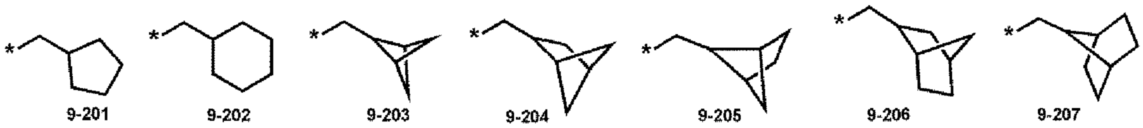

9-201 9-202 9-203 9-204 9-205 9-206 9-207

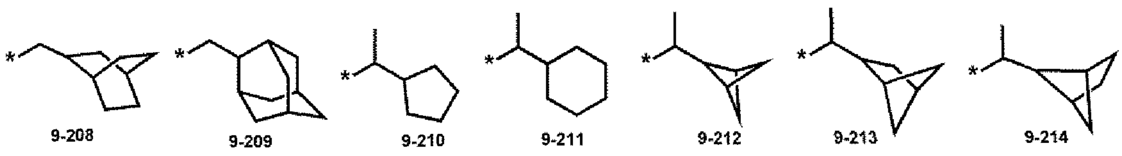

9-208 9-209 9-210 9-211 9-212 9-213 9-214

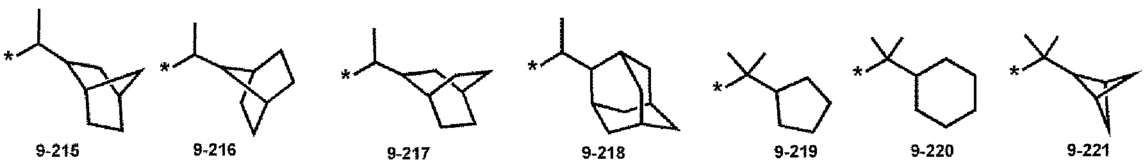

9-215 9-216 9-217 9-218 9-219 9-220 9-221

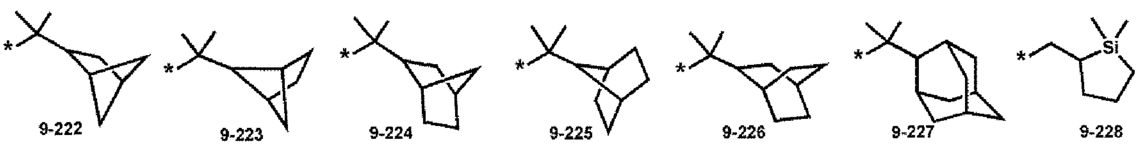

9-222 9-223 9-224 9-225 9-226 9-227 9-228

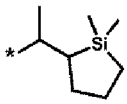
9-229

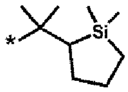
9-230

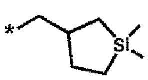
9-231

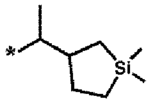
9-232

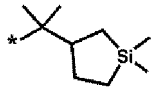
9-233

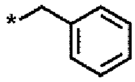
9-234

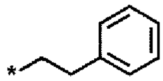
9-235

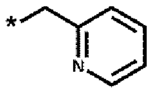
9-236

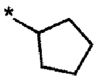
10-1

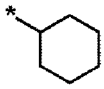
10-2

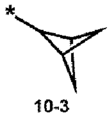
10-3

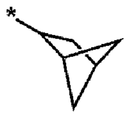
10-4

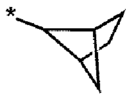
10-5

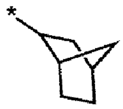
10-6

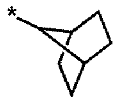
10-7

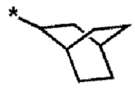
10-8

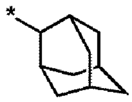
10-9

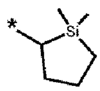
10-10

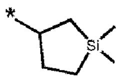
10-11

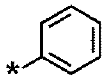
10-12

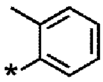
10-13

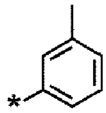
10-14

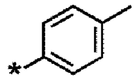
10-15

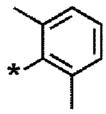
10-16

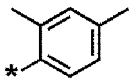
10-17

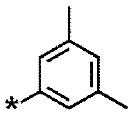
10-18

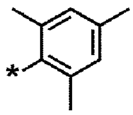
10-19

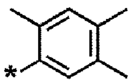
10-20

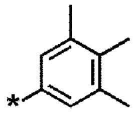
10-21

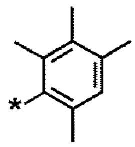
10-22

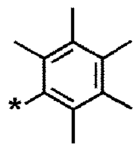
10-23

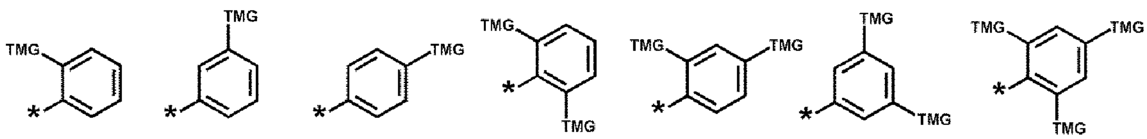
10-24 10-25 10-26 10-27 10-28 10-29 10-30

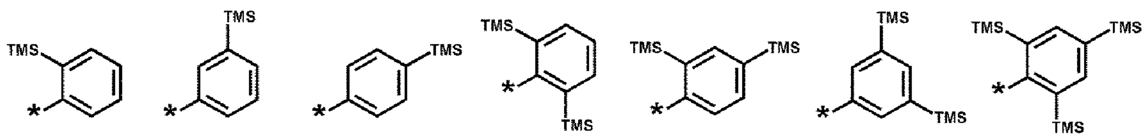
10-31 10-32 10-33 10-34 10-35 10-36 10-37

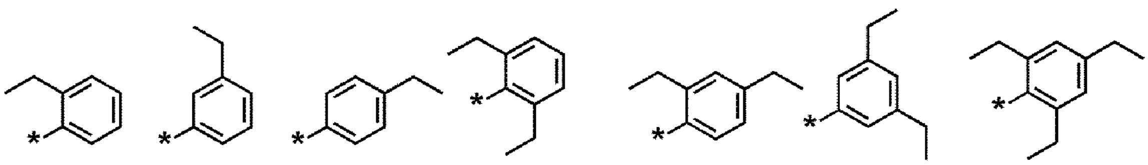
10-38 10-39 10-40 10-41 10-42 10-43 10-44

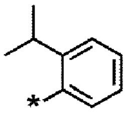 10-45 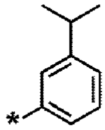 10-46 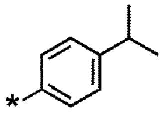 10-47 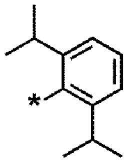 10-48 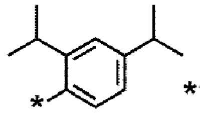 10-49 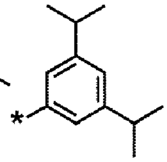 10-50 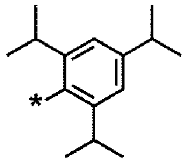 10-51

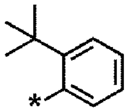 10-52 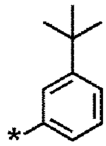 10-53 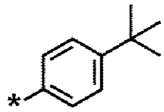 10-54 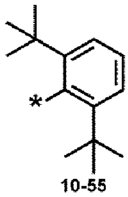 10-55 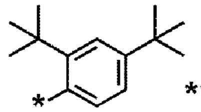 10-56 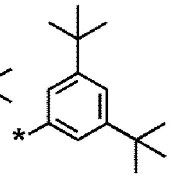 10-57 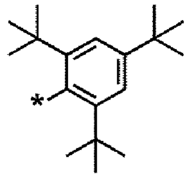 10-58

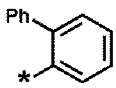 10-59 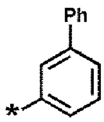 10-60 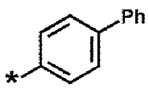 10-61 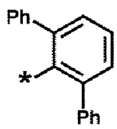 10-62 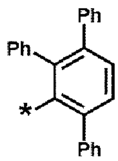 10-63 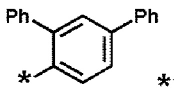 10-64 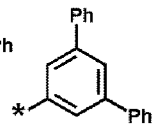 10-65 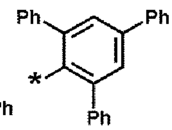 10-66

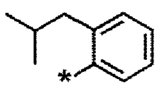 10-67 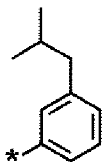 10-68 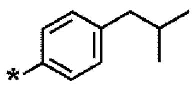 10-69 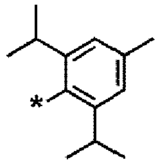 10-70 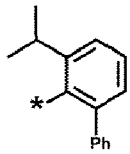 10-71 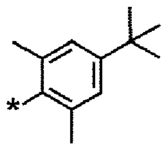 10-72

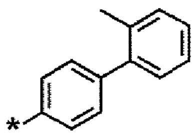 10-73 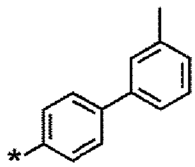 10-74 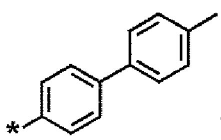 10-75 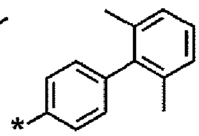 10-76 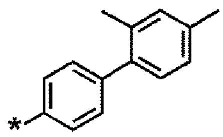 10-77

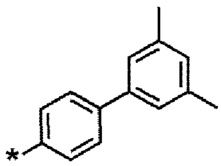 10-78 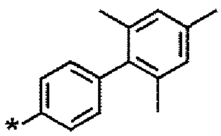 10-79 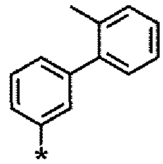 10-80 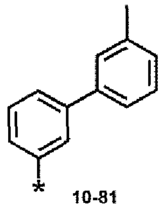 10-81 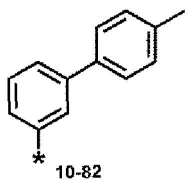 10-82

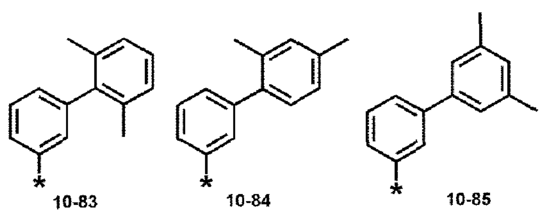 10-83 10-84 10-85 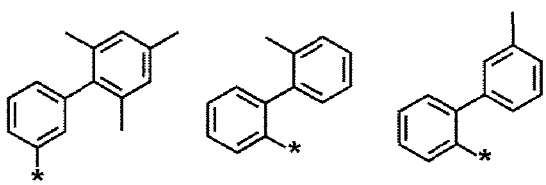 10-86 10-87 10-88

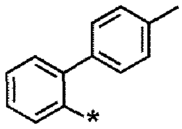
10-89

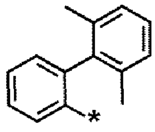
10-90

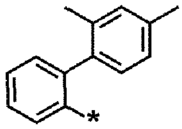
10-91

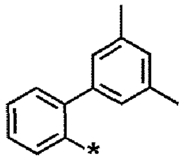
10-92

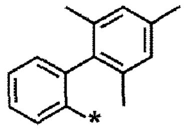
10-93

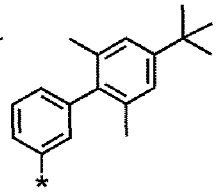
10-94

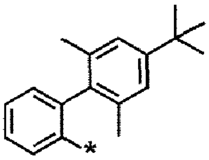
10-95

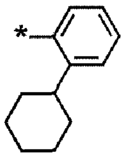
10-96

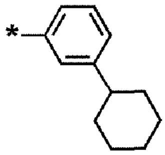
10-97

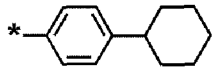
10-98

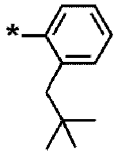
10-99

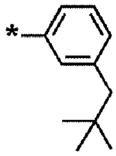
10-100

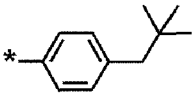
10-101

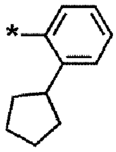
10-102

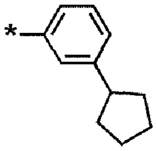
10-103

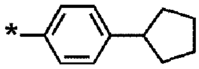
10-104

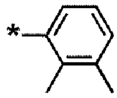
10-105

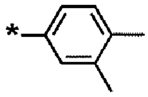
10-106

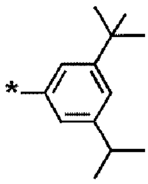
10-107

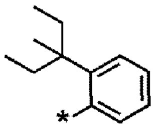
10-108

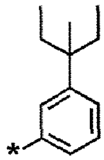
10-109

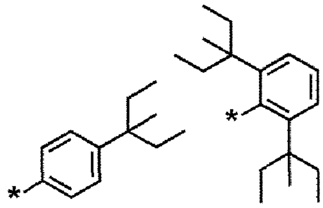
10-110

10-111

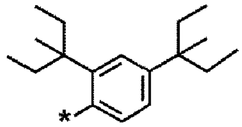
10-112

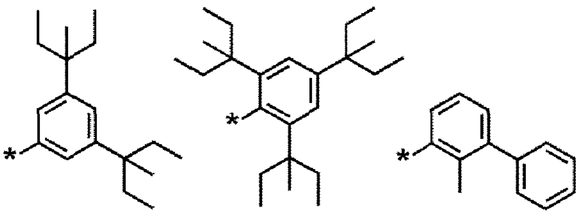
10-113

10-114

10-115

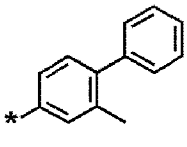
10-116

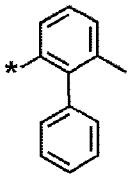
10-117

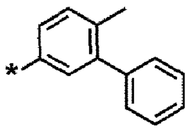
10-118

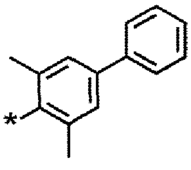
10-119

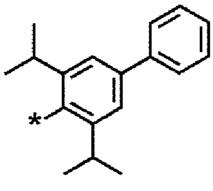
10-120

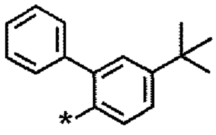
10-121

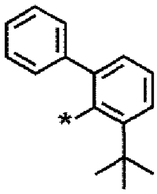
10-122

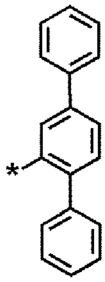
10-123

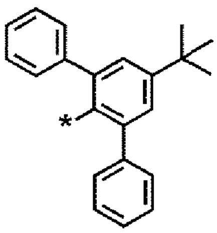
10-124

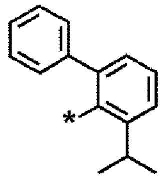
10-125

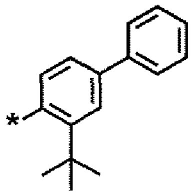
10-126

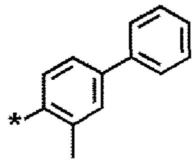
10-127

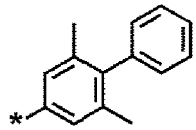
10-128

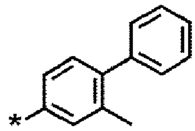
10-129

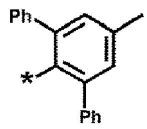
10-130

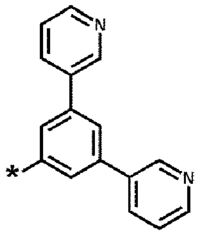
10-201

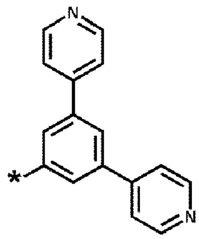
10-202

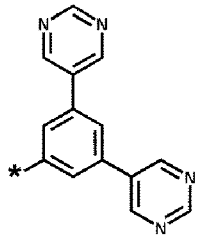
10-203

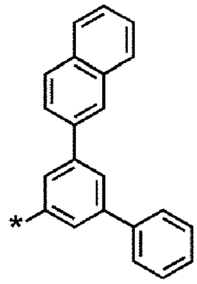
10-204

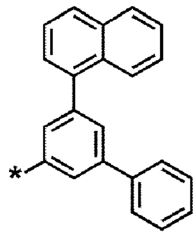
10-205

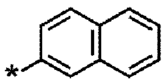
10-206

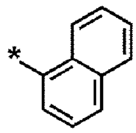
10-207

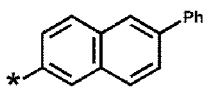
10-208

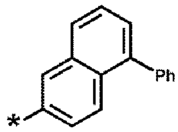
10-209

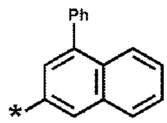
10-210

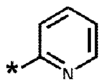
10-211

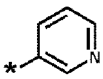
10-212

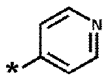
10-213

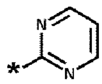
10-214

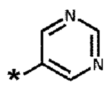
10-215

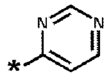
10-216

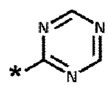
10-217

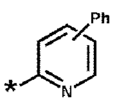
10-218

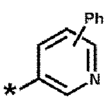
10-219

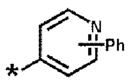
10-220

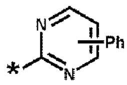
10-221

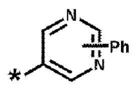
10-222

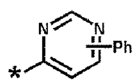
10-223

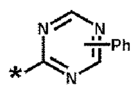
10-224

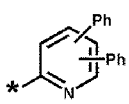
10-225

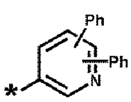
10-226

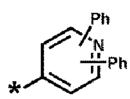
10-227

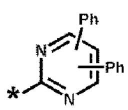
10-228

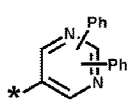
10-229

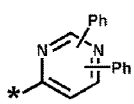
10-230

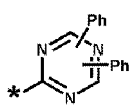
10-231

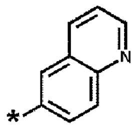
10-232
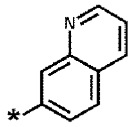
10-233
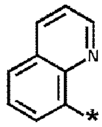
10-234
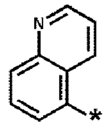
10-235
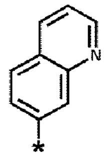
10-236
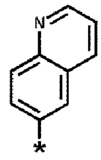
10-237

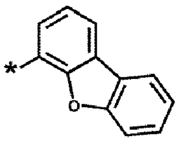
10-238
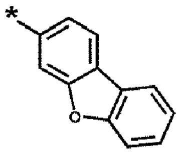
10-239
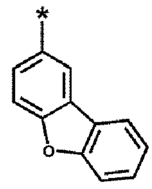
10-240
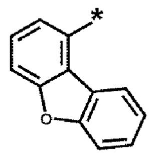
10-241
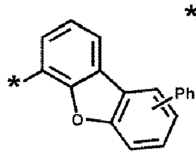
10-242
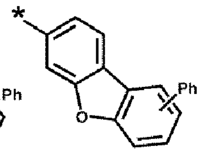
10-243

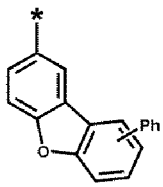
10-244
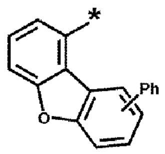
10-245
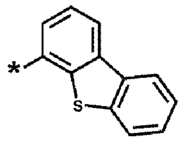
10-246
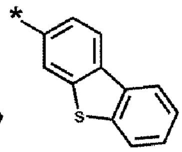
10-247
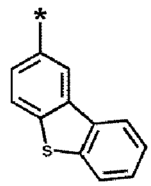
10-248
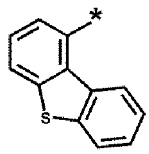
10-249

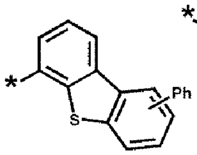
10-250
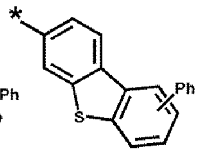
10-251
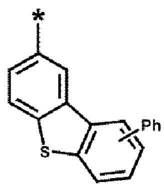
10-252
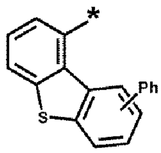
10-253
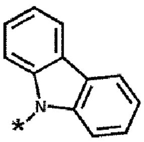
10-254
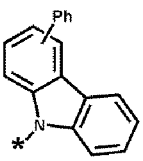
10-255

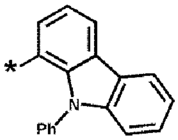
10-256
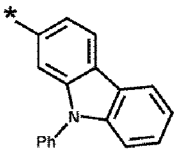
10-257
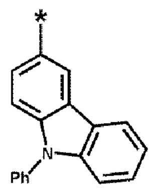
10-258
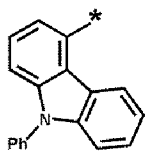
10-259
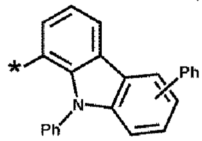
10-260
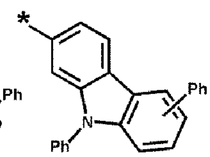
10-261

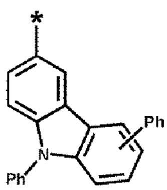
10-262
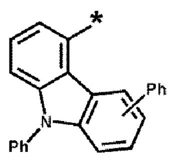
10-263
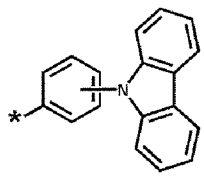
10-264
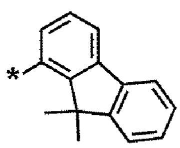
10-265
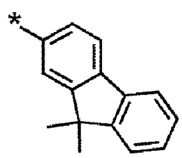
10-266
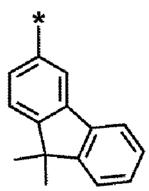
10-267

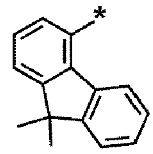 10-268 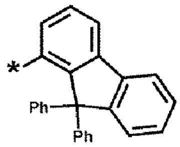 10-269 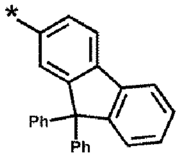 10-270 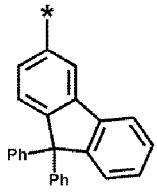 10-271 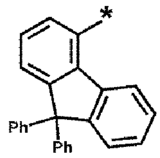 10-272

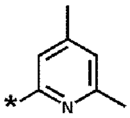 10-273 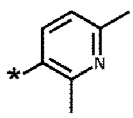 10-274 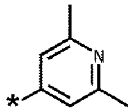 10-275 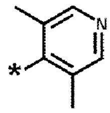 10-276 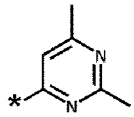 10-277 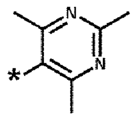 10-278 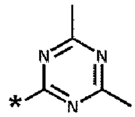 10-279

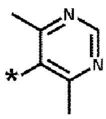 10-280 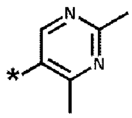 10-281 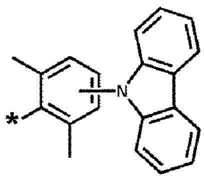 10-282 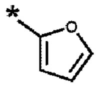 10-283 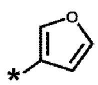 10-284 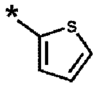 10-285 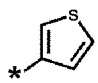 10-286

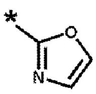 10-287 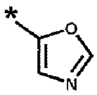 10-288 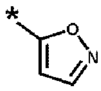 10-289 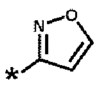 10-290 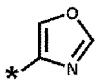 10-291 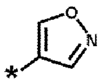 10-292 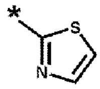 10-293 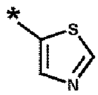 10-294 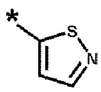 10-295

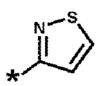 10-296 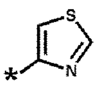 10-297 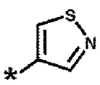 10-298 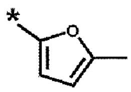 10-299 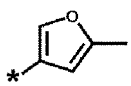 10-300 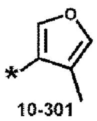 10-301 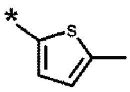 10-302 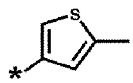 10-303 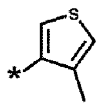 10-304

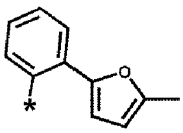 10-305 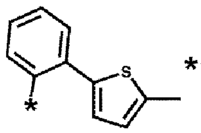 10-306 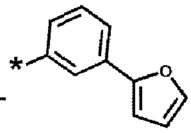 10-307 10-308 10-309 10-310

10-311 10-312 10-313 10-314 10-315 10-316 10-317

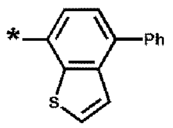 10-318 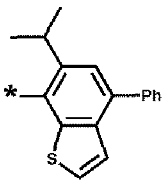 10-319 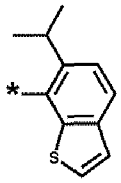 10-320 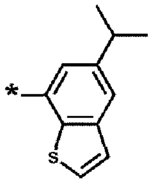 10-321 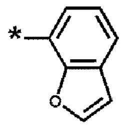 10-322 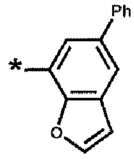 10-323 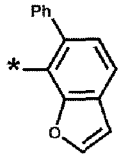 10-324

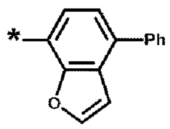 10-325 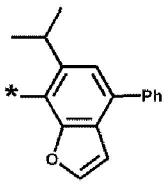 10-326 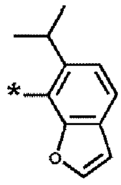 10-327 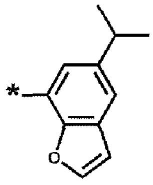 10-328 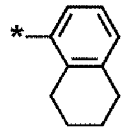 10-329 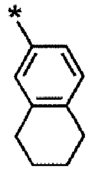 10-330 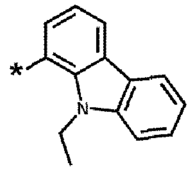 10-331

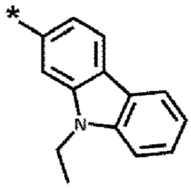 10-332 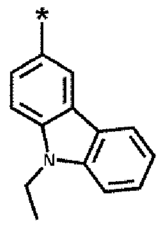 10-333 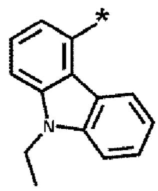 10-334 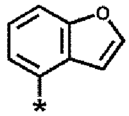 10-335 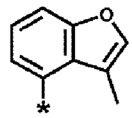 10-336 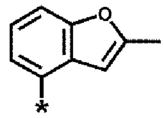 10-337

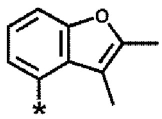 10-338 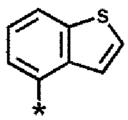 10-339 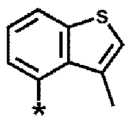 10-340 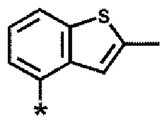 10-341 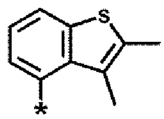 10-342 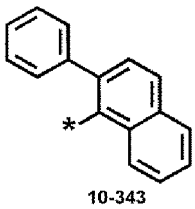 10-343

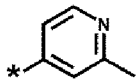 10-344 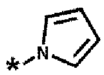 10-345 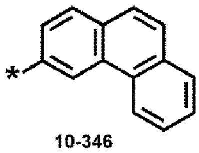 10-346 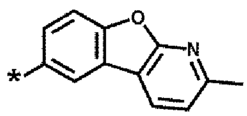 10-347 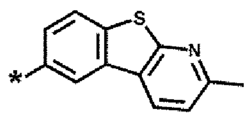 10-348

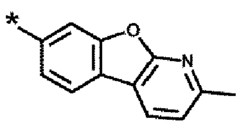 10-349 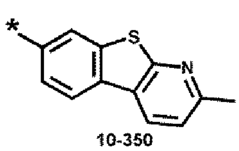 10-350 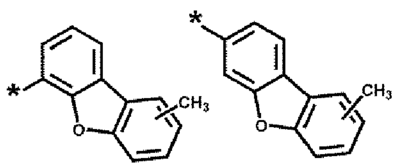 10-351 10-352 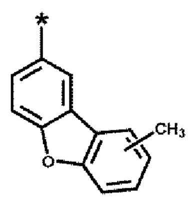 10-353

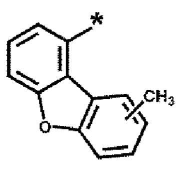 10-354 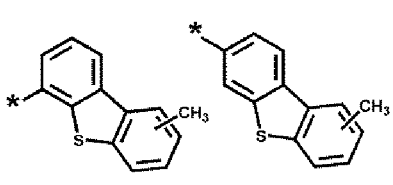 10-355 10-356 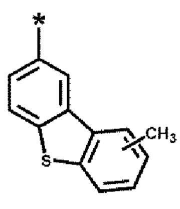 10-357 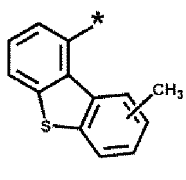 10-358

In Formulae 9-1 to 9-39, 9-201 to 9-236, 10-1 to 10-130, and 10-201 to 10-358, * indicates a binding site to an adjacent atom, "Ph" represents a phenyl group, "TMS" and "$SiMe_3$" each represent a trimethylsilyl group, and "TMG" and "$GeMe_3$" each represent a trimethylgermyl group.

The "group represented by Formulae 9-1 to 9-39 in which at least one hydrogen is substituted with deuterium" and the "group represented by Formulae 9-201 to 9-236 in which at least one hydrogen is substituted with deuterium" may each be, for example, a group represented by one of Formulae 9-501 to 9-514 and 9-601 to 9-636:

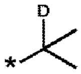
9-501

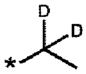
9-502

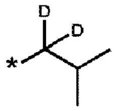
9-503

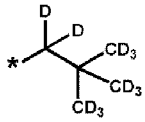
9-504

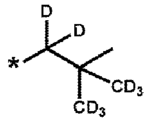
9-505

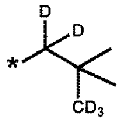
9-506

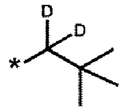
9-507

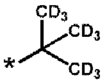
9-508

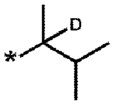
9-509

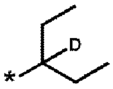
9-510

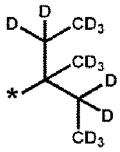
9-511

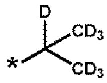
9-512

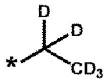
9-513

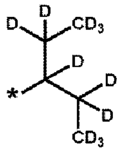
9-514

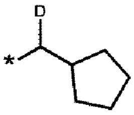
9-601

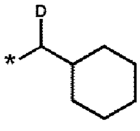
9-602

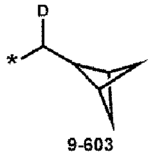
9-603

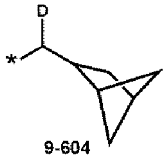
9-604

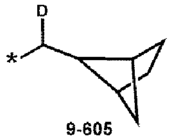
9-605

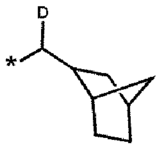
9-606

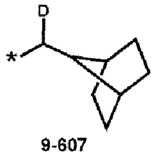
9-607

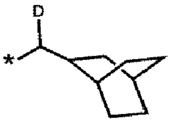
9-608

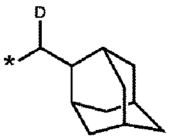
9-609

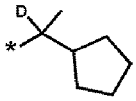
9-610

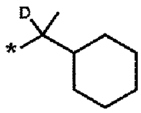
9-611

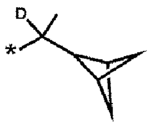
9-612

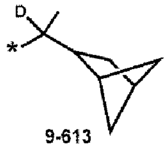
9-613

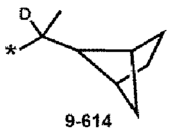
9-614

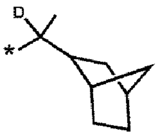
9-615

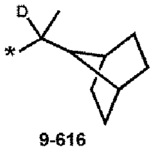
9-616

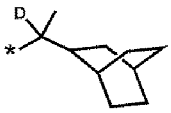
9-617

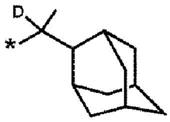
9-618

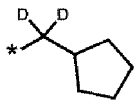
9-619

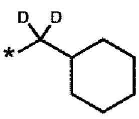
9-620

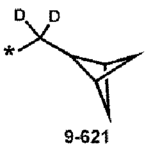
9-621

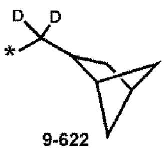
9-622

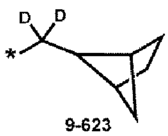
9-623

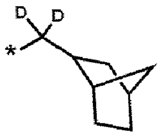
9-624

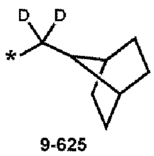
9-625

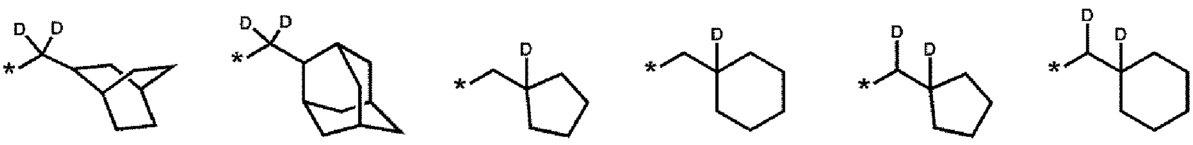

9-626 9-627 9-628 9-629 9-630 9-631

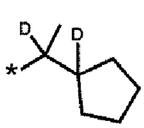 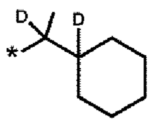 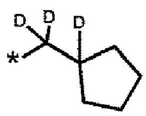 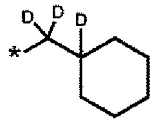 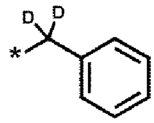

9-632 9-633 9-634 9-635 9-636

The "group represented by Formulae 9-1 to 9-39 in which at least one hydrogen is substituted with -F" and the "group represented by Formulae 9-201 to 9-236 in which at least one hydrogen is substituted with -F" may each be, for example, a group represented by one of Formulae 9-701 to 9-710:

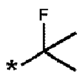 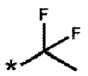 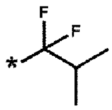 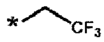 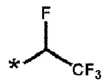 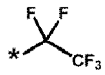 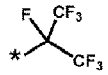

9-701 9-702 9-703 9-704 9-705 9-706 9-707

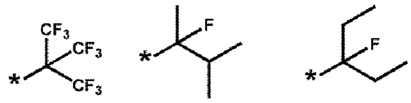

9-708 9-709 9-710

The "group represented by Formulae 10-1 to 10-130 in which at least one hydrogen is substituted with a deuterium" and the "group represented by Formulae 10-201 to 10-358 in which at least one hydrogen is substituted with deuterium" may each be, for example, a group represented by one of Formulae 10-501 to 576:

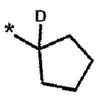 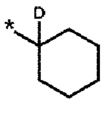 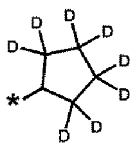 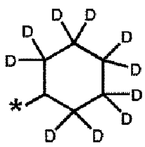 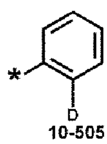 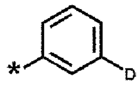 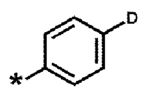 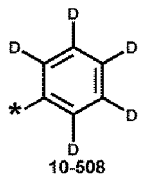

10-501 10-502 10-503 10-504 10-505 10-506 10-507 10-508

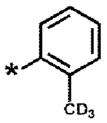 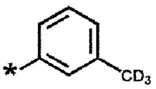 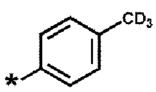 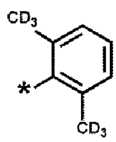 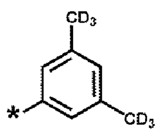 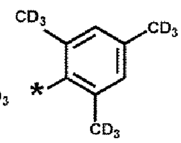 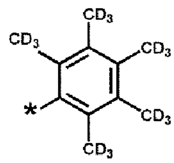

10-509 10-510 10-511 10-512 10-513 10-514 10-515

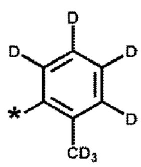 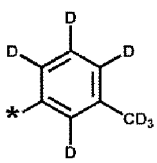 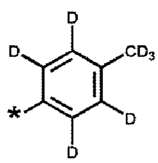 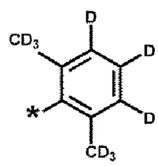 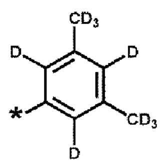 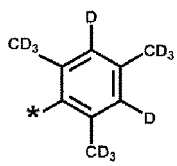

10-516 10-517 10-518 10-519 10-520 10-521

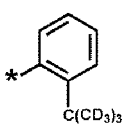 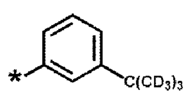 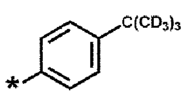 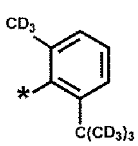 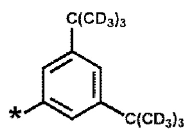 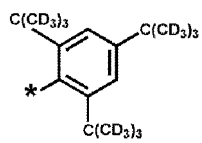

10-522 10-523 10-524 10-525 10-526 10-527

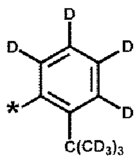
10-528

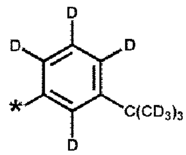
10-529

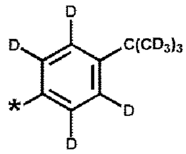
10-530

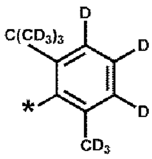
10-531

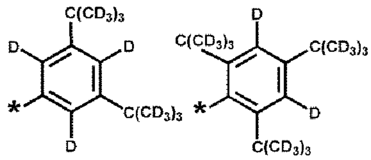
10-532

10-533

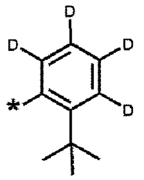
10-534

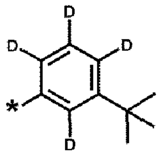
10-535

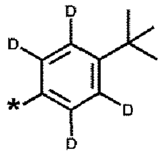
10-536

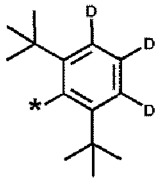
10-537

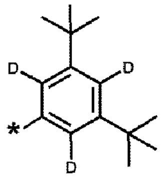
10-538

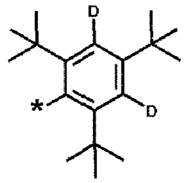
10-540

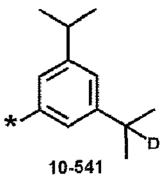
10-541

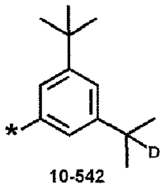
10-542

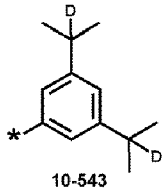
10-543

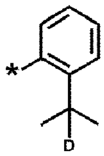
10-544

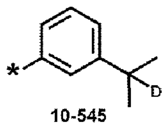
10-545

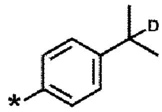
10-546

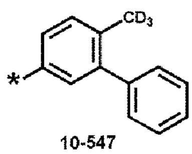
10-547

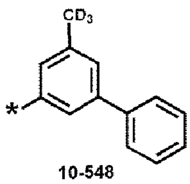
10-548

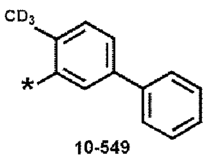
10-549

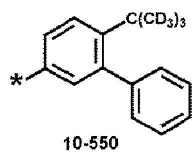
10-550

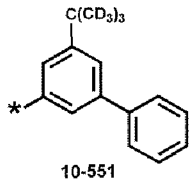
10-551

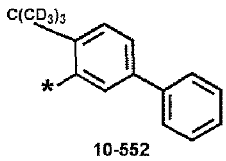
10-552

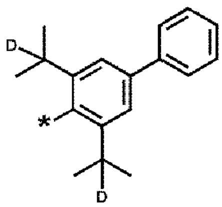
10-553

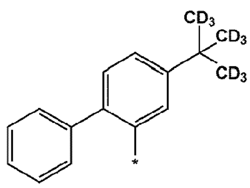
10-554

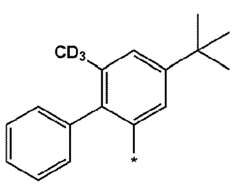
10-555

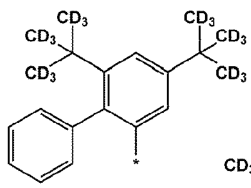
10-556

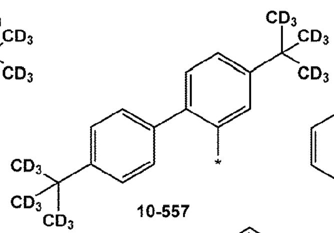
10-557

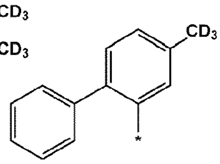
10-558

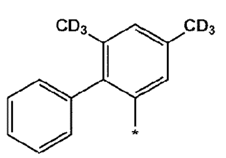
10-559

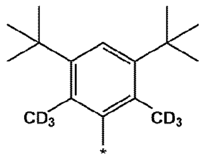
10-560

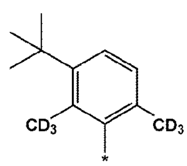
10-561

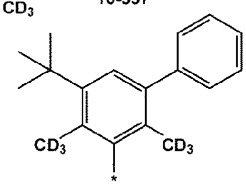
10-562

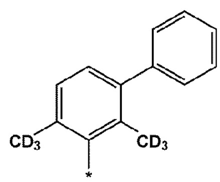
10-563

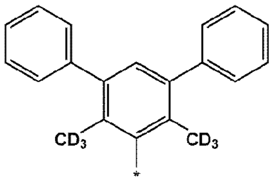 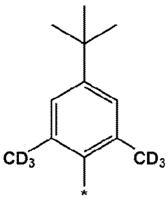 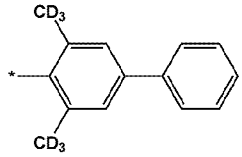 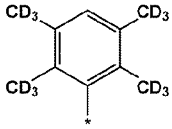 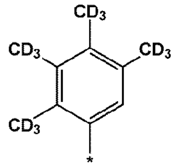

10-564 10-565 10-566 10-567 10-568

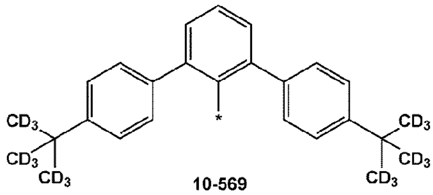

10-569

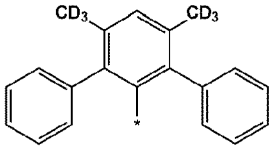

10-570

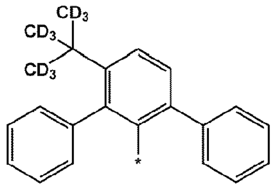

10-571

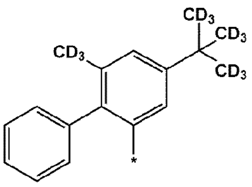 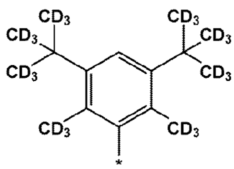 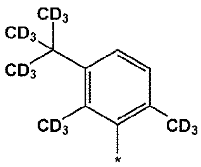 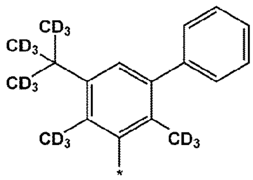 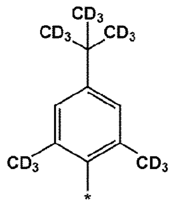

10-572 10-573 10-574 10-575 10-576

.

The "group represented by Formulae 10-1 to 10-130 in which at least one hydrogen is substituted with -F" and the "group represented by Formulae 10-201 to 10-358 in which at least one hydrogen is substituted with -F" may each be, for example, a group represented by one of Formulae 10-601 to 617:

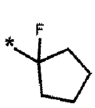 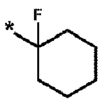 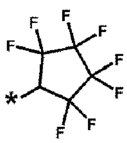 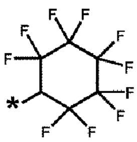 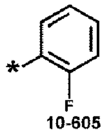 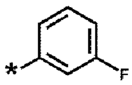 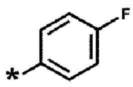 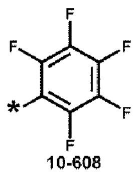

10-601 10-602 10-603 10-604 10-605 10-606 10-607 10-608

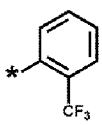 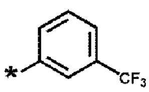 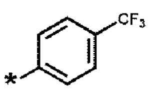 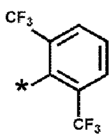 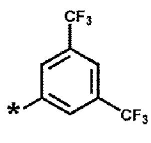 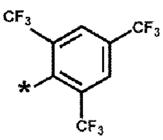 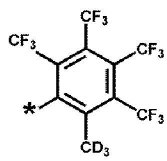

10-609 10-610 10-611 10-612 10-613 10-614 10-615

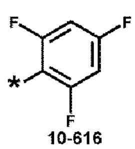 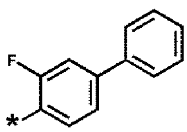

10-616 10-617

In an embodiment, in Formula 1, at least one of $R_{11}$ to $R_{13}$, $R_{141}$ to $R_{144}$, $R_{151}$ to $R_{153}$, $R_{161}$ to $R_{164}$, $R_{171}$, and $R_{172}$ may be a group represented by one of Formulae 2-1 to 2-6 and a group represented by one of Formulae 2-1 to 2-6 in which at least one hydrogen is substituted with deuterium:

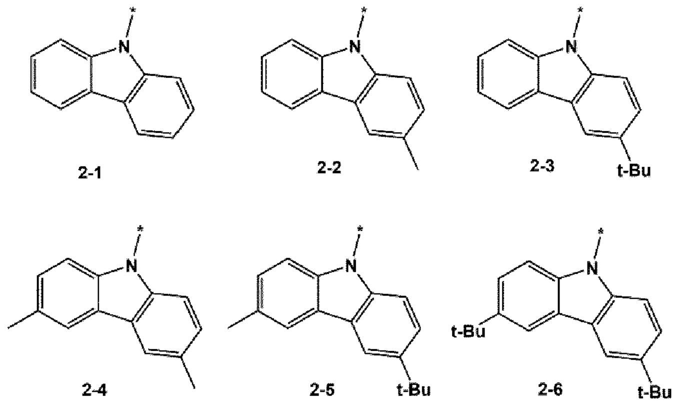

2-1 2-2 2-3 2-4 2-5 2-6

wherein, in Formulae 2-1 to 2-6,
t-Bu may be a tert-butyl group, and
* indicates a binding site to an adjacent atom.

In some embodiments, at least one of $R_{151}$ to $R_{153}$ in Formula 1 may be a group represented by one of Formulae 2-1 to 2-6 or a group represented by one of Formulae 2-1 to 2-6 in which at least one hydrogen is substituted with deuterium.

In some embodiments, $R_{152}$ in Formula 1 may be a group represented by one of Formulae 2-1 to 2-6 or a group represented by one of Formulae 2-1 to 2-6 in which at least one hydrogen is substituted with deuterium.

In an embodiment, the heterocyclic compound may be represented by Formula 1-1:

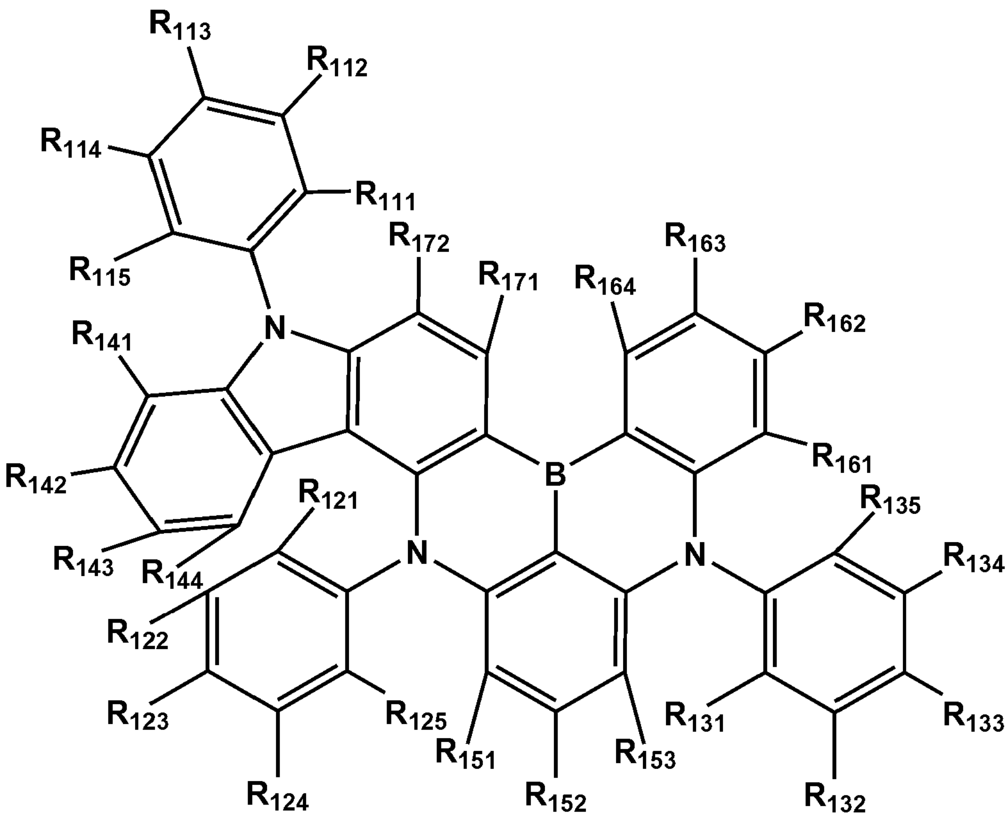

wherein, in Formula 1-1,
$R_{111}$ to $R_{115}$ each refer to $R_{11}$ as defined in Formula 1,
$R_{121}$ to $R_{125}$ each refer to $R_{12}$ as defined in Formula 1,
$R_{131}$ to $R_{135}$ each refer to $R_{13}$ as defined in Formula 1, and
$R_{141}$ to $R_{144}$, $R_{151}$ to $R_{153}$, $R_{161}$ to $R_{164}$, $R_{171}$, and $R_{172}$ refer to the description provided in connection with Formula 1.

In an embodiment, at least one of $R_{11}$ to $R_{13}$, $R_{141}$ to $R_{144}$, $R_{151}$ to $R_{153}$, $R_{161}$ to $R_{164}$, $R_{171}$, and $R_{172}$ in Formula

1-1 may be a group represented by one of Formulae 2-1 to 2-6 and a group represented by one of Formulae 2-1 to 2-6 in which at least one hydrogen is substituted with deuterium.

In some embodiments, at least one of $R_{151}$ to $R_{153}$ and $R_{161}$ to $R_{164}$ in Formula 1-1 may be a group represented by one of Formulae 2-1 to 2-6 and a group represented by one of Formulae 2-1 to 2-6 in which at least one hydrogen is substituted with deuterium.

In some embodiments, at least one of $R_{152}$ and $R_{162}$ in Formula 1 may be a group represented by one of Formulae 2-1 to 2-6 and a group represented by one of Formulae 2-1 to 2-6 in which at least one hydrogen is substituted with deuterium.

In an embodiment, the heterocyclic compound may be compounds of Group C:

Group C

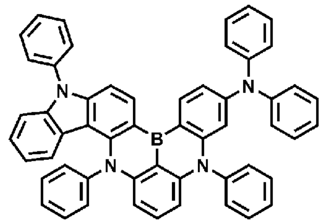

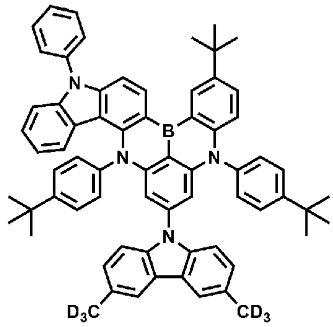

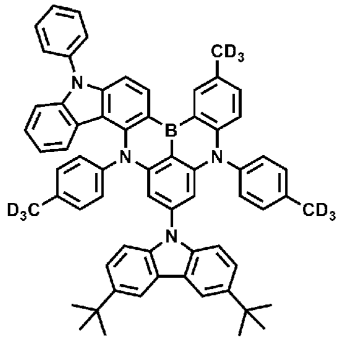

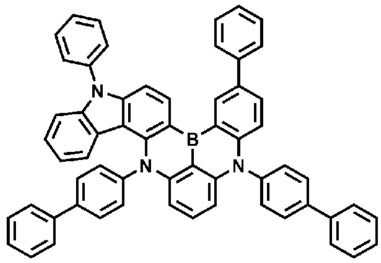

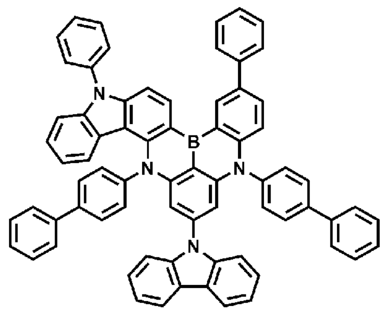

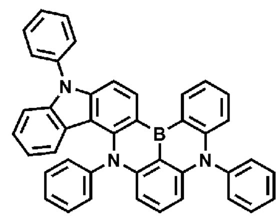

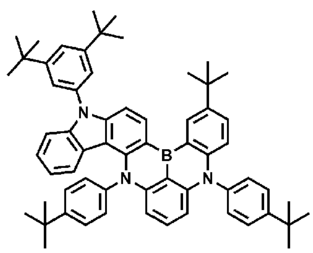

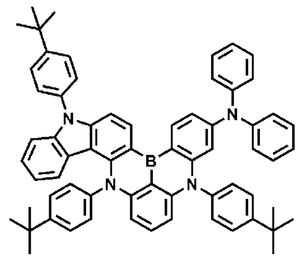

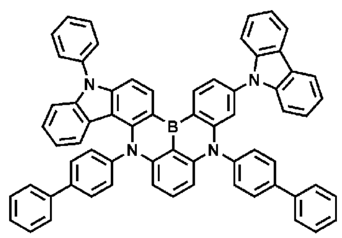

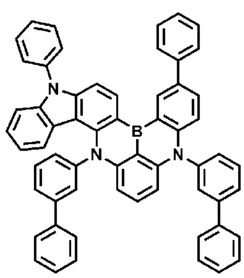

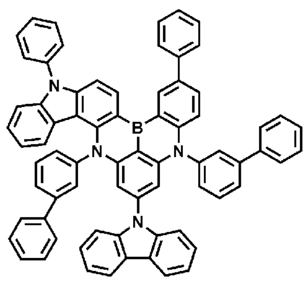

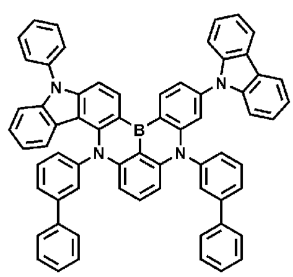

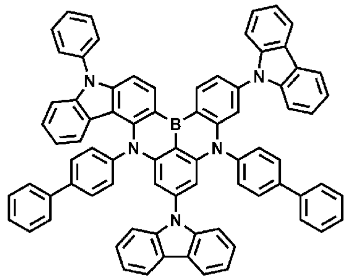
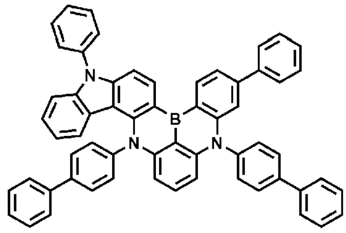
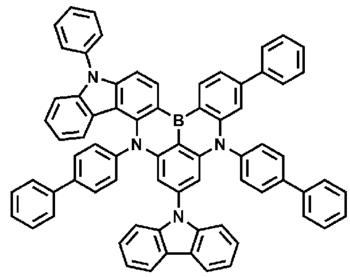
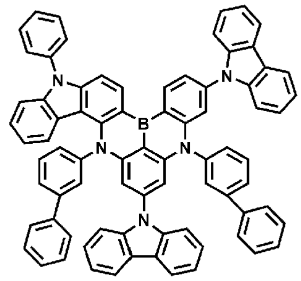
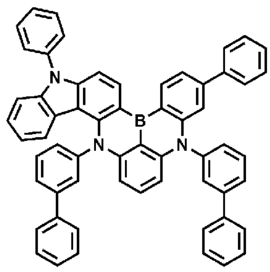
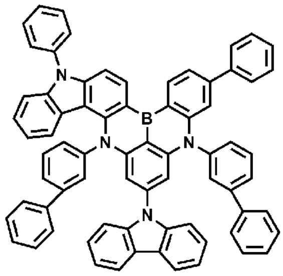
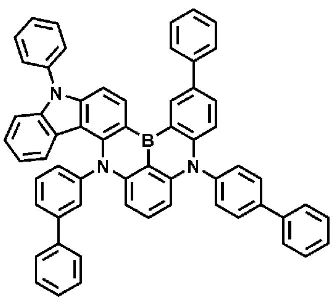
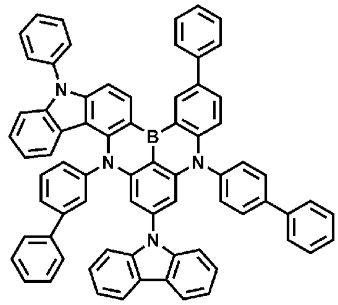
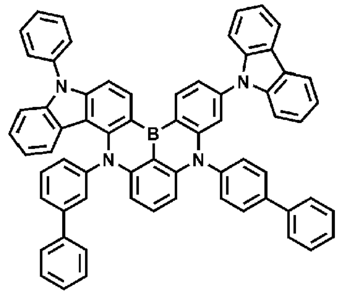
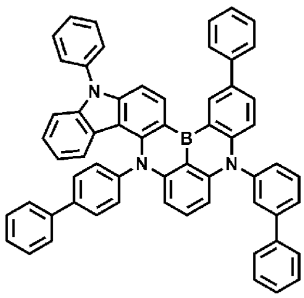
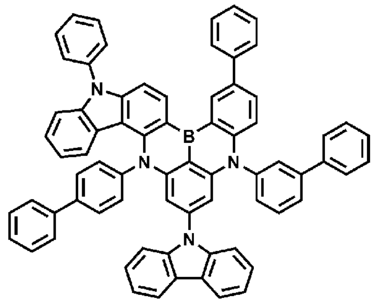
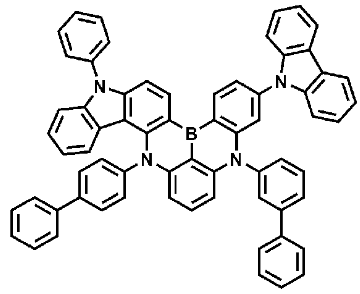

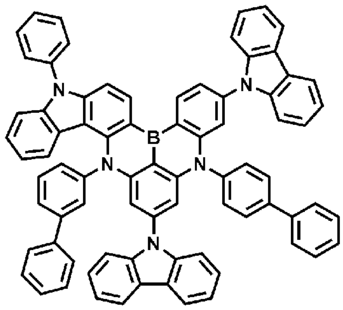
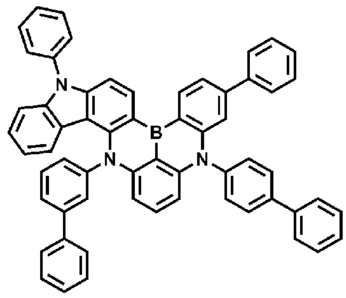
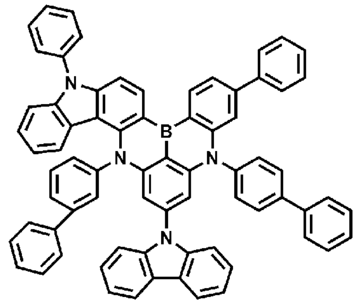
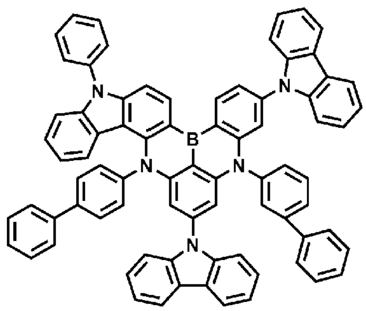
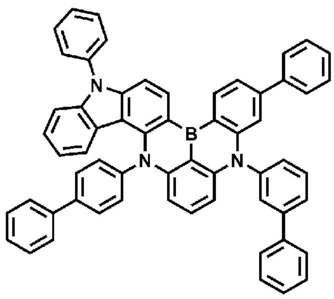
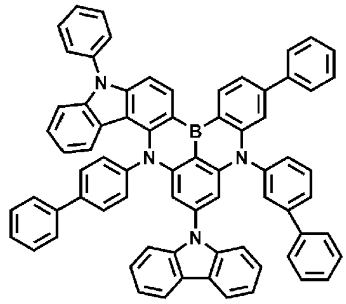
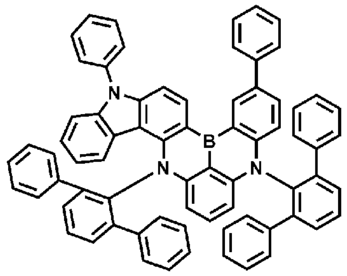
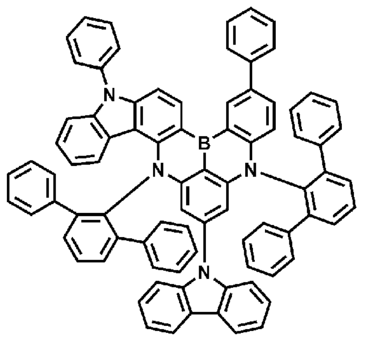
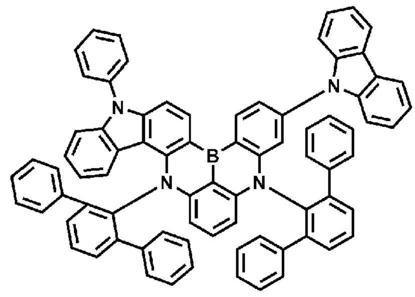
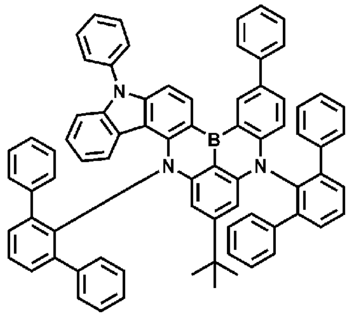
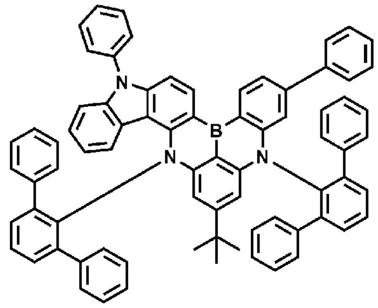
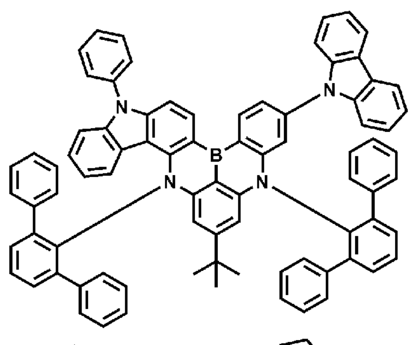
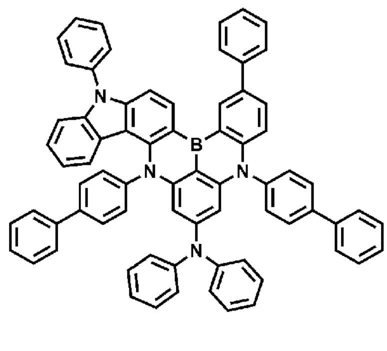
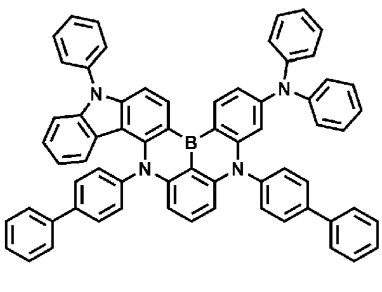
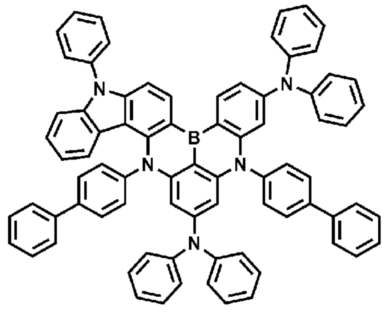

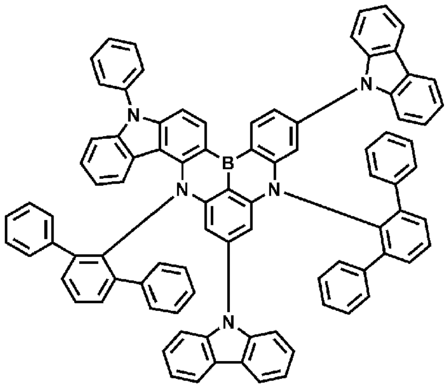
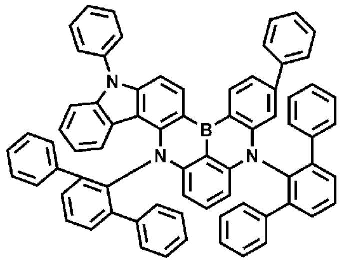
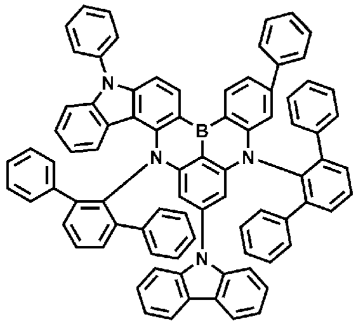
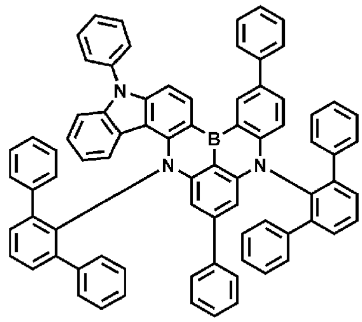
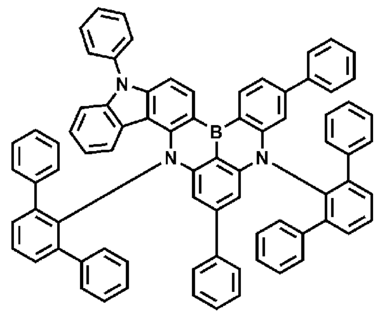
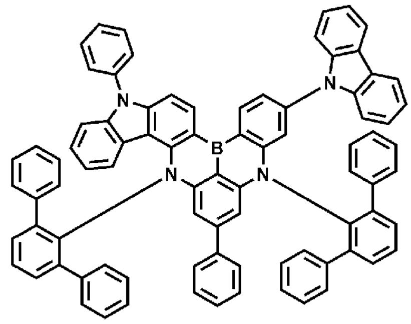
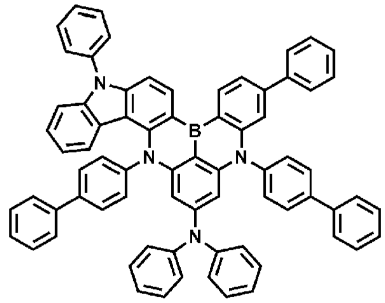
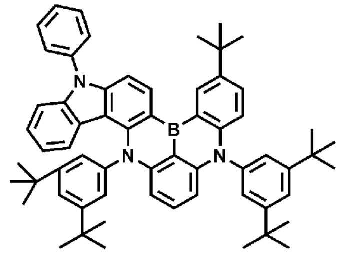
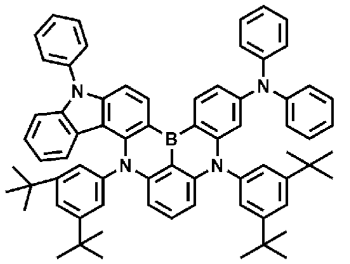
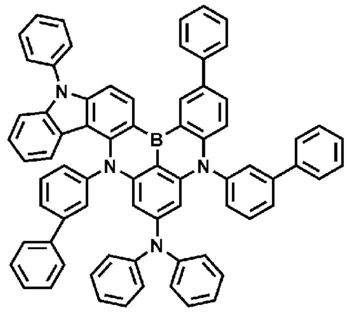
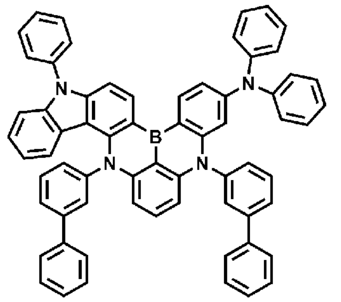
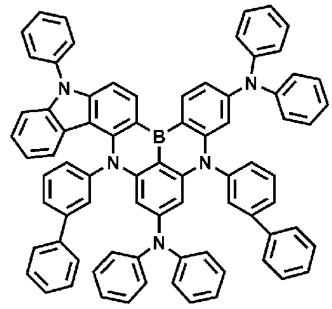
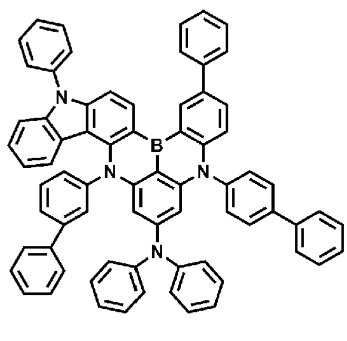
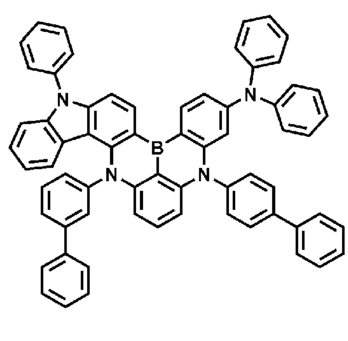
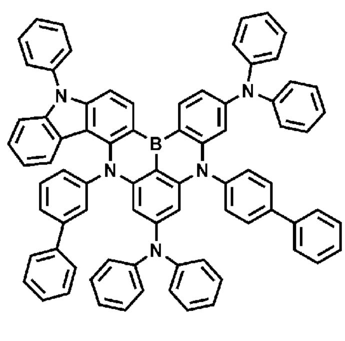

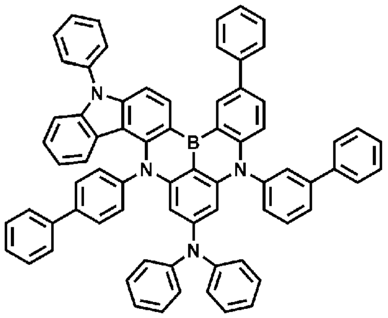
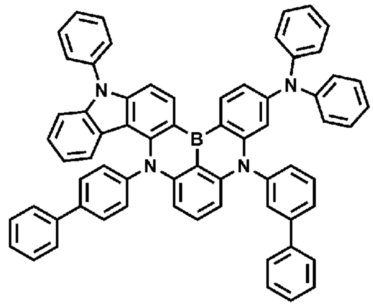
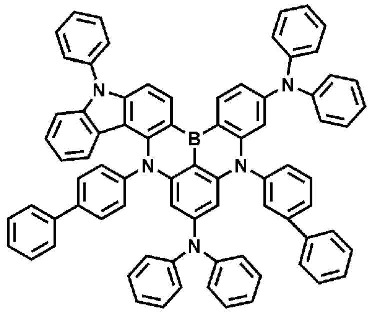
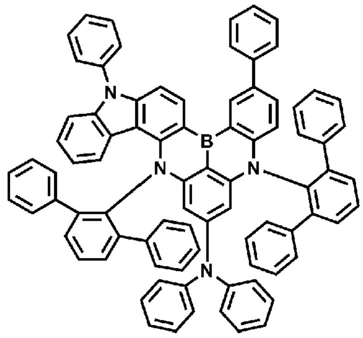
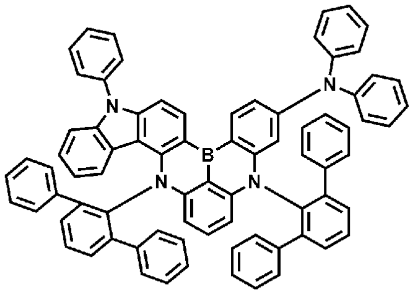
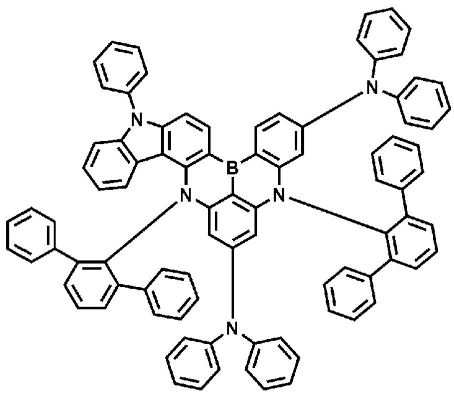
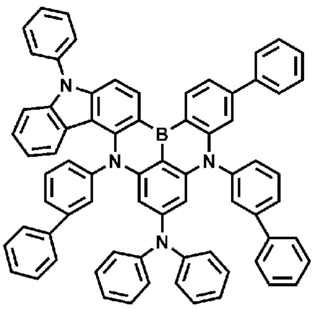
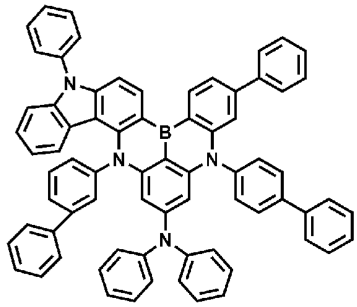
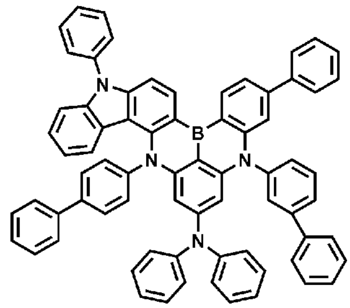
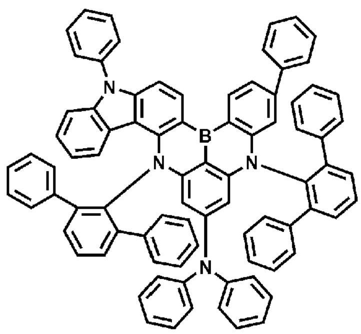
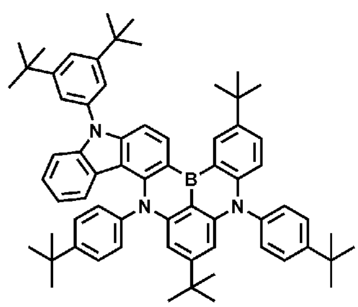
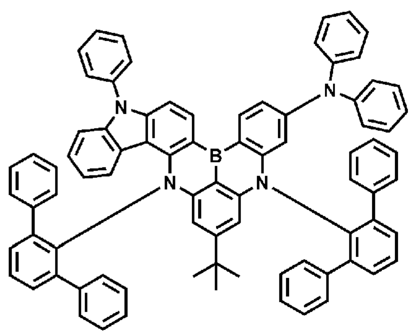

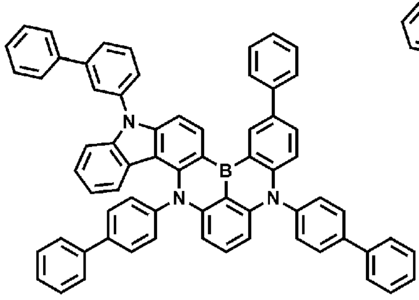

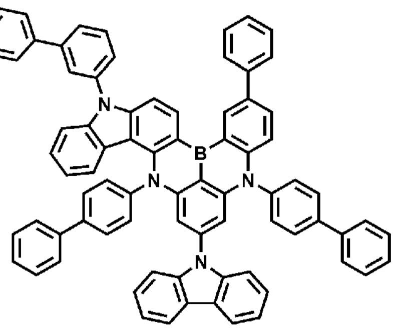

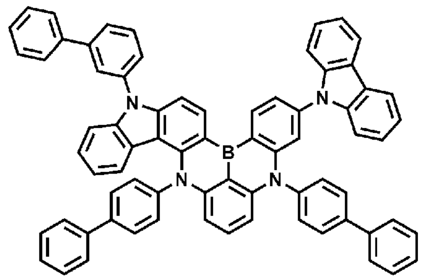

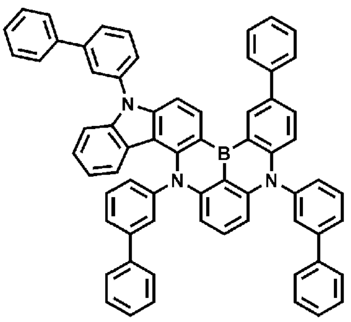

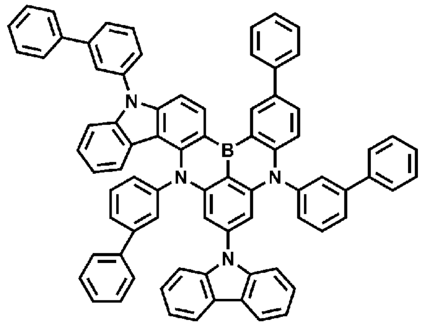

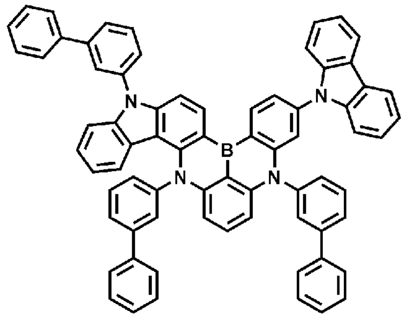

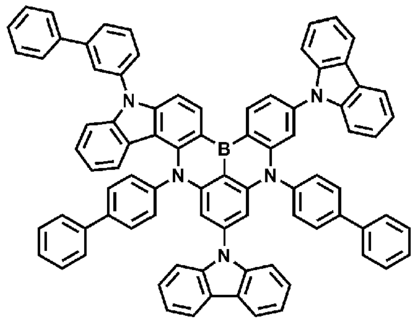

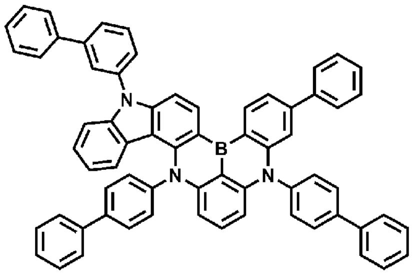

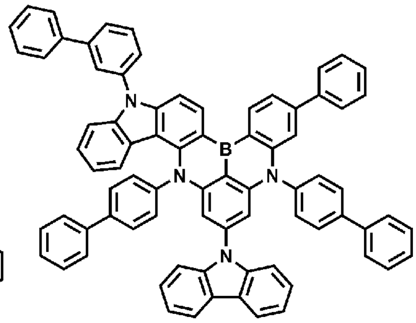

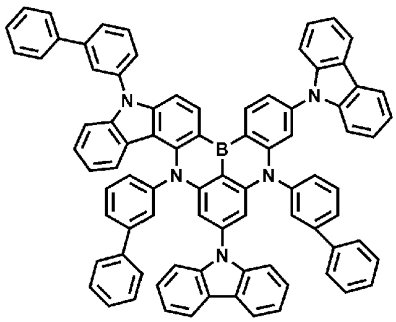

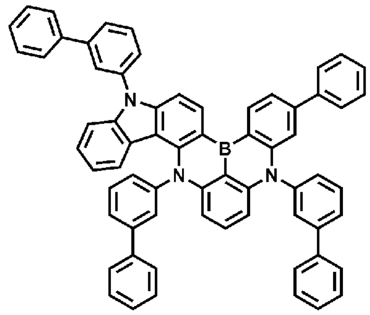

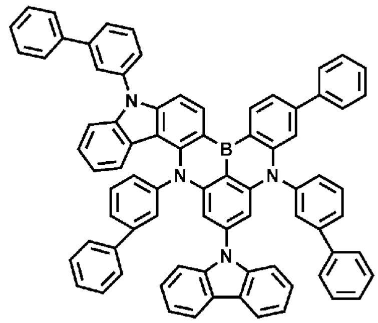

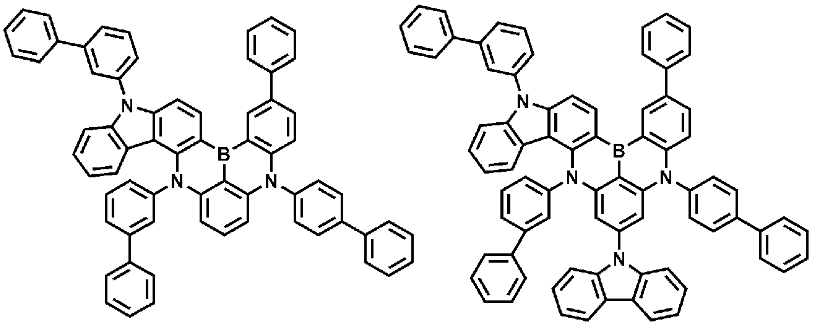

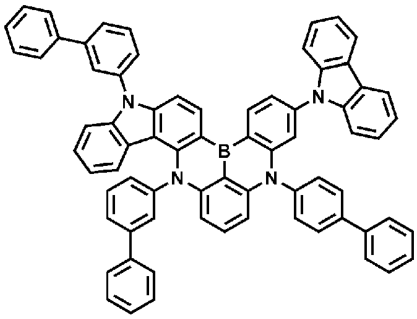

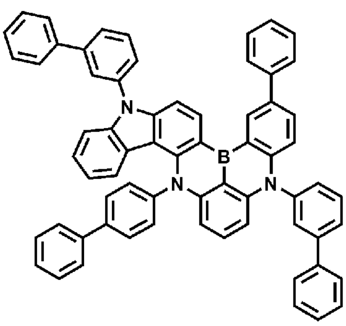

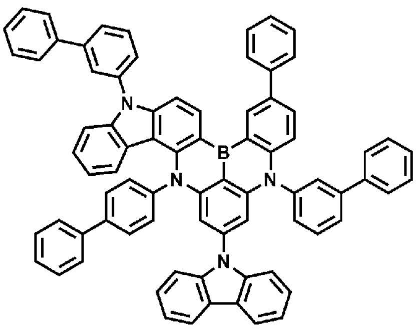

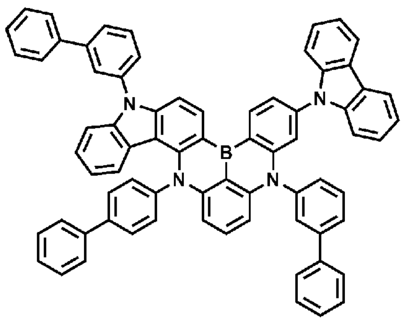

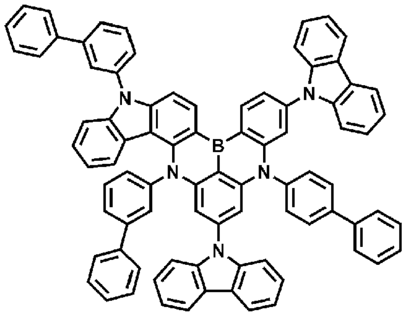

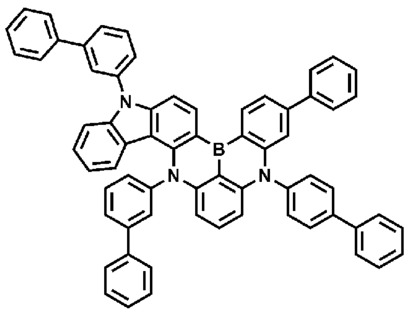

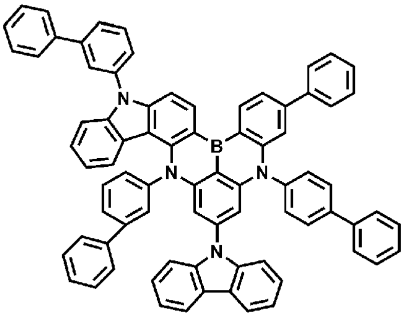

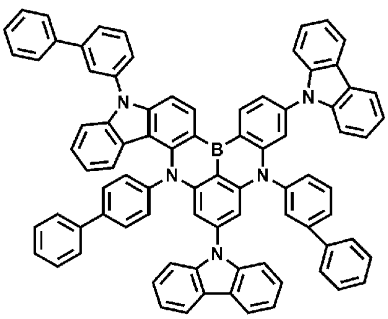

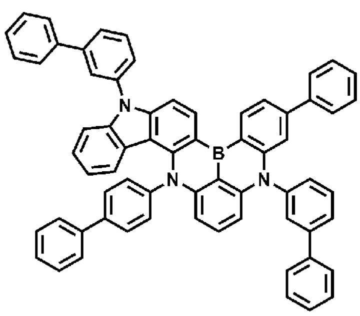

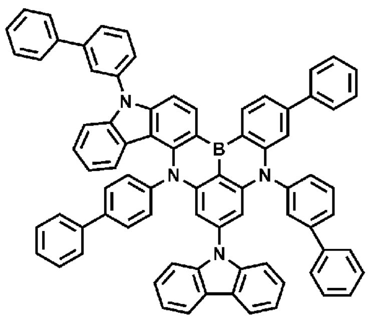

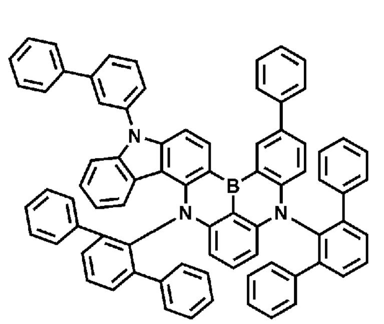
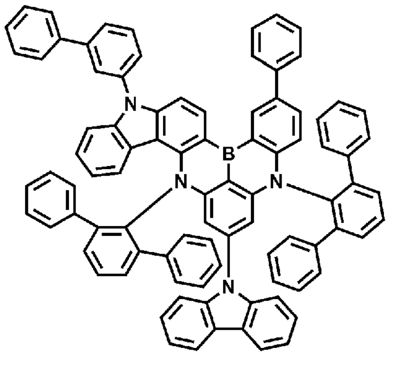
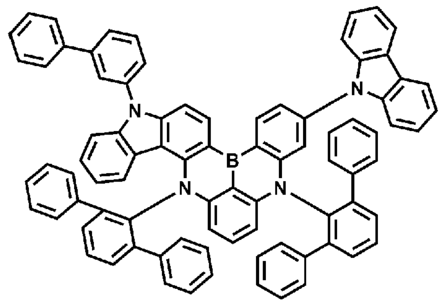
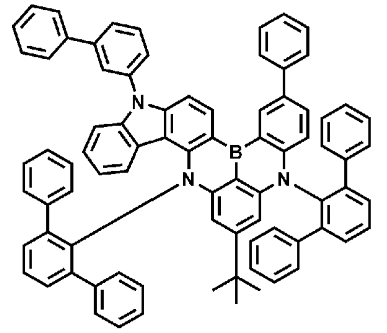
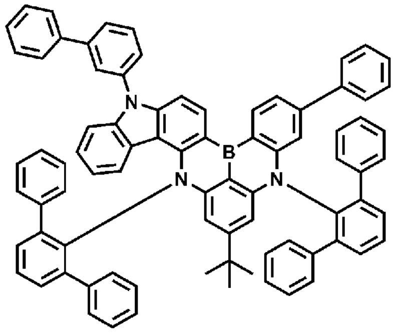
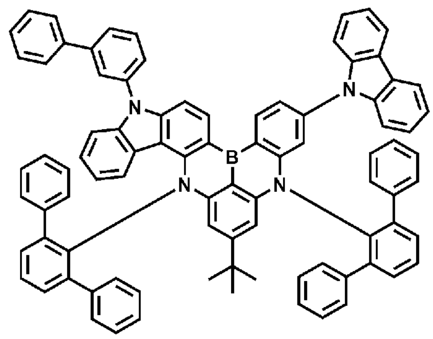
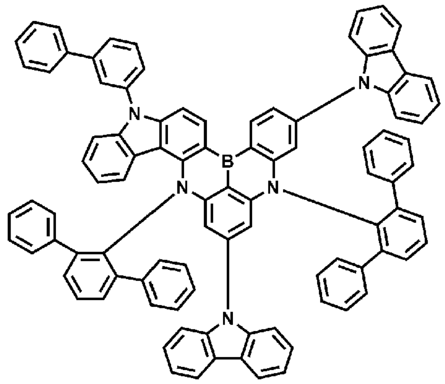
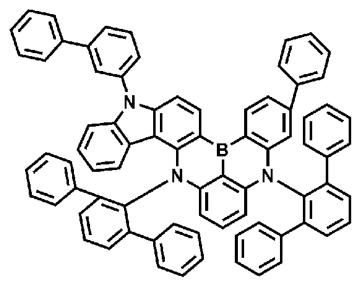
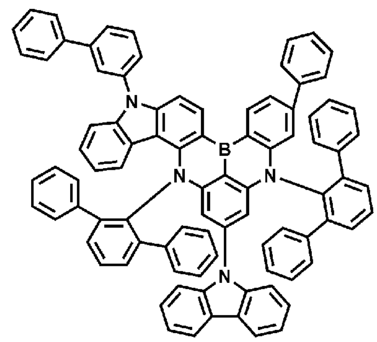
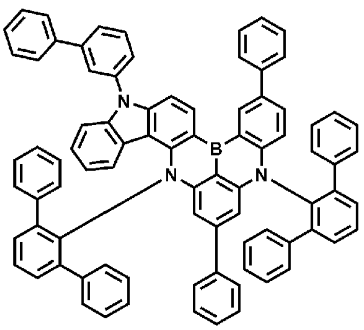
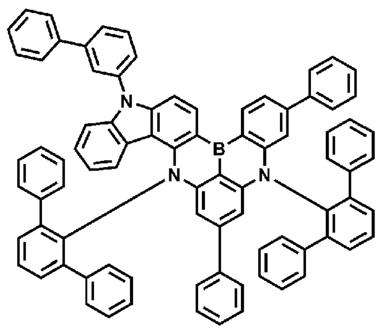
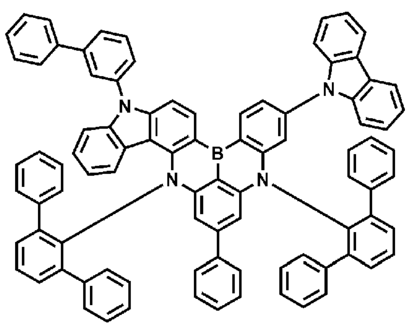

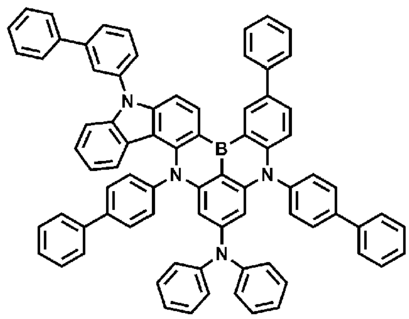 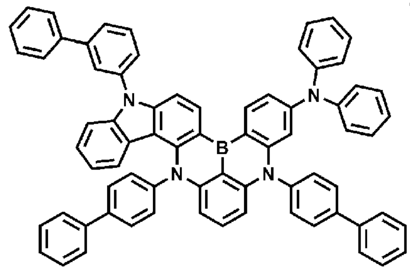 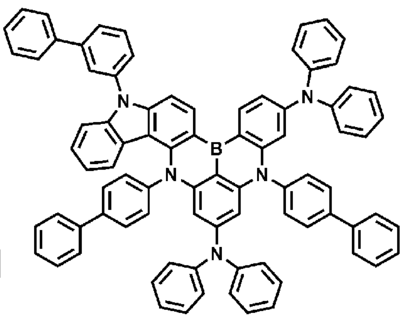

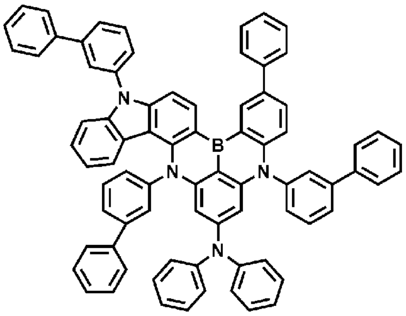 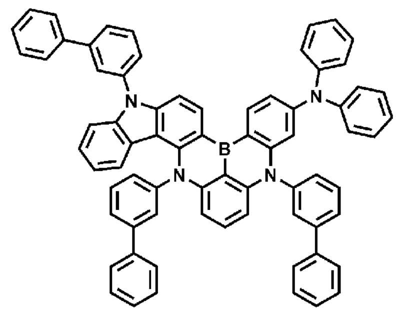 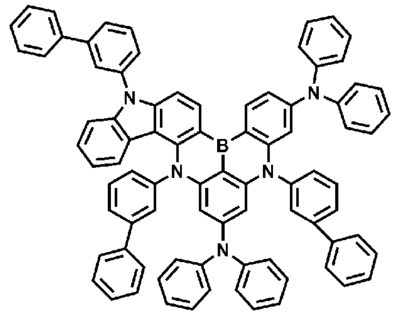

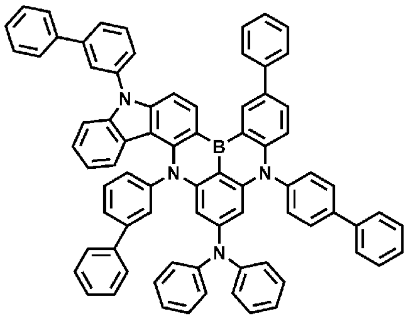 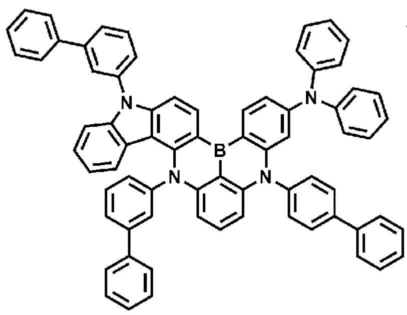 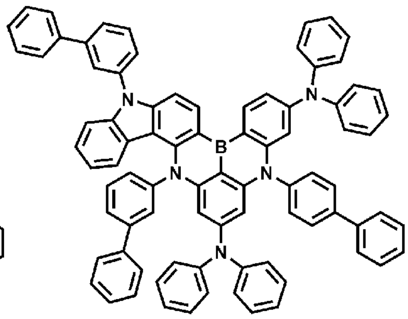

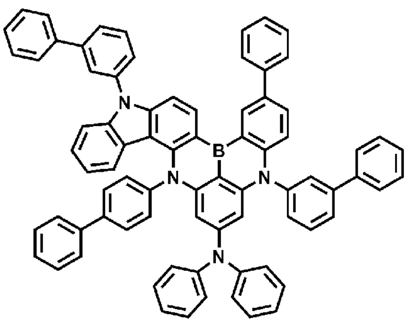 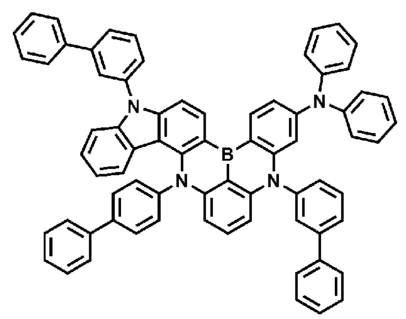 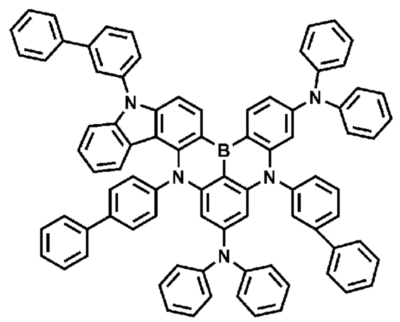

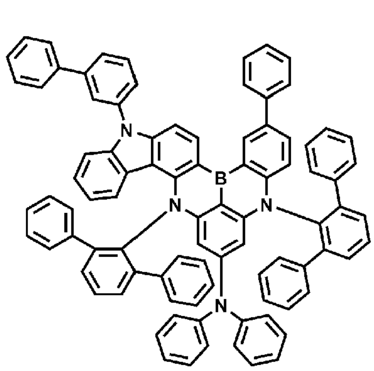 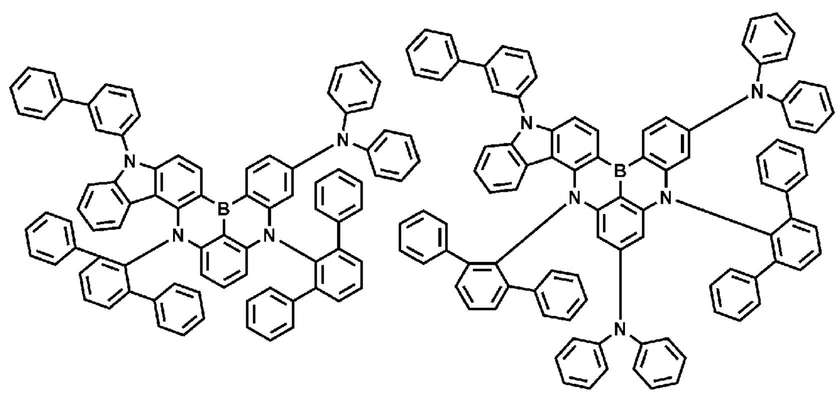

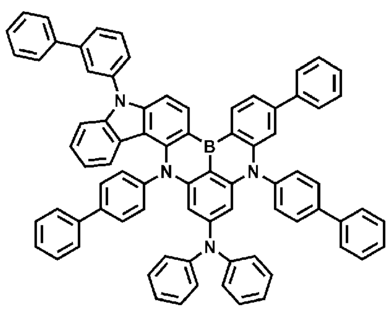

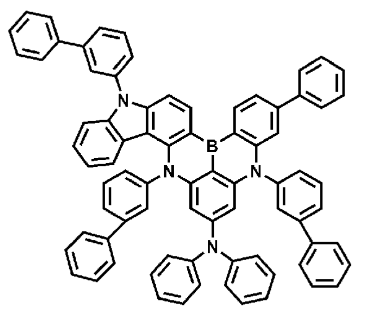

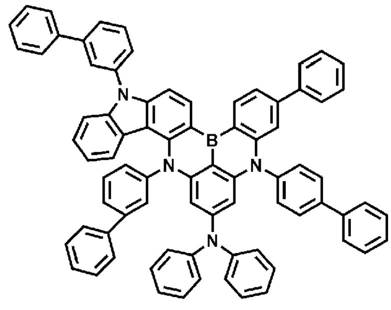

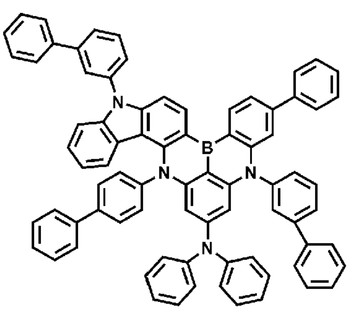

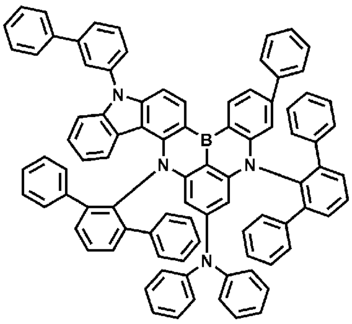

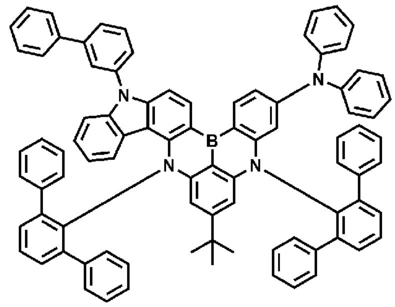

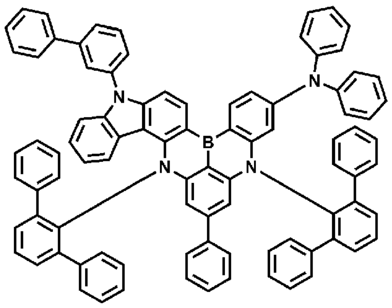

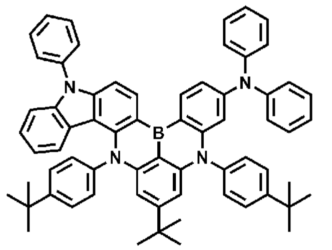

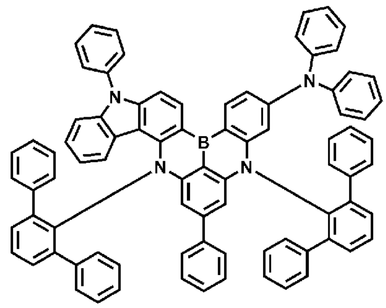

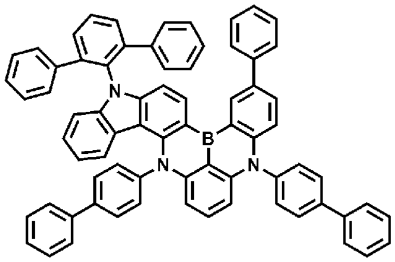
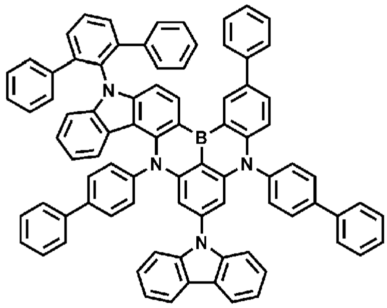
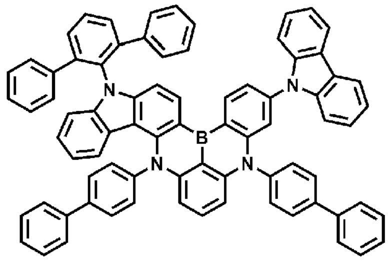

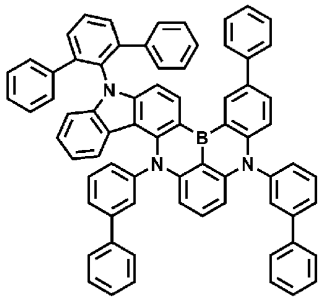
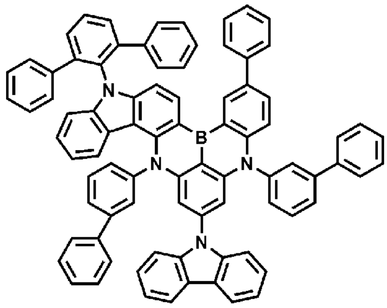
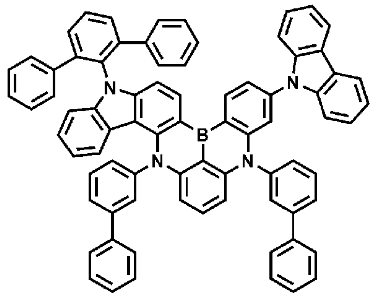

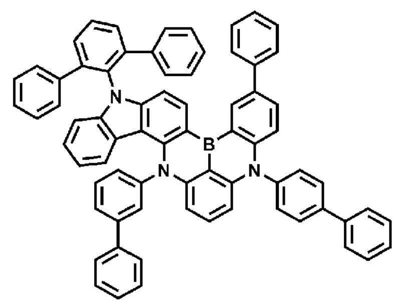
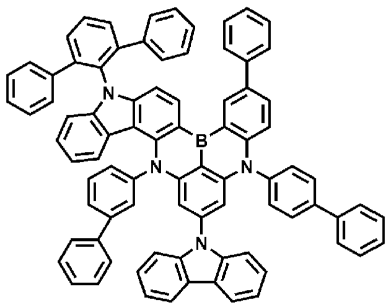
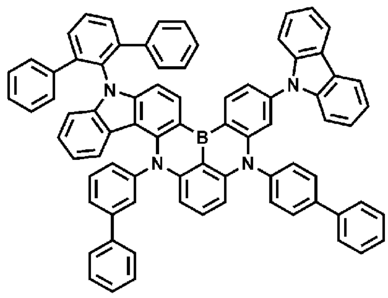

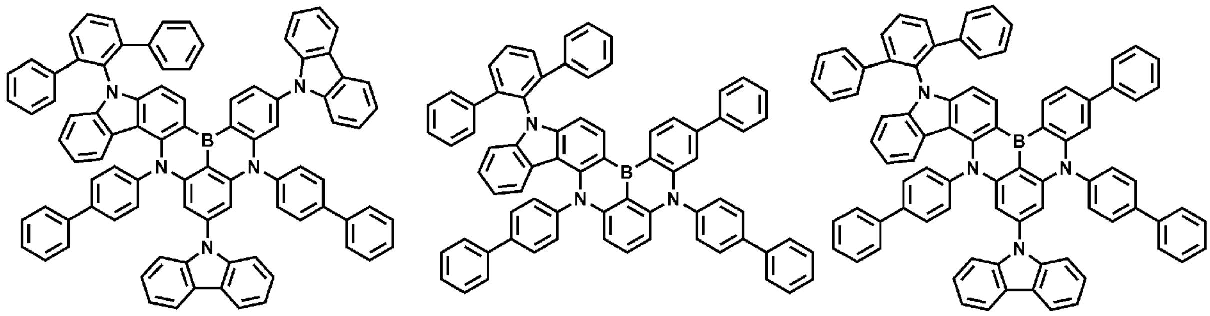

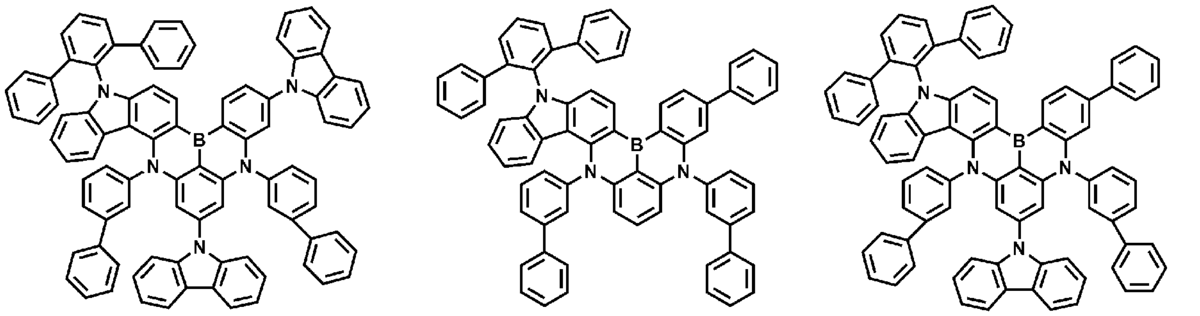

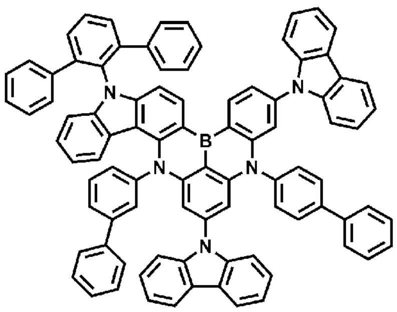

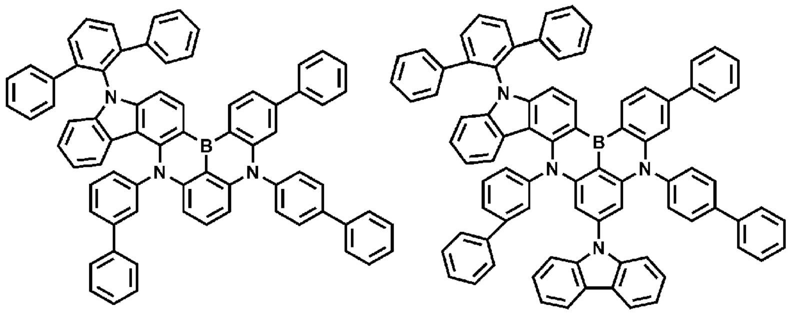

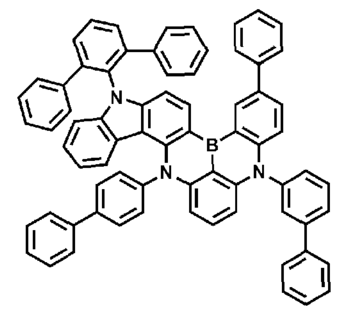
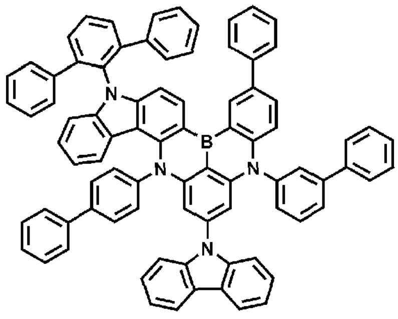
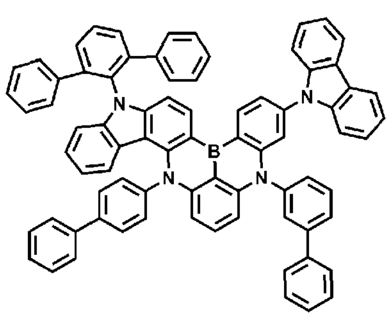

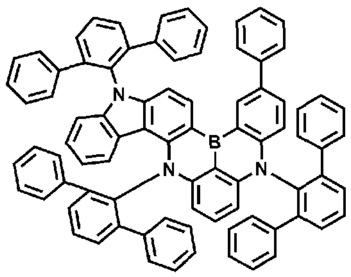
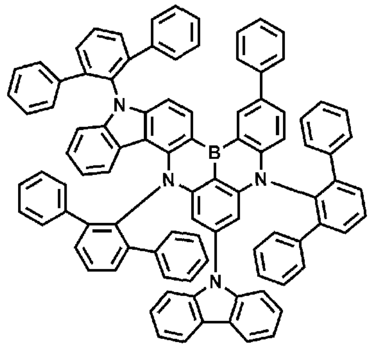
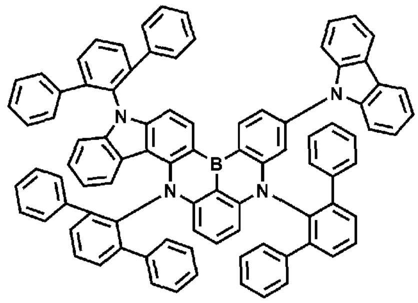

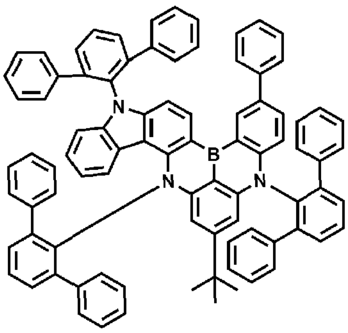
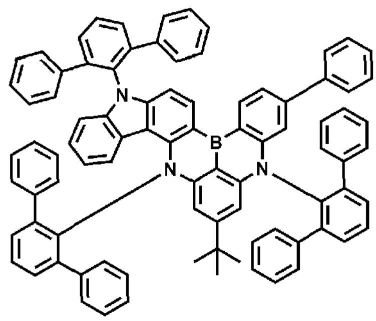
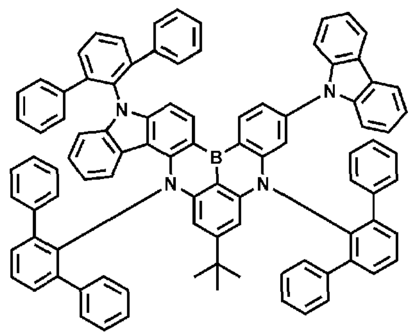

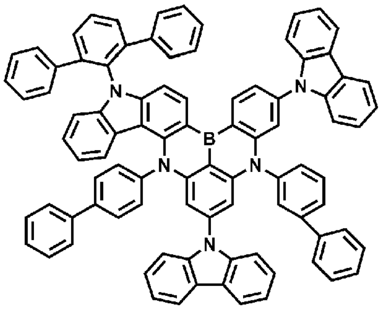
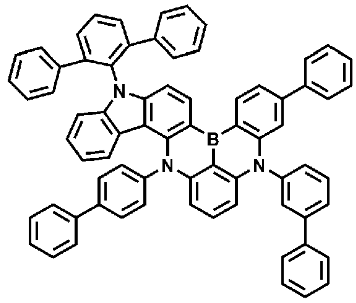
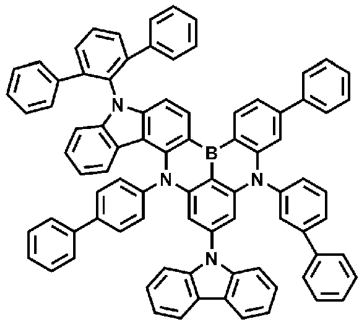
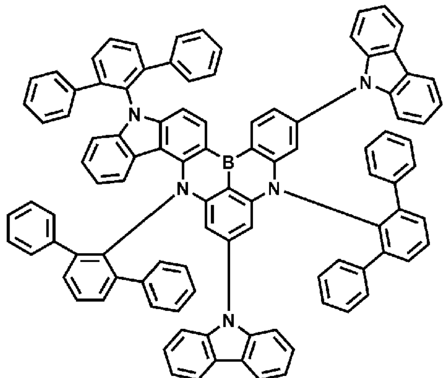
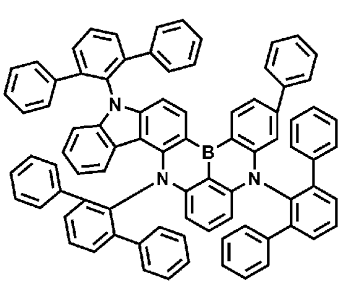
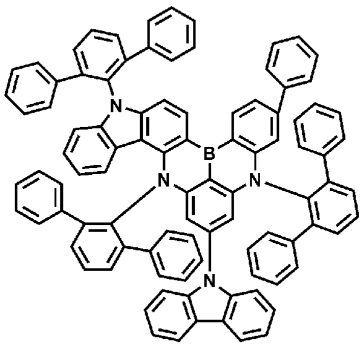
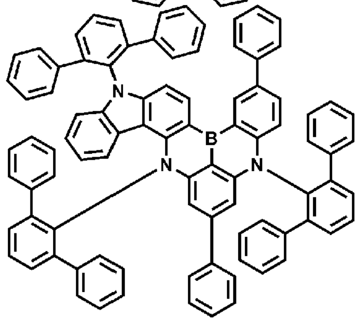
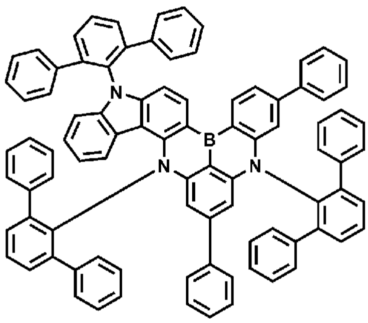
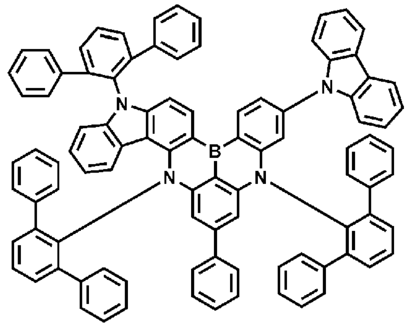

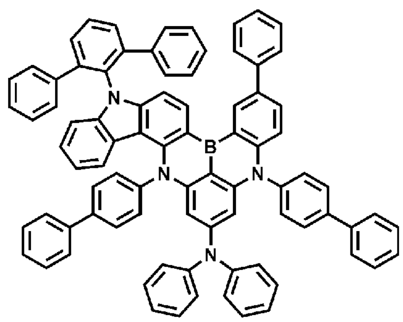

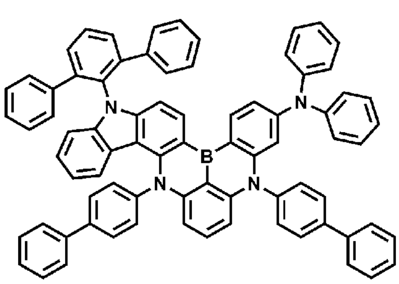

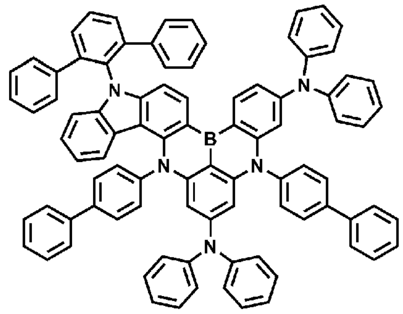

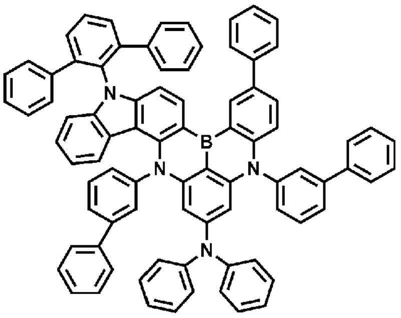

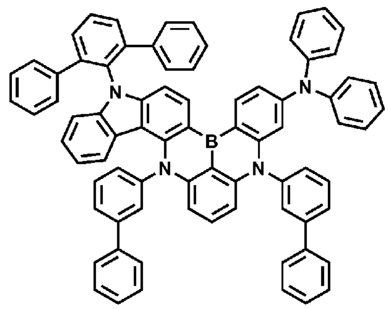

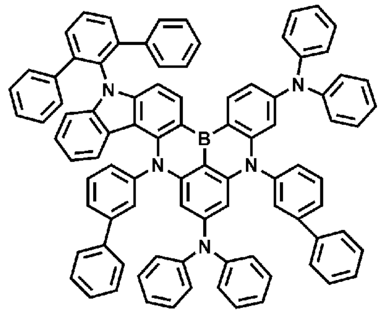

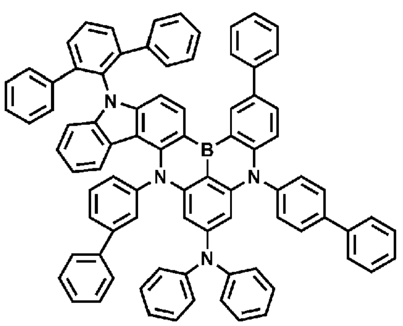

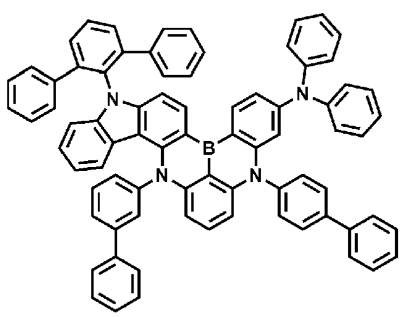

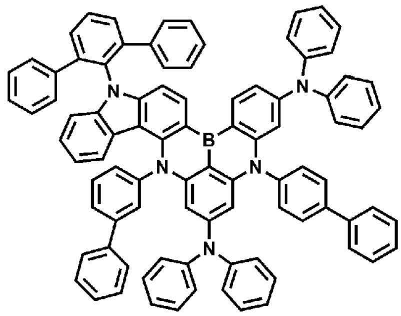

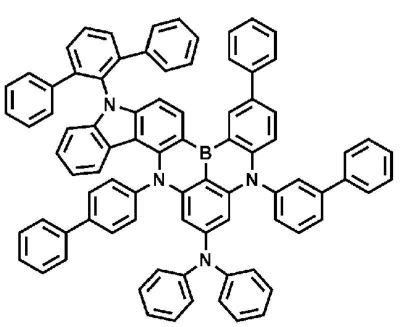

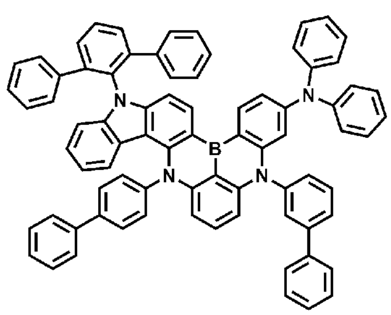

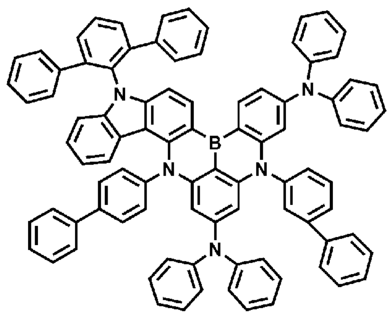

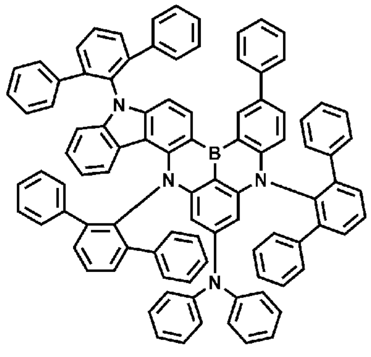

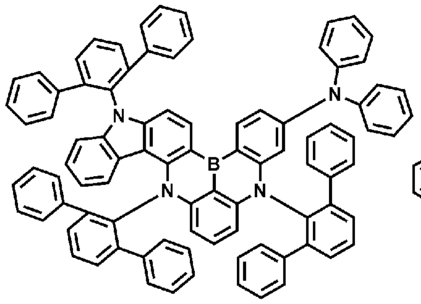

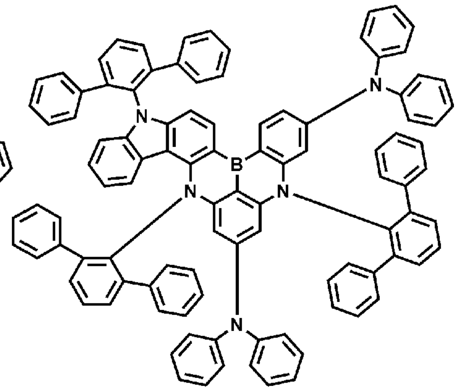

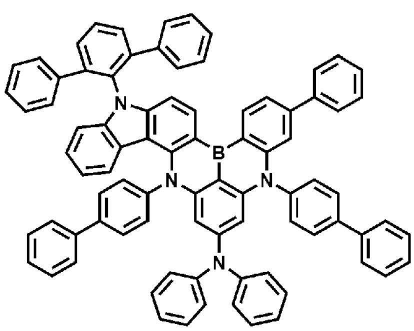
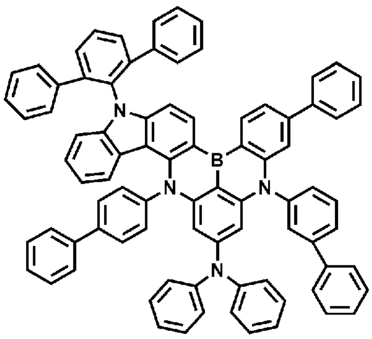
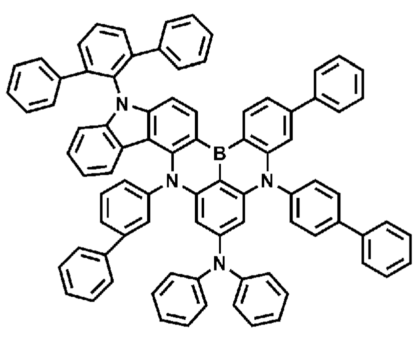
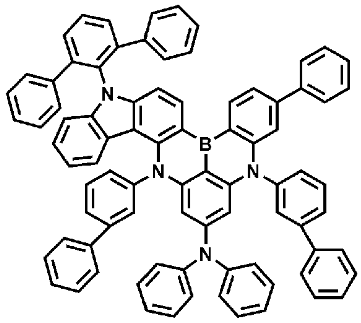
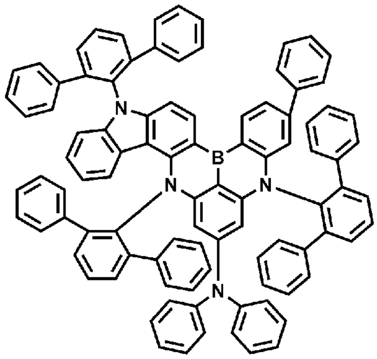
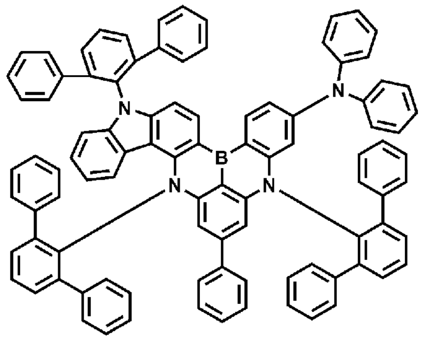
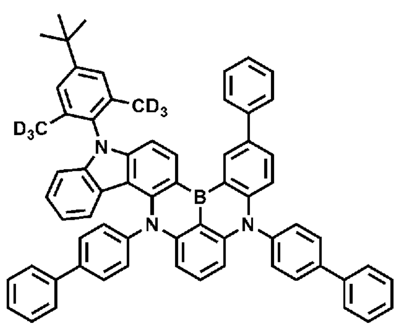
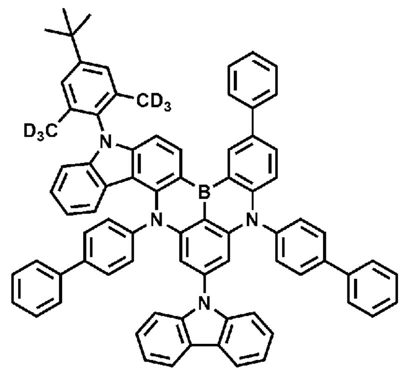
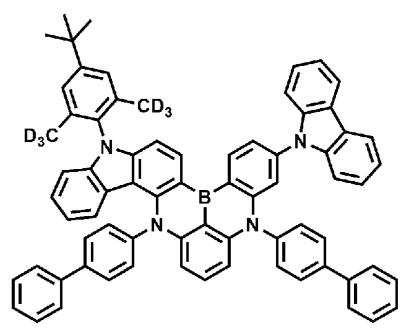
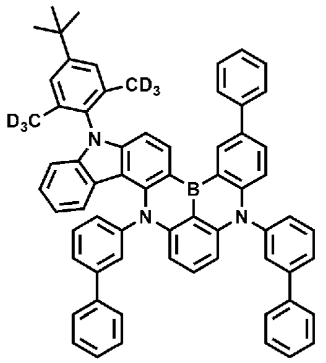
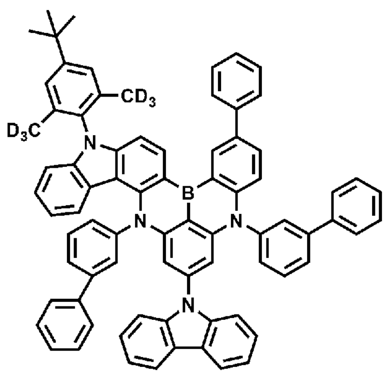
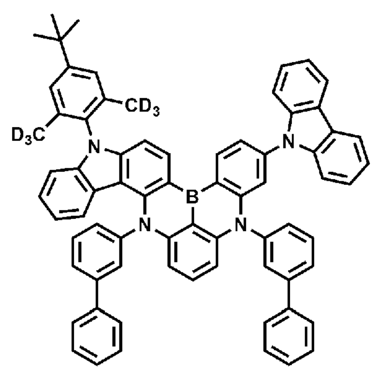

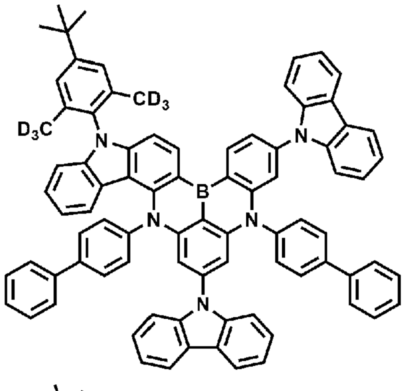
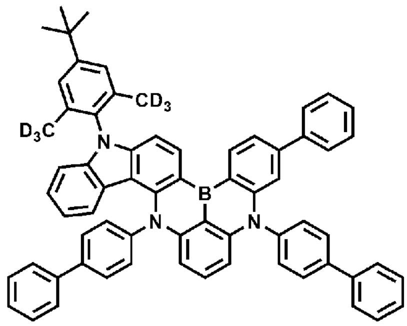
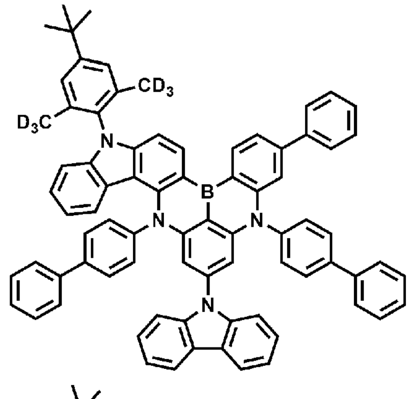
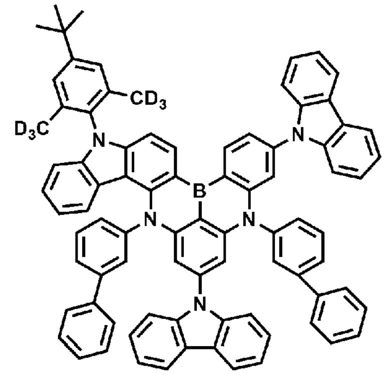
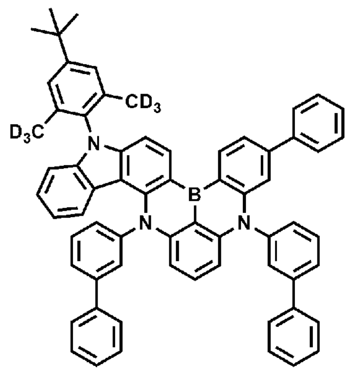
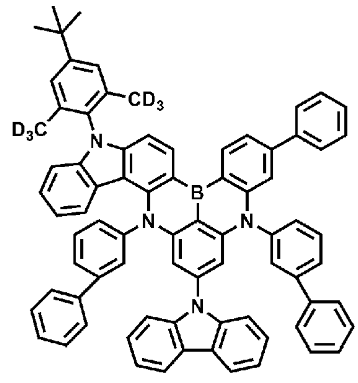
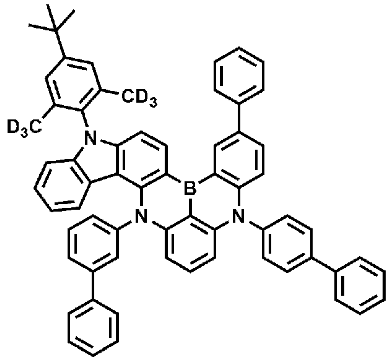
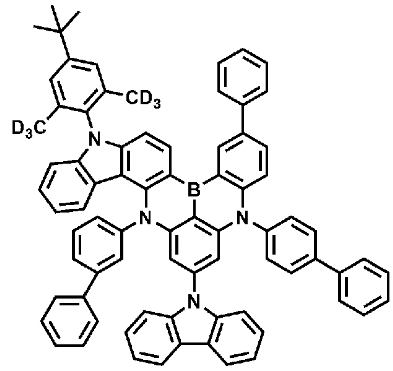
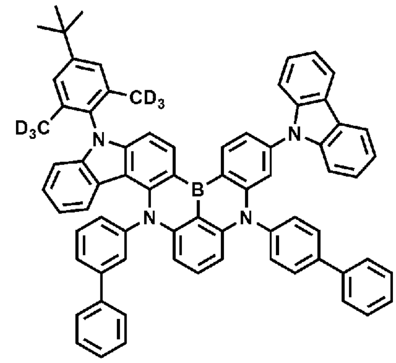
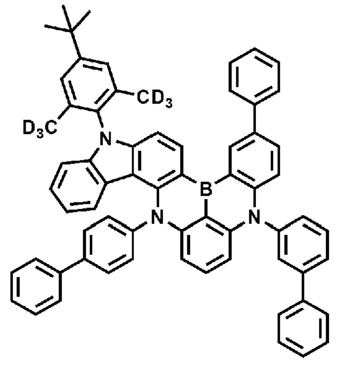
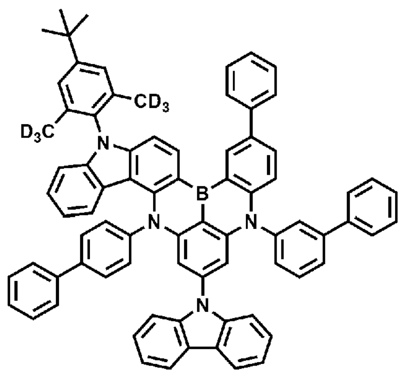
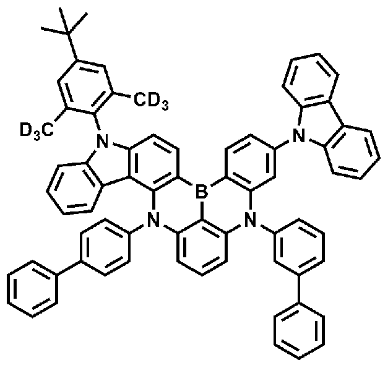

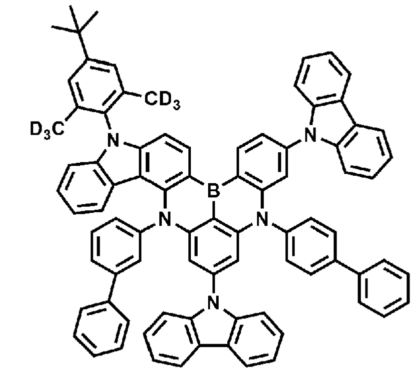
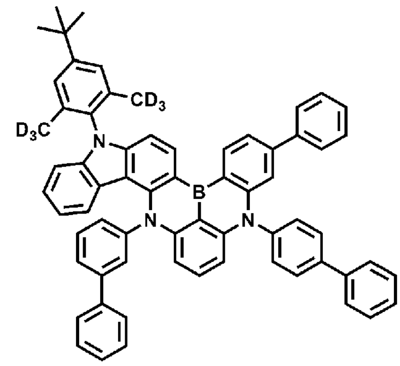
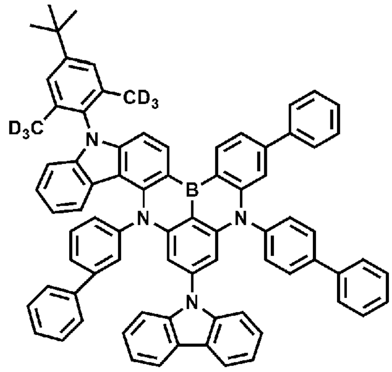
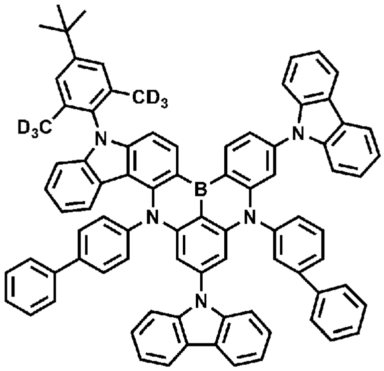
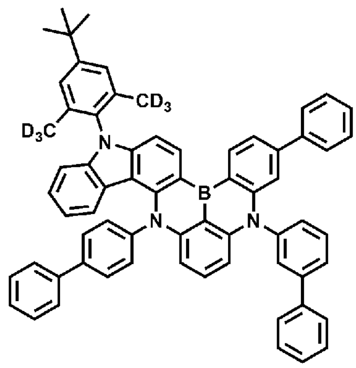
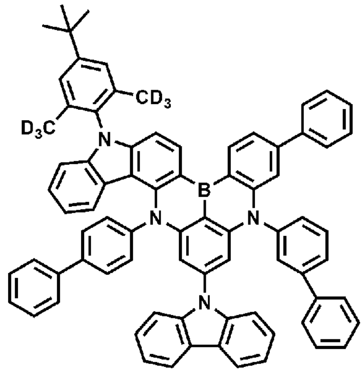
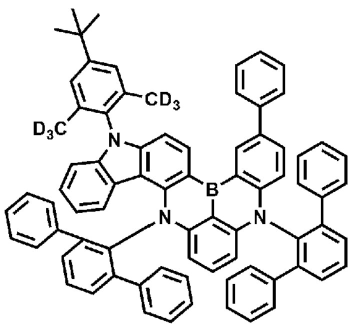
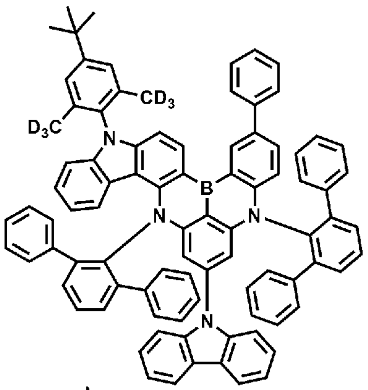
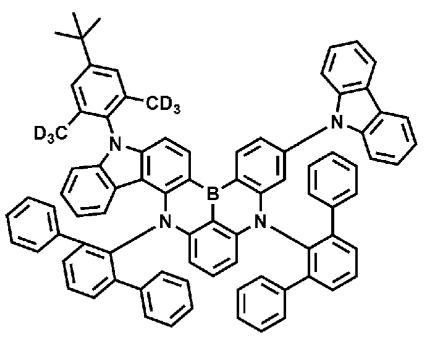
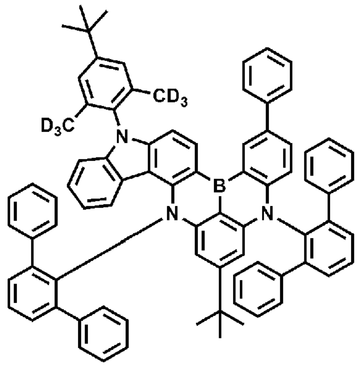
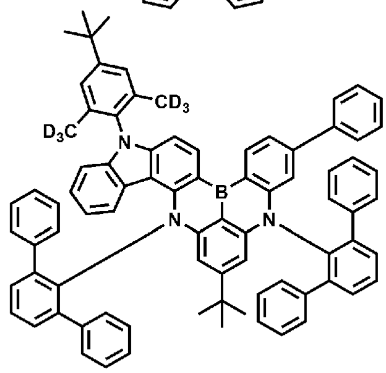
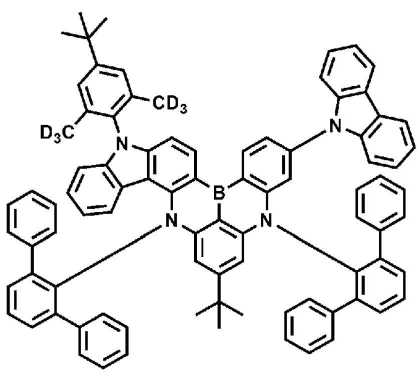

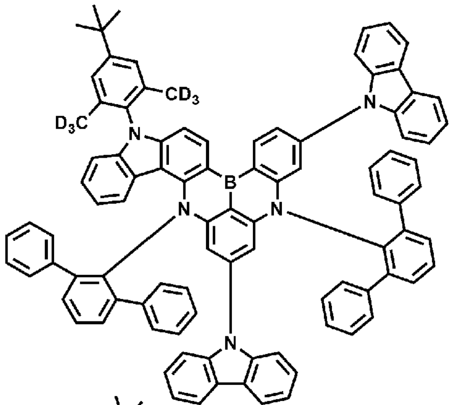

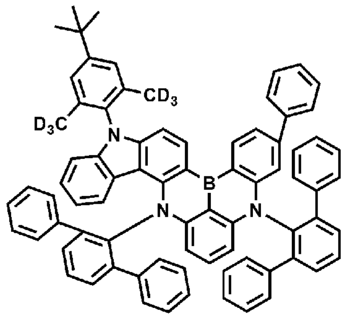

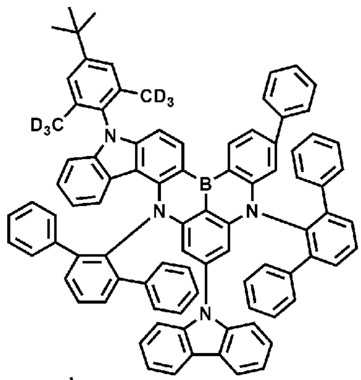

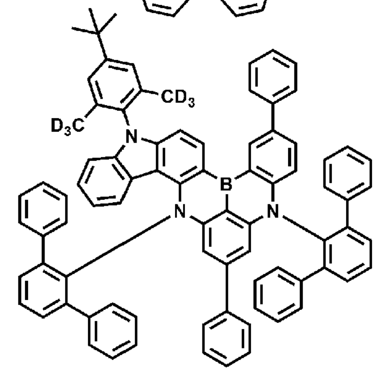

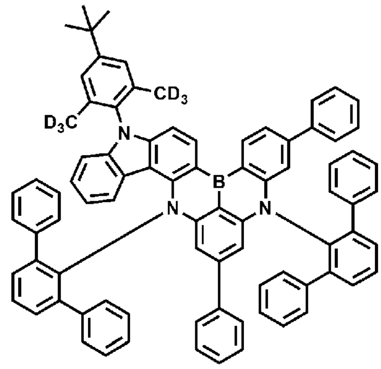

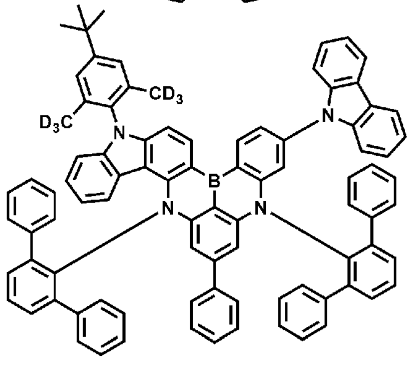

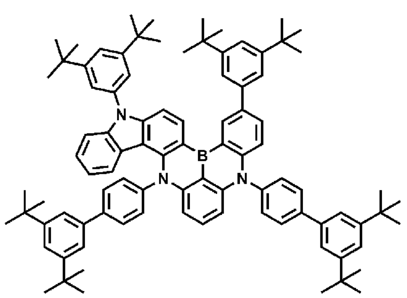

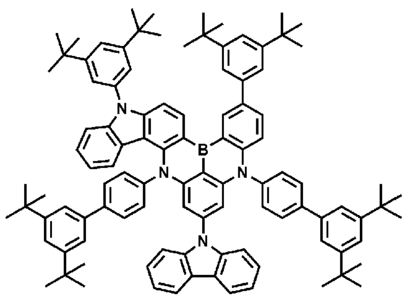

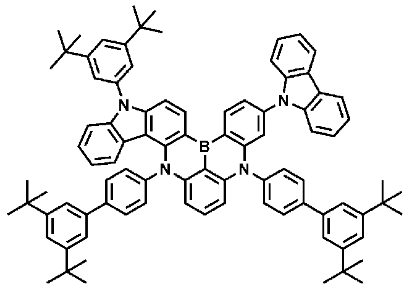

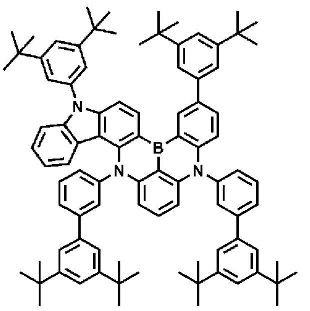

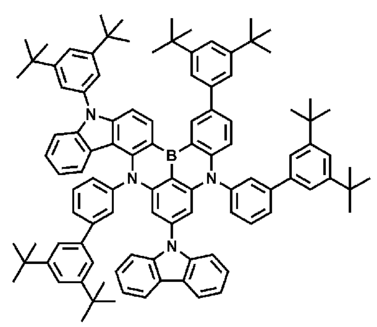

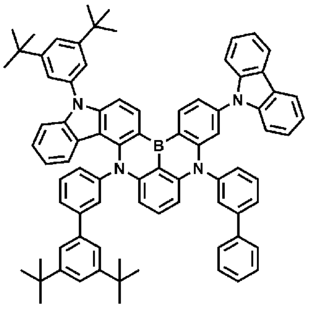

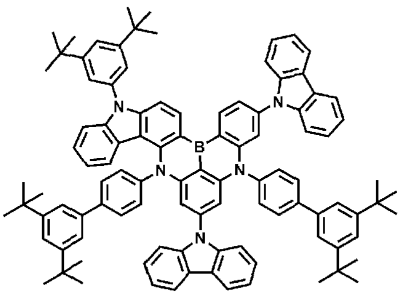
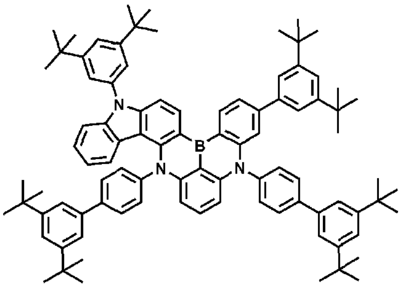
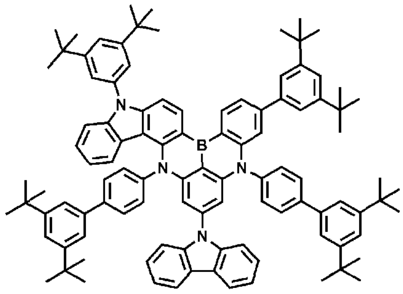
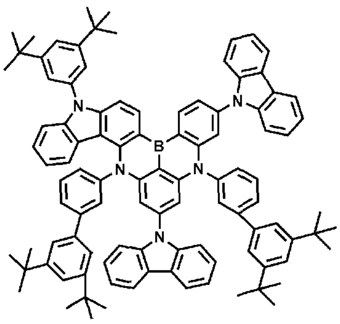
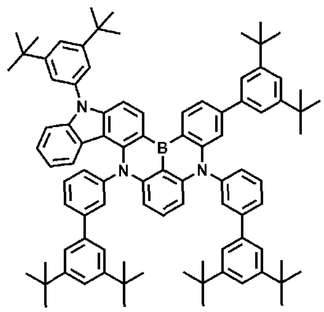
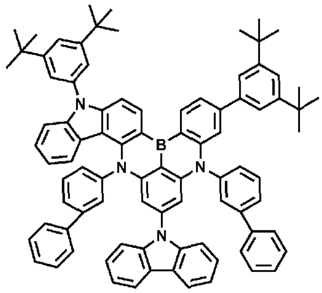
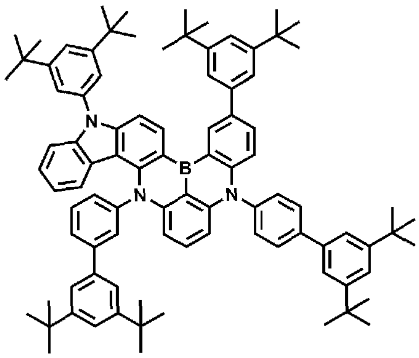
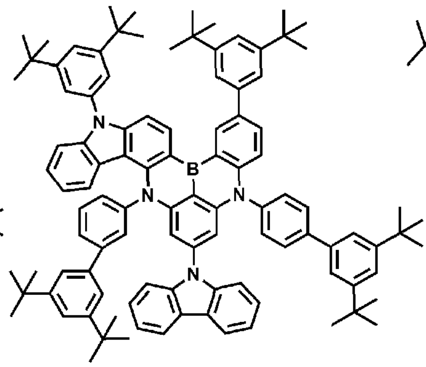
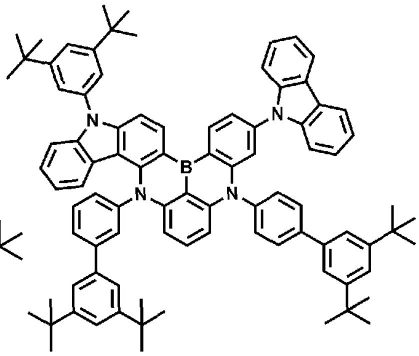
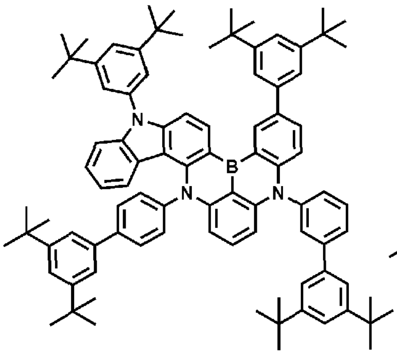
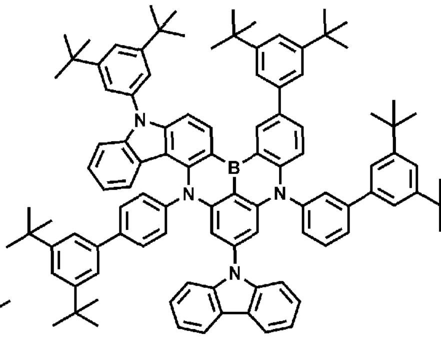
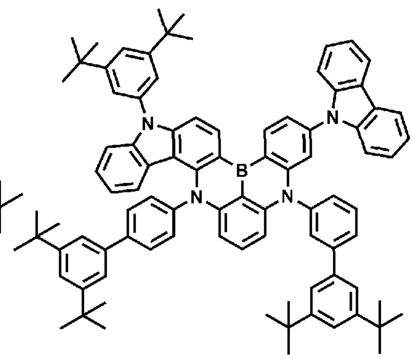

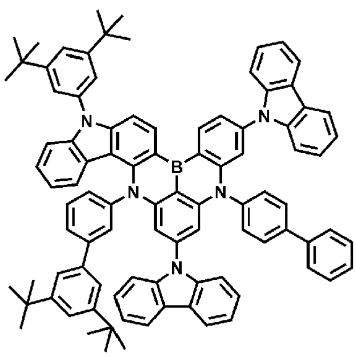
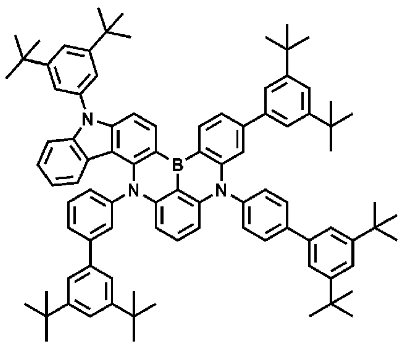
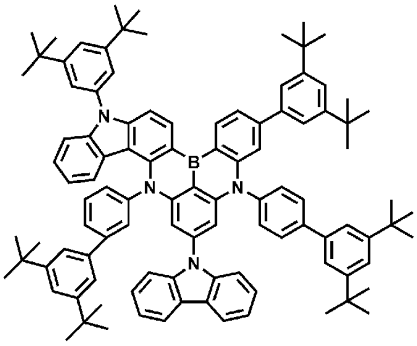
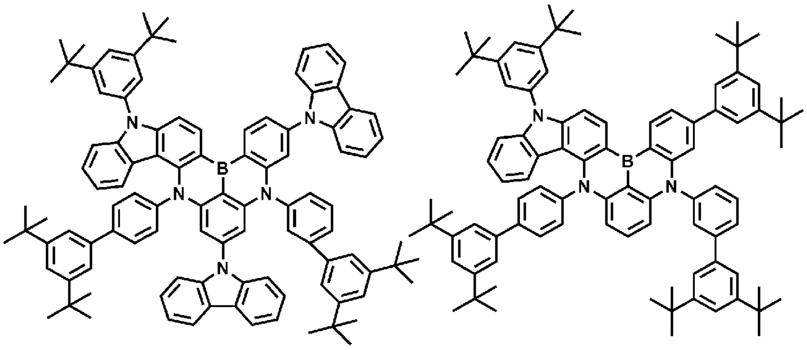
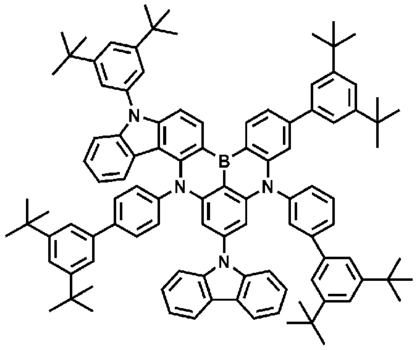
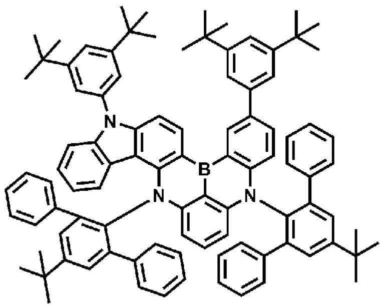
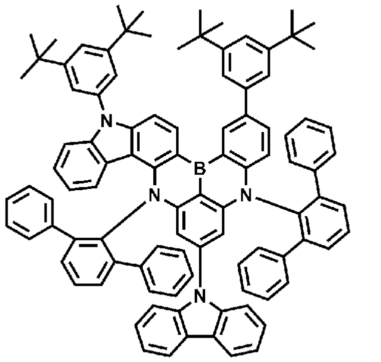
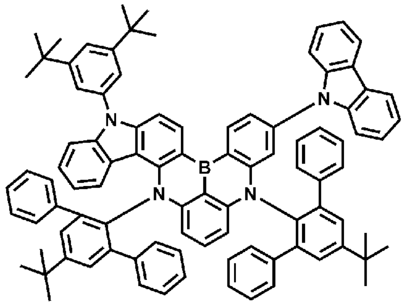
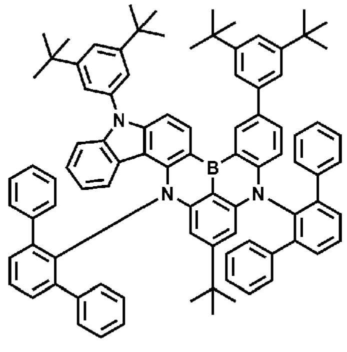
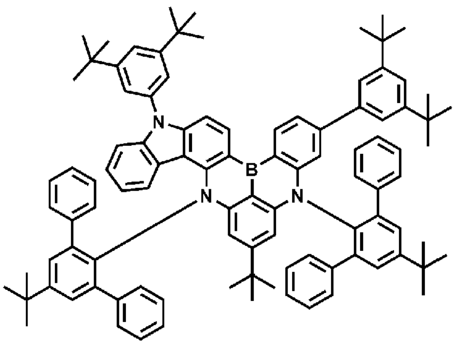
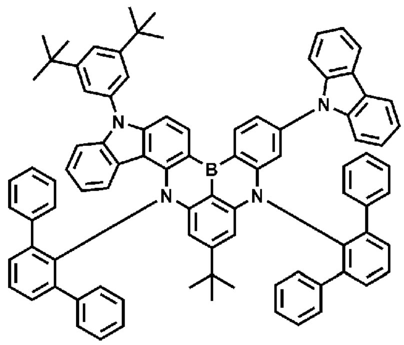

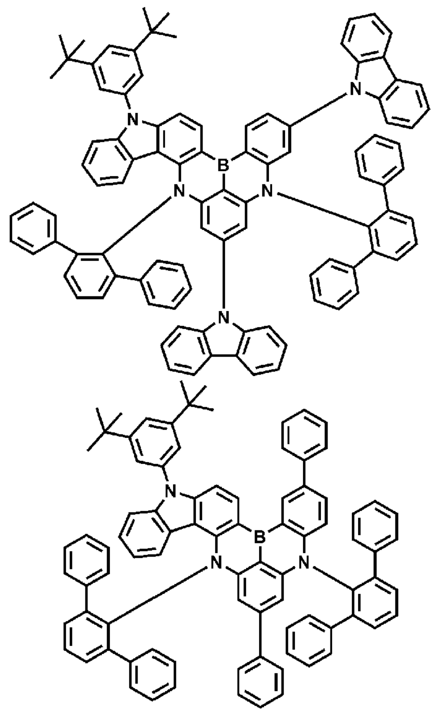

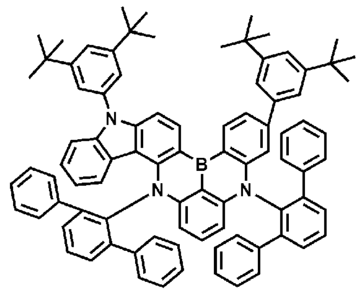

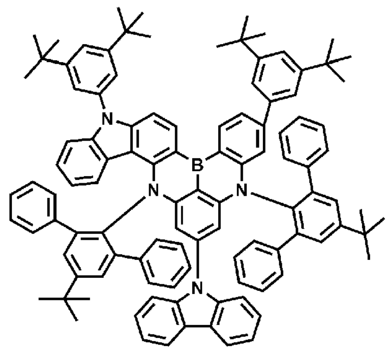

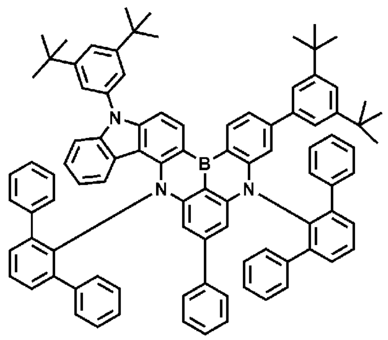

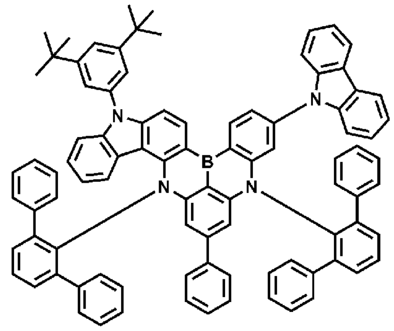

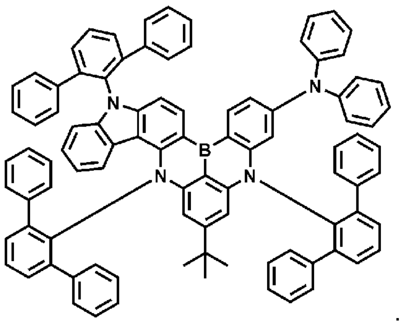

.

Since the heterocyclic compound has a rigid structure in which aromatic hydrocarbon rings or heteroaromatic rings are condensed, structural relaxation in an excited state may be suppressed. As a result, the heterocyclic compound may have a narrow width of blue emission spectrum and improved colorimetric purity.

Specifically, in the heterocyclic compound, carbazole is condensed at a specific position in a specific direction, specifically, at the para and meta positions with respect to boron and nitrogen, respectively, so that the LUMO energy level of the heterocyclic compound may be enhanced (LUMO energy level is elevated), and the lowest singlet excitation energy level can be relatively high, which can be more favorable for deep blue light emission.

In addition, since the heterocyclic compound has an asymmetric structure in the core thereof, the emission wavelength can be shortened and may also be finely adjusted, thereby providing an organic light-emitting device with high efficiency and/or long life.

The peak wavelength in the photoluminescence (PL) spectrum of the heterocyclic compound according to an embodiment is not particularly limited and may be 430 nanometers (nm) or greater. In some embodiments, the peak wavelength may be about 435 nm or greater, about 440 nm or greater, about 500 nm or greater, about 490 nm or greater, or about 480 nm or greater. When the peak wavelength is within any of these ranges, the heterocyclic compound according to an embodiment may be more suitable for blue light emission.

The heterocyclic compound according to one or more embodiments may have a small the full width at half maximum (FWHM) of an emission intensity of a peak having a PL peak wavelength. In some embodiments, FWHM may be 45 nm or less, about 40 nm or less, or about 35 nm or less. When the FWHM is within any of these ranges, the heterocyclic compound according to an embodiment may have improved colorimetric purity.

The peak wavelength at PL and the FWHM at PL may be measured and/or calculated using a spectrofluorophotometer.

$\Delta E_{ST}$ (found value) of the heterocyclic compound may be about 0.300 eV or less. In an embodiment, $\Delta E_{ST}$ (found value) of the heterocyclic compound may be about 0.280 eV or less, or about 0.260 eV or less. Within these

ranges, the width of the emission spectrum of the heterocyclic compound may be narrow, and high-efficiency light emission can be obtained.

A highest occupied molecular orbital (HOMO) energy level and lowest unoccupied molecular orbital (LUMO) energy level of some heterocyclic compounds represented by Formula 1 and compounds of Comparative Examples were evaluated using the Gaussian 09 program with the molecular structure optimization obtained by B3LYP/6-31(d,p)/gas-based TD density functional theory (DFT), and results thereof are shown in Table 1. In addition, the $S_1$ energy level and the $T_1$ energy level of some of the heterocyclic compounds represented by Formula 1 and compounds of Comparative Examples were evaluated by referring to delta SCF-based J. Phys. Chem. A 2021, 125, 10373-10378 method. The evaluation results are shown in Table 1.

Table 1

| | HOMO (eV) | LUMO (eV) | $S_1$ (eV) | $T_1$ (eV) |
|---|---|---|---|---|
| Compound 1 | -4.583 | -1.000 | 2.698 | 2.664 |
| Compound 2 | -4.699 | -1.075 | 2.713 | 2.669 |
| Compound 3 | -4.705 | -1.077 | 2.725 | 2.661 |
| Comparative Example 1 | -4.586 | -1.083 | 2.649 | 2.596 |
| Comparative Example 2 | -4.715 | -1.163 | 2.673 | 2.608 |
| Comparative Example 3 | -4.715 | -1.154 | 2.686 | 2.617 |
| Compound 4 | -4.626 | -1.062 | 2.698 | 2.650 |
| Comparative Example 4 | -4.724 | -1.287 | 2.562 | 2.472 |
| Comparative Example 5 | -4.634 | -1.124 | 2.641 | 2.584 |
| Comparative Example 6 | -4.537 | -1.284 | 2.426 | 2.309 |
| Comparative Example 7 | -4.522 | -1.283 | 2.396 | 2.257 |
| Comparative Example 8 | -4.669 | -1.515 | 2.287 | 2.152 |
| Comparative Example 9 | -4.556 | -1.134 | 2.606 | 2.512 |
| Compound 5 | -4.816 | -1.226 | 2.701 | 2.653 |
| Comparative Example 10 | -4.887 | -1.423 | 2.576 | 2.467 |
| Comparative Example 11 | -4.813 | -1.283 | 2.663 | 2.602 |
| Comparative Example 12 | -4.705 | -1.427 | 2.451 | 2.331 |
| Comparative Example 13 | -4.693 | -1.425 | 2.416 | 2.268 |
| Comparative Example 14 | -4.817 | -1.302 | 2.631 | 2.562 |
| Compound 6 | -4.883 | -1.224 | 2.663 | 2.615 |
| Comparative Example 15 | -4.666 | -1.428 | 2.336 | 2.184 |
| Comparative Example 16 | -4.940 | -1.819 | 2.241 | 2.099 |

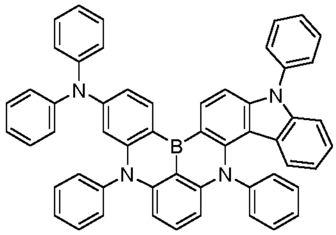

< Compound 1 >

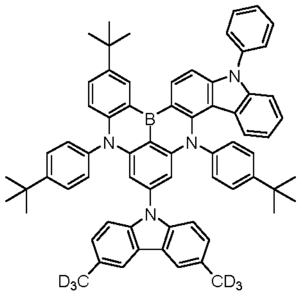

< Compound2 >

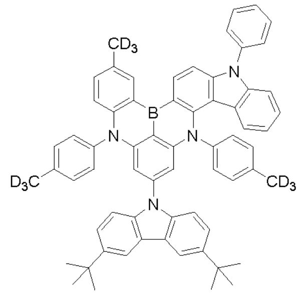

< Compound 3 >

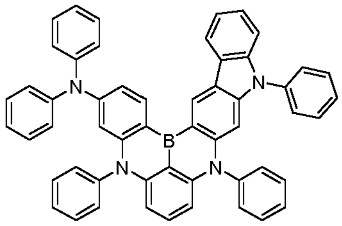
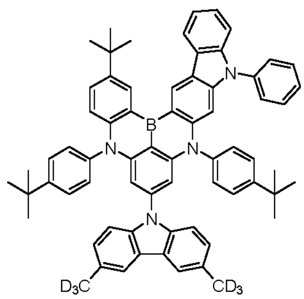
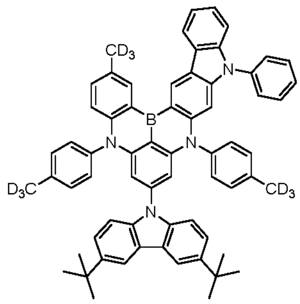

< Comparative Example 1 > < Comparative Example 2 > < Comparative Example 3 >

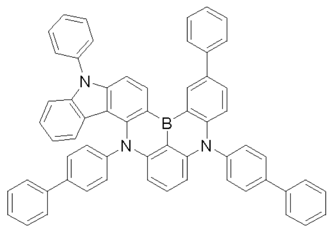

< Compound 4 >

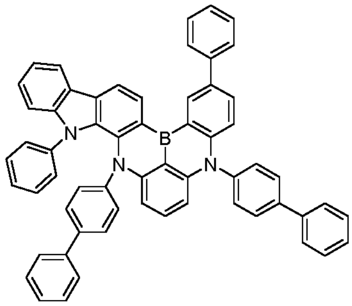
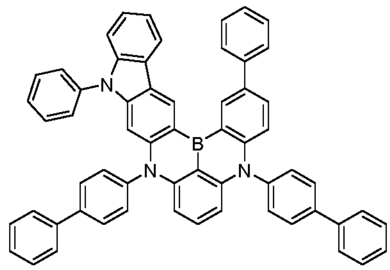
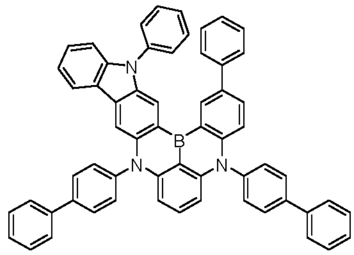

< Comparative Example 4> < Comparative Example 5> < Comparative Example 6>

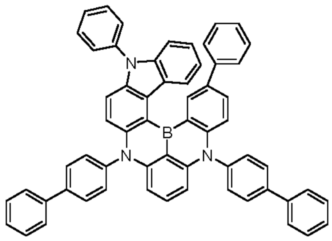
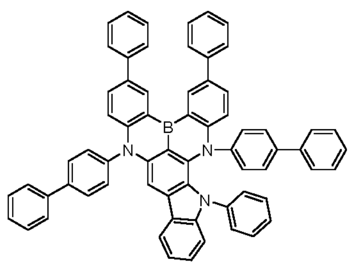
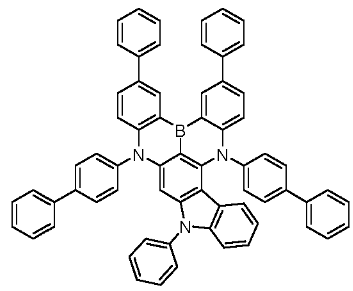

< Comparative Example 7> < Comparative Example 8> < Comparative Example 9>

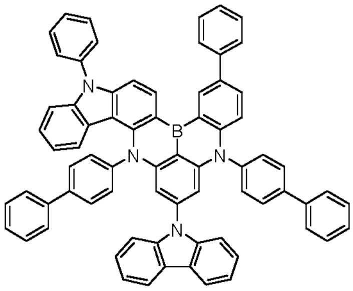

< Compound 5 >

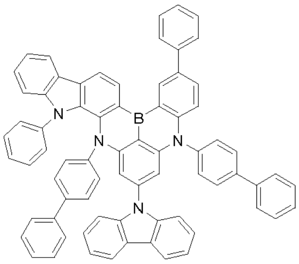

<Comparative Example 10>

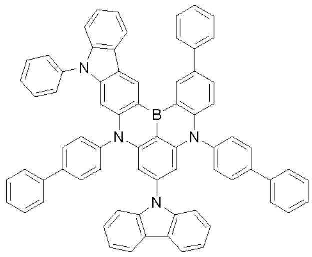

<Comparative Example 11>

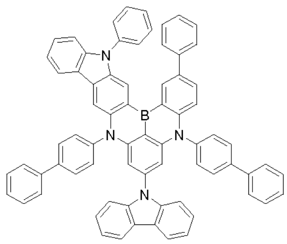

<Comparative Example 12>

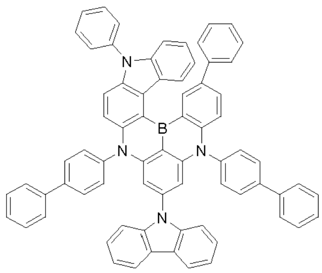

< Comparative Example 13>

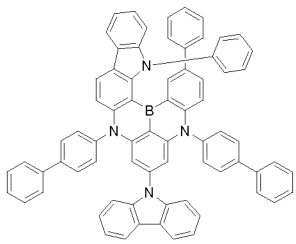

< Comparative Example 14>

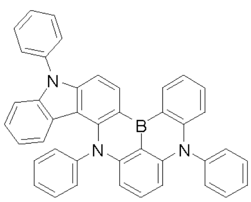

<Compound 6 >

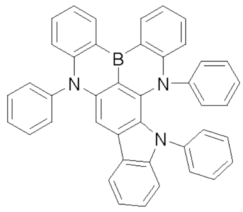

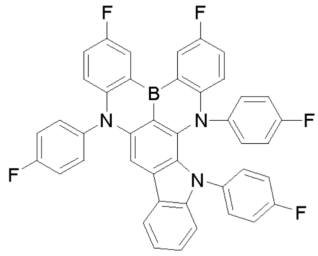

<Comparative Example 15> <Comparative Example 16>

From Table 1, it may be seen that the heterocyclic compound represented by Formula 1 has characteristics suitable for use in an electronic device, for example, for use as a dopant in an emission layer of an organic light-emitting device. Specifically, the heterocyclic compound represented by Formula 1 may have a relatively high lowest singlet excitation energy level compared to the compounds of Comparative Examples 1 to 14, and thus may be suitable for deep blue light emission.

The synthesis method of the heterocyclic compound according to one or more embodiments is not particularly limited and the heterocyclic compound may be synthesized according to a known synthesis method. In particular, it may be synthesized according to or in view of the method described in the Examples. For example, in the method described in the Examples, the heterocyclic compound according to one or more embodiments may be synthesized through modifications such as changing raw materials and reaction conditions, adding or excluding some processes, or appropriately combining with other known synthesis methods.

The method of identifying a structure of the heterocyclic compound according to one or more embodiments is not particularly limited. The heterocyclic compound containing nitrogen according to one or more embodiments may be identified by a known method, for example, NMR or LC-MS.

Description of FIG. 1

FIG. 1 is a schematic view of an organic light-emitting device 10 according to an exemplary embodiment. Hereinafter a structure and a method of manufacturing the organic light-emitting device 10, according to an embodiment, will be described with reference to FIG. 1.

In FIG. 1, an organic light-emitting device 10 includes a first electrode 11, a second electrode 19 facing the first electrode 11, and an organic layer 10A between the first electrode 11 and the second electrode 19.

In FIG. 1, the organic layer 10A includes an emission layer 15, a hole transport region 12 is between the first electrode 11 and an emission layer 15, and an electron transport region 17 is between the emission layer 15 and the second electrode 19.

A substrate may be additionally disposed under the first electrode 11 or on the second electrode 19. The substrate may be a conventional substrate used in organic light-emitting devices, e.g., a glass substrate or a transparent plastic substrate, each having excellent mechanical strength, thermal stability, transparency, surface smoothness, ease of handling, and water repellency.

First electrode 11

The first electrode 11 may be produced by depositing or sputtering, onto the substrate, a material for forming the first electrode 11. The first electrode 11 may be an anode. The material for forming the first electrode 11 may be materials with a high work function for easy hole injection.

The first electrode 11 may be a reflective electrode, a semi-transmissive electrode, or a transmissive electrode. When the first electrode 110 is a transmissive electrode, a material for forming the first electrode 110 may be indium tin oxide (ITO), indium zinc oxide (IZO), tin oxide ($SnO_2$), zinc oxide (ZnO), and any combinations thereof, but embodiments are not limited thereto. In some embodiments, when the first electrode 110 is a semi-transmissive electrode or a reflective electrode, as a material for forming the first electrode 110, at least one of magnesium (Mg), silver (Ag), aluminum (Al), aluminum-lithium (Al-Li), calcium (Ca), magnesium-indium (Mg-In), magnesium-silver (Mg-Ag), or any combination thereof may be used, but embodiments are not limited thereto.

The first electrode 11 may have a single-layered structure or a multi-layered structure including a plurality of layers.

Emission layer 15

The emission layer 15 may include a heterocyclic compound of Formula I.

A thickness of the emission layer may be in a range of about 100 Å to about 1,000 Å, for example, about 200 Å to about 600 Å. When the thickness of the emission layer is within these ranges, excellent light-emission characteristics may be obtained without a substantial increase in driving voltage.

First Embodiment - Descriptions of FIG. 4A

In the First Embodiment, the heterocyclic compound may be a fluorescence emitter. According to the First Embodiment, the emission layer may further include a host (hereinafter, referred to as 'Host A', and Host A may not be identical to the heterocyclic compound). Host A may be understood by referring to the description of the host material provided herein, but embodiments are not limited thereto. Host A may be a fluorescent host.

A general energy transfer of the Example will be described with reference to FIG. 4A as follows.

Singlet excitons may be produced from Host A in the emission layer, and singlet excitons produced from Host A may be transferred to a fluorescence emitter through Förster energy transfer (FRET).

A ratio of singlet excitons produced from Host A may be 25 %, and thus, 75 % of triplet excitons produced from Host A may be fused to one another to be converted into singlet excitons. Thus, efficiency of the organic light-emitting device may be further improved. That is, efficiency of an organic light-emitting device may be further improved by using a triplet-triplet fusion mechanism.

According to the First Embodiment, a ratio of emission components emitted from the heterocyclic compound to the total emission components emitted from the emission layer may be 80 % or greater, for example, 90 % or greater. In some embodiments, a ratio of emission components emitted from the heterocyclic compound may be 95 % or greater to the total emission components emitted from the emission layer.

The heterocyclic compound may emit fluorescence, and the host may not emit light.

In the First Embodiment, when the emission layer further includes Host A, in addition to the heterocyclic compound, an amount of the heterocyclic compound may be 50 parts by weight or less, e.g., 30 parts by weight or less, based on 100 parts by weight of the emission layer, and an amount of Host A in the emission layer may be 50 parts by weight or greater, e.g., 70 parts by weight or greater, based on 100 parts by weight of the emission layer, but embodiments are not limited thereto.

In the First Embodiment, when the emission layer further includes Host A, in addition to the heterocyclic compound, Host A and the heterocyclic compound may satisfy Condition A:

Condition A

$$E(H_A)_{S1} > E_{S1}$$

wherein, in Condition A,

$E(H_A)_{S1}$ indicates a lowest excited singlet energy level of Host A, and

$E_{S1}$ indicates a lowest excited singlet energy level of the heterocyclic compound.

Here, $E(H_A)_{S1}$ and $E_{S1}$ may be evaluated using the DFT method of the Gaussian program, which is structure-optimized at the B3LYP/6-31G(d,p) level.

Second Embodiment - Descriptions of FIG. 4B

In the Second Embodiment, the heterocyclic compound may be a delayed fluorescence emitter. According to the Second Embodiment, the emission layer may further include a host (hereinafter, referred to as 'Host B', and Host B may not be identical to the heterocyclic compound). Host B may be understood by referring to the description of the host material provided herein, but embodiments are not limited thereto.

A general energy transfer of the Second Embodiment will be described with reference to FIG. 4B as follows.

25 % of singlet excitons produced from Host B in the emission layer may be transferred to a delayed fluorescence emitter through FRET. In addition, 75 % of triplet excitons produced from Host B in the emission layer may be transferred to a delayed fluorescence emitter through Dexter energy transfer. Energy transferred to a triplet state of a delayed fluorescence emitter may undergo RISC to a singlet state. Accordingly, by transferring all the singlet excitons and triplet excitons generated in the emission layer to the heterocyclic compound, an organic light-emitting device having improved

efficiency can be obtained.

According to the Second Embodiment, a ratio of emission components emitted from the heterocyclic compound to the total emission components emitted from the emission layer may be 80 % or greater, for example, 90 % or greater. In some embodiments, a ratio of emission components emitted from the heterocyclic compound may be 95 % or greater to the total emission components emitted from the emission layer.

Here, the heterocyclic compound may emit fluorescence and/or delayed fluorescence, and the emission components of the heterocyclic compound may be a total of prompt emission components of the heterocyclic compound and delayed fluorescence components by RISC of the heterocyclic compound. In addition, Host B may not emit light.

In the Second Embodiment, when the emission layer further includes Host B, in addition to the heterocyclic compound, an amount of the heterocyclic compound may be 50 parts by weight or less, e.g., 30 parts by weight or less, based on 100 parts by weight of the emission layer, and an amount of Host B in the emission layer may be 50 parts by weight or greater, e.g., 70 parts by weight or greater, based on 100 parts by weight of the emission layer, but embodiments are not limited thereto.

In the Second Embodiment, when the emission layer further includes Host B, in addition to the heterocyclic compound, Host B and the heterocyclic compound may satisfy Condition B:

Condition B

$$E(H_B)_{S1} > E_{S1}$$

wherein, in Condition B,
$E(H_B)_{S1}$ indicates a lowest excited singlet energy level of Host B, and
$E_{S1}$ indicates a lowest excited singlet energy level of the heterocyclic compound.

Here, $E(H_B)_{S1}$ and $E_{S1}$ may be evaluated using the DFT method of the Gaussian program, which is structure-optimized at the B3LYP/6-31G(d,p) level.

Third Embodiment and Fourth Embodiment

Third Embodiment - Descriptions of FIG. 4C

In the Third Embodiment, the heterocyclic compound may be used as a fluorescence emitter, and the emission layer may include a sensitizer, e.g., a delayed fluorescence sensitizer. In the Third Embodiment, the emission layer may further include a host (hereinafter, the host may be referred to as 'Host C', and Host C may not be identical to the heterocyclic compound and the sensitizer) and a sensitizer (hereinafter, the sensitizer may be referred to as 'Sensitizer A', and Sensitizer A may not be identical to Host C and the heterocyclic compound). Host C and Sensitizer A may respectively be understood by referring to the description of the host material and the sensitizer material provided herein, but embodiments are not limited thereto.

In the Third Embodiment, a ratio of emission components of the heterocyclic compound may be about 80 % or greater, for example, 90 % or greater (or for example, 95 % or greater) to the total emission components emitted from the emission layer. For example, the heterocyclic compound may emit fluorescence. In addition, Host C and Sensitizer A may not each emit light.

A general energy transfer of the Third Embodiment will be described with reference to FIG. 4C as follows.

Singlet and triplet excitons may be produced from Host C in the emission layer, and singlet and triplet excitons produced from Host C may be transferred to Sensitizer A and then to the heterocyclic compound through FRET. 25 % of singlet excitons produced from Host C may be transferred to Sensitizer A through FRET, and energy of 75 % of triplet excitons produced from Host C may be transferred to singlet and triplet states of Sensitizer A. Energy transferred to a triplet state of Sensitizer A may undergo RISC to a singlet state, and then, singlet energy of Sensitizer A may be transferred to the heterocyclic compound through FRET.

Accordingly, by transferring all the singlet excitons and triplet excitons generated in the emission layer to the dopant, an organic light-emitting device having improved efficiency can be obtained. In addition, since an organic light-emitting device can be obtained with significantly reduced energy loss, the lifespan characteristics of the organic light-emitting device can be improved.

In the Third Embodiment, when the emission layer further includes Host C and Sensitizer A, in addition to the heterocyclic compound, Host C and Sensitizer A may satisfy Condition C-1 and/or C-2:

Condition C-1

$$S_1(H_C) \geq S_1(S_A)$$

Condition C-2

$$S_1(S_A) \geq S_1(HC)$$

wherein, in Conditions C-1 and C-2,

$S_1(H_C)$ indicates a lowest excited singlet energy level of Host C,
$S_1(S_A)$ indicates a lowest excited singlet energy level of Sensitizer A, and
$S_1(HC)$ indicates a lowest excited singlet energy level of the heterocyclic compound.

$S_1(Hc)$, $S_1(S_A)$, and $S_1(HC)$ may be evaluated using the DFT method of the Gaussian program, which is structure-optimized at the B3LYP/6-31G(d,p) level.

When Host C, Sensitizer A, and the heterocyclic compound satisfy Condition C-1 and/or C-2, FRET from Sensitizer A to the heterocyclic compound may be facilitated, and accordingly, the organic light-emitting device may have improved luminescence efficiency.

Fourth Embodiment - Descriptions of FIG. 4D

In the Fourth Embodiment, the heterocyclic compound may be used as a fluorescence emitter, and the emission layer may include a sensitizer, e.g., a phosphorescence sensitizer. In the Fourth Embodiment, the emission layer may further include a host (hereinafter, the host may be referred to as 'Host D', and Host D may not be identical to the heterocyclic compound and the sensitizer) and a sensitizer (hereinafter, the sensitizer may be referred to as 'Sensitizer B', and Sensitizer B may not be identical to Host D and the heterocyclic compound). Host D and Sensitizer B may respectively be understood by referring to the description of the host material and the sensitizer material provided herein, but embodiments are not limited thereto.

In the Fourth Embodiment, a ratio of emission components of the heterocyclic compound may be about 80 % or greater, for example, about 90 % or greater (or for example, about 95 % or greater) to the total emission components emitted from the emission layer. For example, the heterocyclic compound may emit fluorescence. In addition, Host D and Sensitizer B may not each emit light.

A general energy transfer of the Fourth Embodiment will be described with reference to FIG. 4D as follows.

75 % of triplet excitons produced from Host D in the emission layer may be transferred to Sensitizer B through Dexter energy transfer, and energy of 25 % of singlet excitons produced from Host D may be transferred to singlet and triplet states of Sensitizer B. Energy transferred to a singlet state of Sensitizer B may undergo ISC to a triplet state, and then, triplet energy of Sensitizer B may be transferred to the heterocyclic compound through FRET.

Accordingly, by transferring all the singlet excitons and triplet excitons generated in the emission layer to the dopant, an organic light-emitting device having improved efficiency can be obtained. In addition, since an organic light-emitting device can be obtained with significantly reduced energy loss, the lifespan characteristics of the organic light-emitting device can be improved.

In the Third Embodiment, when the emission layer further includes Host D and Sensitizer B, in addition to the heterocyclic compound, Host D and Sensitizer B may satisfy Condition D-1 and/or D-2:

Condition D-1

$$T_1(H_D) \geq T_1(S_B)$$

Condition D-2

$$T_1(S_B) \geq S_1(HC)$$

wherein, in Conditions D-1 and D-2,

$T_1(H_D)$ indicates a lowest excited triplet energy level of Host D,
$T_1(S_B)$ indicates a lowest excited triplet energy level of Sensitizer B, and
$S_1(HC)$ indicates a lowest excited singlet energy level of the heterocyclic compound.

$T_1(H_D)$, $T_1(S_B)$, and $S_1(HC)$ may be evaluated using the DFT method of the Gaussian program, which is structure-optimized at the B3LYP/6-31G(d,p) level.

When Host D, Sensitizer B, and the heterocyclic compound satisfy Condition D-1 and/or D-2, FRET from Sensitizer B to the heterocyclic compound may be facilitated, and accordingly, the organic light-emitting device may have improved luminescence efficiency.

In the Third Embodiment and the Fourth Embodiment, an amount of the sensitizer in the emission layer may be in a range of about 5 percent by weight (wt%) to about 50 wt%, or for example, about 10 wt% to about 30 wt%. When the content is within this range, energy transfer may effectively occur in the emission layer. Thus, the organic light-emitting device may have high efficiency and long lifespan.

In the Third Embodiment and the Fourth Embodiment, an amount of the heterocyclic compound in the emission layer may be in a range of about 0.01 wt% to about 15 wt%, or for example, about 0.05 wt% to about 3 wt%, but embodiments are not limited thereto.

In the Third Embodiment and the Fourth Embodiment, the sensitizer and the heterocyclic compound may further satisfy Condition 5:

Condition 5

$$0\ \mu s < T_{decay}(HC) < 5\ \mu s$$

wherein, in Condition 5,
$T_{decay}(HC)$ indicates a decay time of the heterocyclic compound.

The decay time of the heterocyclic compound was measured from a time-resolved photoluminescence (TRPL) spectrum at room temperature of a film (hereinafter, referred to as "Film (HC)") having a thickness of 40 nm formed by vacuum-depositing the host and the heterocyclic compound included in the emission layer on a quartz substrate at a weight ratio of 90:10 at a vacuum pressure of $1.33 \times 10^{-5}$ Pa ($10^{-7}$ torr).

Fifth Embodiment - Descriptions of FIG. 5E

In the Fifth Embodiment, the heterocyclic compound may be used as a delayed fluorescence emitter, and the emission layer may include a sensitizer, e.g., a delayed fluorescence sensitizer. In the Fifth Embodiment, the emission layer may further include a host (hereinafter, the host may be referred to as 'Host E', and Host E may not be identical to the heterocyclic compound and the sensitizer) and a sensitizer (hereinafter, the sensitizer may be referred to as 'Sensitizer C', and Sensitizer C may not be identical to Host E and the heterocyclic compound). Host E and Sensitizer C may respectively be understood by referring to the description of the host material and the sensitizer material provided herein, but embodiments are not limited thereto.

In the Fifth Embodiment, a ratio of emission components of the heterocyclic compound may be about 80 % or greater, for example, about 90 % or greater (or for example, about 95 % or greater) to the total emission components emitted from the emission layer. In some embodiments, the heterocyclic compound may emit fluorescence and/or delayed fluorescence. In addition, Host E and Sensitizer C may not each emit light.

Here, the heterocyclic compound may emit fluorescence and/or delayed fluorescence, and the emission components of the heterocyclic compound may be a total of prompt emission components of the heterocyclic compound and delayed fluorescence components by RISC of the heterocyclic compound.

The general energy transfer of the Fifth Embodiment will be described with reference to FIG. 4E.

25 % of singlet excitons produced from Host E in the emission layer may be transferred to a singlet state of Sensitizer C through FRET, and energy of 75 % of triplet excitons produced from Host E may be transferred to a triplet state of Sensitizer C, and then singlet energy of Sensitizer C may be transferred to the heterocyclic compound through FRET. Subsequently, the triplet energy of Sensitizer C may be transferred to the heterocyclic compound through Dexter energy transfer. Energy transferred to a triplet state of Sensitizer C may undergo RISC to a singlet state. Further, in a case of Sensitizer C, energy of triplet excitons produced from Sensitizer C may undergo reverse transfer to Host E and then to the heterocyclic compound, thus emitting by reverse intersystem transfer.

Accordingly, by transferring all the singlet excitons and triplet excitons generated in the emission layer to the dopant, an organic light-emitting device having improved efficiency can be obtained. In addition, since an organic light-emitting device can be obtained with significantly reduced energy loss, the lifespan characteristics of the organic light-emitting device can be improved.

In the Fifth Embodiment, when the emission layer further includes Host E and Sensitizer C, in addition to the heterocyclic compound, Host E and Sensitizer C may satisfy Condition E-1, E-2, and/or E-3:

Condition E-1

$$S_1(H_E) \geq S_1(S_C)$$

Condition E-2

$$S_1(S_C) \geq S_1(HC)$$

Condition E-3

$$T_1(S_C) \geq T_1(HC)$$

wherein, in Conditions E-1, E-2, and E-3,

$S_1(H_E)$ indicates a lowest excited singlet energy level of Host E,
$S_1(S_C)$ indicates a lowest excited singlet energy level of Sensitizer C,
$S_1(HC)$ indicates a lowest excited singlet energy level of the heterocyclic compound,
$T_1(S_C)$ indicates a lowest excited triplet energy level of Sensitizer C, and
$T_1(HC)$ indicates a lowest excited triplet energy level of the heterocyclic compound.

$S_1(H_E)$, $S_1(S_C)$, $S_1(HC)$, $T_1(S_C)$, and $T_1(HC)$ may be evaluated using the DFT method of the Gaussian program, which is structure-optimized at the B3LYP/6-31G(d,p) level.

When Host E, Sensitizer C, and the heterocyclic compound satisfy Condition E-1, E-2, and/or E-3, Dexter transfer FRET from Sensitizer C to the heterocyclic compound may be facilitated, and accordingly, the organic light-emitting device may have improved luminescence efficiency.

In the Fifth Embodiment, an amount of Sensitizer C in the emission layer may be in a range of about 5 wt% to about 50 wt%, or for example, about 10 wt% to about 30 wt%. When the content is within this range, energy transfer may effectively occur in the emission layer. Thus, the organic light-emitting device may have high efficiency and long lifespan.

In the Fifth Embodiment, an amount of the heterocyclic compound in the emission layer may be in a range of about 0.01 wt% to about 15 wt%, or for example, about 0.05 wt% to about 3 wt%, but embodiments are not limited thereto.

[Host in emission layer 15]

The host may not include a metal atom.

In one or more embodiments, the host may include one kind of host. When the host includes one host, the one host may be a bipolar host, an electron-transporting host, and a hole-transporting host, which will be described later.

In one or more embodiments, the host may include a mixture of two or more different hosts. For example, the host may be a mixture of an electron-transporting host and a hole-transporting host, a mixture of two types of electron-transporting hosts different from each other, or a mixture of two types of hole-transporting hosts different from each other. The electron-transporting host and the hole-transporting host may be understood by referring to the related description to be presented later.

In one or more embodiments, the host may include an electron-transporting host including at least one electron-transporting moiety and a hole-transporting host that is free of an electron-transporting moiety.

The electron-transporting moiety used herein may be a cyano group, a $\pi$ electron-deficient nitrogen-containing cyclic group, and a group represented by one of the following Formulae:

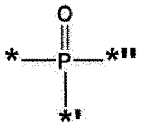 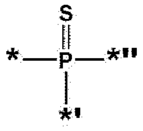 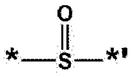 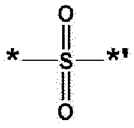

wherein, in the moieties shown above, *, *', and *" may each indicate a binding site to an adjacent atom.

In one or more embodiments, the electron-transporting host of the emission layer 15 may include at least one of a cyano group, a π electron-deficient nitrogen-containing cyclic group, or any combination thereof.

In one or more embodiments, the electron-transporting host in the emission layer 15 may include at least one cyano group.

In one or more embodiments, the electron-transporting host in the emission layer 15 may include at least one cyano group, at least one π electron deficient nitrogen-containing cyclic group, or any combination thereof.

In one or more embodiments, the host may include an electron-transporting host and a hole-transporting host, wherein the electron-transporting host may include at least one π electron-deficient nitrogen-free cyclic group and at least one electron-transporting moiety, and the hole-transporting host may include at least one π electron-deficient nitrogen-free cyclic group and may not include an electron-transporting moiety.

The term "π electron-deficient nitrogen-containing cyclic group" used herein refers to a cyclic group having at least one *-N=*' moiety, and for example, may be an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, and an azacarbazole group; and a condensed cyclic group in which two or more π electron- efficient nitrogen-containing cyclic groups are condensed with each other.

Meanwhile, the π electron-deficient nitrogen-free cyclic group may be a benzene group, a heptalene group, an indene group, a naphthalene group, an azulene group, an indacene group, an acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a pentacene group, a rubicene group, a corogen group, an ovalene group, a pyrrole group, an isoindole group, an indole group, a furan group, a thiophene group, a benzofuran group, a benzothiophene group, a benzocarbazole group, a dibenzocarbazole group, a dibenzofuran group, a dibenzothiophene group, a dibenzothiophene sulfone group, a carbazole group, a dibenzosilole group, an indenocarbazole group, an indolocarbazole group, a benzofurocarbazole group, a benzothienocarbazole group, a triindolobenzene group, and a condensed cyclic group of two or more π electron-deficient nitrogen-free cyclic groups, but embodiments are not limited thereto.

In one or more embodiments, the electron-transporting host may be at least one compound represented by Formula E-1, and the hole-transporting host may be a compound represented by Formula H-1, but embodiments are not limited thereto:

Formula E-1 $[Ar_{301}]_{xb11}$-$[(L_{301})_{xb1}$-$R_{301}]$xb21

wherein, in Formula E-1,

$Ar_{301}$ may be a substituted or unsubstituted $C_5$-$C_{60}$ carbocyclic group or a substituted or unsubstituted $C_1$-$C_{60}$ heterocyclic group,

xb11 may be 1, 2, or 3,

$L_{301}$ may each independently be a single bond, groups represented by one of following Formulae, a substituted or unsubstituted $C_5$-$C_{60}$ carbocyclic group, and a substituted or unsubstituted $C_1$-$C_{60}$ heterocyclic group, wherein in the following Formulae, *, *', and *" may each indicate a binding site to an adjacent atom,

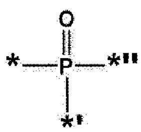 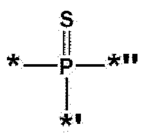 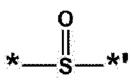 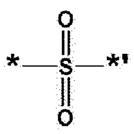

xb1 may be an integer from 1 to 5,

$R_{301}$ may be hydrogen, deuterium, -F, -Cl, -Br, -I, a hydroxyl group, a cyano group, a nitro group, an amidino group, a hydrazino group, a hydrazono group, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent aromatic condensed polycyclic group, a substituted or unsubstituted monovalent aromatic condensed heteropolycyclic group, a substituted or unsubstituted monovalent non-aromatic condensed polycyclic group, a substituted or unsubstituted monovalent non-aromatic condensed heteropolycyclic group, $-Si(Q_{301})(Q_{302})(Q_{303})$, $-N(Q_{301})(Q_{302})$, $-B(Q_{301})(Q_{302})$, - $C(=O)(Q_{301})$, $-S(=O)_2(Q_{301})$, $-S(=O)(Q_{301})$, $-P(=O)(Q_{301})(Q_{302})$, or - $P(=S)(Q_{301})(Q_{302})$,

xb21 may be an integer from 1 to 5,

wherein $Q_{301}$ to $Q_{303}$ may each independently be a $C_1$-$C_{10}$ alkyl group, a $C_1$-$C_{10}$ alkoxy group, a phenyl group, a biphenyl group, a terphenyl group, or a naphthyl group, and

at least one of Condition H-1 to Condition H-3 is satisfied:

Condition H-1

wherein, at least one of $Ar_{301}$, $L_{301}$, and $R_{301}$ in Formula E-1 may each independently include a $\pi$ electron-depleted nitrogen-containing cyclic group,

Condition H-2

wherein, in Formula E-1, $L_{301}$ may be a group represented by one of the following Formulae, and

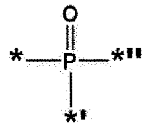
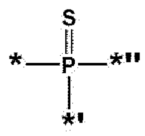
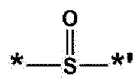
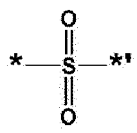

Condition H-3

wherein, in Formula E-1, $R_{301}$ may be a cyano group, $-S(=O)_2(Q_{301})$, - $S(=O)(Q_{301})$, $-P(=O)(Q_{301})(Q_{302})$, or $-P(=S)(Q_{301})(Q_{302})$.

In one or more embodiments, the hole-transporting host may be a compound represented by Formula H-1:

$$Ar_{401}-(L_{401})_{xd1}-(Ar_{402})_{xd11}$$

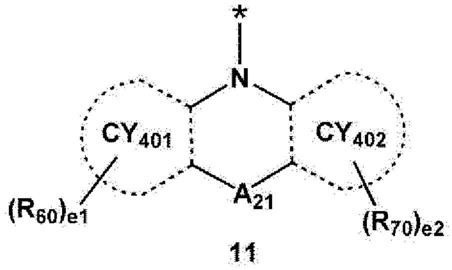

11

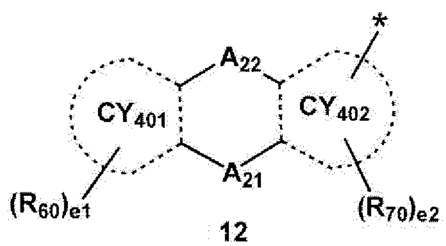

12

wherein, in Formulae H-1, 11, and 12,

$L_{401}$ may be:

a single bond; or

a benzene group, a heptalene group, an indene group, a naphthalene group, an azulene group, an indacene group, an acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a pentacene group, a rubicene group, a corogen group, an ovalene group, a pyrrole group, an

isoindole group, an indole group, a furan group, a thiophene group, a benzofuran group, a benzothiophene group, a benzocarbazole group, a dibenzocarbazole group, a dibenzofuran group, a dibenzothiophene group, a dibenzothiophene sulfone group, a carbazole group, a dibenzosilole group, an indenocarbazole group, an indolocarbazole group, a benzofurocarbazole group, a benzothienocarbazole group, and a triindolobenzene group, each unsubstituted or substituted with at least one deuterium, a $C_1$-$C_{10}$ alkyl group, a $C_1$-$C_{10}$ alkoxy group, a phenyl group, a naphthyl group, a fluorenyl group, a carbazolyl group, a dibenzofuranyl group, a dibenzothiophenyl group, a triphenylenyl group, a biphenyl group, a terphenyl group, a tetraphenyl group, -Si($Q_{401}$)($Q_{402}$)($Q_{403}$), or any combination thereof,

xd1 may be an integer from 1 to 10; and when xd1 is 2 or greater, at least two $L_{401}$ groups may be identical to or different from each other,

$Ar_{401}$ may be groups represented by Formulae 11 or 12,

$Ar_{402}$ may be:

a group represented by Formula 11 or 12, a phenyl group, a naphthyl group, a fluorenyl group, a carbazolyl group, a dibenzofuranyl group, a dibenzothiophenyl group, a biphenyl group, a terphenyl group, or a triphenylenyl group; or

a phenyl group, a naphthyl group, a fluorenyl group, a carbazolyl group, a dibenzofuranyl group, a dibenzothiophenyl group, a biphenyl group, a terphenyl group, and a triphenylenyl group, each substituted with at least one deuterium, a hydroxyl group, an amino group, an amidino group, a hydrazine group, a hydrazone group, a carboxylic acid or a salt thereof, a sulfonic acid or a salt thereof, a phosphoric acid or a salt thereof, a $C_1$-$C_{20}$ alkyl group, a $C_1$-$C_{20}$ alkoxy group, a phenyl group, a naphthyl group, a fluorenyl group, a carbazolyl group, a dibenzofuranyl group, a dibenzothiophenyl group, a biphenyl group, a terphenyl group, or a triphenylenyl group,

$CY_{401}$ and $CY_{402}$ may each independently be a benzene group, a naphthalene group, a fluorene group, a carbazole group, a benzocarbazole group, an indolocarbazole group, a dibenzofuran group, a dibenzothiophene group, a dibenzosilole group, a benzonaphthofuran group, a benzonapthothiophene group, or a benzonaphthosilole group,

$A_{21}$ may be a single bond, O, S, N($R_{51}$), C($R_{51}$)($R_{52}$), or Si($R_{51}$)($R_{52}$),

$A_{22}$ may be a single bond, O, S, N($R_{53}$), C($R_{53}$)($R_{54}$), or Si($R_{53}$)($R_{54}$),

at least one of $A_{21}$ and $A_{22}$ in Formula 12 may not be a single bond,

$R_{51}$ to $R_{54}$, $R_{60}$, and $R_{70}$ may each independently be:

hydrogen, deuterium, a hydroxyl group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, or a $C_1$-$C_{20}$ alkoxy group;

a $C_1$-$C_{20}$ alkyl group or a $C_1$-$C_{20}$ alkoxy group, each substituted with at least one deuterium, a hydroxyl group, an amino group, an amidino group, a hydrazine group, a hydrazone group, a carboxylic acid group or a salt thereof, a sulfonic acid group or a salt thereof, a phosphoric acid group or a salt thereof, a phenyl group, a naphthyl group, a fluorenyl group, a carbazolyl group, a dibenzofuranyl group, a dibenzothiophenyl group, or any combination thereof;

a $\pi$ electron-depleted nitrogen-free cyclic group (e.g., a phenyl group, a naphthyl group, a fluorenyl group, a carbazolyl group, a dibenzofuranyl group, a dibenzothiophenyl group, a biphenyl group, a terphenyl group, and a triphenylenyl group);

a $\pi$ electron-depleted nitrogen-free cyclic group (e.g., a phenyl group, a naphthyl group, a fluorenyl group, a carbazolyl group, a dibenzofuranyl group, a dibenzothiophenyl group, a biphenyl group, a terphenyl group, and a triphenylenyl group) substituted with at least one deuterium, a hydroxyl group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, a fluorenyl group, a carbazolyl group, a dibenzofuranyl group, a dibenzothiophenyl group, or a biphenyl group,

-Si(Q404)(Q405)(Q406),

e1 and e2 may each independently be an integer from 0 to 10,

wherein $Q_{401}$ to $Q_{406}$ may each independently be hydrogen, deuterium, a hydroxyl group, an amino group, an amidino group, a hydrazine group, a hydrazone group, a carboxylic acid group or a salt thereof, a sulfonic acid group or a salt thereof, a phosphoric acid group or a salt thereof, a phenyl group, a naphthyl group, a fluorenyl group, a carbazolyl group, a dibenzofuranyl group, a dibenzothiophenyl group, a biphenyl group, a terphenyl group, or a triphenylenyl group, and

* indicates a binding site to an adjacent atom.

In some embodiments, in Formula E-1, $Ar_{301}$ and $L_{301}$ may each independently be a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, or an azacarbazole group, each unsubstituted or substituted with at least one deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a phenyl group, a biphenyl group, a terphenyl group, a naphthyl group, a cyano group-containing phenyl group, a cyano group-containing biphenyl group, a cyano group-containing terphenyl group, a cyano group-containing naphthyl group, a pyridinyl group, a phenylpyridinyl group, a diphenylpyridinyl group, a biphenylpyridinyl group, a di(biphenyl)pyridinyl group, a pyrazinyl group, a phenylpyrazinyl group, a diphenylpyrazinyl group, a biphenylpyrazinyl group, a di(biphenyl)pyrazinyl group, a pyridazinyl group, a phenylpyridazinyl group, a diphenylpyridazinyl group, a biphenylpyridazinyl group, a di(biphenyl)pyridazinyl group, a pyrimidinyl group, a phenylpyrimidinyl group, a diphenylpyrimidinyl group, a biphenylpyrimidinyl group, a di(biphenyl)pyrimidinyl group, a triazinyl group, a phenyltriazinyl group, a diphenyltriazinyl group, a biphenyltriazinyl group, a di(biphenyl)triazinyl group, - $Si(Q_{31})(Q_{32})(Q_{33})$, $-N(Q_{31})(Q_{32})$, $-B(Q_{31})(Q_{32})$, $-C(=O)(Q_{31})$, $-S(=O)_2(Q_{31})$, - $P(=O)(Q_{31})(Q_{32})$, or any combination thereof,

at least one of $L_{301}$ in the number of xb1 may each independently be an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, or an azacarbazole group, each unsubstituted or substituted with at least one deuterium, -F, -Cl, -Br, -I, a hydroxyl group, a cyano group, a nitro group, an amidino group, a hydrazine group, a hydrazone group, a $C_1$-$C_{20}$ alkyl group, a $C_1$-$C_{20}$ alkoxy group, a phenyl group, a biphenyl group, a terphenyl group, a naphthyl group, a cyano-containing phenyl group, a cyano-containing biphenyl group, a cyano-containing terphenyl group, a cyano-containing naphthyl group, a pyridinyl group, a phenylpyridinyl group, a diphenylpyridinyl group, a biphenylpyridinyl group, a di(biphenyl)pyridinyl group, a pyrazinyl group, a phenylpyrazinyl group, a diphenylpyrazinyl group, a biphenylpyrazinyl group, a di(biphenyl)pyrazinyl group, a pyridazinyl group, a phenylpyridazinyl group, a diphenylpyridazinyl group, a biphenylpyridazinyl group, a di(biphenyl)pyridazinyl group, a pyrimidinyl group, a phenylpyrimidinyl group, a diphenylpyrimidinyl group, a biphenylpyrimidinyl group, a di(biphenyl)pyrimidinyl group, a triazinyl group, a phenyltriazinyl group, a diphenyltriazinyl group, a biphenyltriazinyl group, a di(biphenyl)triazinyl group, $-Si(Q_{31})(Q_{32})(Q_{33})$, $-N(Q_{31})(Q_{32})$, $-B(Q_{31})(Q_{32})$, $-C(=O)(Q_{31})$, $-S(=O)_2(Q_{31})$, - $P(=O)(Q_{31})(Q_{32})$, or any combination thereof, and

$R_{301}$ may be hydrogen, deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a phenyl group, a biphenyl group, a terphenyl group, a tetraphenyl group, a naphthyl group, a cyano group-containing phenyl group, a cyano group-containing biphenyl group, a cyano group-containing terphenyl group, a cyano group-containing tetraphenyl group, a cyano group-containing naphthyl group, a pyridinyl group, a phenylpyridinyl group, a diphenylpyridinyl group, a biphenylpyridinyl group, a di(biphenyl)pyridinyl group, a pyrazinyl group, a phenylpyrazinyl group, a diphenylpyrazinyl group, a biphenylpyrazinyl group, a di(biphenyl)pyrazinyl group, a pyridazinyl group, a phenylpyridazinyl group, a diphenylpyridazinyl group, a biphenylpyridazinyl group, a di(biphenyl)pyridazinyl group, a pyrimidinyl group, a phenylpyrimidinyl group, a diphenylpyrimidinyl group, a biphenylpyrimidinyl group, a di(biphenyl)pyrimidinyl group, a triazinyl group, a phenyltriazinyl group, a diphenyltriazinyl group, a biphenyltriazinyl group, a di(biphenyl)triazinyl group, $-Si(Q_{31})(Q_{32})(Q_{33})$, $-N(Q_{31})(Q_{32})$, $-B(Q_{31})(Q_{32})$, - $C(=O)(Q_{31})$, $-S(=O)_2(Q_{31})$, or $-P(=O)(Q_{31})(Q_{32})$,

wherein $Q_{31}$ to $Q_{33}$ may each independently be a $C_1$-$C_{10}$ alkyl group, a $C_1$-$C_{10}$ alkoxy group, a phenyl group, a biphenyl group, a terphenyl group, or a naphthyl group, but embodiments are not limited thereto.

In one or more embodiments, $Ar_{301}$ may be

a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, or a dibenzothiophene group, each unsubstituted or substituted with at least one deuterium, -F, -Cl, -Br, -I, a hydroxyl group, a cyano group, a nitro group, an amidino group, a hydrazine group, a hydrazone group, a $C_1$-$C_{20}$ alkyl group, a $C_1$-$C_{20}$ alkoxy group, a phenyl group, a biphenyl group, a terphenyl group, a naphthyl group, a cyano-containing phenyl group, a cyano-containing biphenyl group, a cyano-containing terphenyl group, a cyano-containing naphthyl group, a pyridinyl group, a phenylpyridinyl group, a diphenylpyridinyl group, a biphenylpyridinyl group, a di(biphenyl)pyridinyl group, a pyrazinyl group, a phenylpyrazinyl group, a diphenylpyrazinyl group, a biphenylpyrazinyl group, a di(biphenyl)pyrazinyl group, a pyridazinyl group, a phenylpyridazinyl group, a diphenylpyridazinyl group, a biphenylpyridazinyl group, a di(biphenyl)pyridazinyl group, a pyrimidinyl group, a phenylpyrimidinyl group, a diphenylpyrimidinyl group, a biphenylpyrimidinyl group, a di(biphenyl)pyrimidinyl group, a triazinyl group, a phenyltriazinyl group, a diphenyltriazinyl group, a biphenyltriazinyl group, a di(biphenyl)triazinyl group, -Si($Q_{31}$)($Q_{32}$)($Q_{33}$), -N($Q_{31}$)($Q_{32}$), -B($Q_{31}$)($Q_{32}$), -C(=O)($Q_{31}$), -S(=O)$_2$($Q_{31}$), -P(=O)($Q_{31}$)($Q_{32}$), or any combination thereof; or

a group represented by Formulae 5-1 to 5-3 and 6-1 to 6-33, and

$L_{301}$ may be a group represented by Formulae 5-1 to 5-3 and 6-1 to 6-33:

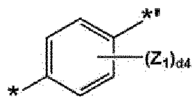
5-1
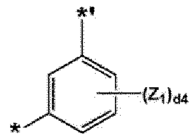
5-2
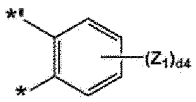
5-3

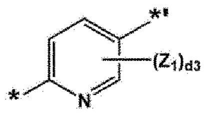
6-1
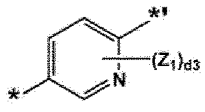
6-2
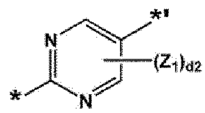
6-3
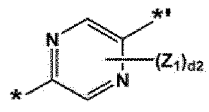
6-4

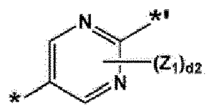
6-5
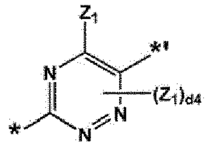
6-6
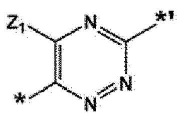
6-7
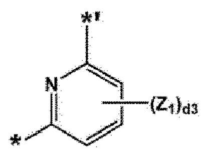
6-8

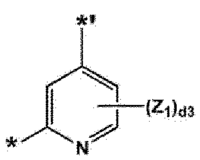
6-9
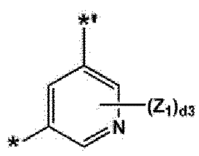
6-10
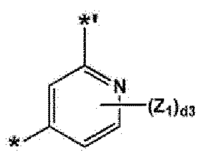
6-11
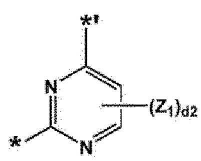
6-12

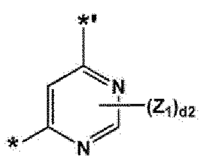
6-13
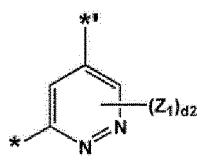
6-14
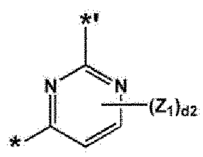
6-15
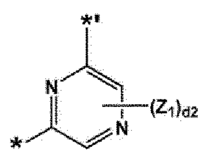
6-16

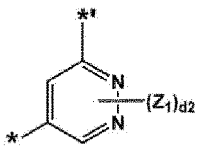
6-17
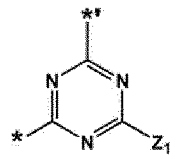
6-18
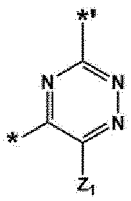
6-19
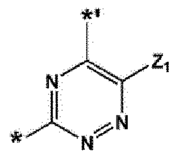
6-20

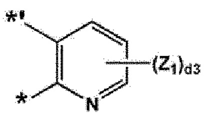
6-21
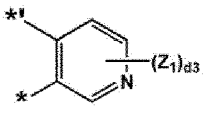
6-22
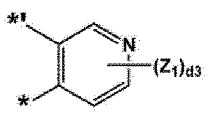
6-23
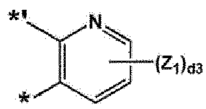
6-24

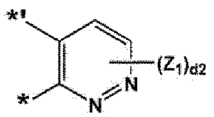
6-25
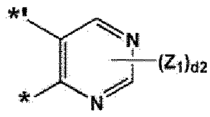
6-26
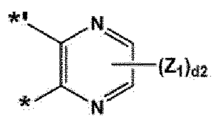
6-27
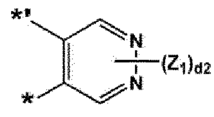
6-28

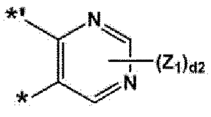
6-29
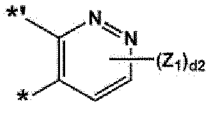
6-30
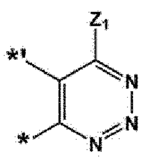
6-31
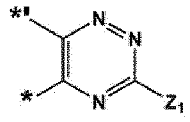
6-32

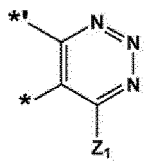
6-33

wherein, in Formulae 5-1 to 5-3 and 6-1 to 6-33,

$Z_1$ may be hydrogen, deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a phenyl group, a biphenyl group, a terphenyl group, a naphthyl group, a cyano group-containing phenyl group, a cyano group-containing biphenyl group, a cyano group-containing terphenyl group, a cyano group-containing naphthyl group, a pyridinyl group, a phenylpyridinyl group, a diphenylpyridinyl group, a biphenylpyridinyl group, a di(biphenyl)pyridinyl group, a pyrazinyl group, a phenylpyrazinyl group, a diphenylpyrazinyl group, a biphenylpyrazinyl group, a di(biphenyl)pyrazinyl group, a pyridazinyl group, a phenylpyridazinyl group, a diphenylpyridazinyl group, a biphenylpyridazinyl group, a di(biphenyl)pyridazinyl group, a pyrimidinyl group, a phenylpyrimidinyl group, a diphenylpyrimidinyl group, a biphenylpyrimidinyl group, a di(biphenyl)pyrimidinyl group, a triazinyl group, a phenyltriazinyl group, a diphenyltriazinyl group, a biphenyltriazinyl group, a di(biphenyl)triazinyl group, -Si($Q_{31}$)($Q_{32}$)($Q_{33}$), -N($Q_{31}$)($Q_{32}$), -B($Q_{31}$)($Q_{32}$), - C(=O)($Q_{31}$), -S(=O)$_2$($Q_{31}$), or -P(=O)($Q_{31}$)($Q_{32}$),

d4 may be 0, 1, 2, 3, or 4,

d3 may be 0, 1, 2, or 3,

d2 may be 0, 1, or 2, and

* and *' each indicate a binding site to an adjacent atom.

$Q_{31}$ to $Q_{33}$ are each the same as described above.

In one or more embodiments, $L_{301}$ may be a group represented by Formulae 5-2, 5-3 and 6-8 to 6-33.

In one or more embodiments, $R_{301}$ may be a cyano group or a group represented by Formula 7-1 to 7-18, and at least one of $Ar_{402}$ in the number of xd11 may be a group represented by Formulae 7-1 to 7-18, but embodiments are not limited thereto:

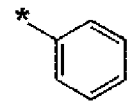
7-1

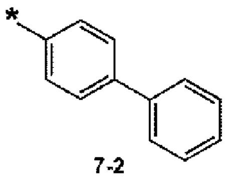
7-2

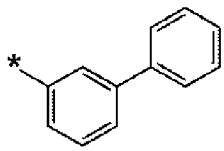
7-3

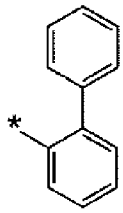
7-4

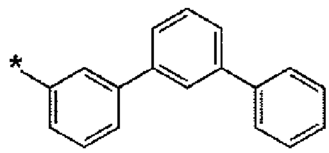
7-5

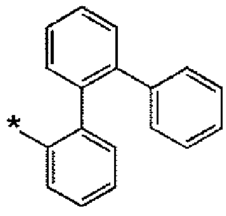
7-6

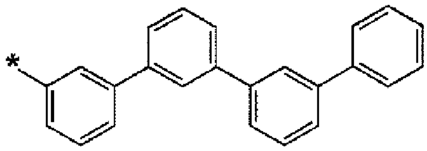
7-7

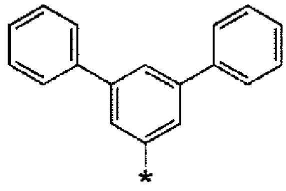
7-8

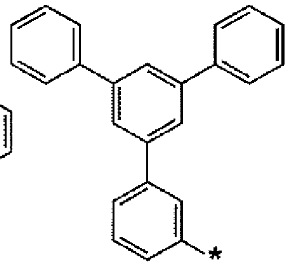
7-9

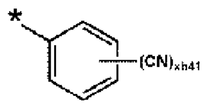
7-10

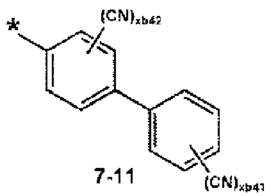
7-11

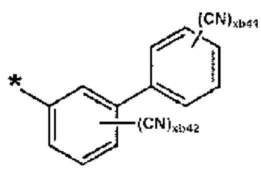
7-12

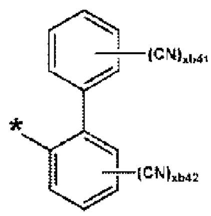
7-13

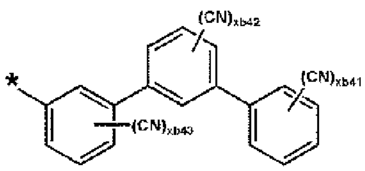
7-14

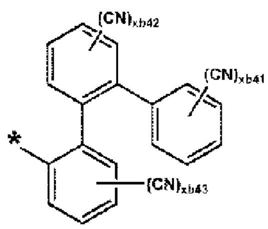
7-15

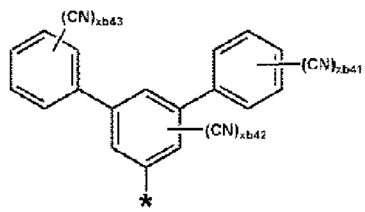
7-16

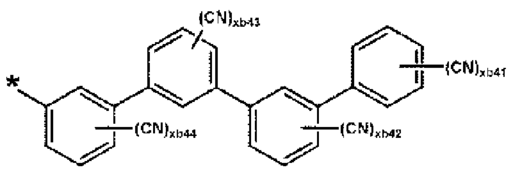
7-17

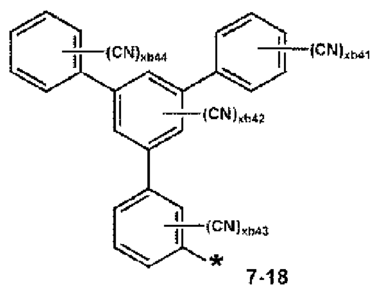
7-18

wherein, in Formulae 7-1 to 7-18,

xb41 to xb44 may each be 0, 1, or 2, provided that xb41 in Formula 7-10 may not be 0, xb41+xb42 in Formulae 7-11 to 7-13 may not be 0, xb41+xb42+xb43 in Formulae 7-14 to 7-16 may not be 0, xb41+xb42+xb43+xb44 in Formulae 7-17 and 7-18 may not be 0, and * indicates a binding site to an adjacent atom.

In Formula E-1, at least two $Ar_{301}$(s) may be identical to or different from each other, and at least two $L_{301}$(s) may be identical to or different from each other. In Formula H-1, at least two $L_{401}$(s) may be identical to or different from

each other, and at least two $Ar_{402}$(s) may be identical to or different from each other.

In an embodiment, the electron-transporting host includes i) at least one of a cyano group, a pyrimidine group, a pyrazine group, a triazine group, or any combination thereof, or ii) a triphenylene group, and the hole-transporting host may include a carbazole group.

In one or more embodiments, the electron-transporting host may include at least one cyano group.

In an embodiment, the host may be a fluorescent host, and the fluorescent host may be represented by, for example, one of Formulae FH-1 to FH-4.

In an embodiment, the fluorescent host may be represented by Formula FH-1:

Formula FH-1

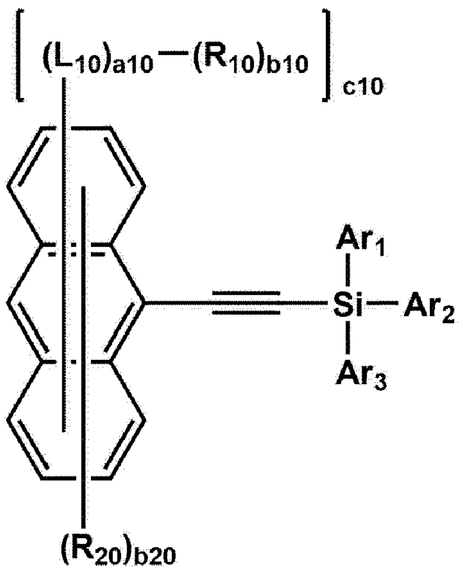

wherein, in Formula FH-1,

$Ar_1$ to $Ar_3$ may each independently be a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, - $N(Q_1)(Q_2)$, $-Si(Q_3)(Q_4)(Q_5)$, $-B(Q_6)(Q_7)$, or $-P(=O)(Q_8)(Q_9)$,

at least one of $Ar_1$ to $Ar_3$ may be a substituted or unsubstituted $C_6$-$C_{60}$ aryl group, a substituted or unsubstituted $C_1$-$C_{60}$ heteroaryl group, a substituted or unsubstituted monovalent non-aromatic condensed polycyclic group, or a substituted or unsubstituted monovalent non-aromatic condensed heteropolycyclic group,

$L_{10}$ may be a substituted or unsubstituted $C_5$-$C_{30}$ carbocyclic group or a substituted or unsubstituted $C_1$-$C_{30}$ heterocyclic group,

a10 may be an integer from 0 to 3, and when a10 is 2 or more, two or more of $L_{10}$(s) may be identical to or different from each other,

$R_{10}$ and $R_{20}$ may each independently be hydrogen, deuterium, -F, -Cl, -Br, -I, $-SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, $-N(Q_1)(Q_2)$,

$-Si(Q_3)(Q_4)(Q_5)$, $-B(Q_6)(Q_7)$, or - $P(=O)(Q_8)(Q_9)$,
b10 and b20 may each independently an integer from 1 to 8,
wherein, when b10 is 2 or more, two or more of $R_{10}$(s) may be identical to or different from each other, and when b20 is 2 or more, two or more of $R_{20}$(s) may be identical to or different from each other,
c10 may be an integer from 1 to 9,
when c10 is 2 or more, two or more of $-[(L_{10})_{a10}-(R_{10})_{b10}]$ may be identical to or different from each other.

In an embodiment, the fluorescent host may be represented by Formula FH-2:

Formula FH-2

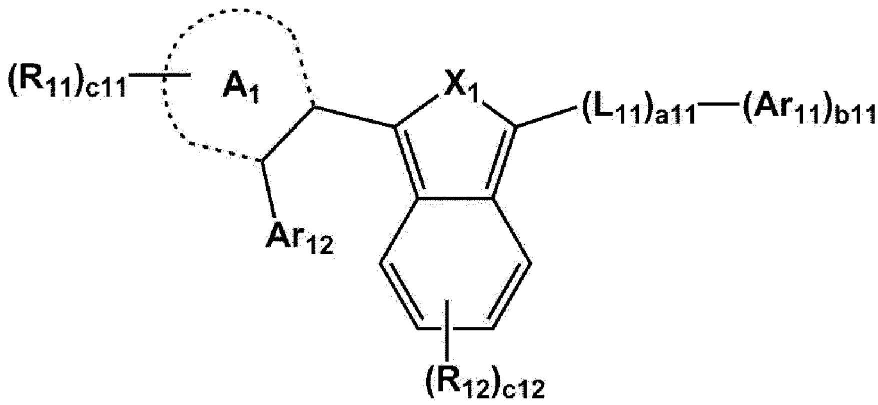

wherein, in Formula FH-2,

$X_1$ may be O or S,
$A_1$ may be a $C_5$-$C_{60}$ carbocyclic group or a $C_1$-$C_{60}$ heterocyclic group,
$L_{11}$ may be a substituted or unsubstituted $C_5$-$C_{60}$ carbocyclic group or a substituted or unsubstituted $C_1$-$C_{60}$ heterocyclic group,
a11 may be an integer from 0 to 3,
$Ar_{11}$ and $Ar_{12}$ may each independently be a $C_6$-$C_{60}$ aryl group, a $C_1$-$C_{60}$ heteroaryl group, a monovalent non-aromatic condensed polycyclic group, or a monovalent non-aromatic condensed heteropolycyclic group, each unsubstituted or substituted with at least one $R_a$,
b11 is an integer from 1 to 5, and
$R_{11}$, $R_{12}$, and $R_a$ may each independently be hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, $-Si(Q_1)(Q_2)(Q_3)$, $-N(Q_4)(Q_5)$, or$-B(Q_6)(Q_7)$,
c11 may be an integer from 1 to 20,
c12 may be an integer from 1 to 4,
when c11 is 2 or more, two neighboring $R_{11}$ may optionally be bonded together to form a substituted or unsubstituted $C_5$-$C_{30}$ carbocyclic group, or a substituted or unsubstituted $C_1$-$C_{30}$heterocarbocyclic group,
when c12 is 2 or more, two neighboring $R_{12}$ may optionally be bonded together to form a substituted or unsubstituted $C_5$-$C_{30}$ carbocyclic group or a substituted or unsubstituted $C_1$-$C_{30}$ heterocyclic group,
$A_1$ and $Ar_{12}$ may optionally be bonded together via a first linking group a single bond, $*-Ar_{31}-*'$, $*-O-*'$, $*-S-*'$, $*-[C(R_{31})(R_{32})]_{k11}-*'$, $*-C(R_{31})=*'$, $*=C(R_{31})-*'$, $*-C(R_{31})=C(R_{32})-*'$, $*-C(=O)-*'$, $*-C(=S)-*'$, $*-C\equiv C-*'$, $*-N(R_{31})-*'$, $*-P(R_{31})-*'$, $*-[Si(R_{31})(R_{32})]_{k11}-*'$, or $*-P(R_{31})(R_{32})-*'$ to form a substituted or unsubstituted $C_5$-$C_{30}$ carbocyclic group or a substituted or unsubstituted $C_1$-$C_{30}$ heterocyclic group,
$Ar_{31}$ may be a $C_5$-$C_{30}$ carbocyclic group,

$R_{31}$ and $R_{32}$ are each the same as described in connection with $R_{11}$, and
k11 may be 1, 2, 3, or 4.

In an embodiment, the fluorescent host may be represented by Formula FH-3:

Formula FH-3

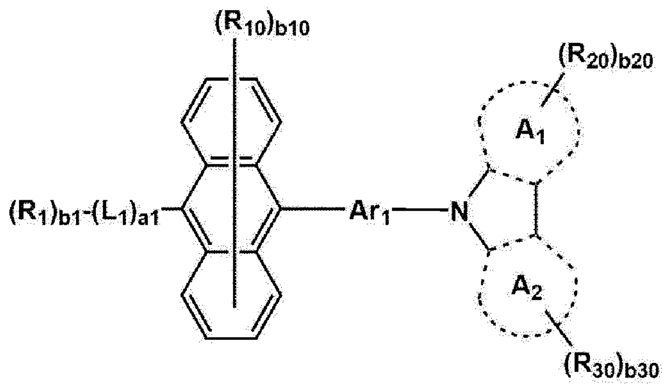

wherein, in Formula FH-3,

$Ar_1$ may be a group represented by Formula 2,

Formula 2

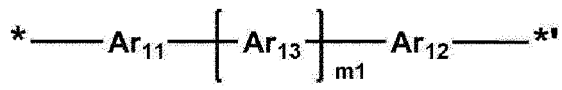

$Ar_1$ may include at least one cyano group,
$A_1$ and $A_2$ may each independently be a $C_5$-$C_{30}$ carbocyclic group or a $C_1$-$C_{30}$ heterocyclic group,
$L_1$ may be a substituted or unsubstituted $C_5$-$C_{30}$ carbocyclic group or a substituted or unsubstituted $C_1$-$C_{30}$ heterocyclic group,
a1 may be 0, 1, 2, or 3,
when a1 is 2 or more, two or more of $L_1$(s) may be identical to or different from each other,
m1 may be 0, 1, 2, or 3,
$Ar_{11}$ may be a group represented by Formula 4, $Ar_{12}$ may be a group represented by Formula 5, and $Ar_{13}$ may be a group represented by Formula 6,

Formula 4

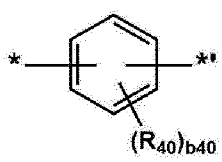

Formula 5 Formula 6

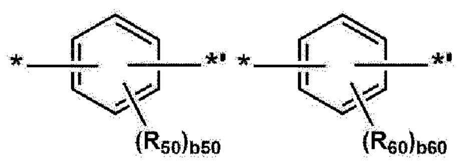

wherein, in these formulae,
$R_1$, $R_{10}$, $R_{20}$, $R_{30}$, $R_{40}$, $R_{50}$, and $R_{60}$ may each independently be hydrogen, deuterium, -F, -Cl, -Br, -I, $-SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio

group, a substituted or unsubstituted $C_1$-$C_{60}$ heteroaryl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, a substituted or unsubstituted monovalent non-aromatic condensed heteropolycyclic group, $-N(Q_1)(Q_2)$, $-Si(Q_3)(Q_4)(Q_5)$, $-B(Q_6)(Q_7)$, or $-P(=O)(Q_8)(Q_9)$,
b1 is an integer from 1 to 5,
when b1 is 2 or more, two or more of $R_1$(s) may be identical to or different from each other,
b10 may be an integer from 1 to 8,
when b10 is 2 or more, two or more of $R_{10}$(s) may be identical to or different from each other,
b20 and b30 may each independently be an integer from 1 to 4,
when b20 is 2 or more, two or more of $R_{20}$ may be identical to or different from each other, and when b30 is 2 or more, two or more of $R_{30}$ may be identical to or different from each other,
b40, b50, and b60 may each independently be an integer from 1 to 4,
when b40 is 2 or more, two or more of $R_{40}$(s) may be identical to or different from each other, when b50 is 2 or more, two or more of $R_{50}$(s) may be identical to or different from each other, and when b60 is 2 or more, two or more of $R_{60}$(s) may be identical to or different from each other,
* and *' each indicate a binding site to a neighboring atom.

In an embodiment, the fluorescent host may be represented by Formula FH-4:

Formula FH-4

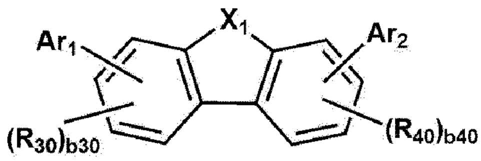

wherein, in Formula FH-4,

$X_1$ may be O or Se,
$Ar_1$ may be a group represented by Formula 1A, and $Ar_2$ may be a group represented by Formula 1B,

Formula 1A     Formula 1B

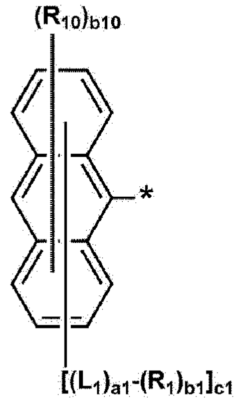

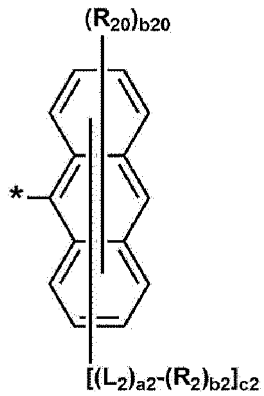

wherein, in these formulae,
$L_1$ and $L_2$ may each independently a substituted or unsubstituted $C_5$-$C_{30}$ carbocyclic group or a substituted or unsubstituted $C_1$-$C_{30}$ heterocyclic group,
a1 and a2 may each independently be an integer from 0 to 3,
wherein when a1 is 2 or more, two or more of $L_1$(s) may be identical to or different from each other, and when a2 is 2 or more, two or more of $L_2$(s) may be identical to or different from each other,
$R_1$, $R_2$, $R_{10}$, $R_{20}$, $R_{30}$, and $R_{40}$ may each independently be hydrogen, deuterium, -F, -Cl, -Br, -I, $-SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubsti-

tuted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, -N($Q_1$)($Q_2$), -Si($Q_3$)($Q_4$)($Q_5$), - B($Q_6$)($Q_7$), or -P(=O)($Q_8$)($Q_9$),

b1 and b2 may each independently be an integer from 1 to 5, wherein when b1 is 2 or more, two or more of $R_1$(s) may be identical to or different from each other, and when b2 is 2 or more, two or more of $R_2$ may be identical to or different from each other,

b10 and b20 may each independently an integer from 1 to 8,

b30 and b40 may each independently an integer from 1 to 3,

c1 and c2 may each independently be an integer from 1 to 8, and

the sum of b10 and c1 may be 9, and the sum of b20 and c2 may be 9.

When the host is a mixture of an electron-transporting host and a hole-transporting host, the weight ratio of the electron-transporting host and the hole-transporting host may be 1: 9 to 9: 1, for example, 2: 8 to 8: 2, for example, 4: 6 to 6: 4, for example, 5: 5. When the weight ratio of the electron-transporting host and the hole-transporting host satisfies these ranges, the hole-and-electron-transporting balance in the emission layer 15 may be made.

[Dopant in emission layer 15]

The dopant includes the heterocyclic compound of Formula I.

[Sensitizer in emission layer 15]

In an embodiment, the sensitizer may be a phosphorescent sensitizer including at least one metal of a first-row transition metal of the Periodic Table of Elements, a second-row transition metal of the Periodic Table of Elements, a third-row transition metal of the Periodic Table of Elements, or any combination thereof.

In an embodiment, the sensitizer may include at least one metal ($M_{11}$) a first-row transition metal of the Periodic Table of Elements, a second-row transition metal of the Periodic Table of Elements, and a third-row transition metal of the Periodic Table of Elements, and an organic ligand ($L_1$), and $L_{11}$ and $M_{11}$ may form 1, 2, 3, or 4 cyclometalated rings.

In an embodiment, the sensitizer may include an organometallic compound represented by Formula 101:

Formula 101 $$M_{11}(L_{11})_{n11}(L_{12})_{n12}$$

wherein, in Formula 101,

$M_{11}$ may be a first-row transition metal of the Periodic Table of Elements, a second-row transition metal of the Periodic Table of Elements, or a third-row transition metal of the Periodic Table of Elements;

$L_{11}$ is a ligand represented by one of Formulae 1-1 to 1-4;

$L_{12}$ is a monodentate ligand or a bidentate ligand;

n11 is 1,

n12 is 0, 1, or 2;

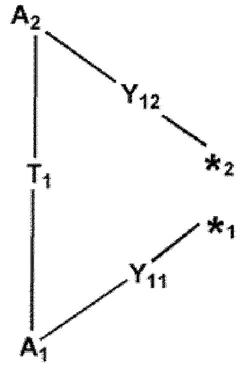

1-1

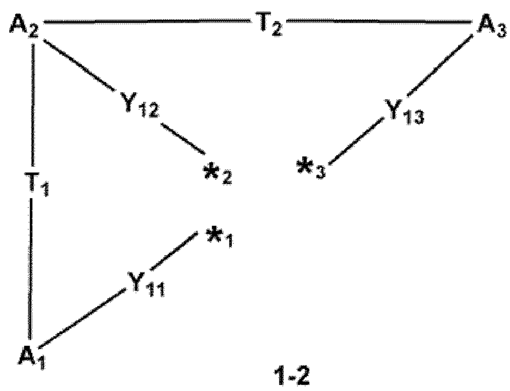

1-2

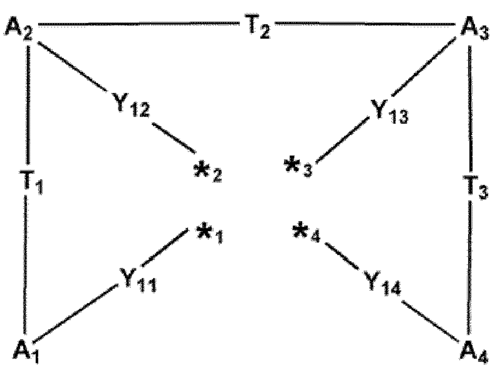

1-3

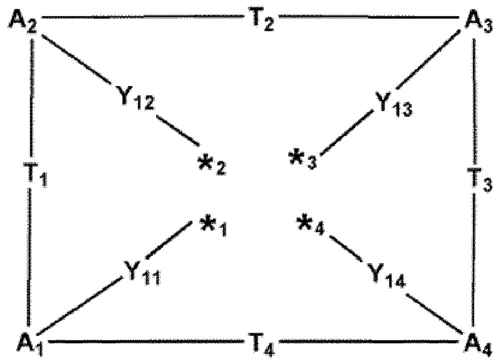

1-4

wherein, in Formulae 1-1 to 1-4,

$A_1$ to $A_4$ may each independently be a substituted or unsubstituted $C_5$-$C_{30}$ carbocyclic group, a substituted or unsubstituted $C_1$-$C_{30}$ heterocyclic group, or a non-cyclic group,

$Y_{11}$ to $Y_{14}$ may each independently be a chemical bond, O, S, $N(R_{91})$, $B(R_{91})$, $P(R_{91})$, or $C(R_{91})(R_{92})$,

$T_1$ to $T_4$ may each independently be a single bond, a double bond, *-$N(R_{93})$-*', *-$B(R_{93})$-*', *-$P(R_{93})$-*', *-$C(R_{93})(R_{94})$-*', *-$Si(R_{93})(R_{94})$-*', *-$Ge(R_{93})(R_{94})$-*', *-S-*', *-Se-*', *-O-*', *-C(=O)-*', *-S(=O)-*', *-$S(=O)_2$-*', *-$C(R_{93})$=*', *=$C(R_{93})$-*', *-$C(R_{93})=C(R_{94})$-*', *-C(=S)-*', or *-C≡C-*',

a substituent of the substituted $C_5$-$C_{30}$ carbocyclic group, a substituent of the substituted $C_1$-$C_{30}$ heterocyclic group, and $R_{91}$ to $R_{94}$ may each independently be hydrogen, deuterium, -F, -Cl, -Br, -I, -$SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent aromatic condensed polycyclic group, a substituted or unsubstituted monovalent aromatic condensed heteropolycyclic group, a substituted or unsubstituted monovalent non-aromatic condensed polycyclic group, a substituted or unsubstituted monovalent non-aromatic condensed heteropolycyclic group, -$Si(Q_1)(Q_2)(Q_3)$, -$Ge(Q_1)(Q_2)(Q_3)$, -$C(Q_1)(Q_2)(Q_3)$, -$B(Q_1)(Q_2)$, -$N(Q_1)(Q_2)$, -$P(Q_1)(Q_2)$, -$C(=O)(Q_1)$, -$S(=O)(Q_1)$, -$S(=O)_2(Q_1)$, - $P(=O)(Q_1)(Q_2)$, and -$P(=S)(Q_1)(Q_2)$, wherein the substituent of the substituted $C_5$-$C_{30}$ carbocyclic group and the substituent of the substituted $C_1$-$C_{30}$ heterocyclic group are not hydrogen,

$*_1$, $*_2$, $*_3$, and $*_4$ each indicate a binding site to $M_{11}$, and

$Q_1$ to $Q_3$ may each independently be hydrogen, deuterium, -F, -Cl, -Br, -I, a hydroxyl group, a cyano group, a nitro group, an amidino group, a hydrazino group, a hydrazono group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$

aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent aromatic condensed polycyclic group, a monovalent aromatic condensed heteropolycyclic group, a monovalent non-aromatic condensed polycyclic group, a monovalent non-aromatic condensed heteropolycyclic group, a $C_1$-$C_{60}$ alkyl group that is substituted with at least one deuterium, -F, a cyano group, a $C_1$-$C_{60}$ alkyl group, a $C_6$-$C_{60}$ aryl group, or any combination thereof, or a $C_6$-$C_{60}$ aryl group that is substituted with at least one deuterium, -F, a cyano group, a $C_1$-$C_{60}$ alkyl group, a $C_6$-$C_{60}$ aryl group, or any combination thereof.

In an embodiment, the sensitizer may be represented by Formula 101 or 102, and in this case, the sensitizer may be referred to as a delayed fluorescence sensitizer:

Formula 101 Formula 102

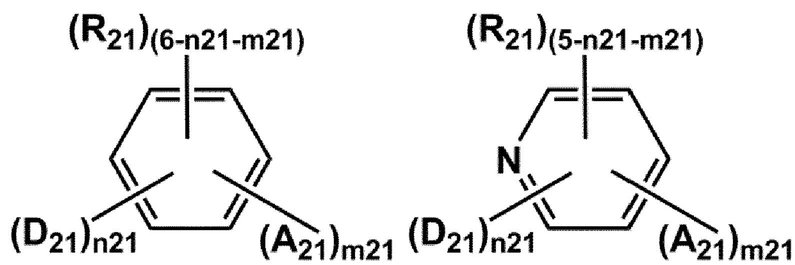

wherein, in Formulae 101 and 102,

$A_{21}$ is an acceptor group,
D21 is a donor group,
m21 may be 1, 2, or 3, and n21 may be 1, 2, or 3,
the sum of n21 and m21 in Formula 101 may be 6 or less, and the sum of n21 and m21 in Formula 102 may be 5 or less;
$R_{21}$ may be hydrogen, deuterium, -F, -Cl, -Br, -I, $-SF_5$, a hydroxyl group, a cyano group, a nitro group, an amidino group, a hydrazino group, a hydrazono group, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, a substituted or unsubstituted monovalent non-aromatic condensed heteropolycyclic group, $-Si(Q_1)(Q_2)(Q_3)$, $-Ge(Q_1)(Q_2)(Q_3)$, $-C(Q_1)(Q_2)(Q_3)$, $-B(Q_1)(Q_2)$, $-N(Q_1)(Q_2)$, $-P(Q_1)(Q_2)$, $-C(=O)(Q_1)$, $-S(=O)(Q_1)$, $-S(=O)_2(Q_1)$, $-P(=O)(Q_1)(Q_2)$, or $-P(=S)(Q_1)(Q_2)$, and a plurality of $R_{21}$(s) may optionally be bonded together to form a substituted or unsubstituted $C_5$-$C_{30}$carbocyclic group or a substituted or unsubstituted $C_1$-$C_{30}$ heterocyclic group, and
$Q_1$ to $Q_3$ may each independently be hydrogen, deuterium, -F, -Cl, -Br, -I, a hydroxyl group, a cyano group, a nitro group, an amidino group, a hydrazino group, a hydrazono group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent aromatic condensed polycyclic group, a monovalent aromatic condensed heteropolycyclic group, a monovalent non-aromatic condensed polycyclic group, a monovalent non-aromatic condensed heteropolycyclic group, a $C_1$-$C_{60}$ alkyl group that is substituted with at least one deuterium, -F, a cyano group, a $C_1$-$C_{60}$ alkyl group, a $C_6$-$C_{60}$ aryl group, or any combination thereof, or a $C_6$-$C_{60}$ aryl group that is substituted with at least one deuterium, -F, a cyano group, a $C_1$-$C_{60}$ alkyl group, a $C_6$-$C_{60}$ aryl group, or any combination thereof.

In an embodiment, $A_{21}$ in Formulae 101 and 102 may be a substituted or unsubstituted $\pi$ electron-deficient nitrogen-free cyclic group.

In an embodiment, the $\pi$ electron-deficient nitrogen-free cyclic group may be a benzene group, a heptalene

group, an indene group, a naphthalene group, an azulene group, an indacene group, an acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a pentacene group, a rubicene group, a corogen group, an ovalene group, a pyrrole group, an isoindole group, an indole group, a furan group, a thiophene group, a benzofuran group, a benzothiophene group, a benzocarbazole group, a dibenzocarbazole group, a dibenzofuran group, a dibenzothiophene group, a dibenzothiophene sulfone group, a carbazole group, a dibenzosilole group, an indenocarbazole group, an indolocarbazole group, a benzofurocarbazole group, a benzothienocarbazole group, a triindolobenzene group; or a condensed cyclic group of two or more π electron-deficient nitrogen-free cyclic groups, but embodiments are not limited thereto.

In an embodiment, in Formulae 101 and 102, $D_{21}$ may be: -F, a cyano group, or a π electron-deficient nitrogen-containing cyclic group;

a $C_1$-$C_{60}$ alkyl group, a π-electron deficient nitrogen-containing cyclic group, or a π electron-deficient nitrogen-free cyclic group, each substituted with at least one -F, a cyano group, or any combination thereof; or
a π-electron deficient nitrogen-containing cyclic group, each substituted with at least one deuterium, a $C_1$-$C_{60}$ alkyl group, a π -electron deficient nitrogen-containing cyclic group, a π electron-deficient nitrogen-free cyclic group, or any combination thereof.

In an embodiment, the π electron-deficient nitrogen-free cyclic group is the same as described above.

The term "π electron-deficient nitrogen-containing cyclic group" used herein refers to a cyclic group having at least one *-N=*' moiety, and, for example, may be an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, an azacarbazole group, or a benzimidazolobenzimidazole group; and a condensed cyclic group in which two or more π electron-deficient nitrogen-containing cyclic groups are condensed with each other.

[Hole transport region 12]

The hole transport region 12 may be located between the first electrode 11 and the emission layer 15 of the organic light-emitting device 10.

The hole transport region 12 may have a single-layered structure or a multi-layered structure.

For example, the hole transport region 12 may have a hole injection layer, a hole-transport layer, a hole injection layer/hole-transport layer structure, a hole injection layer/first hole-transport layer/second hole-transport layer structure, a hole-transport layer/interlayer structure, a hole injection layer/hole-transport layer/interlayer structure, a hole-transport layer/electron blocking layer structure, or a hole injection layer/hole-transport layer/electron blocking layer structure, but embodiments are not limited thereto.

The hole transport region 12 may include any compound having hole-transporting properties.

For example, the hole transport region 12 may include an amine-based compound.

In an embodiment, the hole transport region 1 may include at least one a compound represented by Formula 201 to a compound represented by Formula 205, but embodiments are not limited thereto:

Formula 201

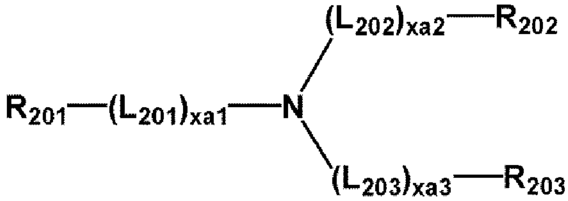

Formula 202

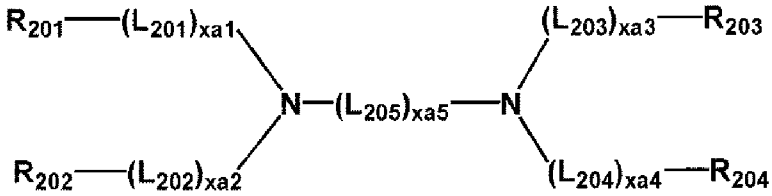

Formula 203

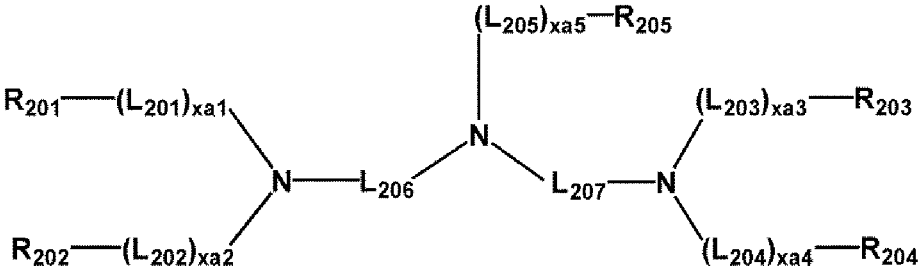

Formula 204

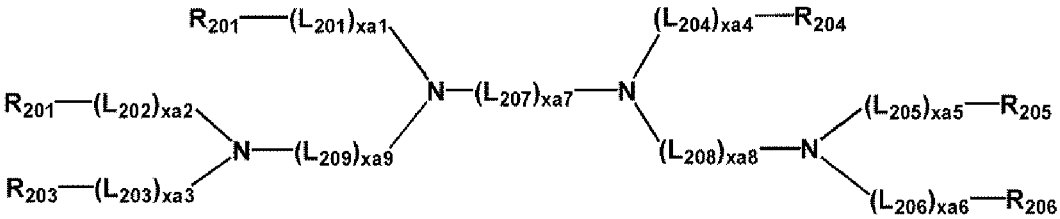

Formula 205

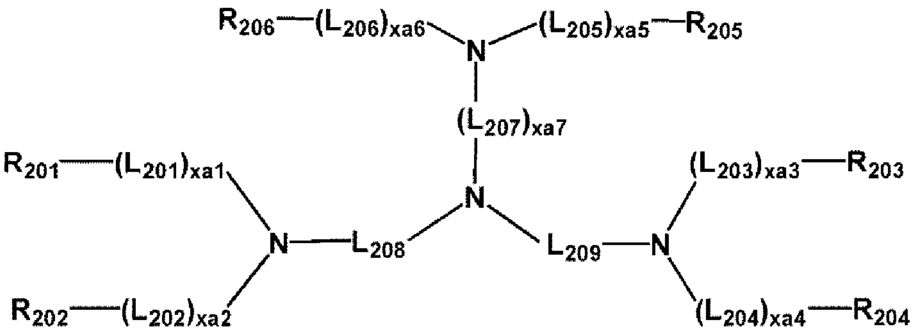

wherein, in Formulae 201 to 205,

$L_{201}$ to $L_{209}$ may each independently be *-O-*', *-S-*', a substituted or unsubstituted $C_5$-$C_{60}$ carbocyclic group, or a substituted or unsubstituted $C_1$-$C_{60}$ heterocyclic group,

xa1 to xa9 may each independently be an integer from 0 to 5, and

$R_{201}$ to $R_{206}$ may each independently be a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent aromatic condensed polycyclic group, a substituted or unsubstituted monovalent aromatic condensed heteropolycyclic group, a substituted or unsubstituted monovalent non-aromatic condensed polycyclic group, or a substituted or unsubstituted monovalent non-aromatic condensed heteropolycyclic group, and two neighboring groups of $R_{201}$ to $R_{206}$ may optionally be linked via a single

bond, a dimethyl-methylene group, or a diphenyl-methylene group.

For example, $L_{201}$ to $L_{209}$ may be a benzene group, a heptalene group, an indene group, a naphthalene group, an azulene group, a heptalene group, an indacene group, an acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a pentacene group, a rubicene group, a corogen group, an ovalene group, a pyrrole group, an isoindole group, an indole group, a furan group, a thiophene group, a benzofuran group, a benzothiophene group, a benzocarbazole group, a dibenzocarbazole group, a dibenzofuran group, a dibenzothiophene group, a dibenzothiophene sulfone group, a carbazole group, a dibenzosilole group, an indenocarbazole group, an indolocarbazole group, a benzofurocarbazole group, a benzothienocarbazole group, and a triindolobenzene group, each unsubstituted or substituted with deuterium, a $C_1$-$C_{10}$ alkyl group, a $C_1$-$C_{10}$ alkoxy group, a phenyl group, a naphthyl group, a fluorenyl group, a carbazolyl group, a dibenzofuranyl group, a dibenzothiophenyl group, a triphenylenyl group, a biphenyl group, a terphenyl group, a tetraphenyl group, or -Si($Q_{11}$)($Q_{12}$)($Q_{13}$),

xa1 to xa9 may each independently be 0, 1, or 2, and
$R_{201}$ to $R_{206}$ may each independently be a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an indeno carbazolyl group, an indolocarbazolyl group, a benzofurocarbazolyl group, or a benzothienocarbazolyl group, each unsubstituted or substituted with deuterium, -F, -Cl, -Br, -I, a hydroxyl group, a cyano group, a nitro group, an amidino group, a hydrazine group, a hydrazone group, a $C_1$-$C_{20}$ alkyl group, a $C_1$-$C_{20}$ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a $C_1$-$C_{10}$ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, - Si($Q_{31}$)($Q_{32}$)($Q_{33}$), or -N($Q_{31}$)($Q_{32}$),
wherein $Q_{11}$ to $Q_{13}$ and $Q_{31}$ to $Q_{33}$ may each independently be a $C_1$-$C_{10}$ alkyl group, a $C_1$-$C_{10}$ alkoxy group, a phenyl group, a biphenyl group, a terphenyl group, or a naphthyl group.

In one or more embodiments, the hole transport region 12 may include a carbazole-containing amine-based compound.

In an embodiment, the hole transport region 12 may include a carbazole-containing amine-based compound and a carbazole-free amine-based compound.

The carbazole-containing amine-based compound may be, for example, a compound represented by Formula 201 including a carbazole group and further including at least one a dibenzofuran group, a dibenzothiophene group, a fluorene group, a spiro-bifluorene group, an indenocarbazole group, an indolocarbazole group, a benzofurocarbazole group, a benzothienocarbazole group, or any combination thereof.

The carbazole-free amine-based compound may be, for example, a compound represented by Formula 201 which do not include a carbazole group and which include at least one a dibenzofuran group, a dibenzothiophene group, a fluorene group, a spiro-bifluorene group, an indenocarbazole group, an indolocarbazole group, a benzofurocarbazole group, a benzothienocarbazole group, or any combination thereof.

In one or more embodiments, the hole transport region 12 may include at least one compound represented by Formulae 201 or 202.

In an embodiment, the hole transport region 12 may include at least one compound represented by Formulae 201-1, 202-1 and 201-2, but embodiments are not limited thereto:

Formula 201-1

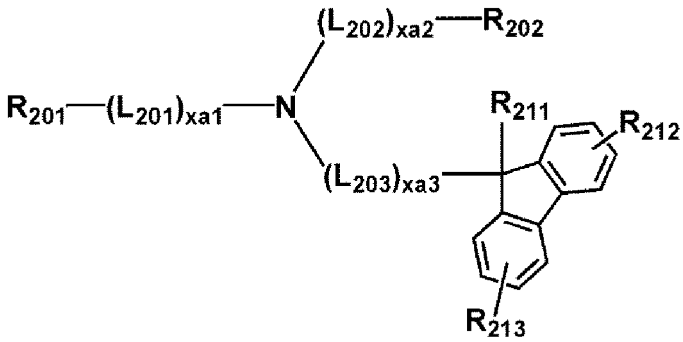

Formula 202-1

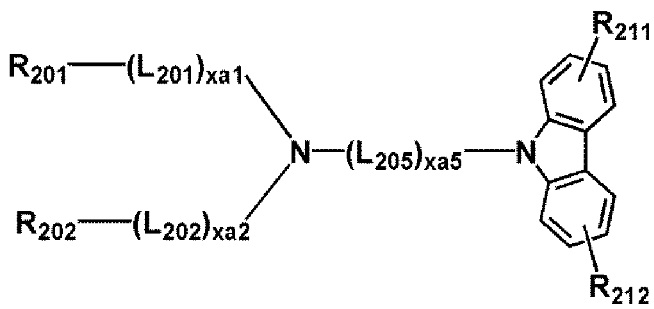

Formula 201-2

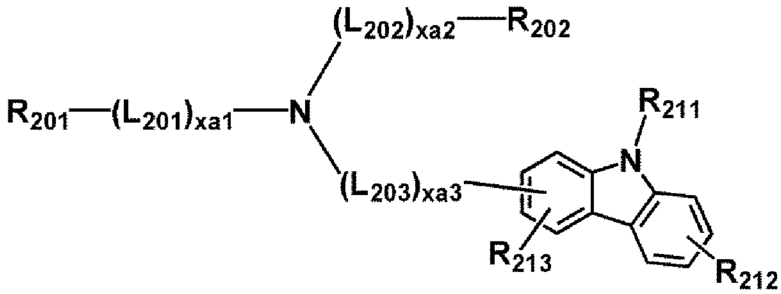

In Formulae 201-1, 202-1, and 201-2, $L_{201}$ to $L_{203}$, $L_{205}$, xa1 to xa3, xa5, $R_{201}$ and $R_{202}$ are the same as described herein, and $R_{211}$ to $R_{213}$ are each independently hydrogen, deuterium, -F, -Cl, -Br, -I, a hydroxyl group, a cyano group, a nitro group, an amidino group, a hydrazine group, a hydrazone group, a $C_1$-$C_{20}$ alkyl group, a $C_1$-$C_{26}$ alkoxy group, a phenyl group, a biphenyl group, a terphenyl group, a phenyl group substituted with a $C_1$-$C_{10}$ alkyl group, a phenyl group substituted with -F, a naphthyl group, a fluorenyl group, a spiro-bifluorenyl group, a dimethylfluorenyl group, a diphenyl fluorenyl group, a triphenylenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, or a pyridinyl group.

For example, the hole transport region 12 may include at least one of Compounds HT1 to HT39, but embodiments are not limited thereto.

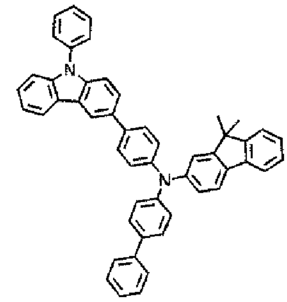

HT1

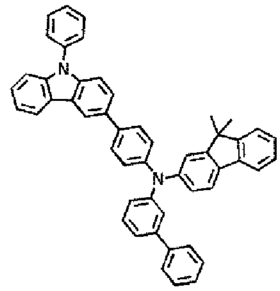

HT2

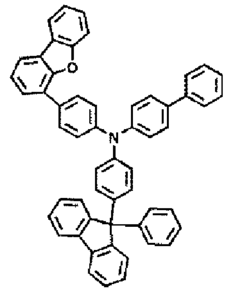

HT3

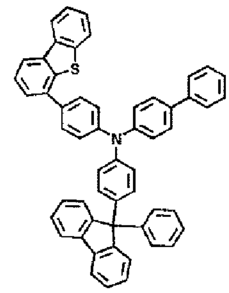

HT4

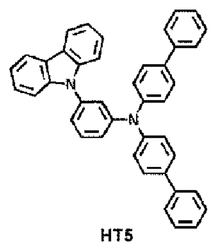

HT5

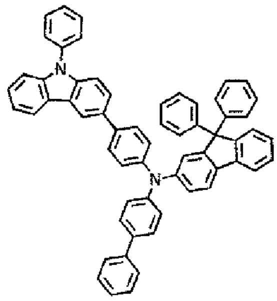

HT6

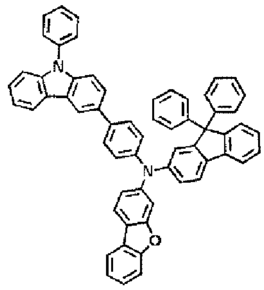

HT7

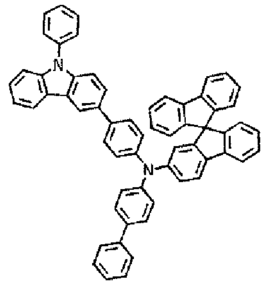

HT8

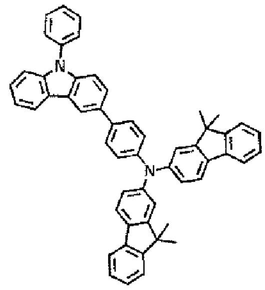

HT9

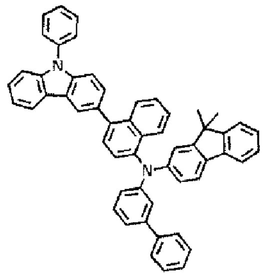

HT10

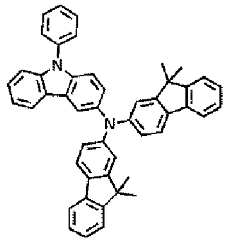

HT11

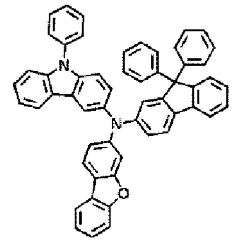

HT12

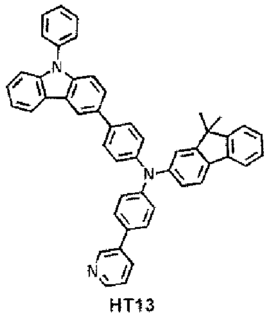

HT13

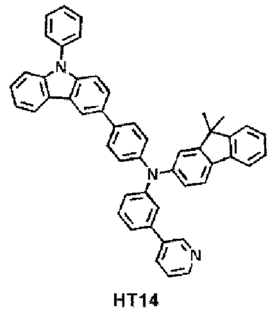

HT14

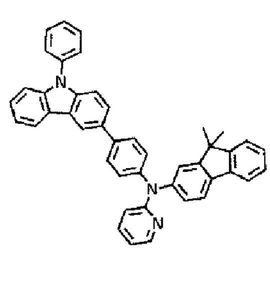

HT15

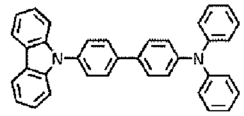

HT16

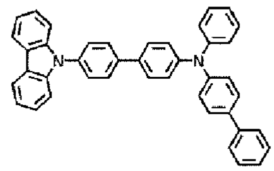

HT17

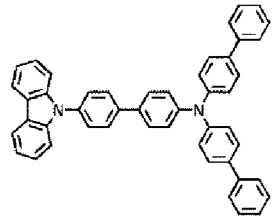

HT18

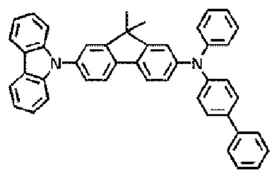

HT19

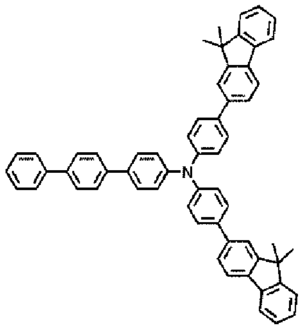

HT20

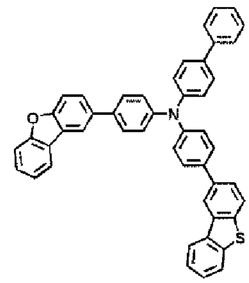

HT21

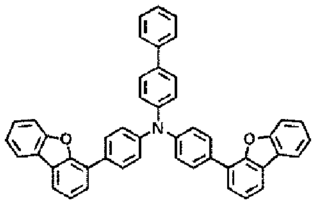

HT22

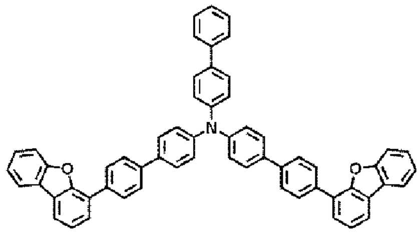

HT23

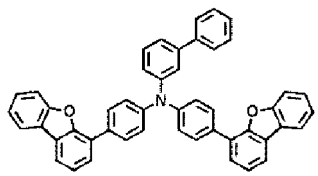

HT24

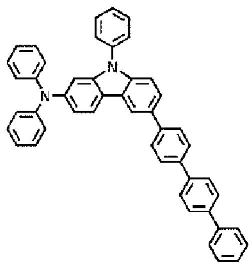

HT25

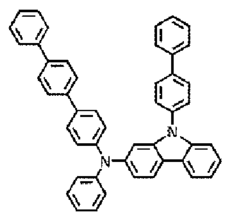

HT26

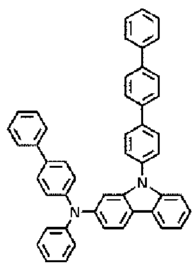

HT27

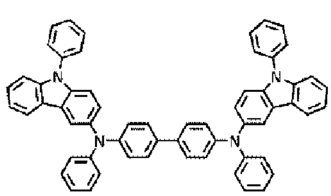

HT28

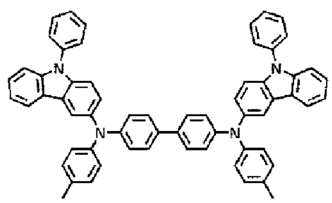

HT29

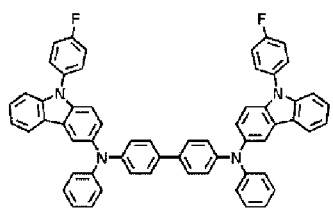

HT30

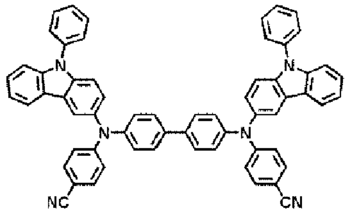

HT31

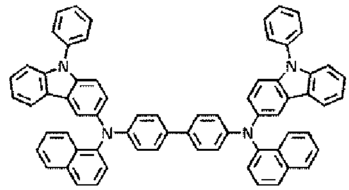

HT32

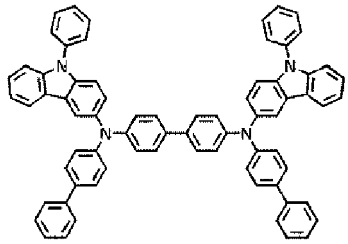

HT33

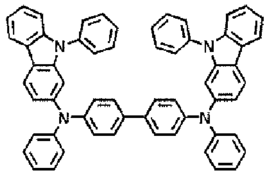

HT34

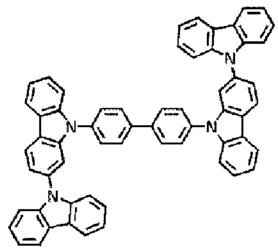

HT35

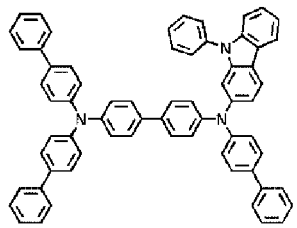

HT36

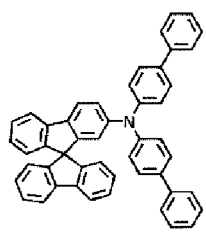

HT37

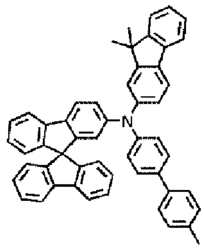

HT38

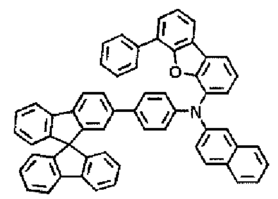

HT39

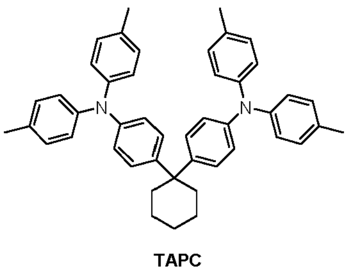

TAPC

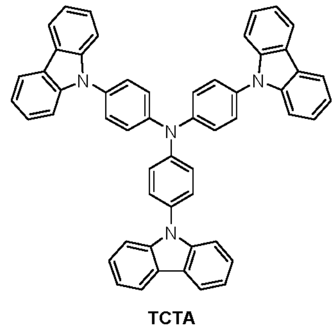

TCTA

.

In an embodiment, the hole transport region may include 4,4'-cyclohexylidenebis[N,N-bis(4-methylphenyl)benzenamine] (TAPC), tris(4-carbazoyl-9-ylphenyl)amine (TCTA), or any combination thereof.

In one or more embodiments, hole transport region 12 of the organic light-emitting device 10 may further include a p-dopant. When the hole transport region 12 further includes a p-dopant, the hole transport region 12 may have a matrix (for example, at least one of compounds represented by Formulae 201 to 205) and a p-dopant included in the matrix. The p-dopant may be uniformly or non-uniformly doped in the hole transport region 12.

In an embodiment, the LUMO energy level of the p-dopant may be about -3.5 eV or less.

The p-dopant may include at least one of a quinone derivative, a metal oxide, a cyano group-containing compound, or any combination thereof, but embodiments are not limited thereto.

In an embodiment, the p-dopant may include at least one of:

a quinone derivative, such as tetracyanoquinodimethane (TCNQ),2,3,5,6-tetrafluoro-7,7,8,8-tetracyanoquinodimethane (F4-TCNQ), F6-TCNNQ, or any combination thereof;

a metal oxide, such as tungsten oxide or molybdenum oxide;

1,4,5,8,9,12-hexaazatriphenylene-hexacarbonitrile (HAT-CN);

a compound represented by Formula 221, or any combination thereof, but embodiments are not limited thereto:

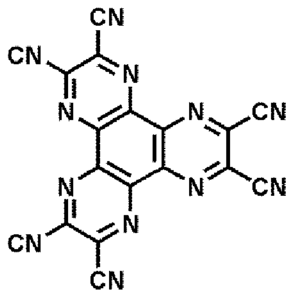

HAT-CN

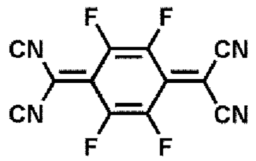

F4-TCNQ

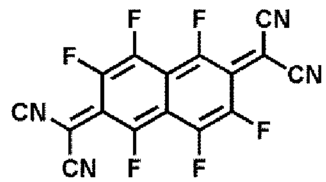

F6-TCNNQ

Formula 221

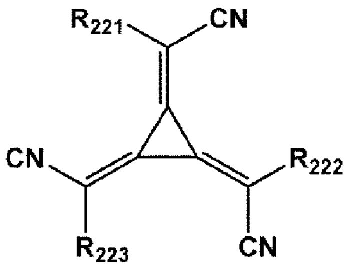

wherein, in Formula 221,

$R_{221}$ to $R_{223}$ may each independently be a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_1$-$C_{60}$ heteroaryl group, a substituted or unsubstituted monovalent aromatic condensed polycyclic group, a substituted or unsubstituted monovalent aromatic condensed heteropolycyclic group, a substituted or unsubstituted monovalent non-aromatic condensed polycyclic group, or a substituted or unsubstituted monovalent non-aromatic condensed heteropolycyclic group, wherein at least one of $R_{221}$ to $R_{223}$ may have at least one of a cyano group, - F, -Cl, -Br, -I, a $C_1$-$C_{20}$ alkyl group substituted with -F, a $C_1$-$C_{20}$ alkyl group substituted with -Cl, a $C_1$-$C_{20}$ alkyl group substituted with -Br, and a $C_1$-$C_{20}$ alkyl group substituted with -I, or any combination thereof.

The hole transport region 12 may have a thickness of about 100 Å to about 10000 Å, for example, about 400 Å to about 2000 Å, and the emission layer 15 may have a thickness of about 100 Å to about 3000 Å, for example, about 300 Å to about 1000 Å. When the thickness of each of the hole transport region 12 and the emission layer 15 is within these ranges described above, satisfactory hole transportation characteristics and/or luminescent characteristics may be obtained without a substantial increase in driving voltage.

[Electron transport region 17]

The electron transport region 17 may be placed between the emission layer 15 and the second electrode 19 of the organic light-emitting device 10.

The electron transport region 17 may have a single-layered structure or a multi-layered structure.

For example, the electron transport region 17 may have an electron transport layer, an electron transport layer/electron injection layer structure, a buffer layer/electron transport layer structure, hole blocking layer/electron transport layer structure, a buffer layer/electron transport layer/electron injection layer structure, or a hole blocking layer/electron transport layer/electron injection layer structure, but embodiments are not limited thereto. The electron transport region 17 may further include an electron control layer.

The electron transport region 17 may include known electron-transporting materials.

The electron transport region (for example, a buffer layer, a hole blocking layer, an electron control layer, or an electron transport layer in the electron transport region) may include a metal-free compound containing at least one

π electron-deficient nitrogen-containing cyclic group. The π electron-deficient nitrogen-containing cyclic group is the same as described above.

In an embodiment, the electron transport region may include a compound represented by Formula 601:

Formula 601 $[Ar_{601}]_{xe11}-[(L_{601})_{xe1}-R_{601}]_{xe21}$

wherein, in Formula 601,

$Ar_{601}$ and $L_{601}$ may each independently be a substituted or unsubstituted $C_5$-$C_{60}$ carbocyclic group or a substituted or unsubstituted $C_1$-$C_{60}$ heterocyclic group,

xe11 may be 1, 2, or 3,

xe1 is an integer from 0 to 5,

$R_{601}$ may be a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent aromatic condensed polycyclic group, a substituted or unsubstituted monovalent aromatic condensed heteropolycyclic group, a substituted or unsubstituted monovalent non-aromatic condensed polycyclic group, a substituted or unsubstituted monovalent non-aromatic condensed heteropolycyclic group, - $Si(Q_{601})(Q_{602})(Q_{603})$, $-C(=O)(Q_{601})$, $-S(=O)_2(Q_{601})$, or $-P(=O)(Q_{601})(Q_{602})$,

$Q_{601}$ to $Q_{603}$ may each independently be a $C_1$-$C_{10}$ alkyl group, a $C_1$-$C_{10}$ alkoxy group, a phenyl group, a biphenyl group, a terphenyl group, or a naphthyl group, and

xe21 is an integer from 1 to 5.

In an embodiment, at least one of $Ar_{601}$ in the number of xe11 and $R_{601}$ in the number of xe21 may include a π electron-deficient nitrogen-containing cyclic group.

In an embodiment, ring $Ar_{601}$ and $L_{601}$ in Formula 601 may each independently be a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, a carbazole group, an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, or an azacarbazole group, each unsubstituted or substituted with deuterium, -F, -Cl, -Br, -I, a hydroxyl group, a cyano group, a nitro group, an amidino group, a hydrazine group, a hydrazone group, a $C_1$-$C_{20}$ alkyl group, a $C_1$-$C_{20}$ alkoxy group, a phenyl group, a biphenyl group, a terphenyl group, a naphthyl group, $-Si(Q_{31})(Q_{32})(Q_{33})$, $-S(=O)_2(Q_{31})$, or $-P(=O)(Q_{31})(Q_{32})$,

wherein $Q_{31}$ to $Q_{33}$ may each independently be a $C_1$-$C_{10}$ alkyl group, a $C_1$-$C_{10}$ alkoxy group, a phenyl group, a biphenyl group, a terphenyl group, or a naphthyl group.

When xe11 in Formula 601 is 2 or more, two or more of $Ar_{601}$(s) may be linked to each other via a single bond.

In one or more embodiments, $Ar_{601}$ in Formula 601 may be an anthracene group.

In one or more embodiments, the compound represented by Formula 601 may be represented by Formula 601-1:

Formula 601-1

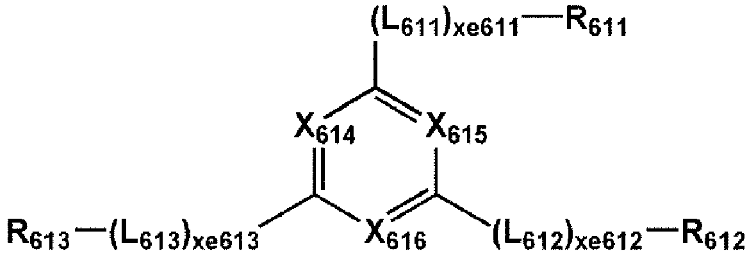

wherein, in Formula 601-1,

$X_{614}$ may be N or C($R_{614}$), $X_{615}$ may be N or C($R_{615}$), $X_{616}$ may be N or C($R_{616}$), and at least one of $X_{614}$ to $X_{616}$ may be N,
$L_{611}$ to $L_{613}$ may each independently be the same as described in connection with $L_{601}$,
xe611 to xe613 may each independently be the same as described in connection with xe1,
$R_{611}$ to $R_{613}$ may each independently be the same as described in connection with $R_{601}$, and
$R_{614}$ to $R_{616}$ may each independently be hydrogen, deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a phenyl group, a biphenyl group, a terphenyl group, or a naphthyl group.

In one or more embodiments, xe1 and xe611 to xe613 in Formulae 601 and 601-1 may each independently be 0, 1, or 2.

In one or more embodiments, $R_{601}$ and $R_{611}$ to $R_{613}$ in Formulae 601 and 601-1 may each independently be a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, or an azacarbazolyl group, each unsubstituted or substituted with deuterium, -F, -Cl, -Br, -I, a hydroxyl group, a cyano group, a nitro group, an amidino group, a hydrazine group, a hydrazone group, a $C_1$-$C_{20}$ alkyl group, a $C_1$-$C_{20}$ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, an azacarbazolyl group, or any combination thereof; or

$-S(=O)_2(Q_{601})$ or $-P(=O)(Q_{601})(Q_{602})$,
wherein $Q_{601}$ and $Q_{602}$ are the same as described above.

The electron transport region may include at least one of Compounds ET1 to ET36, but embodiments are not limited thereto:

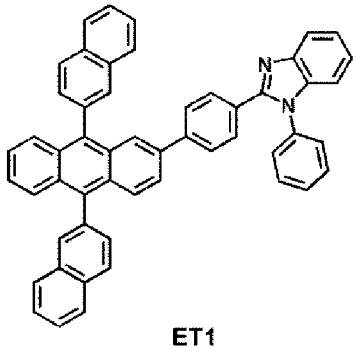
ET1

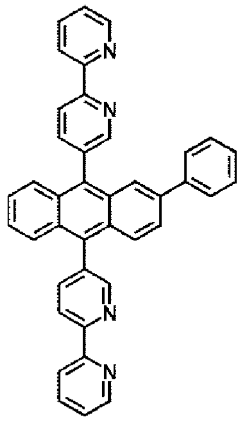
ET2

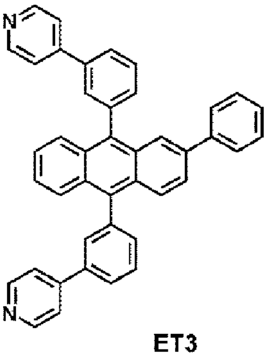
ET3

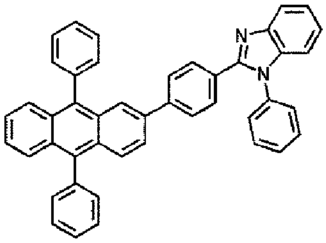
ET4

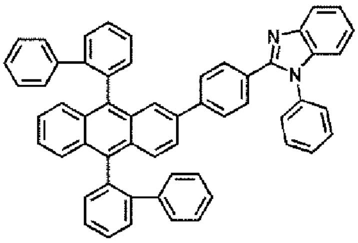
ET5

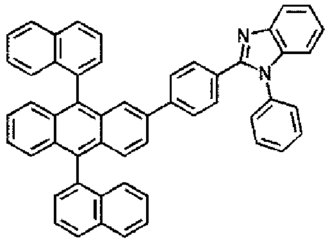
ET6

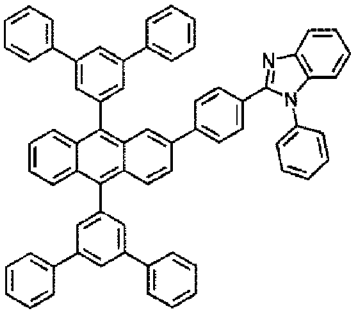
ET7

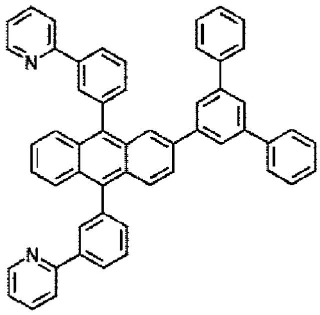
ET8

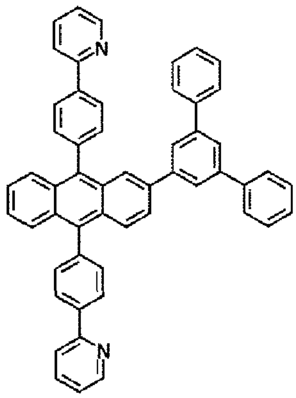
ET9

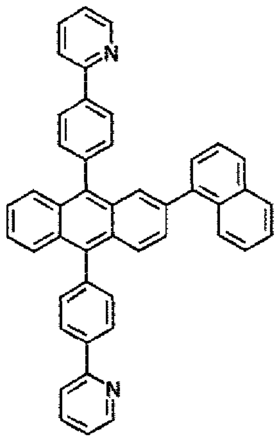

ET10

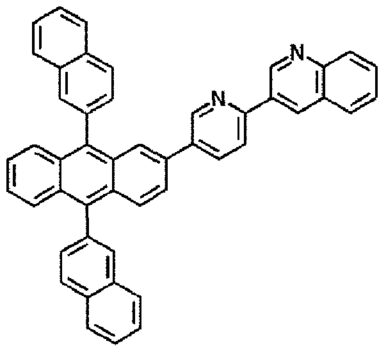

ET11

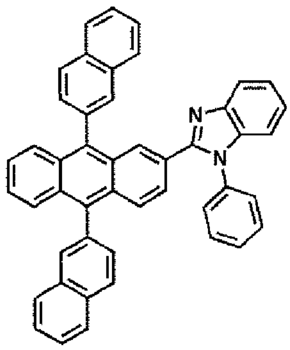

ET12

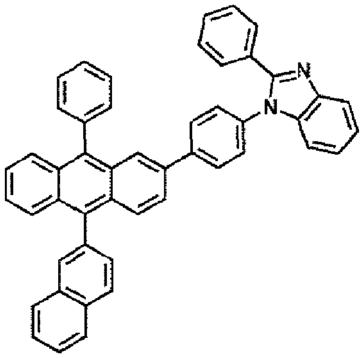

ET13

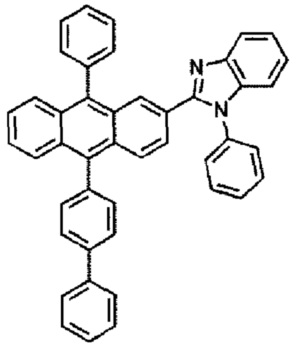

ET14

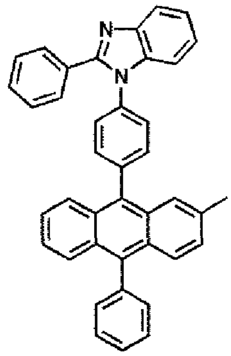

ET15

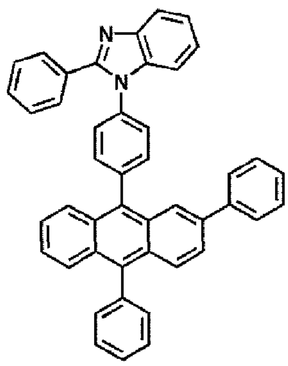

ET16

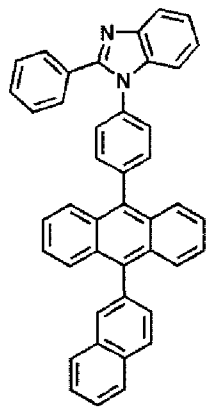

ET17

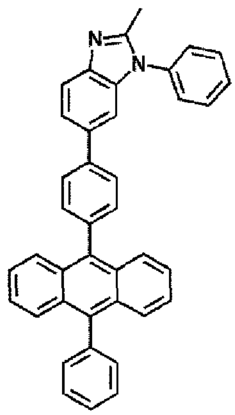

ET18

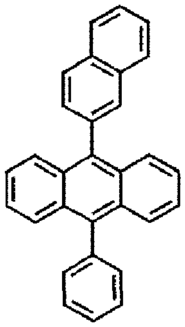

ET19

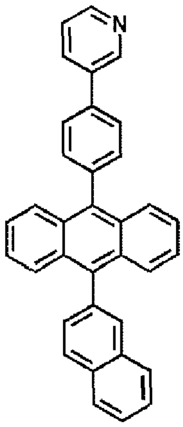

ET20

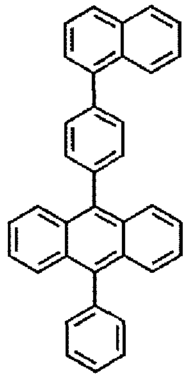

ET21

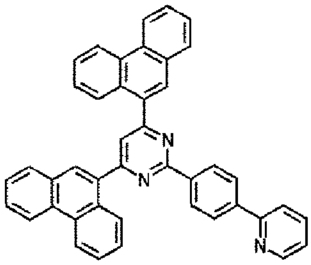

ET22

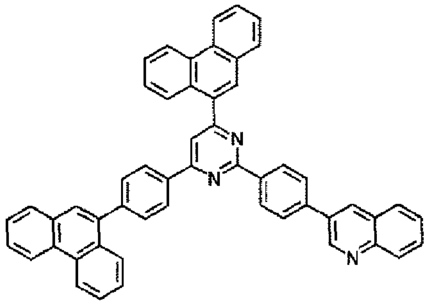

ET23

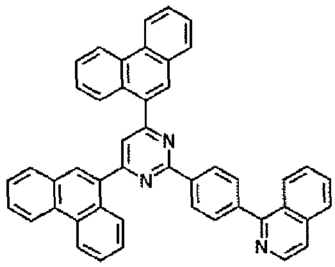

ET24

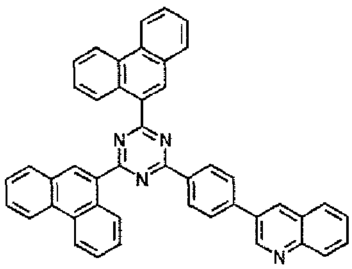

ET25

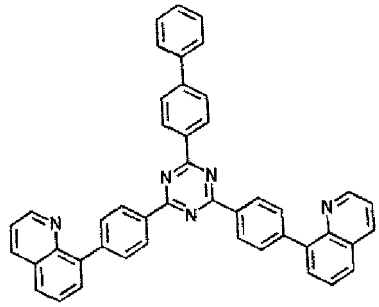

ET26

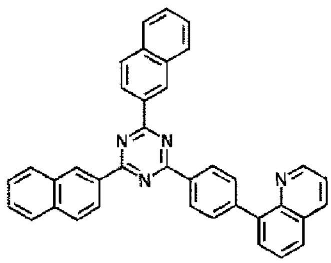

ET27

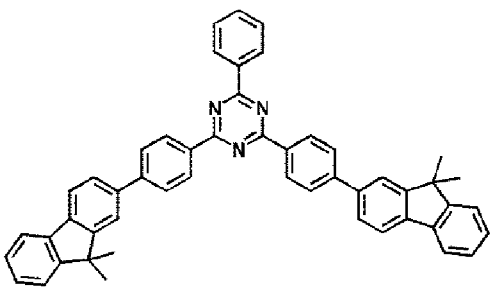

ET28

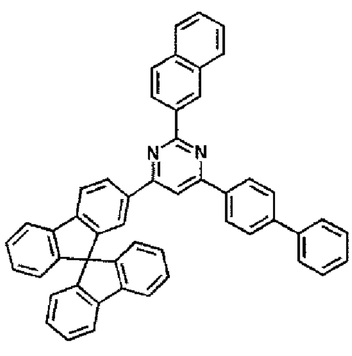

ET29

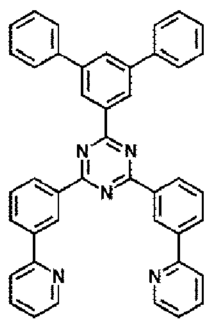

ET30

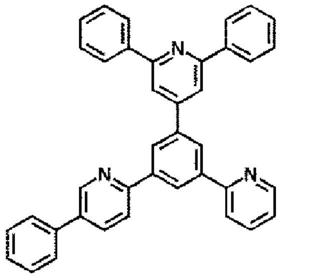
ET31

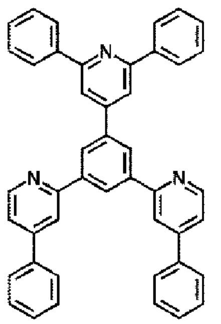
ET32

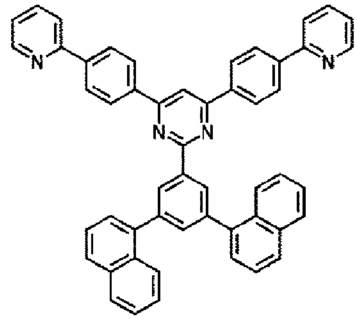
ET33

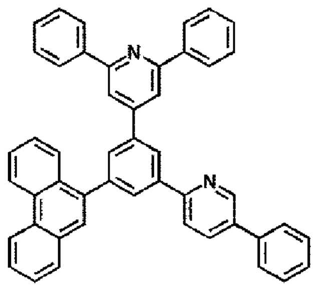
ET34

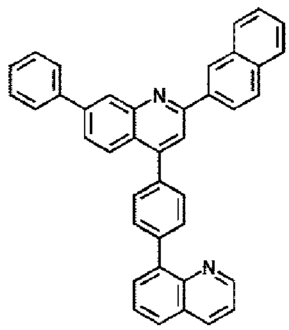
ET35

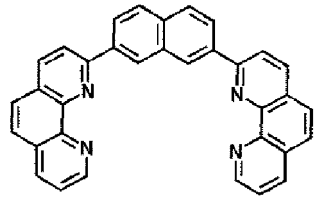
ET36

In an embodiment, the electron transport region may include at least one of 2,9-dimethyl-4,7-diphenyl-1,10-phenanthroline (BCP), 4,7-diphenyl-1,10-phenanthroline (Bphen), $Alq_3$, BAlq, 3-(biphenyl-4-yl)-5-(4-tert-butylphenyl)-4-phenyl-4H-1,2,4-triazole (TAZ), 2,2',2"-(1,3,5-benzinetriyl)-tris(1-phenyl-1-H-benzimidazole) (TPBi), NTAZ, or any combination thereof.

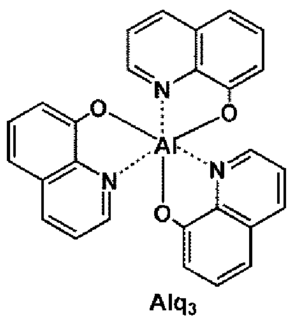
$Alq_3$

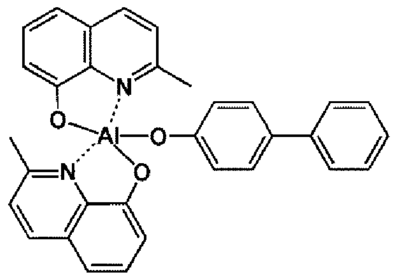
BAlq

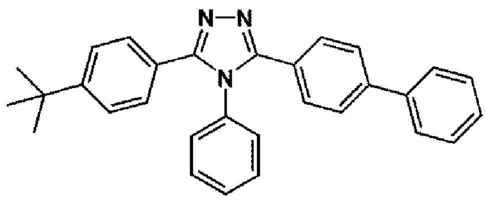
TAZ

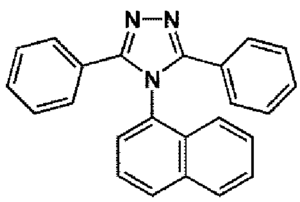
NTAZ

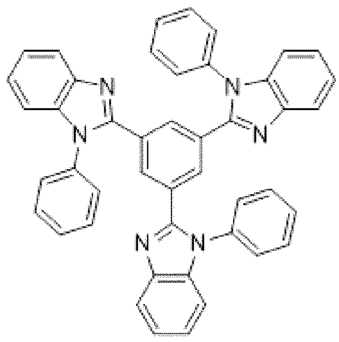

TPBi

Thicknesses of the buffer layer, the hole blocking layer, and the electron control layer may each independently be in the range of about 20 Å to about 1,000 Å, for example, about 30 Å to about 300 Å. When the thicknesses of the buffer layer, the hole blocking layer, and the electron control layer are within these ranges, excellent hole blocking characteristics or excellent electron control characteristics may be obtained without a substantial increase in driving voltage.

A thickness of the electron transport layer may be in the range of about 100 Å to about 1,000 Å, for example, about 150 Å to about 500 Å. When the thickness of the electron transport layer is within the range described above, the electron transport layer may have satisfactory electron transporting characteristics without a substantial increase in driving voltage.

The electron transport region 17 (for example, the electron transport layer in the electron transport region 17) may further include, in addition to the materials described above, a metal-containing material.

The metal-containing material may include at least one alkali metal complex, alkaline earth-metal complex, or any combination thereof. The alkali metal complex may include a Li ion, a Na ion, a K ion, a Rb ion, a Cs ion, or any combination thereof and the alkaline earth-metal complex may include a Be ion, a Mg ion, a Ca ion, a Sr ion, a Ba ion, or any combination thereof. A ligand coordinated with the metal ion of the alkali metal complex or the alkaline earth-metal complex may be a hydroxy quinoline, a hydroxy isoquinoline, a hydroxy benzoquinoline, a hydroxy acridine, a hydroxy phenanthridine, a hydroxy phenyloxazole, a hydroxy phenylthiazole, a hydroxy diphenyloxadiazole, a hydroxy diphenylthiadiazole, a hydroxy phenylpyridine, a hydroxy phenylbenzimidazole, a hydroxy phenylbenzothiazole, a bipyridine, a phenanthroline, or a cyclopentadiene, but embodiments are not limited thereto.

In an embodiment, the metal-containing material may include a Li complex. The Li complex may include, for example, Compound ET-D1 (lithium quinolate, LiQ) or ET-D2:

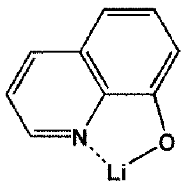

ET-D1

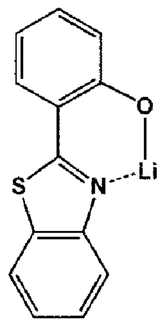

ET-D2

The electron transport region 17 may include an electron injection layer that facilitates the injection of electrons from the second electrode 19. The electron injection layer may directly contact the second electrode 19.

The electron injection layer may have i) a single-layered structure including a single layer including a single material, ii) a single-layered structure including a single layer including a plurality of different materials, or iii) a multi-layered structure having a plurality of layers including a plurality of different materials.

The electron injection layer may include an alkali metal, an alkaline earth metal, a rare earth metal, an alkali metal compound, an alkaline earth-metal compound, a rare earth metal compound, an alkali metal complex, an alkaline earth-metal complex, a rare earth metal complex, or any combinations thereof.

The alkali metal may be Li, Na, K, Rb, or Cs. In an embodiment, the alkali metal may be Li, Na, or Cs. In one or more embodiments, the alkali metal may be Li or Cs, but embodiments are not limited thereto.

The alkaline earth metal may be Mg, Ca, Sr, or Ba.

The rare earth metal may be Sc, Y, Ce, Tb, Yb, or Gd.

The alkali metal compound, the alkaline earth-metal compound, and the rare earth metal compound may be an oxide and a halide (for example, fluoride, chloride, bromide, or iodide) of the alkali metal, the alkaline earth-metal, and the rare earth metal.

The alkali metal compound may be an alkali metal oxide, such as $Li_2O$, $Cs_2O$, or $K_2O$, or an alkali metal halide, such as LiF, NaF, CsF, KF, LiI, NaI, CsI, or KI. In an embodiment, the alkali metal compound may be LiF, $Li_2O$, NaF, LiI, NaI, CsI, or KI, but embodiments are not limited thereto.

The alkaline earth-metal compound may be an alkaline earth-metal oxide, such as BaO, SrO, CaO, $Ba_xSr_{1-x}O$ ($0<x<1$), or $Ba_xCa_{1-x}O$ ($0<x<1$). In an embodiment, the alkaline earth-metal compound may be BaO, SrO, or CaO, but embodiments are not limited thereto.

The rare earth metal compound may be $YbF_3$, $ScF_3$, $ScO_3$, $Y_2O_3$, $Ce_2O_3$, $GdF_3$, or $TbF_3$. In an embodiment, the rare earth metal compound may be $YbF_3$, $ScF_3$, $TbF_3$, $YbI_3$, $ScI_3$, or $TbI_3$, but embodiments are not limited thereto.

The alkali metal complex, the alkaline earth-metal complex, and the rare earth metal complex may include an ion of an alkali metal, an alkaline earth-metal, or a rare earth metal as described above, and a ligand coordinated with a metal ion of the alkali metal complex, the alkaline earth-metal complex, or the rare earth metal complex may be hydroxy quinoline, hydroxy isoquinoline, hydroxy benzoquinoline, hydroxy acridine, hydroxy phenanthridine, hydroxy phenyloxazole, hydroxy phenylthiazole, hydroxy diphenyloxadiazole, hydroxy diphenylthiadiazole, hydroxy phenylpyridine, hydroxy phenylbenzimidazole, hydroxy phenylbenzothiazole, bipyridine, phenanthroline, or cyclopentadiene, but embodiments are not limited thereto.

The electron injection layer may consist of an alkali metal, an alkaline earth metal, a rare earth metal, an alkali metal compound, an alkaline earth-metal compound, a rare earth metal compound, an alkali metal complex, an alkaline earth-metal complex, a rare earth metal complex, or any combinations thereof, as described above. In one or more embodiments, the electron injection layer may further include an organic material. When the electron injection layer further includes an organic material, an alkali metal, an alkaline earth metal, a rare earth metal, an alkali metal compound, an alkaline earth-metal compound, a rare earth metal compound, an alkali metal complex, an alkaline earth-metal complex, a rare earth metal complex, or any combination thereof may be homogeneously or non-homogeneously dispersed in a matrix including the organic material.

A thickness of the electron injection layer may be in a range of about 1 Å to about 100 Å, and, for example, about 3 Å to about 90 Å. When the thickness of the electron injection layer is within the ranges described above, satisfactory electron injection characteristics may be obtained without a substantial increase in driving voltage.

[Second electrode 19]

The second electrode 19 is located on the organic layer 10A having such a structure. The second electrode 19 may be a cathode which is an electron injection electrode, and in this regard, a material for forming the second electrode 19 may be a metal, an alloy, an electrically conductive compound, or a combination thereof, which have a relatively low work function.

The second electrode 19 may include at least one of lithium (Li), silver (Ag), magnesium (Mg), aluminum (Al), aluminum-lithium (Al-Li), calcium (Ca), magnesium-indium (Mg-In), magnesium-silver (Mg-Ag), ITO, IZO, or any combination thereof, but embodiments are not limited thereto. The second electrode 19 may be a transmissive electrode, a semi-transmissive electrode, or a reflective electrode.

The second electrode 19 may have a single-layered structure having a single layer or a multi-layered structure including two or more layers.

Hereinbefore, the organic light-emitting device has been described with reference to the figures, but embodiments are not limited thereto.

Description of FIG. 2

FIG. 2 is a schematic view of a cross-section of an organic light-emitting device 100 according to another embodiment.

The organic light-emitting device 100 of FIG. 2 includes a first electrode 110, a second electrode 190 facing the first electrode 110, and a first light-emitting unit 151 and a second light-emitting unit 152 between the first electrode 110 and the second electrode 190. A charge generation layer 141 is located between the first emission unit 151 and the second emission unit 152, and the charge generation layer 141 may include an n-type charge generation layer 141-N and a p-type charge generation layer 141-P. The charge generation layer 141 generates charge and supplies the charge

to neighboring emission units, and any known material may be used therefor.

The first light-emitting unit 151 may include a first emission layer 151-EM, and the second light-emitting unit 152 may include a second emission layer 152-EM. The maximum emission wavelength of light emitted from the first light-emitting unit 151 may be different from the maximum emission wavelength of light emitted from the second light-emitting unit 152. For example, the mixed light including the light emitted from the first light-emitting unit 151 and the light emitted from the second light-emitting unit 152 may be white light, but embodiments are not limited thereto.

The hole transport region 120 is located between the first emission unit 151 and the first electrode 110, and the second emission unit 152 may include the first hole transport region 121 located on the side of the first electrode 110.

An electron transport region 170 is located between the second emission unit 152 and the second electrode 190, and the first emission unit 151 may include a first electron transport region 171 located between the charge generation layer 141 and the first emission layer 151-EM.

The first emission layer 151-EM may include the heterocyclic compound.

The second emission layer 152-EM may include the heterocyclic compound.

The first electrode 110 and the second electrode 190 illustrated in FIG. 2 may be the same as described in connection with the first electrode 11 and the second electrode 19 illustrated in FIG. 1.

The first emission layer 151-EM and the second emission layer 152-EM in FIG. 2 are respectively the same as described in connection with the emission layer 15 in FIG. 1.

The hole transport region 120 and the first hole transport region 121 illustrated in FIG. 2 are each the same as described in connection with the hole transport region 12 illustrated in FIG. 1.

The electron transport region 170 and the first electron transport region 171 illustrated in FIG. 2 are each the same as described in connection with the electron transport region 17 illustrated in FIG. 1.

As described above, referring to FIG. 2, an organic light-emitting device in which each of the first light-emitting unit 151 and the second light-emitting unit 152 includes an emission layer including a host, a dopant, and a sensitizer, has been described. However, the organic light-emitting device may have various other forms. For example, the first light-emitting unit 151 or the second light-emitting unit 152 of the organic light-emitting device 100 of FIG. 2 may be replaced with any known light-emitting unit, or may include three or more light-emitting units.

[Description of FIG. 3]

FIG. 3 is a schematic cross-sectional view of an organic light-emitting device 200 according to another exemplary embodiment.

The organic light-emitting device 200 includes a first electrode 210, a second electrode 290 facing the first electrode 210, and a first emission layer 251 and a second emission layer 252 which are stacked between the first electrode 210 and the second electrode 290.

The maximum emission wavelength of light emitted from the first emission layer 251 may be different from the maximum emission wavelength of light emitted from the second emission layer 252. For example, the mixed light of the light emitted from the first emission layer 251 and the light emitted from the second emission layer 252 may be white light, but embodiments are not limited thereto.

In one or more embodiments, a hole transport region 220 may be located between the first emission layer 251 and the first electrode 210, and an electron transport region 270 may be located between the second emission layer 252 and the second electrode 290.

The first emission layer 251 may include the heterocyclic compound.

The second emission layer 252 may include the heterocyclic compound.

The first electrode 210, the hole transport region 220, and the second electrode 290 illustrated in FIG. 3 are respectively the same as described in connection with the first electrode 11, the hole transport region 12, and the second electrode 19 illustrated in FIG. 1.

The first emission layer 251 and the second emission layer 252 illustrated in FIG. 3 are each the same as described in connection with the emission layer 15 illustrated in FIG. 1.

The electron transport region 270 illustrated in FIG. 3 may be the same as described in connection with the electron transport region 17 in FIG. 1.

Hereinbefore, referring to FIG. 3, although the organic light-emitting device including the heterocyclic compound is described, various modifications are available, for example, one of the first emission layer 251 and the second emission layer 252 in FIG. 3 may be replaced with a known layer, the organic light-emitting device may include three or more emission layers, or an interlayer may be additionally arranged between neighboring emission layers.

Electronic apparatus

The organic light-emitting device may be included in various electronic apparatuses.

The electronic apparatus may further include a thin-film transistor in addition to the organic light-emitting device as described above. The thin-film transistor may include a source electrode, a drain electrode, and an activation layer, wherein any one of the source electrode and the drain electrode may be electrically connected to any one of the first electrode and the second electrode of the organic light-emitting device.

Explanation of terms

The term "$C_1$-$C_{60}$ alkyl group" as used herein refers to a linear or branched saturated aliphatic hydrocarbon monovalent group having 1 to 60 carbon atoms, and examples thereof include a methyl group, an ethyl group, a propyl group, an isobutyl group, a sec-butyl group, a tert-butyl group, a pentyl group, an isoamyl group, and a hexyl group. The term "$C_1$-$C_{60}$ alkylene group" as used herein refers to a divalent group having the same structure as the $C_1$-$C_{60}$ alkyl group.
The term "$C_1$-$C_{60}$ alkoxy group" used herein refers to a monovalent group represented by $-OA_{101}$ (wherein $A_{101}$ is the $C_1$-$C_{60}$ alkyl group), and examples thereof include a methoxy group, an ethoxy group, and an isopropoxy group.
The term "$C_2$-$C_{60}$ alkenyl group" as used herein refers to a hydrocarbon group formed by substituting at least one carbon-carbon double bond in the middle or at the terminus of the $C_2$-$C_{60}$ alkyl group, and examples thereof include an ethenyl group, a propenyl group, and a butenyl group. The term "$C_2$-$C_{60}$ alkenylene group" as used herein refers to a divalent group having the same structure as the $C_2$-$C_{60}$ alkenyl group.
The term "$C_2$-$C_{60}$ alkynyl group" as used herein refers to a hydrocarbon group formed by substituting at least one carbon-carbon triple bond in the middle or at the terminus of the $C_2$-$C_{60}$ alkyl group, and examples thereof include an ethynyl group, and a propynyl group. The term "$C_2$-$C_{60}$ alkynylene group" as used herein refers to a divalent group having the same structure as the $C_2$-$C_{60}$ alkynyl group.
The term "$C_3$-$C_{10}$ cycloalkyl group" as used herein refers to a monovalent saturated hydrocarbon monocyclic group having 3 to 10 carbon atoms, and examples thereof include a cyclopropyl group, a cyclobutyl group, a cyclopentyl group, a cyclohexyl group, and a cycloheptyl group. The term "$C_3$-$C_{10}$ cycloalkylene group" as used herein refers to a divalent group having the same structure as the $C_3$-$C_{10}$ cycloalkyl group.
The term "$C_1$-$C_{10}$ heterocycloalkyl group" as used herein refers to a monovalent saturated monocyclic group having at least one heteroatom of N, O, P, Si, S, B, Se, Ge, or any combination thereof as a ring-forming atom and 1 to 10 carbon atoms, and non-limiting examples thereof include a tetrahydrofuranyl group and a tetrahydrothiophenyl group. The term "$C_1$-$C_{10}$ heterocycloalkylene group" as used herein refers to a divalent group having the same structure as the $C_1$-$C_{10}$ heterocycloalkyl group.
The term "$C_3$-$C_{10}$ cycloalkenyl group" as used herein refers to a monovalent monocyclic group that has 3 to 10 carbon atoms and at least one carbon-carbon double bond in the ring thereof and no aromaticity, and non-limiting examples thereof include a cyclopentenyl group, a cyclohexenyl group, and a cycloheptenyl group. The term "$C_3$-$C_{10}$ cycloalkenylene group" as used herein refers to a divalent group having the same structure as the $C_3$-$C_{10}$ cycloalkenyl group.
The term "$C_1$-$C_{10}$ heterocycloalkenyl group" as used herein refers to a monovalent monocyclic group that has at least one heteroatom N, O, P, Si, S, B, Se, Ge, or any combination thereof as a ring-forming atom, 1 to 10 carbon atoms, and at least one carbon-carbon double bond in its ring. Examples of the $C_1$-$C_{10}$ heterocycloalkenyl group are a 2,3-dihydrofuranyl group, and a 2,3-dihydrothiophenyl group. The term "$C_1$-$C_{10}$ heterocycloalkenylene group" as used herein refers to a divalent group having the same structure as the $C_1$-$C_{10}$ heterocycloalkenyl group.
The term "$C_6$-$C_{60}$ aryl group" as used herein refers to a monovalent group having a carbocyclic aromatic system having 6 to 60 carbon atoms, and the term "$C_6$-$C_{60}$ arylene group" as used herein refers to a divalent group having a carbocyclic aromatic system having 6 to 60 carbon atoms. Examples of the $C_6$-$C_{60}$ aryl group include a phenyl group, a naphthyl group, an anthracenyl group, a phenanthrenyl group, a pyrenyl group, and a chrysenyl group. When the $C_6$-$C_{60}$ aryl group and the $C_6$-$C_{60}$ arylene group each include two or more rings, the rings may be fused to each other.
The term "$C_1$-$C_{60}$ heteroaryl group" as used herein refers to a monovalent group having a heterocyclic aromatic system that has at least one heteroatom N, O, P, Si, S, B, Se, Ge, or any combination thereof as a ring-forming atom, and 1 to 60 carbon atoms. The term "$C_1$-$C_{60}$ heteroarylene group" as used herein refers to a divalent group having a carbocyclic aromatic system that has at least one heteroatom N, O, P, S, B, Se, Ge, or any combination thereof as a ring-forming atom, and 1 to 60 carbon atoms. Examples of the $C_1$-$C_{60}$ heteroaryl group include a pyridinyl group, a pyrimidinyl group, a pyrazinyl group, a pyridazinyl group, a triazinyl group, a quinolinyl group, and an isoquinolinyl group. When the $C_6$-$C_{60}$ heteroaryl group and the $C_6$-$C_{60}$ heteroarylene group each include two or more rings, the rings may be fused to each other.
The term "$C_6$-$C_{60}$ aryloxy group" as used herein indicates $-OA_{102}$ (wherein $A_{102}$ is the $C_6$-$C_{60}$ aryl group), and the term "$C_6$-$C_{60}$ arylthio group" as used herein indicates $-SA_{103}$ (wherein $A_{103}$ is the $C_6$-$C_{60}$ aryl group).
The term "monovalent aromatic condensed polycyclic group" as used herein refers to a monovalent group having two or more rings condensed with each other, including only carbon atoms (for example, the number of carbon atoms may be in a range of 8 to 60) as ring-forming atoms, and having aromaticity in its molecular structure when

considered as a whole. The term "divalent aromatic condensed polycyclic group" as used herein refers to a divalent group having the same structure as the monovalent aromatic condensed polycyclic group.

The term "monovalent aromatic condensed heteropolycyclic group" as used herein refers to a monovalent group having at least two rings condensed with each other, including a heteroatom N, O, P, Si, and S as well as carbon atoms (for example, the number of carbon atoms may be in a range of 1 to 60) as ring-forming atoms, and having aromaticity in its molecular structure when considered as a whole. The term "divalent aromatic condensed heteropolycyclic group" as used herein refers to a divalent group having the same structure as the monovalent aromatic condensed heteropolycyclic group.

The term "monovalent non-aromatic condensed polycyclic group" used herein refers to a monovalent group in which two or more rings are condensed with each other, only carbon is used as a ring-forming atom (for example, the number of carbon atoms may be 8 to 60) and the whole molecule is a non-aromaticity group. Examples of the monovalent non-aromatic condensed polycyclic group include a fluorenyl group. The term "divalent non-aromatic condensed polycyclic group" as used herein refers to a divalent group having the same structure as the monovalent non-aromatic condensed polycyclic group described above.

The term "monovalent non-aromatic condensed heteropolycyclic group" as used herein refers to a monovalent group having two or more rings condensed to each other, a heteroatom N, O, P, Si, S, B, Se, Ge, or any combination thereof, other than carbon atoms (for example, having 1 to 60 carbon atoms), as a ring-forming atom, and no aromaticity in its entire molecular structure. Examples of the monovalent non-aromatic condensed heteropolycyclic group include a carbazolyl group. The term "divalent non-aromatic condensed heteropolycyclic group" as used herein refers to a divalent group having the same structure as the monovalent non-aromatic condensed heteropolycyclic group described above.

The term "$\pi$ electron-depleted nitrogen-containing $C_1$-$C_{60}$ cyclic group" as used herein refers to a cyclic group having 1 to 60 carbon atoms and including at least one *-N=*' (wherein * and *' each indicate a binding site to an adjacent atom) as a ring-forming moiety. For example, the $\pi$ electron-depleted nitrogen-containing $C_1$-$C_{60}$ cyclic group may be a) a first ring, b) a condensed ring in which at least two first rings are condensed, or c) a condensed ring in which at least one first ring and at least one second ring are condensed with each other.

The term "$\pi$ electron-rich $C_3$-$C_{60}$ cyclic group" as used herein refers to a cyclic group having 3 to 60 carbon atoms and not including at least one *-N=*' (wherein * and *' each indicate a binding site to an adjacent atom) as a ring-forming moiety. For example, the $\pi$ electron-rich $C_3$-$C_{60}$ cyclic group may be a) a second ring or b) a condensed ring in which at least two second rings are condensed.

The term "$C_5$-$C_{60}$ carbocyclic group" as used herein refers to a monocyclic or polycyclic group having 5 to 60 carbon atoms, and may be, for example, a) a third ring or b) a condensed ring in which two or more third rings are condensed with each other.

The term "$C_1$-$C_{60}$ heterocyclic group" as used herein refers to a monocyclic or polycyclic group that has 1 to $_{60}$ carbon atoms and includes at least one heteroatom, and may be, for example, a) a fourth ring, b) a condensed ring in which two or more fourth rings are condensed with each other, or c) a condensed ring in which at least one third ring is condensed with at least one fourth ring.

The "first ring" as used herein may be an imidazole group, a pyrazole group, a thiazole group, an isothiazole group, an oxazole group, an isoxazole group, a pyridine group, a pyrazine group, a pyridazine group, a pyrimidine group, a triazole group, a tetrazole group, an oxadiazole group, a triazine group, or a thiadiazole group.

The "second ring" as used herein may be a benzene group, a cyclopentadiene group, a pyrrole group, a furan group, a thiophene group, or a silole group.

The "third ring" as used herein may be a cyclopentane group, a cyclopentadiene group, an indene group, an adamantane group, a norbornene group, a bicyclo[1.1.1]pentane group, a bicyclo[2.1.1]hexane group, a bicyclo[2.2.1]heptane group (a norbornane group), a bicyclo[2.2.2]octane group, a cyclohexane group, a cyclohexene group, or a benzene group.

The "fourth ring" as used herein may be a furan group, a thiophene group, a pyrrole group, a silole group, an oxazole group, an isoxazole group, an oxadiazole group, an isoxadiazole group, an oxatriazole group, an isoxatriazole group, a thiazole group, an isothiazole group, a thiadiazole group, an isothiadiazole group, a thiatriazole group, an isothiatriazole group, a pyrazole group, an imidazole group, a triazole group, a tetrazole group, an azasilole group, a diazasilole group, a triazasilole group, a pyridine group, a pyrimidine group, a pyrazine group, a pyridazine group, or a triazine group.

In some embodiments, the $\pi$ electron-depleted nitrogen-containing $C_1$-$C_{60}$ cyclic group may be an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a benzoisoquinoline group, a phthalazine group, a naphthyridine group, a quinoxaline group, a benzoquinoxaline group, a quinazoline group, a cinnoline group, a phenanthridine group, an acridine group, a phenanthroline group, a phenazine group, a benzimidazole group, an isobenzothiazole group, a benzoxazole

group, an isobenzoxazole group, a triazole group, a tetrazole group, an oxadiazole group, a triazine group, a thiadiazole group, an imidazopyridine group, an imidazopyrimidine group, an azacarbazole group, an azadibenzofuran group, an azadibenzothiophene group, an azadibenzosilole group, an acridine group, or a pyridopyrazine group:
In some embodiments, the π electron-rich $C_3$-$C_{60}$ cyclic group may be a benzene group, a heptalene group, an indene group, a naphthalene group, an azulene group, an indacene group, an acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a pentaphene group, a rubicene group, a coronene group, an ovalene group, a pyrrole group, a furan group, a thiophene group, an isoindole group, an indole group, an indene group, a benzofuran group, a benzothiophene group, a benzosilole group, a naphthopyrrole group, a naphthofuran group, a naphthothiophene group, a naphthosilole group, a benzocarbazole group, a dibenzocarbazole group, a dibenzofuran group, a dibenzothiophene group, a carbazole group, a dibenzosilole group, an indenocarbazole group, an indolocarbazole group, a benzofurocarbazole group, a benzothienocarbazole group, a benzosilolocarbazole group, a triindolobenzene group, a pyrrolophenanthrene group, a furanophenanthrene group, a thienophenanthrene group, a benzonaphthofuran group, a benzonapthothiophene group, an (indolo)phenanthrene group, a (benzofurano)phenanthrene group, or a (benzothieno)phenanthrene group.

For example, the $C_5$-$C_{60}$ carbocyclic group may be a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, cyclopentadiene group, an indene group, a fluorene group, a 5,6,7,8-tetrahydroisoquinoline group, a 5,6,7,8-tetrahydroquinoline group, an adamantane group, a norbornane group, or a norbornene group.

For example, the $C_1$-$C_{60}$ heterocyclic group may be a thiophene group, a furan group, a pyrrole group, a cyclopentadiene group, a silole group, a borole group, a phosphole group, a selenophene group, a germole group, a benzothiophene group, a benzofuran group, an indole group, an indene group, a benzosilole group, a benzoborole group, a benzophosphole group, a benzoselenophene group, a benzogermole group, a dibenzothiophene group, a dibenzofuran group, a carbazole group, a dibenzosilole group, a dibenzoborole group, a dibenzophosphole group, a dibenzoselenophene group, a dibenzogermole group, a dibenzothiophene 5-oxide group, a 9H-fluorene-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, or a benzothiadiazole group.

The term "a π electron-deficient nitrogen-containing $C_1$-$C_{60}$ cyclic group, a π electron-rich $C_3$-$C_{60}$ cyclic group, a $C_5$-$C_{60}$ cyclic group, and a $C_1$-$C_{60}$ heterocyclic group" may be part of a condensed cycle or may be a monovalent, a divalent, a trivalent, a tetravalent, a pentavalent, or a hexavalent group, depending on the formula structure.

As used herein, the number of carbons in each group that is substituted (e.g., $C_1$-$C_{60}$) excludes the number of carbons in the substituent. For example, a $C_1$-$C_{60}$ alkyl group can be substituted with a $C_1$-$C_{60}$ alkyl group. The total number of carbons included in the $C_1$-$C_{60}$ alkyl group substituted with the $C_1$-$C_{60}$ alkyl group is not limited to 60 carbons. In addition, more than one $C_1$-$C_{60}$ alkyl substituent may be present on the $C_1$-$C_{60}$ alkyl group. This definition is not limited to the $C_1$-$C_{60}$ alkyl group and applies to all substituted groups that recite a carbon range.

In the present specification, at least one substituent of the substituted $C_5$-$C_{30}$ carbocyclic group, the substituted $C_1$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_6$-$C_{60}$ aryloxy group, the substituted $C_6$-$C_{60}$ arylthio group, the substituted $C_1$-$C_{60}$ heteroaryl group, the substituted monovalent aromatic condensed polycyclic group, the substituted monovalent aromatic condensed heteropolycyclic group, the substituted monovalent non-aromatic condensed polycyclic group, and the substituted monovalent non-aromatic condensed heteropolycyclic group may be:

deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a $C_1$-$C_{60}$ alkyl group, a $C_2$-$C_{60}$ alkenyl group, a

$C_2$-$C_{60}$ alkynyl group, or a $C_1$-$C_{60}$ alkoxy group;

a $C_1$-$C_{60}$ alkyl group, a $C_2$-$C_{60}$ alkenyl group, a $C_2$-$C_{60}$ alkynyl group, or a $C_1$-$C_{60}$ alkoxy group, each substituted with at least one deuterium, -F, -Cl, - Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent aromatic condensed polycyclic group, a monovalent aromatic condensed heteropolycyclic group, a monovalent non-aromatic condensed polycyclic group, a monovalent non-aromatic condensed heteropolycyclic group, -$N(Q_{11})(Q_{12})$, $-Si(Q_{13})(Q_{14})(Q_{15})$, $-B(Q_{16})(Q_{17})$, $-P(=O)(Q_{18})(Q_{19})$, or any combination thereof;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent aromatic condensed polycyclic group, a monovalent aromatic condensed heteropolycyclic group, a monovalent non-aromatic condensed polycyclic group, or a monovalent non-aromatic condensed heteropolycyclic group;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent aromatic condensed polycyclic group, a monovalent aromatic condensed heteropolycyclic group, a monovalent non-aromatic condensed polycyclic group, or a monovalent non-aromatic condensed heteropolycyclic group, each substituted with at least one of deuterium, -F, -Cl, -Br, -I, $-CD_3$, - $CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent aromatic condensed polycyclic group, a monovalent aromatic condensed heteropolycyclic group, a monovalent non-aromatic condensed polycyclic group, a monovalent non-aromatic condensed heteropolycyclic group, -$N(Q_{21})(Q_{22})$, $-Si(Q_{23})(Q_{24})(Q_{25})$, $-B(Q_{26})(Q_{27})$, $-P(=O)(Q_{28})(Q_{29})$, or any combination thereof; or

$-N(Q_{31})(Q_{32})$, $-Si(Q_{33})(Q_{34})(Q_{35})$, $-B(Q_{36})(Q_{37})$, or $-P(=O)(Q_{38})(Q_{39})$,

wherein $Q_1$ to $Q_9$, $Q_{11}$ to $Q_{19}$, $Q_{21}$ to $Q_{29}$, and $Q_{31}$ to $Q_{39}$ may each independently be hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryl group substituted with at least one a $C_1$-$C_{60}$ alkyl group, a $C_6$-$C_{60}$ aryl group, or any combination thereof, a $C_6$-$C_{60}$ aryloxy group, a $C_6$-$C_{60}$ arylthio group, a $C_1$-$C_{60}$ heteroaryl group, a monovalent aromatic condensed polycyclic group, a monovalent aromatic condensed heteropolycyclic group, a monovalent non-aromatic condensed polycyclic group, or a monovalent non-aromatic condensed heteropolycyclic group.

The term "room temperature" used herein refers to a temperature of about 25 °C.

The terms "a biphenyl group, a terphenyl group, and a tetraphenyl group" used herein respectively refer to monovalent groups in which two, three, or four phenyl groups which are linked together via a single bond.

The terms "a cyano-containing phenyl group, a cyano-containing biphenyl group, a cyano-containing terphenyl group, and a cyano-containing tetraphenyl group" used herein respectively refer to a phenyl group, a biphenyl group, a terphenyl group, and a tetraphenyl group, each of which is substituted with at least one cyano group. In "a cyano-containing phenyl group, a cyano-containing biphenyl group, a cyano-containing terphenyl group, and a cyano-containing tetraphenyl group", a cyano group may be substituted to any position of the corresponding group, and the "cyano-containing phenyl group, the cyano-containing biphenyl group, the cyano-containing terphenyl group, and the cyano-containing tetraphenyl group" may further include substituents other than a cyano group. For example, a phenyl group substituted with a cyano group, and a phenyl group substituted with a cyano group and a methyl group may all belong to "a cyano-containing phenyl group."

Hereinafter, a compound and an organic light-emitting device according to embodiments are described in detail with reference to Synthesis Examples and Examples. However, the organic light-emitting device is not limited thereto. The wording "'B' was used instead of 'A'" used in describing Synthesis Examples means that an amount of 'A' used was identical to an amount of 'B' used, in terms of a molar equivalent.

[Examples]

Synthesis Example 1: Synthesis of Compound 5 (5,9-di([1,1'-biphenyl]-4-yl)-7-(9H-carbazol-9-yl)-12,16-diphenyl-5,16-dihydro-9H-5,9,16-triaza-13b-boraindeno[1,2-a]naphtho[1,2,3-fg]anthracene)

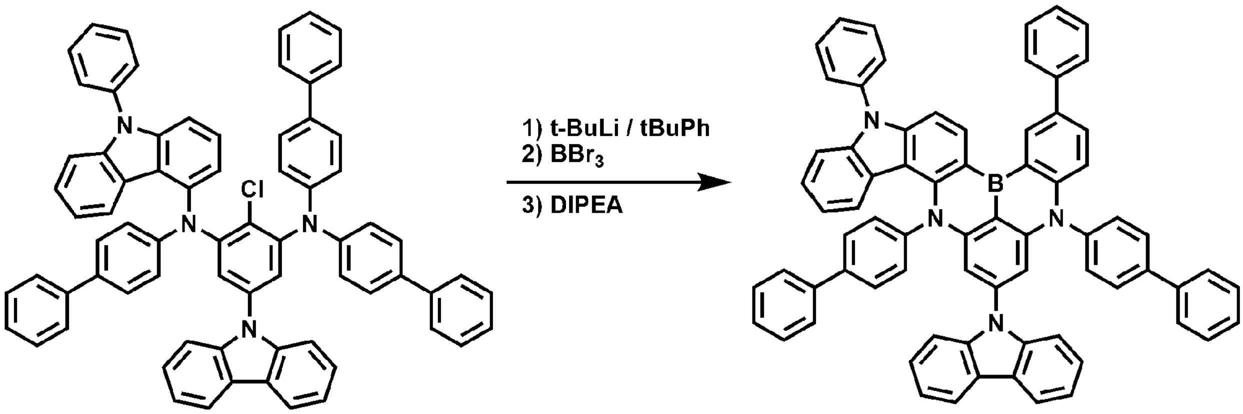


N1,N1,N3-tri([1,1'-biphenyl]-4-yl)-5-(9H-carbazol-9-yl)-2-chloro-N3-(9-phenyl-9H-carbazol-4-yl)benzene-1,3-diamine (6.4 g, 5.54 mmol) was added to a 50 mL round-bottom flask, and t-Bu-benzene (184 mL) was added thereto in a nitrogen atmosphere. The resultant mixture was cooled to -78 °C by using dry ice and acetone, and then, t-BuLi (11.0 mL, 16.61 mmol) was slowly added and stirred at 60 °C for 2 hours. The temperature was lowered to -78 °C, and $BBr_3$ (1.1 mL, 11.07 mmol) was slowly added thereto, followed by 2 hours of stirring at room temperature. The temperature was lowered to 0 °C using an ice water bath, and then, i-$Pr_2$NEt (3.4 mL, 19.38 mmol) was slowly added thereto and stirred at 130 °C for 4 hours. The reaction solution was cooled to 0°C using an ice water bath, and then, the reaction was terminated with 5% sodium acetate (20 mL), followed by extraction with 100 mL of EtOAc. The organic layer was collected, and then, $MgSO_4$ was added thereto to remove water, and then filtered and concentrated. The concentrated reaction product was purified by silica gel column chromatography (DCM:hexanes=2:8) to obtain Compound 5 (3.21 g) as a yellow solid. The obtained Compound 5 was identified by UPLC-MS ($C_{72}H_{47}BN_4$ : 978.99).

Synthesis Example 2: Synthesis of Compound 7(16-([1,1'-biphenyl]-3-yl)-5,9-di([1,1'-biphenyl]-4-yl)-7,11-di(9H-carbazol-9-yl)-5,16-dihydro-9H-5,9,16-triaza-13b-boraindeno[1,2-a]naphtho[1,2,3-fg]anthracene)

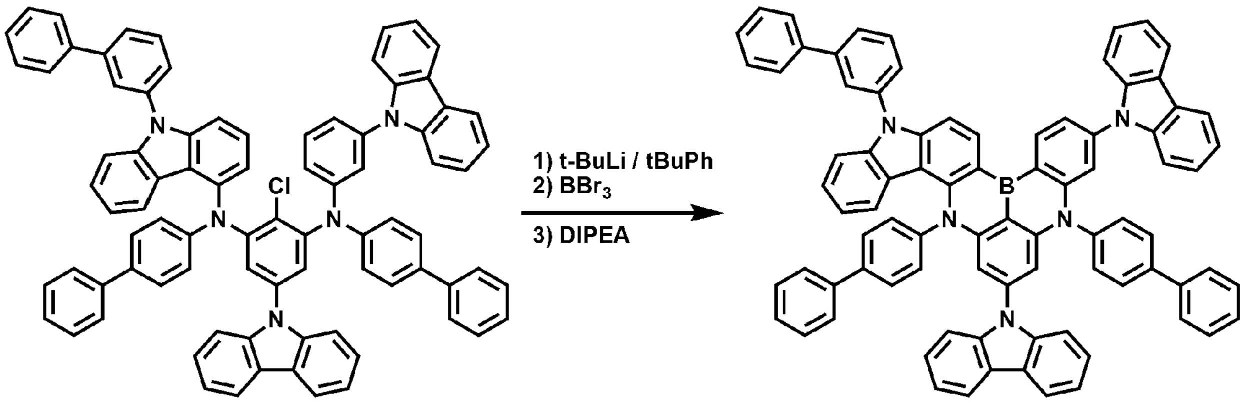


Compound 7 (1.1g) was prepared in the same manner as in Synthesis Example 1, except that N1-(3-(9H-carbazol-9-yl)phenyl)-N3-(9-([1,1'-biphenyl]-3-yl)-9H-carbazol-4-yl)-N1,N3-di([1,1'-biphenyl]-4-yl)-5-(9H-carbazol-9-yl)-2-chlorobenzene-1,3-diamine(4.0 g) was used instead of N1,N1,N3-tri([1,1'-biphenyl]-4-yl)-5-(9H-carbazol-9-yl)-2-chloro-N3-(9-phenyl-9H-carbazol-4-yl)benzene-1,3-diamine. The compound was identified by UPLC-MS ($C_{84}H_{54}BN_5$:1144.42).

Evaluation Example 1: Evaluation of maximum emission wavelength (PL max) and FWHM

Compound 5 was diluted in toluene to a concentration of 1.0 $\times$ $10^{-5}$ M, and the photoluminescence (PL) spectrum thereof was measured at room temperature using an ISC PC1 spectrofluorometer equipped with a xenon lamp. The maximum emission wavelength of Compound 5 was 461 nm, and the FWHM thereof was evaluated as 19 nm, confirming suitability for deep blue light emission. In addition, the PL spectrum of Compound 5 is illustrated in FIG. 5.

Example 1-1

An ITO glass substrate was cut to a size of 50 mm $\times$ 50 mm $\times$ 0.5 mm and then, sonicated in acetone isopropyl alcohol and pure water, each for 15 minutes, and then, washed by exposure to ultraviolet (UV) light ozone for 30 minutes.

Then, HAT-CN was deposited on the ITO electrode (anode) on the glass substrate to form a hole injection layer having a thickness of 100 Å, NPB was deposited on the hole injection layer to form a first hole transport layer having a thickness of 500 Å, TCTA was deposited on the first hole transport layer to form a second hole transport layer having a thickness of 50 Å, and mCP was deposited on the second hole transport layer to form an electron blocking layer having a thickness of 50 Å.

A first host (Compound H1), a second host (Compound H2) and an emitter (Compound 5) were co-deposited on the electron-blocking layer to form an emission layer having a thickness of 400 Å. In this regard, the first host and the second host were mixed in a weight ratio of 60:40, and the emitter was adjusted to be 3 wt% based on the total weight of the first host, the second host, and the emitter.

DBFPO was deposited on the emission layer to form a hole blocking layer having a thickness of 100 Å, and then DBFPO and Liq were co-deposited thereon at a weight ratio of 5:5 to form an electron transport layer having a thickness of 300 Å, and then, Liq was deposited on the electron transport layer to form an electron injection layer having a thickness of 10 Å, and Al was deposited on the electron injection layer to form a cathode having a thickness of 1000 Å, thereby completing the manufacture of an organic light-emitting device.

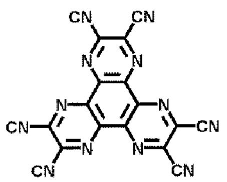
HT-D1(HAT-CN)

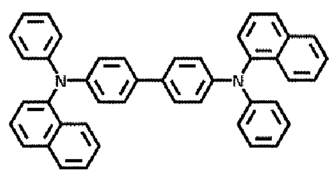
NPB

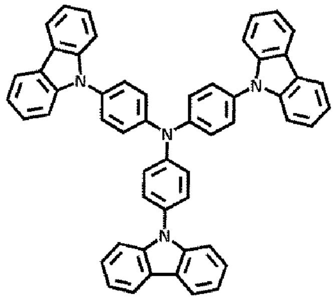
TCTA

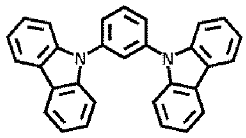
mCP

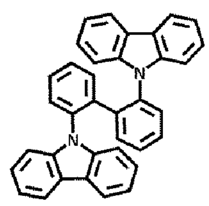
H1

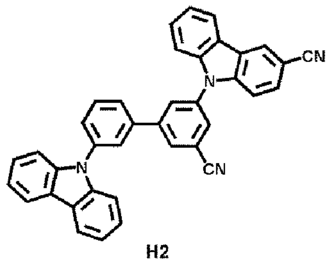
H2

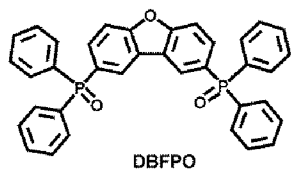
DBFPO

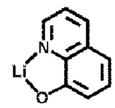
Liq

## Example 1-2

An organic light-emitting device was manufactured in the same manner as Example 1-1, except that Compound 7 was used as the dopant to form the emission layer.

Comparative Example 1-1

An organic light-emitting device was manufactured in the same manner as in Example 1-1, except that, in forming an emission layer, for use as a dopant, corresponding compounds shown in Table 2 were used.

Example 2-1

A glass substrate with an ITO electrode located thereon was cut to a size of 50 mm × 50 mm × 0.5 mm and then, sonicated in acetone isopropyl alcohol and pure water, each for 15 minutes, and then, washed by exposure to UV ozone for 30 minutes.

Then, HAT-CN was deposited on the ITO electrode (anode) on the glass substrate to form a hole injection layer having a thickness of 100 Å, NPB was deposited on the hole injection layer to form a first hole transport layer having a thickness of 500 Å, TCTA was deposited on the first hole transport layer to form a second hole transport layer having a thickness of 50 Å, and mCP was deposited on the second hole transport layer to form an electron blocking layer having a thickness of 50 Å.

A first host (Compound H1), a second host (Compound H2), a sensitizer (Compound S-1), and an emitter (Compound 1) were co-deposited on the electron blocking layer to form an emission layer having a thickness of 400 Å. At this time, the first host and the second host were mixed at a weight ratio of 60:40, and the amounts of the sensitizer and the emitter were adjusted to be 15 wt% and 1 wt%, respectively, based on the total weight of the first host, the second host, the sensitizer, and the emitter.

DBFPO was deposited on the emission layer to form a hole blocking layer having a thickness of 100 Å, and then DBFPO and Liq were co-deposited thereon at a weight ratio of 5:5 to form an electron transport layer having a thickness of 300 Å, and then, Liq was deposited on the electron transport layer to form an electron injection layer having a thickness of 10 Å, and Al was deposited on the electron injection layer to form a cathode having a thickness of 1000 Å, thereby completing the manufacture of an organic light-emitting device.

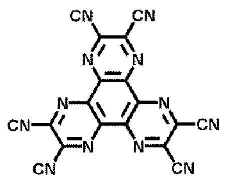
HT-D1(HAT-CN)

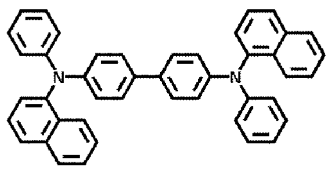
NPB

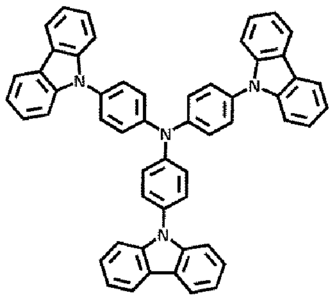
TCTA

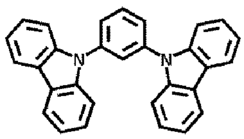
mCP

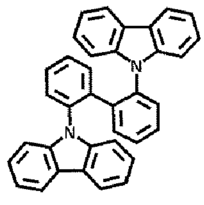
H1

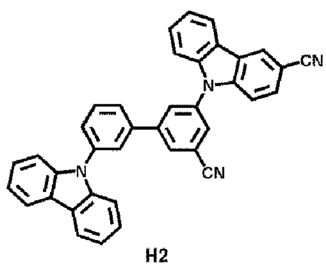
H2

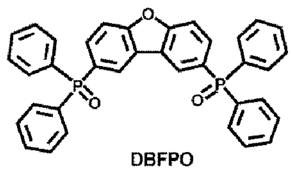
DBFPO

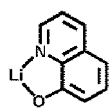
Liq

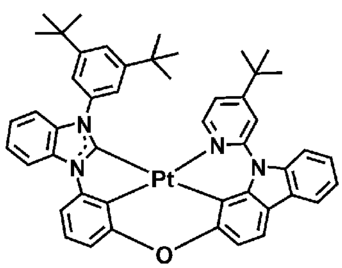
S-1

## Example 2-2

An organic light-emitting device was manufactured in the same manner as in Example 1-1, except that, in

forming an emission layer, for use as a sensitizer and a dopant, Compound 7 was used.

Comparative Example 2-1

An organic light-emitting device was manufactured in the same manner as in Example 2-1, except that, in forming an emission layer, for use as a sensitizer and a dopant, the compound shown in Table 3 was used.

Evaluation Example: Evaluation of OLED characteristics

The driving voltage, maximum external quantum efficiency, and/or maximum emission wavelength of the organic light-emitting devices manufactured in Examples and Comparative Example above were measured using a current-voltage meter (Keithley 2400) and a luminance meter (Minolta Cs-1000A), and results thereof are shown in Tables 2 and 3.

Table 2

| | Dopant | $\lambda_{max}$ | Driving voltage (V) | $EQE_{max}$ (%) |
|---|---|---|---|---|
| Example 1-1 | Compound 5 | 461 | 5.19 | 18.4 |
| Example 1-2 | Compound 7 | 458 | 5.07 | 17.8 |
| Comparative Example 1-1 | Comparative Example 10 | 465 | 5.21 | 17.9 |

Table 3

| | Sensitizer | Dopant | $\lambda_{max}$ (nm) | Driving voltage (V) |
|---|---|---|---|---|
| Example 2-1 | S-1 | Compound 5 | 462 | 4.36 |
| Example 2-2 | S-1 | Compound 7 | 461 | 4.32 |
| Comparative Example 2-1 | S-1 | Comparative Example 10 | 465 | 4.39 |

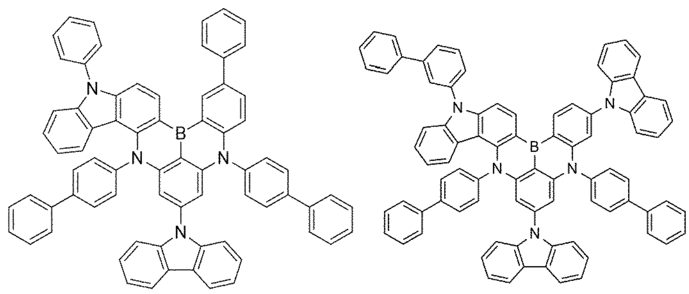

< Compound 5 > < Compound 7 >

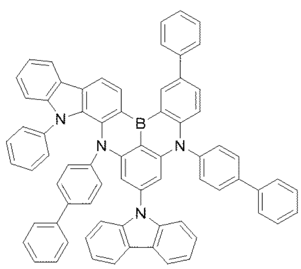

<Comparative Example 10>

Referring to Table 2, it can be seen that the organic light-emitting devices of Examples 1-1 and 1-2 are suitable for deep blue light emission and have a low driving voltage compared to the organic light-emitting device of Comparative

Example 1-1. In general, it is known that EQE significantly decreases as the wavelength of light emitted from an organic light-emitting device becomes shorter. However, the organic light-emitting device of Example 1-1 showed significantly improved EQE while emitting a shorter wavelength compared to the organic light-emitting device of Comparative Example 1-1, and the organic light-emitting device of Example 1-2 shows a similar level of EQE while emitting significantly shorter wavelength of light compared to the organic light-emitting device of Comparative Example 1-1. Accordingly, it can be seen that the organic light-emitting devices of Examples 1-1 and 1-2 show, compared to the organic light-emitting device of Comparative Example 1-1, further improved EQE within the desired wavelength range compared to the light-emitting device.

Referring to Table 3, it can be seen that the organic light-emitting devices of Examples 2-1 and 2-2 are suitable for deep blue light emission and have a low driving voltage compared to the organic light-emitting device of Comparative Example 1-1.

In addition, referring to Tables 2 and 3, it can be seen that the heterocyclic compound is applicable to all organic light-emitting devices that emit light through various mechanisms.

An organic light-emitting device including the heterocyclic compound may have improved efficiency and/or color purity.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A heterocyclic compound represented by Formula 1:

Formula 1

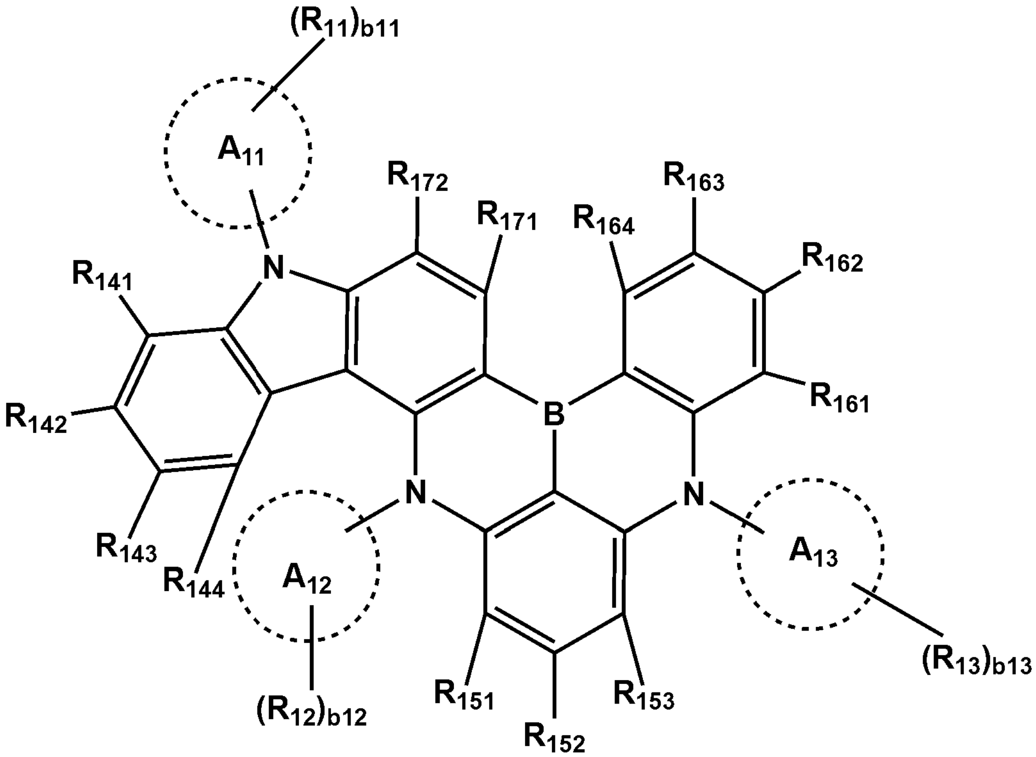

wherein, in Formula 1,

$A_{11}$ to $A_{13}$ are each independently a substituted or unsubstituted $C_5$-$C_{30}$ carbocyclic group or a substituted or unsubstituted $C_1$-$C_{30}$ heterocyclic group,

$R_{11}$ to $R_{13}$, $R_{141}$ to $R_{144}$, $R_{151}$ to $R_{153}$, $R_{161}$ to $R_{164}$, $R_{171}$, and $R_{172}$ are each independently hydrogen, deuterium,

-F, -Cl, -Br, -I, a hydroxyl group, a cyano group, a nitro group, an amidino group, a hydrazino group, a hydrazono group, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkylaryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, a substituted or unsubstituted monovalent non-aromatic condensed heteropolycyclic group, $-Si(Q_1)(Q_2)(Q_3)$, $-C(Q_1)(Q_2)(Q_3)$, $-B(Q_1)(Q_2)$, $-N(Q_1)(Q_2)$, $-P(Q_1)(Q_2)$, $-C(=O)(Q_1)$, $-S(=O)(Q_1)$, $-S(=O)_2(Q_1)$, $-P(=O)(Q_1)(Q_2)$, or $-P(=S)(Q_1)(Q_2)$,

b11 to b13 are each independently 0, 1, 2, 3, 4, 5, or 6,

$Q_1$ to $Q_3$ are each independently hydrogen, deuterium, -F, -Cl, -Br, -I, a hydroxyl group, a cyano group, a nitro group, an amidino group, a hydrazino group, a hydrazono group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, a $C_1$-$C_{60}$ alkyl group that is substituted with at least one deuterium, -F, a cyano group, a $C_1$-$C_{60}$ alkyl group, a $C_6$-$C_{60}$ aryl group, or any combination thereof, or a $C_6$-$C_{60}$ aryl group substituted with at least one deuterium, -F, a cyano group, a $C_1$-$C_{60}$ alkyl group, a $C_6$-$C_{60}$ aryl group, or any combination thereof, and

* indicates a binding site to an adjacent atom.

**2.** The heterocyclic compound of claim 1, wherein $A_{11}$ to $A_{13}$ are each independently a benzene group or a naphthalene group; and/or

wherein at least one of $R_{11}$ to $R_{13}$, $R_{141}$ to $R_{144}$, $R_{151}$ to $R_{153}$, $R_{161}$ to $R_{164}$, $R_{171}$, and $R_{172}$ is a group represented by one of Formulae 2-1 to 2-6 or a group represented by one of Formulae 2-1 to 2-6 in which at least one hydrogen is substituted with deuterium:

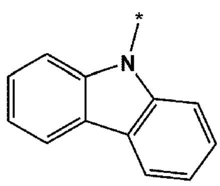

2-1

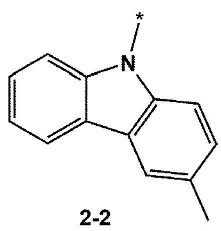

2-2

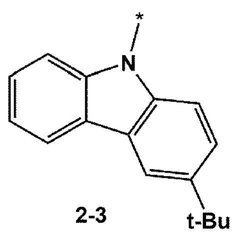

2-3

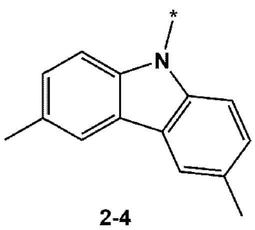

2-4

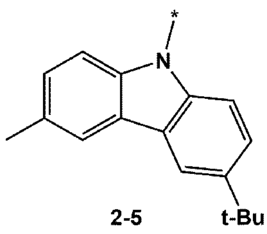

2-5

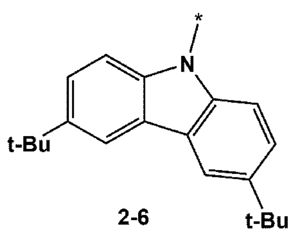

2-6

wherein, in Formulae 2-1 to 2-6,

t-Bu is a tert-butyl group, and

* indicates a binding site to an adjacent atom.

**3.** The heterocyclic compound of claims 1 or 2, wherein

at least one of $R_{151}$ to $R_{153}$ and $R_{161}$ to $R_{164}$ is a group represented by one of Formulae 2-1 to 2-6 or a group

represented by one of Formulae 2-1 to 2-6 in which at least one hydrogen is substituted with deuterium:

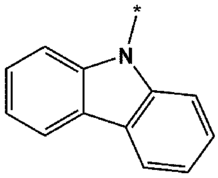
2-1
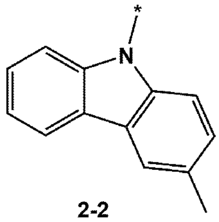
2-2
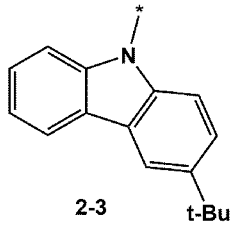
2-3
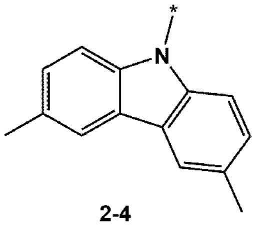
2-4
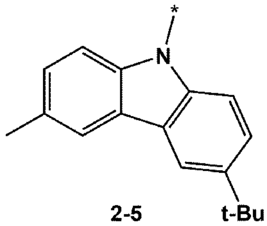
2-5
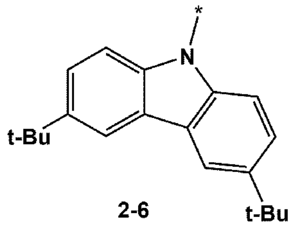
2-6

wherein, in Formulae 2-1 to 2-6,
t-Bu is a tert-butyl group, and
* indicates a binding site to an adjacent atom.

**4.** The heterocyclic compound of any of claims 1-3, wherein

at least one of $R_{152}$ and $R_{162}$ is a group represented by one of Formulae 2-1 to 2-6 or a group represented by one of Formulae 2-1 to 2-6 in which at least one hydrogen is substituted with deuterium:

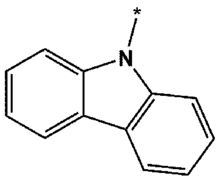
2-1
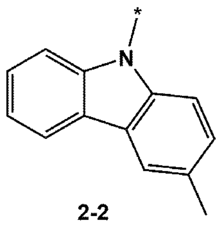
2-2
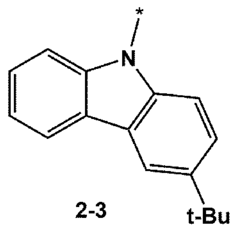
2-3
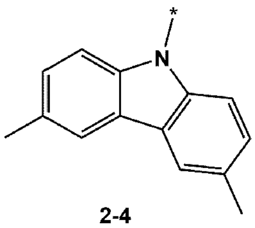
2-4
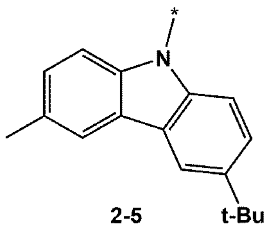
2-5
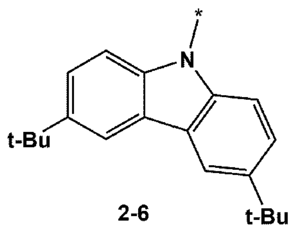
2-6

wherein, in Formulae 2-1 to 2-6,
t-Bu is a tert-butyl group, and
* indicates a binding site to an adjacent atom.

**5.** The heterocyclic compound of any of claims 1-4, wherein the heterocyclic compound is represented by Formula 1-1:

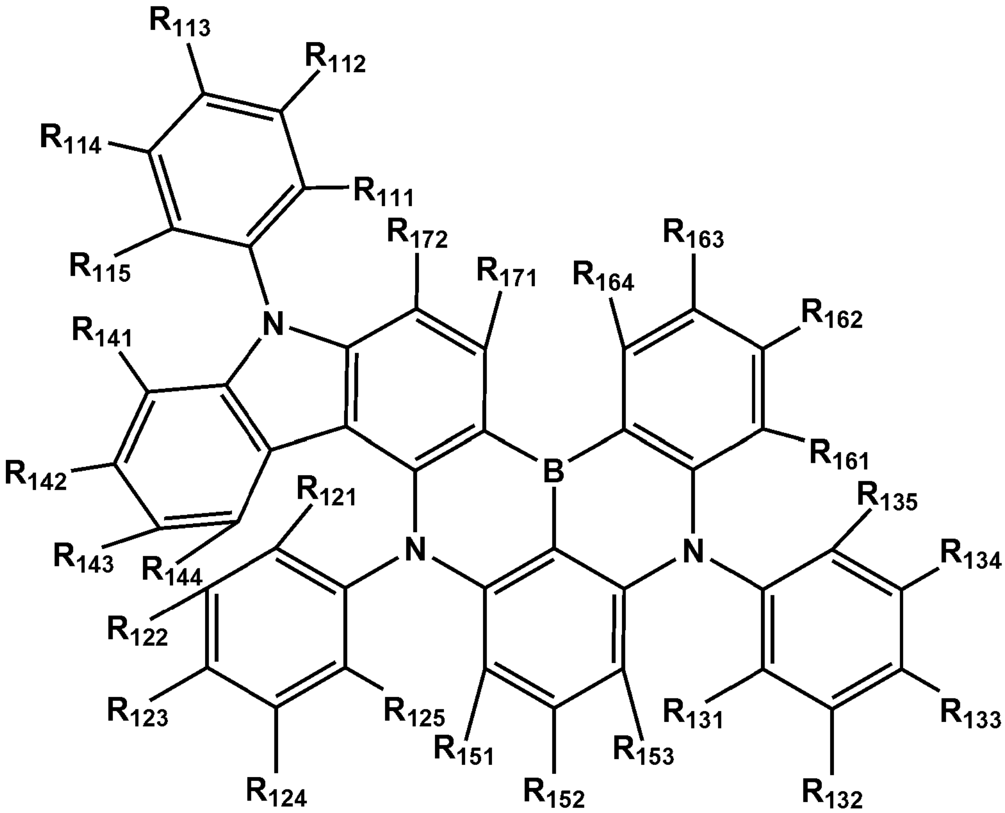

; preferably wherein

at least one of $R_{151}$ to $R_{153}$ and $R_{161}$ to $R_{164}$ is a group represented by one of Formulae 2-1 to 2-6 or a group represented by one of Formulae 2-1 to 2-6 in which at least one hydrogen is substituted with deuterium:

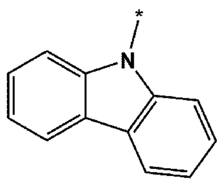

2-1

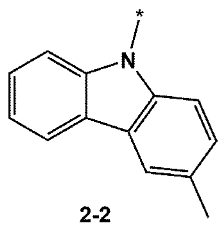

2-2

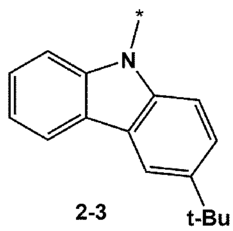

2-3

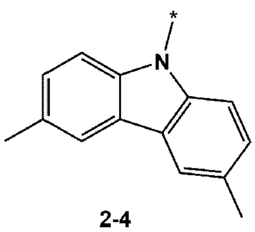

2-4

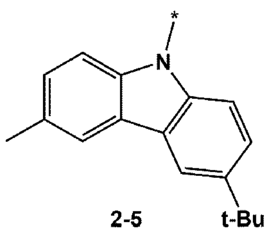

2-5

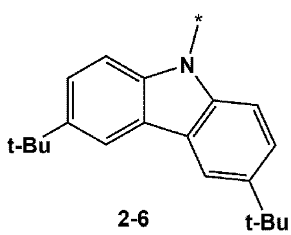

2-6

wherein, in Formulae 2-1 to 2-6,
t-Bu is a tert-butyl group, and
* indicates a binding site to an adjacent atom.

**6.** The heterocyclic compound of any of claims 1-5, wherein a peak wavelength in a photoluminescence (PL) spectrum of the heterocyclic compound is at least 430 nm and not more than 500 nm; and/or

wherein a full width at half maximum (FWHM) of the heterocyclic compound is 45 nm or less;
wherein the peak wavelength and full width at half maximum are measured according to the method of Evaluation

Example 1 in the description.

**7.** An organic light-emitting device comprising:

a first electrode;
a second electrode; and
an organic layer arranged between the first electrode and the second electrode and comprising an emission layer, wherein the organic layer comprises the heterocyclic compound of any of claims 1-6.

**8.** The organic light-emitting device of claim 7, wherein the heterocyclic compound is included in the emission layer.

**9.** The organic light-emitting device of claim 8, wherein: the emission layer comprises a host and an emitter, the host and the emitter are different from each other, and the heterocyclic compound is included in the emitter.

**10.** The organic light-emitting device of claim 9, wherein a peak wavelength of light emitted from the emission layer is at least 430 nm and not more than 500 nm, wherein the peak wavelength of light is measured using a luminance meter; and/or
wherein the emitter is a fluorescence emitter, a delayed fluorescence emitter, or a combination thereof.

**11.** The organic light-emitting device of any of claims 8-10, wherein: the emission layer comprises a host, an emitter, and a sensitizer, the host, the emitter, and the sensitizer are different from each other, and the heterocyclic compound is included in the emitter.

**12.** The organic light-emitting device of claim 11, wherein a peak wavelength of light emitted from the emission layer is at least 430 nm and not more than 500 nm, wherein the peak wavelength of light is measured using a luminance meter.

**13.** The organic light-emitting device of claims 11 or 12, wherein the emitter is a fluorescence emitter, a delayed fluorescence emitter, or a combination thereof.

**14.** The organic light-emitting device of any of claims 11-13, wherein

the sensitizer and the heterocyclic compound satisfy Condition 5:

Condition 5 $0\ \mu s < T_{decay}(HC) < 5\ \mu s$

wherein, in Condition 5,
$T_{decay}(HC)$ indicates a decay time of the heterocyclic compound, and
the decay time of the heterocyclic compound is measured from a time-resolved photoluminescence spectrum at room temperature of a film having a thickness of 40 nm formed by vacuum-depositing the host and the heterocyclic compound included in the emission layer on a quartz substrate at a weight ratio of 90:10 at a vacuum pressure of $1.33 \times 10^{-5}$ Pa ($10^{-7}$ torr).

**15.** An electronic apparatus comprising the organic light-emitting device of any of claims 7-14.

**Patentansprüche**

**1.** Heterocyclische Verbindung, dargestellt durch Formel 1:

Formel 1

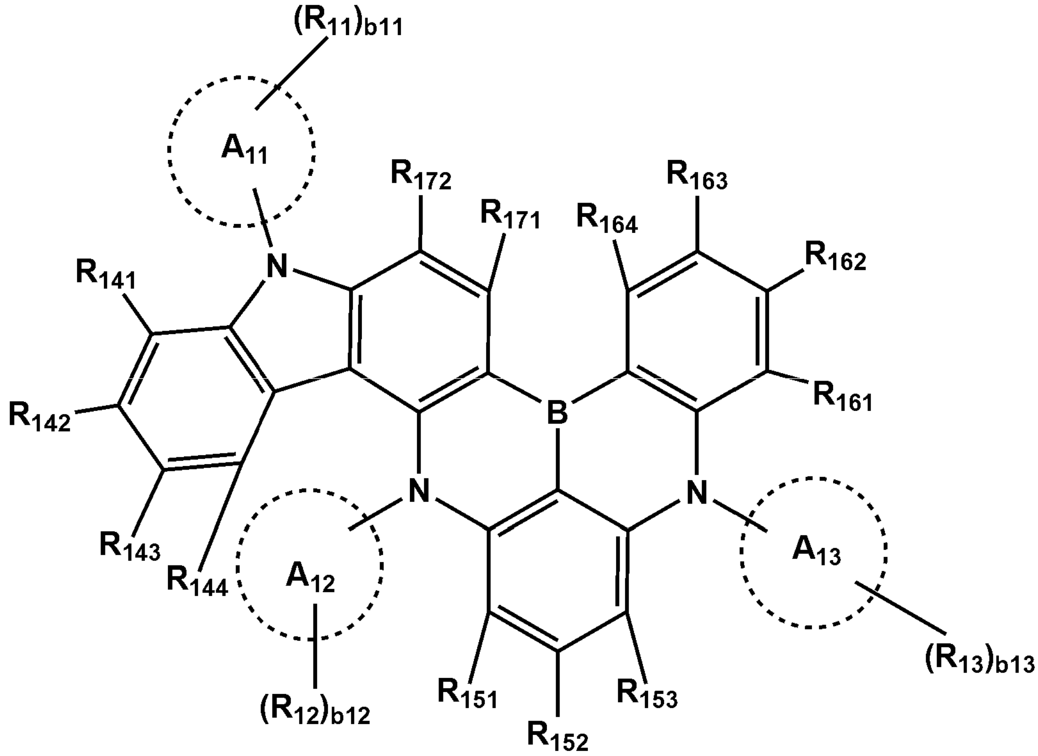

wobei in Formel 1

$A_{11}$ bis $A_{13}$ jeweils unabhängig eine substituierte oder unsubstituierte carbocyclische $C_5$-$C_{30}$-Gruppe oder eine substituierte oder unsubstituierte heterocyclische $C_1$-$C_{30}$-Gruppe sind,

Rn bis $R_{13}$, $R_{141}$ bis $R_{144}$, $R_{151}$ bis $R_{153}$, $R_{161}$ bis $R_{164}$, $R_{171}$ und $R_{172}$ jeweils unabhängig ausgewählt sind aus Wasserstoff, Deuterium, -F, -Cl, -Br, -I, einer Hydroxygruppe, einer Cyanogruppe, einer Nitrogruppe, einer Amidinogruppe, einer Hydrazingruppe, einer Hydrazongruppe, einer substituierten oder unsubstituierten $C_1$-$C_{60}$-Alkylgruppe, einer substituierten oder unsubstituierten $C_2$-$C_{60}$-Alkenylgruppe, einer substituierten oder unsubstituierten $C_2$-$C_{60}$-Alkinylgruppe, einer substituierten oder unsubstituierten $C_1$-$C_{60}$-Alkoxygruppe, einer substituierten oder unsubstituierten $C_3$-$C_{10}$-Cycloalkylgruppe, einer substituierten oder unsubstituierten $C_1$-$C_{10}$-Heterocycloalkylgruppe, einer substituierten oder unsubstituierten $C_3$-$C_{10}$-Cycloalkenylgruppe, einer substituierten oder unsubstituierten $C_1$-$C_{10}$-Heterocycloalkenylgruppe, einer substituierten oder unsubstituierten $C_6$-$C_{60}$-Arylgruppe, einer substituierten oder unsubstituierten $C_7$-$C_{60}$-Alkylarylgruppe, einer substituierten oder unsubstituierten $C_6$-$C_{60}$-Aryloxygruppe, einer substituierten oder unsubstituierten $C_6$-$C_{60}$-Arylthiogruppe, einer substituierten oder unsubstituierten $C_1$-$C_{60}$-Heteroarylgruppe, einer substituierten oder unsubstituierten $C_2$-$C_{60}$-Alkylheteroarylgruppe, einer substituierten oder unsubstituierten $C_1$-$C_{60}$-Heteroaryloxygruppe, einer substituierten oder unsubstituierten $C_1$-$C_{60}$-Heteroarylthiogruppe, einer substituierten oder unsubstituierten einwertigen nichtaromatischen kondensierten polycyclischen Gruppe, einer substituierten oder unsubstituierten einwertigen nichtaromatischen kondensierten heteropolycyclischen Gruppe, $-Si(Q_1)(Q_2)(Q_3)$, $-C(Q_1)(Q_2)(Q_3)$, $-B(Q_1)(Q_2)$, $-N(Q_1)(Q_2)$, $-P(Q_1)(Q_2)$, $-C(=O)(Q_1)$, $-S(=O)(Q_1)$, $-S(=O)_2(Q_1)$, $-P(=O)(Q_1)(Q_2)$ oder $-P(=S)(Q_1)(Q_2)$,

b11 und b13 jeweils unabhängig 0, 1, 2, 3, 4, 5 oder 6 sind,

$Q_1$ bis $Q_3$ jeweils unabhängig Folgendes sind: Wasserstoff, Deuterium, -F, -Cl, -Br, -I, eine Hydroxygruppe, eine Cyanogruppe, eine Nitrogruppe, eine Amidinogruppe, eine Hydrazingruppe, eine Hydrazongruppe, eine $C_1$-$C_{60}$-Alkylgruppe, eine $C_2$-$C_{60}$-Alkenylgruppe, eine $C_2$-$C_{60}$-Alkinylgruppe, eine $C_1$-$C_{60}$-Alkoxygruppe, eine $C_3$-$C_{10}$-Cycloalkylgruppe, eine $C_1$-$C_{10}$-Heterocycloalkylgruppe, eine $C_3$-$C_{10}$-Cycloalkenylgruppe, eine $C_1$-$C_{10}$-Heterocycloalkenylgruppe, eine $C_6$-$C_{60}$-Arylgruppe, eine $C_7$-$C_{60}$-Alkylarylgruppe, eine $C_6$-$C_{60}$-Aryloxygruppe, eine $C_6$-$C_{60}$-Arylthiogruppe, eine $C_1$-$C_{60}$-Heteroarylgruppe, eine $C_2$-$C_{60}$-Alkyl-Heteroarylgruppe, eine $C_1$-$C_{60}$-Heteroaryloxygruppe, eine $C_1$-$C_{60}$-Heteroarylthiogruppe, eine einwertige nichtaromatische kondensierte polycyclische Gruppe, eine einwertige nichtaromatische kondensierte heteropolycyclische Gruppe, eine $C_1$-$C_{60}$-Alkylgruppe, die mit mindestens einem von Deuterium, -F, einer Cyanogruppe, einer $C_1$-$C_{60}$-Alkylgruppe, einer $C_6$-$C_{60}$-Arylgruppe oder einer Kombination davon substituiert ist, oder eine $C_6$-$C_{60}$-Arylgruppe, die

mit mindestens einem von Deuterium, -F, einer Cyanogruppe, einer $C_1$-$C_{60}$-Alkylgruppe, einer $C_6$-$C_{60}$-Arylgruppe oder einer Kombination davon substituiert ist, und
* eine Bindungsstelle zu einem benachbarten Atom anzeigt.

**2.** Heterocyclische Verbindung nach Anspruch 1, wobei An bis $A_{13}$ jeweils unabhängig eine Benzolgruppe oder eine Naphthalingruppe sind, und/oder

wobei mindestens einer von Rn bis $R_{13}$, $R_{141}$ bis $R_{144}$, $R_{151}$ bis $R_{153}$, $R_{161}$ bis $R_{164}$, $R_{171}$ und $R_{172}$ eine durch eine von Formeln 2-1 bis 2-6 dargestellte Gruppe oder eine durch eine von Formeln 2-1 bis 2-6 dargestellte Gruppe ist, in der mindestens ein Wasserstoff durch Deuterium ersetzt ist:

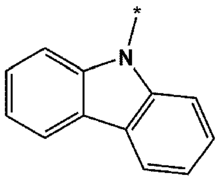
2-1

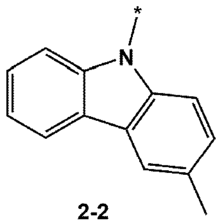
2-2

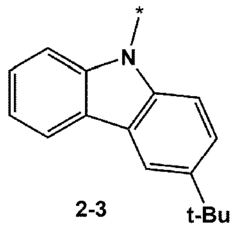
2-3

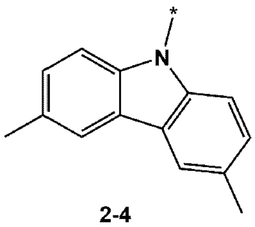
2-4

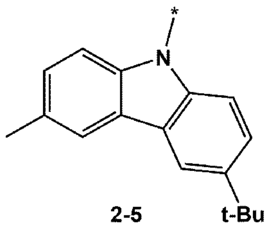
2-5

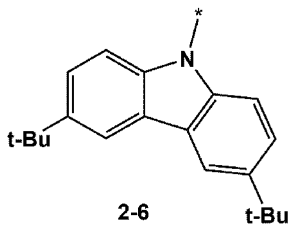
2-6

wobei in Formeln 2-1 bis 2-6
t-Bu eine tert-Butylgruppe ist und
* eine Bindungsstelle zu einem benachbarten Atom anzeigt.

**3.** Heterocyclische Verbindung nach Anspruch 1 oder 2, wobei

mindestens einer von $R_{151}$ bis $R_{153}$ und $R_{161}$ bis $R_{164}$ eine Gruppe ist, die durch eine von Formeln 2-1 bis 2-6 dargestellt wird, oder eine Gruppe ist, die durch eine von Formeln 2-1 bis 2-6 dargestellt wird, in der mindestens ein Wasserstoff durch Deuterium substituiert ist:

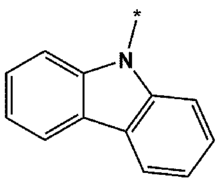
2-1

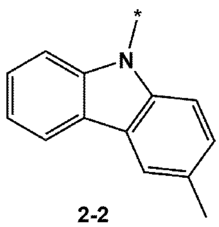
2-2

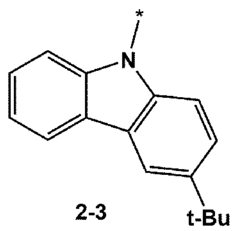
2-3

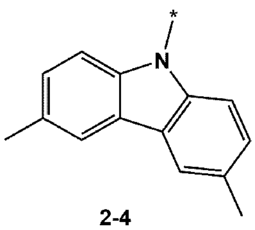
2-4

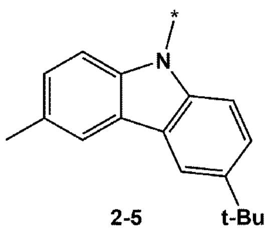
2-5

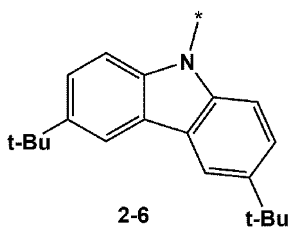
2-6

wobei in Formeln 2-1 bis 2-6

t-Bu eine tert-Butylgruppe ist und
* eine Bindungsstelle zu einem benachbarten Atom anzeigt.

**4.** Heterocyclische Verbindung nach einem der Ansprüche 1 bis 3, wobei

mindestens einer von $R_{152}$ und $R_{162}$ eine durch eine von Formeln 2-1 bis 2-6 dargestellte Gruppe oder eine durch eine von Formeln 2-1 bis 2-6 dargestellte Gruppe ist, in der mindestens ein Wasserstoff durch Deuterium ersetzt ist:

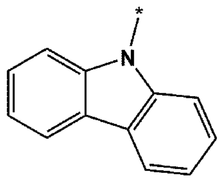
2-1

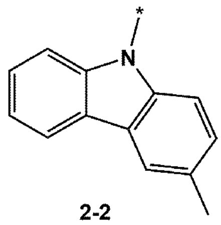
2-2

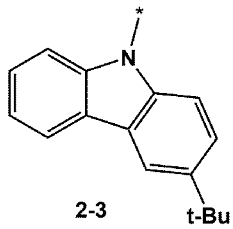
2-3

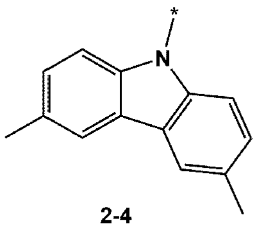
2-4

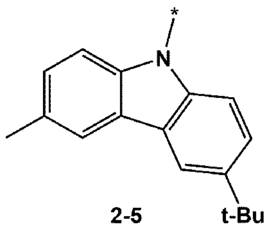
2-5

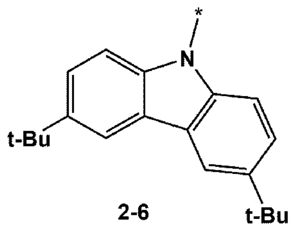
2-6

wobei in Formeln 2-1 bis 2-6
t-Bu eine tert-Butylgruppe ist und
* eine Bindungsstelle zu einem benachbarten Atom anzeigt.

**5.** Heterocyclische Verbindung nach einem der Ansprüche 1 bis 4, wobei

die heterocyclische Verbindung durch Formel 1-1 dargestellt wird:

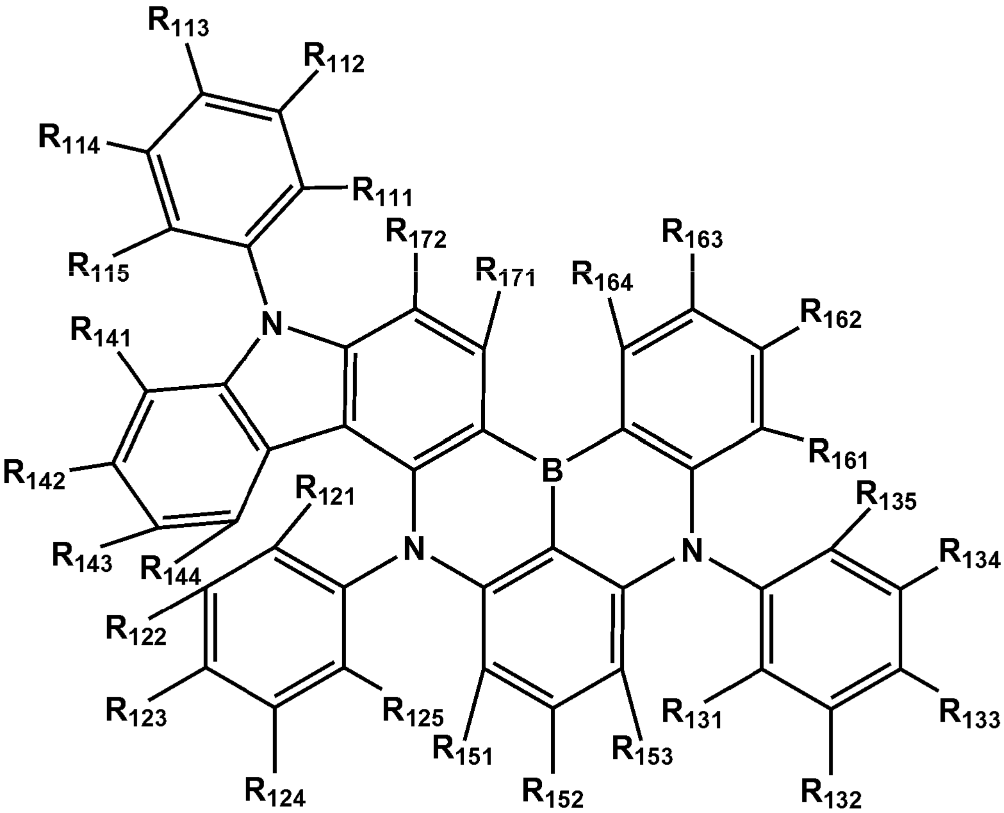

vorzugsweise wobei
mindestens einer von $R_{151}$ bis $R_{153}$ und $R_{161}$ bis $R_{164}$ eine Gruppe ist, die durch eine von Formeln 2-1 bis 2-6 dargestellt wird, oder eine Gruppe ist, die durch eine von Formeln 2-1 bis 2-6 dargestellt wird, in der mindestens ein Wasserstoff durch Deuterium substituiert ist:

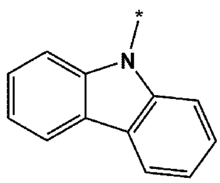

2-1

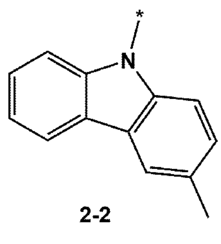

2-2

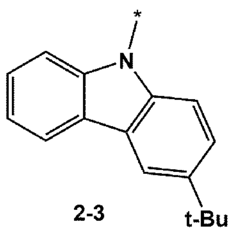

2-3

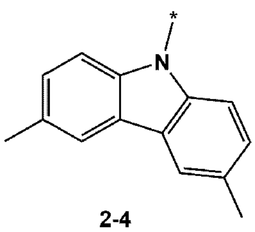

2-4

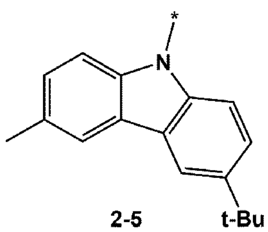

2-5

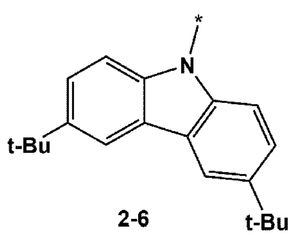

2-6

wobei, in Formeln 2-1 bis 2-6,
t-Bu eine tert-Butylgruppe ist, und
* eine Bindungsstelle zu einem benachbarten Atom anzeigt.

6. Heterocyclische Verbindung nach einem der Ansprüche 1 bis 5, wobei eine Peak-Wellenlänge in einem Photolumineszenz (PL)-Spektrum der heterocyclischen Verbindung mindestens 430 nm und höchstens 500 nm betragt, und/oder

wobei die Halbwertsbreite (FWHM) der heterocyclischen Verbindung 45 nm oder weniger beträgt;
wobei die Peak-Wellenlänge und die Halbwertsbreite gemäß dem Verfahren von Bewertungsbeispiel 1 in der Beschreibung gemessen werden.

**7.** Organische lichtemittierende Vorrichtung, umfassend:

eine erste Elektrode,
eine zweite Elektrode, und
eine organische Schicht, die zwischen der ersten Elektrode und der zweiten Elektrode vorgesehen ist und eine Emissionsschicht umfasst,
wobei die organische Schicht die heterocyclische Verbindung nach einem der Ansprüche 1 bis 6 umfasst.

**8.** Organische lichtemittierende Vorrichtung nach Anspruch 7, wobei die heterocyclische Verbindung in der Emissionsschicht enthalten ist.

**9.** Organische lichtemittierende Vorrichtung nach Anspruch 8, wobei die Emissionsschicht einen Wirt und einen Emitter umfasst, wobei sich der Wirt und der Emitter voneinander unterscheiden und die heterocyclische Verbindung im Emitter enthalten ist.

**10.** Organische Licht emittierende Vorrichtung nach Anspruch 9, wobei eine Peak-Wellenlänge des von der Emissionsschicht emittierten Lichts mindestens 430 nm und höchstens 500 nm beträgt, wobei die Peak-Wellenlänge des Lichts unter Verwendung eines Leuchtdichtemessgeräts gemessen wird, und/oder
wobei der Emitter ein Fluoreszenzemitter, ein verzögerter Fluoreszenzemitter oder eine Kombination davon ist.

**11.** Organische lichtemittierende Vorrichtung nach einem der Ansprüche 8 bis 10, wobei die Emissionsschicht einen Wirt, einen Emitter und einen Sensibilisator umfasst, wobei der Wirt, der Emitter und der Sensibilisator sich voneinander unterscheiden und die heterocyclische Verbindung im Emitter enthalten ist.

**12.** Organische lichtemittierende Vorrichtung nach Anspruch 11, wobei eine Peak-Wellenlänge des von der Emissionsschicht emittierten Lichts mindestens 430 nm und höchstens 500 nm beträgt, wobei die Peak-Wellenlänge des Lichts unter Verwendung eines Leuchtdichtemessgeräts gemessen wird.

**13.** Organische lichtemittierende Vorrichtung nach Anspruch 11 oder 12, wobei der Emitter ein Fluoreszenzemitter, ein verzögerter Fluoreszenzemitter oder eine Kombination davon ist.

**14.** Organische lichtemittierende Vorrichtung nach einem der Ansprüche 11 bis 13, wobei der Sensibilisator und die heterocyclische Verbindung Bedingung 5 erfüllen:

Bedingung 5 $$0\ \mu s < T_{decay}(HC) < 5\ \mu s$$

wobei in Bedingung 5

$T_{decay}(HC)$ eine Zerfallszeit der heterocyclischen Verbindung angibt, und
die Zerfallszeit der heterocyclischen Verbindung anhand eines zeitaufgelösten Photolumineszenzspektrums bei Raumtemperatur eines 40 nm dicken Films gemessen wird, der durch Vakuumabscheiden des Wirts und der in der Emissionsschicht enthaltenen heterocyclischen Verbindung auf einem Quarzsubstrat in einem Masseverhältnis von 90:10 bei einem Vakuumdruck von $1,33 \times 10^{-5}$ Pa ($10^{-7}$ Torr) gebildet wird.

**15.** Elektronische Einrichtung, umfassend die organische lichtemittierende Vorrichtung nach einem der Ansprüche 7 bis 14.

## Revendications

**1.** Composé hétérocyclique représenté par la formule 1 :

Formule 1

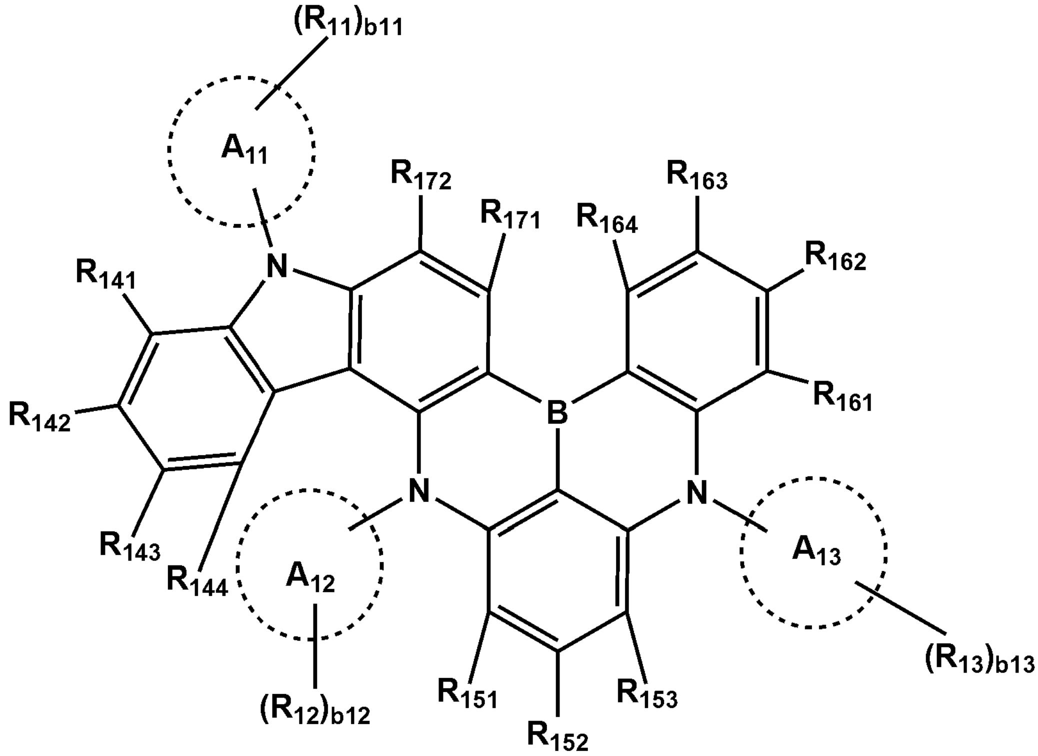

dans lequel, dans la formule 1,

An à $A_{13}$ sont chacun indépendamment un groupe $C_5$-$C_{30}$ carbocyclique substitué ou non substitué ou un groupe $C_1$-$C_{30}$ hétérocyclique substitué ou non substitué,

$R_{11}$ à $R_{13}$, $R_{141}$ à $R_{144}$, $R_{151}$ à $R_{153}$, $R_{161}$ à $R_{164}$, $R_{171}$, et $R_{172}$ sont chacun indépendamment hydrogène, deutérium, -F, -Cl, -Br, -I, un groupe hydroxyle, un groupe cyano, un groupe nitro, un groupe amidino, un groupe hydrazino, un groupe hydrazono, un groupe $C_1$-$C_{60}$ alkyle substitué ou non substitué, un groupe $C_2$-$C_{60}$ alkényle substitué ou non substitué, un groupe $C_2$-$C_{60}$ alkynyle substitué ou non substitué, un groupe $C_1$-$C_{60}$ alkoxy substitué ou non substitué, un groupe $C_3$-$C_{10}$ cycloalkyle substitué ou non substitué, un groupe $C_1$-$C_{10}$ hétérocycloalkyle substitué ou non substitué, un groupe $C_3$-$C_{10}$ cycloalkényle substitué ou non substitué, un groupe $C_1$-$C_{10}$ hétérocycloalkényle substitué ou non substitué, un groupe $C_6$-$C_{60}$ aryle substitué ou non substitué, un groupe $C_7$-$C_{60}$ alkylaryle substitué ou non substitué, un groupe $C_6$- $C_{60}$ aryloxy substitué ou non substitué, un groupe $C_6$-$C_{60}$ arylthio substitué ou non substitué, un groupe $C_1$-$C_{60}$ hétéroaryle substitué ou non substitué, un groupe $C_2$-$C_{60}$ alkyle hétéroaryle substitué ou non substitué, un groupe $C_1$-$C_{60}$ hétéroaryloxy substitué ou non substitué, un groupe $C_1$-$C_{60}$ hétéroarylthio substitué ou non substitué, un groupe polycyclique condensé non aromatique monovalent substitué ou non substitué, un groupe hétéropolycyclique condensé non aromatique monovalent substitué ou non substitué, $-Si(Q_1)(Q_2)(Q_3)$, $-C(Q_1)(Q_2)(Q_3)$, $-B(Q_1)(Q_2)$, $-N(Q_1)(Q_2)$, $-P(Q_1)(Q_2)$, $-C(=O)(Q_1)$, - $S(=O)(Q_1)$, $-S(=O)_2(Q_1)$, $-P(=O)(Q_1)(Q_2)$, ou $-P(=S)(Q_1)(Q_2)$,

b11 à b13 sont chacun indépendamment 0, 1, 2, 3, 4, 5 ou 6,

$Q_1$ à $Q_3$ sont chacun indépendamment hydrogène, deutérium, -F, -Cl, -Br, -I, un groupe hydroxyle, un groupe cyano, un groupe nitro, un groupe amidino, un groupe hydrazino, un groupe hydrazono, un groupe $C_1$-$C_{60}$ alkyle, un groupe $C_2$-$C_{60}$ alkényle, un groupe $C_2$-$C_{60}$ alkynyle, un groupe $C_1$-$C_{60}$ alkoxy, un groupe $C_3$-$C_{10}$ cycloalkyle, un groupe $C_1$-$C_{10}$ hétérocycloalkyle, un groupe $C_3$-$C_{10}$ cycloalkényle, un groupe $C_1$-$C_{10}$ hétérocycloalkényle, un groupe $C_6$-$C_{60}$ aryle, un groupe $C_7$-$C_{60}$ alkyl aryle, un groupe $C_6$-$C_{60}$ aryloxy, un groupe $C_6$-$C_{60}$ arylthio, un groupe $C_1$-$C_{60}$ hétéroaryle, un groupe $C_2$-$C_{60}$ alkyl hétéroaryle, un groupe $C_1$-$C_{60}$ hétéroaryloxy, un groupe $C_1$-$C_{60}$ hétéroarylthio, un groupe polycyclique condensé non aromatique monovalent, un groupe hétéropolycyclique condensé non aromatique monovalent, un groupe $C_1$-$C_{60}$ alkyle qui est substitué par au moins un deutérium, -F, un groupe cyano, un groupe $C_1$-$C_{60}$ alkyle, un groupe $C_6$-$C_{60}$ aryle, ou toute combinaison de ceux-ci, ou un groupe $C_6$-$C_{60}$ aryle substitué par au moins un deutérium, -F, un groupe cyano, un groupe $C_1$-$C_{60}$ alkyle, un groupe $C_6$-$C_{60}$ aryle, ou toute combinaison de ceux-ci, et

* indique un site de liaison à un atome adjacent.

**2.** Composé hétérocyclique selon la revendication 1, dans lequel An à $A_{13}$ sont chacun indépendamment un groupe benzène ou un groupe naphtalène ; et/ou

dans lequel au moins l'un de $R_{11}$ à $R_{13}$, $R_{141}$ à $R_{144}$, $R_{151}$ à $R_{153}$, $R_{161}$ à $R_{164}$, $R_{171}$, et $R_{172}$ est un groupe représenté par l'une des formules 2-1 à 2-6 ou un groupe représenté par l'une des formules 2-1 à 2-6, dans lequel au moins un hydrogène est substitué par deutérium :

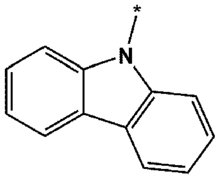
2-1
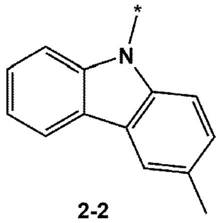
2-2
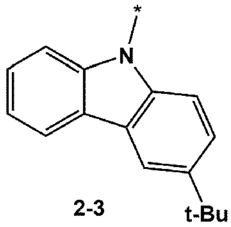
2-3
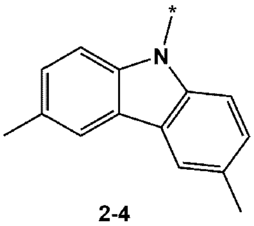
2-4
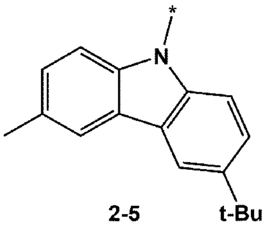
2-5
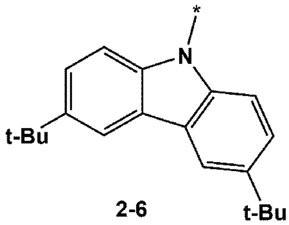
2-6

dans lequel, dans les formules 2-1 à 2-6,
t-Bu est un groupe tert-butyle, et
* indique un site de liaison à un atome adjacent.

**3.** Composé hétérocyclique selon les revendications 1 ou 2, dans lequel

au moins l'un de $R_{151}$ à $R_{153}$ et $R_{161}$ à $R_{164}$ est un groupe représenté par l'une des formules 2-1 à 2-6 ou un groupe représenté par l'une des formules 2-1 à 2-6, dans lequel au moins un hydrogène est substitué par deutérium :

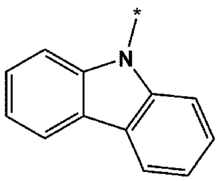
2-1
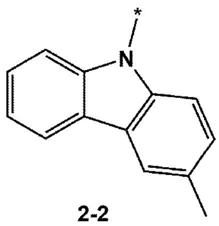
2-2
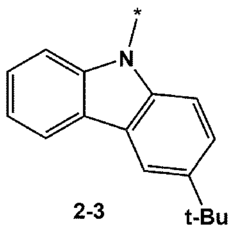
2-3
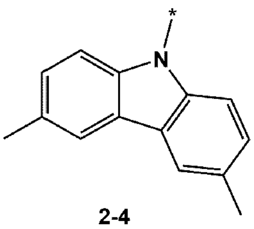
2-4
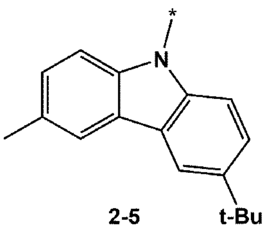
2-5
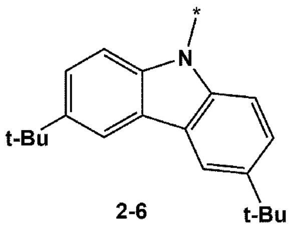
2-6

dans lequel, dans les formules 2-1 à 2-6,
t-Bu est un groupe tert-butyle, et
* indique un site de liaison à un atome adjacent.

**4.** Composé hétérocyclique selon l'une quelconque des revendications 1-3, dans lequel

au moins l'un de $R_{152}$ et $R_{162}$ est un groupe représenté par l'une des formules 2-1 à 2-6 ou un groupe représenté par l'une des Formules 2-1 à 2-6 dans lequel au moins un hydrogène est substitué par deutérium :

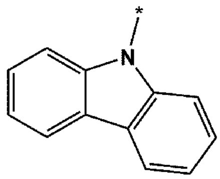
2-1

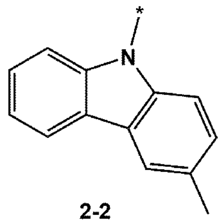
2-2

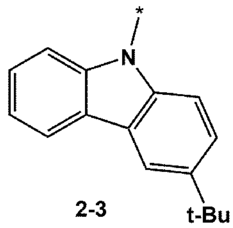
2-3

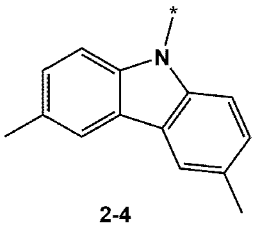
2-4

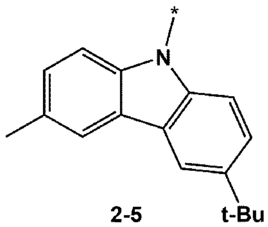
2-5

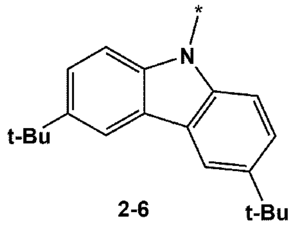
2-6

dans lequel, dans les formules 2-1 à 2-6,
t-Bu est un groupe tert-butyle, et
* indique un site de liaison à un atome adjacent.

**5.** Composé hétérocyclique selon l'une quelconque des revendications 1-4, dans lequel le composé hétérocyclique est représenté par la formule 1-1 :

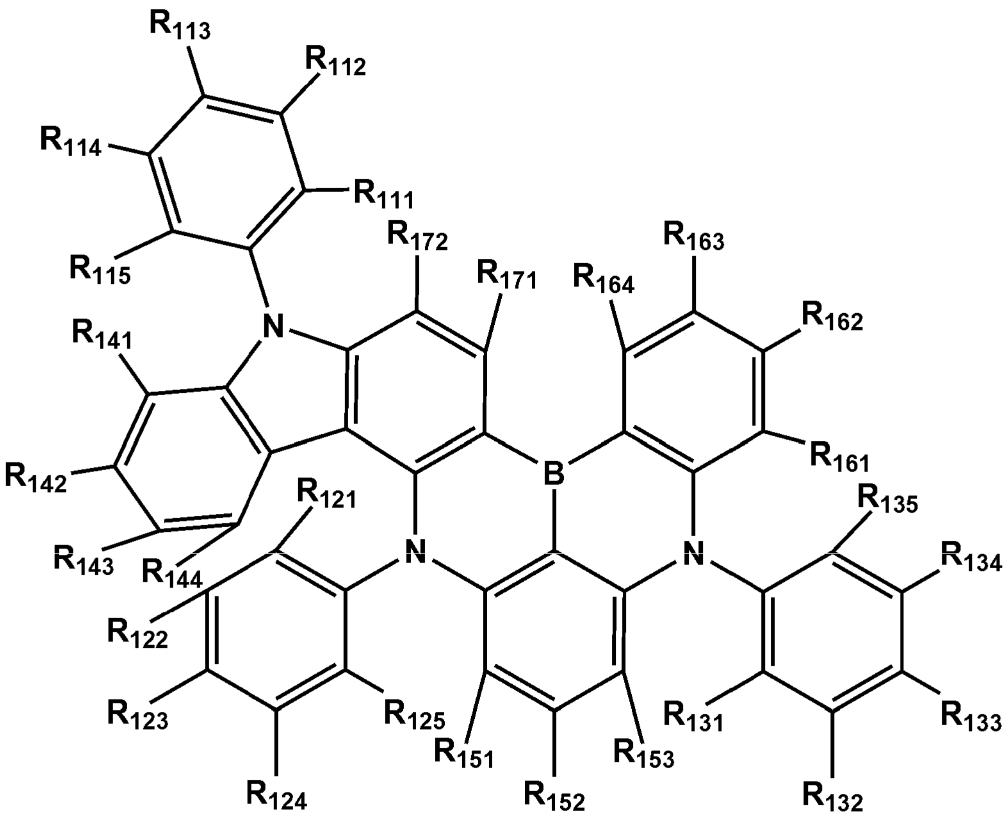

de préférence dans lequel

au moins l'un de $R_{151}$ à $R_{153}$ et $R_{161}$ à $R_{164}$ est un groupe représenté par l'une des formules 2-1 à 2-6 ou un

groupe représenté par l'une des formules 2-1 à 2-6 dans lequel au moins un hydrogène est substitué par deutérium :

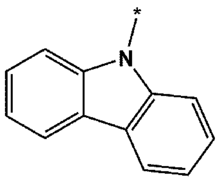
2-1

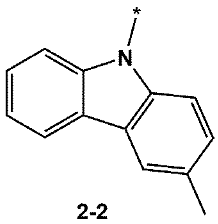
2-2

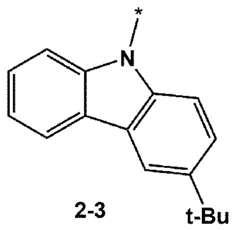
2-3

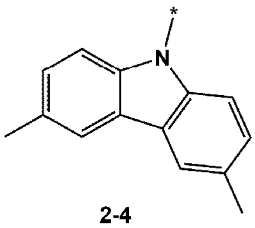
2-4

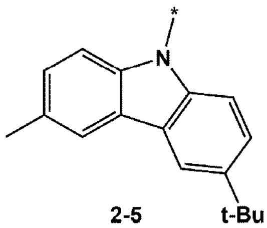
2-5

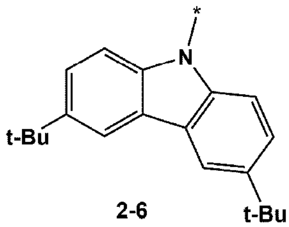
2-6

dans lequel, dans les formules 2-1 à 2-6,
t-Bu est un groupe tert-butyle, et
* indique un site de liaison à un atome adjacent.

**6.** Composé hétérocyclique selon l'une quelconque des revendications 1-5, dans lequel une longueur d'onde pic dans un spectre de photoluminescence (PL) du composé hétérocyclique est d'au moins 430 nm et ne dépasse pas 500 nm ; et/ou

dans lequel une largeur totale à mi-hauteur (LTMH) du composé hétérocyclique est de 45 nm ou moins ;
dans lequel la longueur d'onde pic et la largeur totale à mi-hauteur sont mesurées conformément à la méthode d'évaluation de l'exemple 1 figurant dans la description.

**7.** Dispositif électroluminescent organique comprenant :

une première électrode ;
une seconde électrode ; et
une couche organique disposée entre la première électrode et la seconde électrode et comprenant une couche émissive,
dans lequel la couche organique comprend le composé hétérocyclique selon l'une quelconque des revendications 1-6.

**8.** Dispositif électroluminescent organique selon la revendication 7, dans lequel le composé hétérocyclique est compris dans la couche émissive.

**9.** Dispositif électroluminescent organique selon la revendication 8, dans lequel :
la couche émissive comprend un hôte et un émetteur, l'hôte et l'émetteur sont différents l'un de l'autre, et le composé hétérocyclique est compris dans l'émetteur.

**10.** Dispositif électroluminescent organique selon la revendication 9, dans lequel une longueur d'onde pic de lumière émise par la couche émissive est d'au moins 430 nm et ne dépasse pas 500 nm, dans lequel la longueur d'onde pic de lumière est mesurée au moyen d'un luminancemètre ; et/ou
dans lequel l'émetteur est un émetteur de fluorescence, un émetteur de fluorescence retardée, ou une combinaison de ceux-ci.

**11.** Dispositif électroluminescent organique selon l'une quelconque des revendications 8-10, dans lequel :

la couche émissive comprend un hôte, un émetteur et un sensibilisateur, l'hôte, l'émetteur et le sensibilisateur sont différents les uns des autres, et le composé hétérocyclique est compris dans l'émetteur.

**12.** Dispositif électroluminescent organique selon la revendication 11, dans lequel une longueur d'onde pic de lumière émise par la couche émissive est d'au moins 430 nm et ne dépasse pas 500 nm, la longueur d'onde pic de lumière étant mesurée au moyen d'un luminancemètre.

**13.** Dispositif électroluminescent organique selon la revendication 11 ou 12, dans lequel l'émetteur est un émetteur de fluorescence, un émetteur de fluorescence retardée, ou une combinaison de ceux-ci.

**14.** Dispositif électroluminescent selon l'une quelconque des revendications 11-13, dans lequel le sensibilisateur et le composé hétérocyclique satisfont la condition 5 :

Condition 5 $0\ \mu s < T_{déclin}\ (HC) < 5\ \mu s$

dans lequel, dans la condition 5,
$T_{déclin}$ (HC) indique un temps de déclin du composé hétérocyclique, et
le temps de déclin du composé hétérocyclique est mesuré à partir d'un spectre de photoluminescence en temps différé à la température ambiante d'un film comportant une épaisseur de 40 nm formé par dépôt sous vide de l'hôte et du composé hétérocyclique compris dans la couche émissive sur un substrat de quartz à un rapport de poids de 90:10 à une dépression de $1,33 \times 10^{-5}$ Pa ($10^{-7}$ torr).

**15.** Appareil électronique comprenant le dispositif électroluminescent organique selon l'une quelconque des revendications 7-14.

FIG. 1

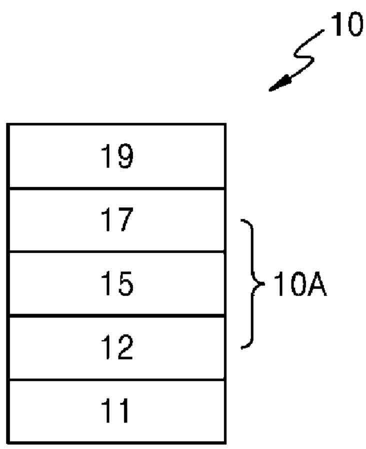

FIG. 2

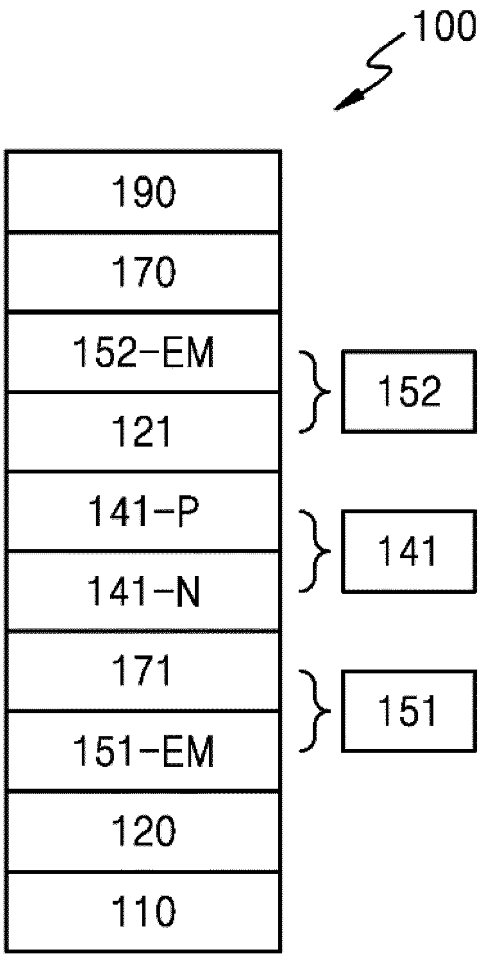

FIG. 3

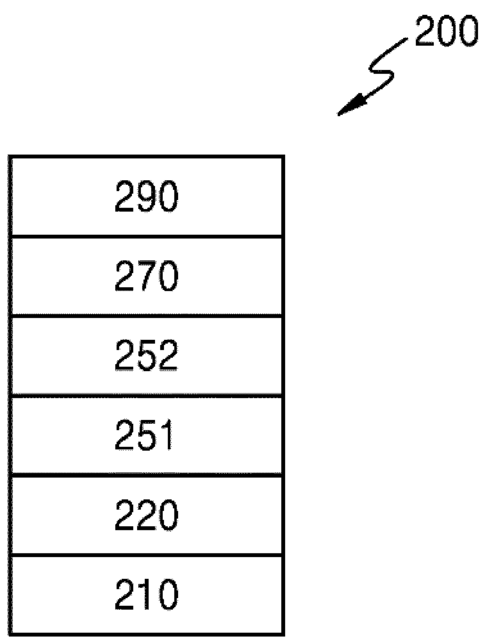

FIG. 4A

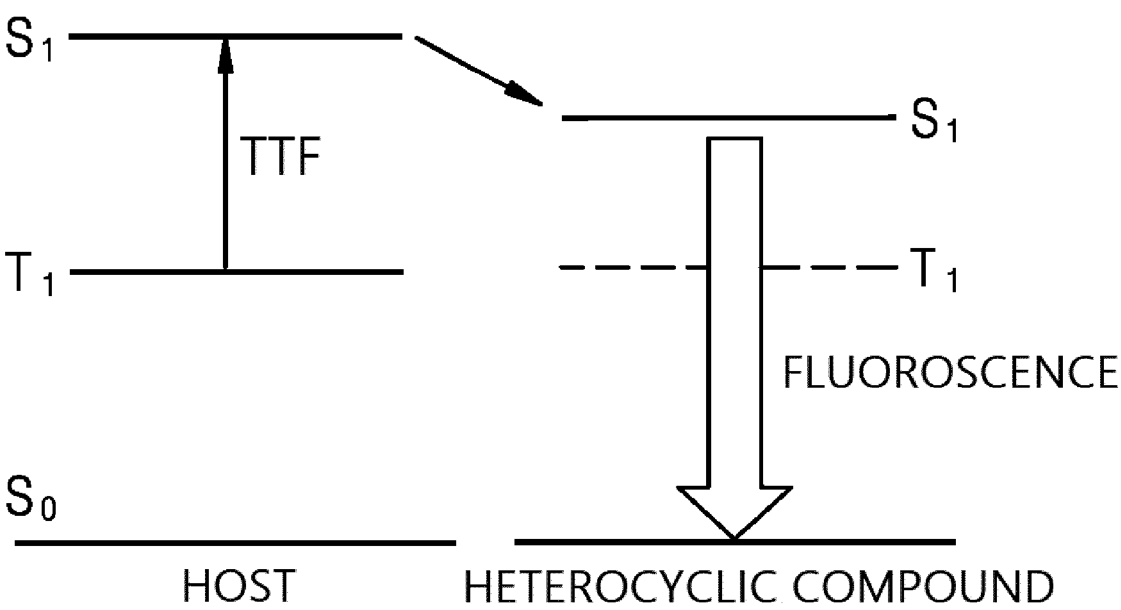

FIG. 4B

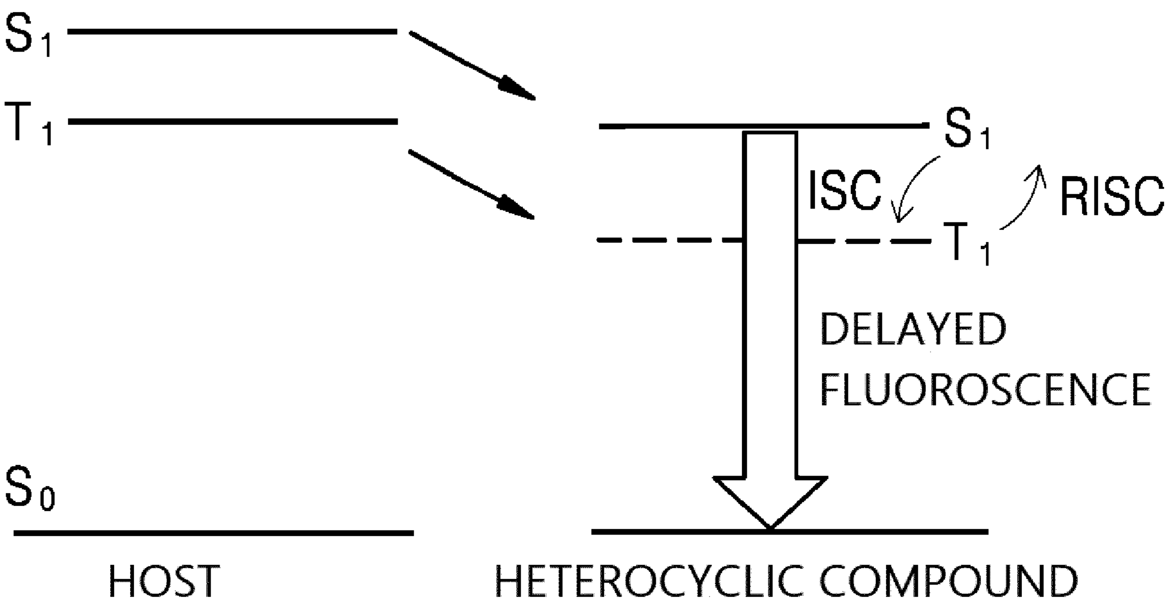
S1
T1
S1
ISC
RISC
T1
DELAYED
FLUOROSCENCE
S0
HOST
HETEROCYCLIC COMPOUND

FIG. 4C

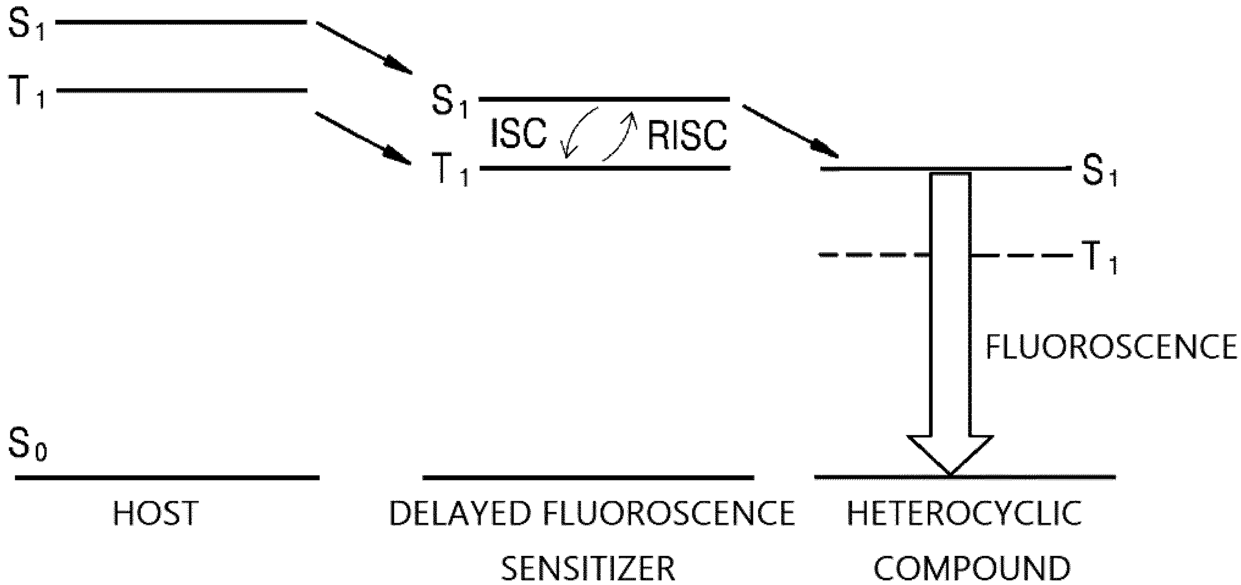
S1
T1
S1
ISC
RISC
T1
S1
T1
FLUOROSCENCE
S0
HOST
DELAYED FLUOROSCENCE
SENSITIZER
HETEROCYCLIC
COMPOUND

FIG. 4D

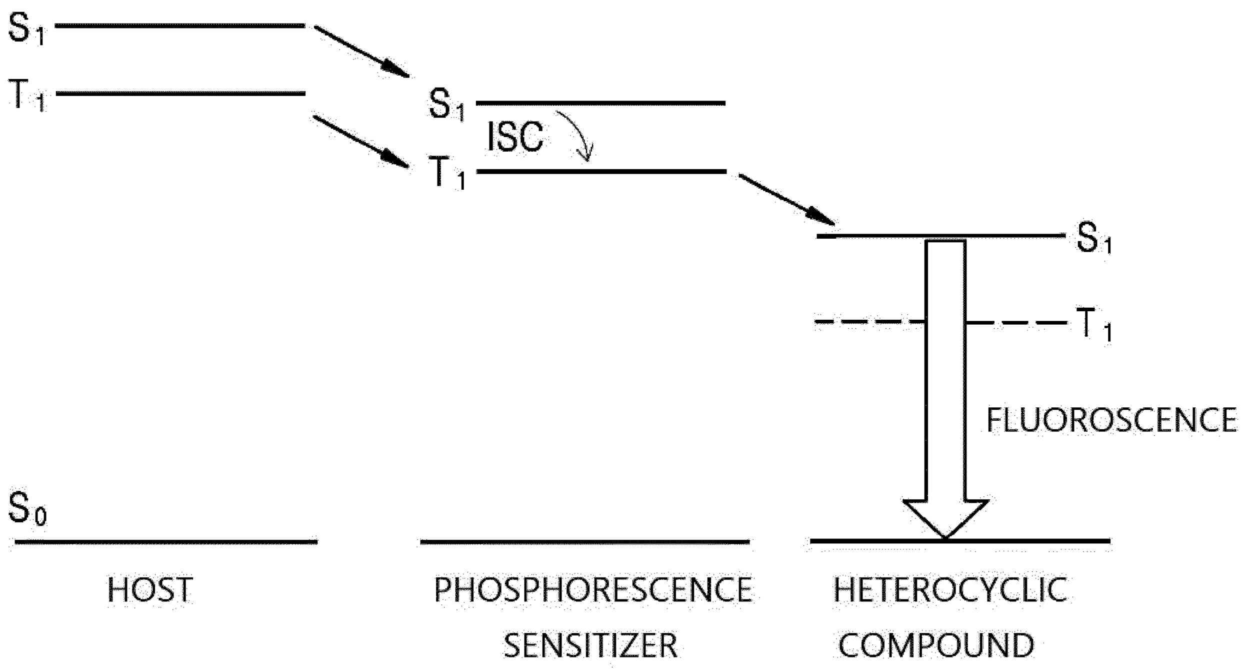
S1
T1
S1
ISC
T1
S1
T1
FLUOROSCENCE
S0
HOST
PHOSPHORESCENCE SENSITIZER
HETEROCYCLIC COMPOUND

FIG. 4E

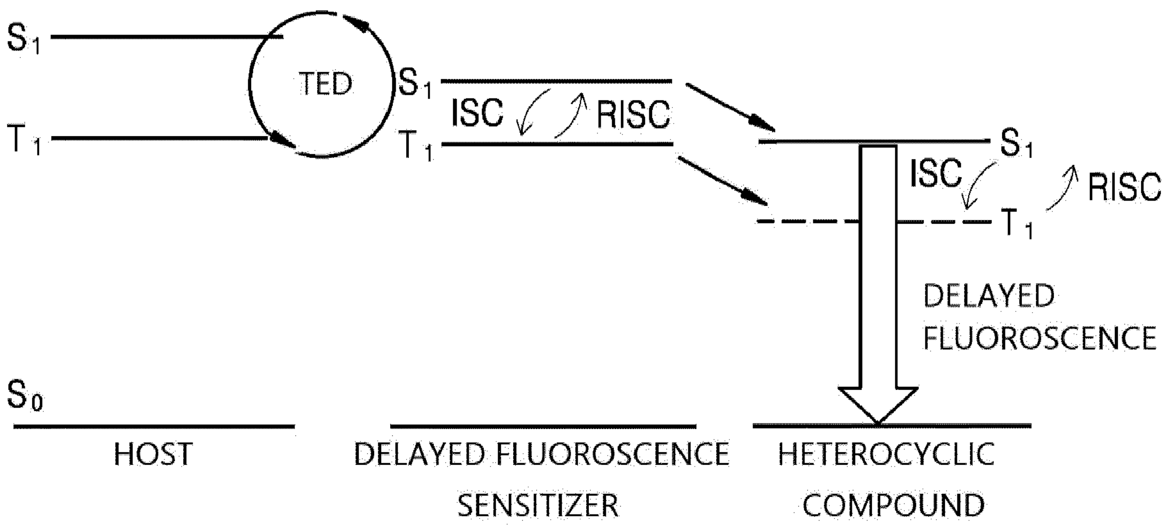
S1
T1
TED
S1
T1
ISC
RISC
S1
ISC
T1
RISC
DELAYED FLUOROSCENCE
S0
HOST
DELAYED FLUOROSCENCE SENSITIZER
HETEROCYCLIC COMPOUND

FIG. 5

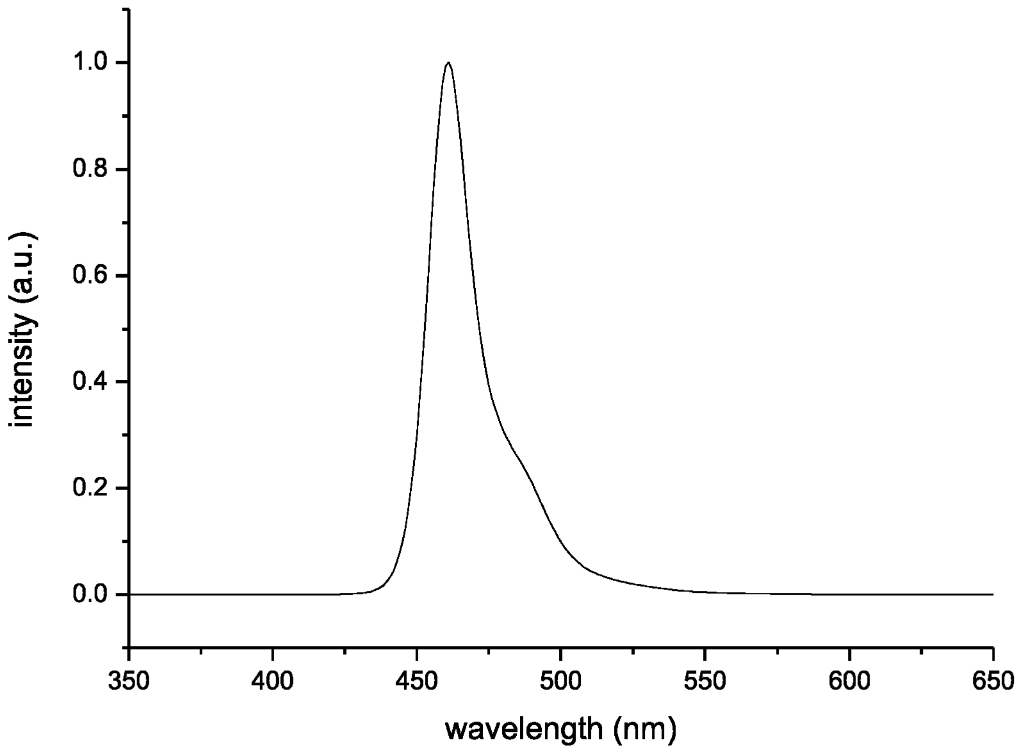
1.0
0.8
0.6
0.4
0.2
0.0
intensity (a.u.)
350
400
450
500
550
600
650
wavelength (nm)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 2020328351 A

### Non-patent literature cited in the description

- *J. Phys. Chem. A,* 2021, vol. 125, 10373-10378